# EUROPEAN PATENT APPLICATION

(11) **EP 4 794 494 A1**
(43) Date of publication of application: **19.08.2026**
(21) Application number: 26157695.3
(22) Date of filing: 10.02.2026
(51) Int. Cl.: H10K 50/11, H10K 50/12, H10K 85/60

(54) **LIGHT EMITTING ELEMENT, POLYCYCLIC COMPOUND FOR THE SAME, AND ELECTRONIC DEVICE INCLUDING THE SAME**

(30) Priority: 13.02.2025 JP 2025021473
(71) Applicant: Samsung Display Co., Ltd., Yongin-si, Gyeonggi-do (KR)
(72) Inventor: AOKI, Yuma, Yongin-si (KR); SUGITA, Yoshiro, Yongin-si (KR)
(74) Representative: Marks & Clerk LLP

(57) **Abstract**

A light emitting element includes a first electrode, a second electrode on the first electrode, and a light emitting layer between the first electrode and the second electrode and including a first compound represented by Formula 1.

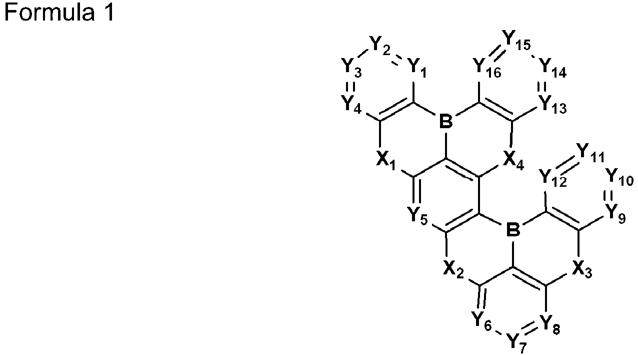

## Description

### BACKGROUND

### 1. Field

One or more embodiments of the present disclosure relate to a light emitting element, a polycyclic compound used therein, and an electronic device including the light emitting element.

### 2. Description of the Related Art

An organic electroluminescent display device including organic electroluminescent elements has been used as a display device included in an electronic device. The organic electroluminescent display device is a display device including self-luminous type (kind) light emitting elements that realizes display of images by injecting holes and electrons respectively from a first electrode and a second electrode into a light emitting layer under a driving voltage and emitting light from a light emitting material of the light emitting layer.

When applying light emitting elements to display devices, improvements in light efficiency and lifespan are desired or required, and thus there is a continuous demand or desire for the development of materials for light emitting elements that may stably achieve such improvements, for example, low driving voltage, high luminous efficiency, and long lifespan.

### SUMMARY

One or more aspects of embodiments of the present disclosure are directed toward a light emitting element with improved light emitting efficiency and lifespan.

One or more aspects of embodiments of the present disclosure are directed toward a polycyclic compound which has improved quantum efficiency and material stability.

One or more aspects of embodiments of the present disclosure are directed toward an electronic device that has excellent or suitable display quality by including the light emitting element with improved light emitting efficiency and lifespan.

Additional aspects will be set forth in part in the description which follows and, in part, will be apparent from the description, or may be learned by practice of the presented embodiments.

One or more embodiments of the present disclosure provide a polycyclic compound represented by Formula 1.

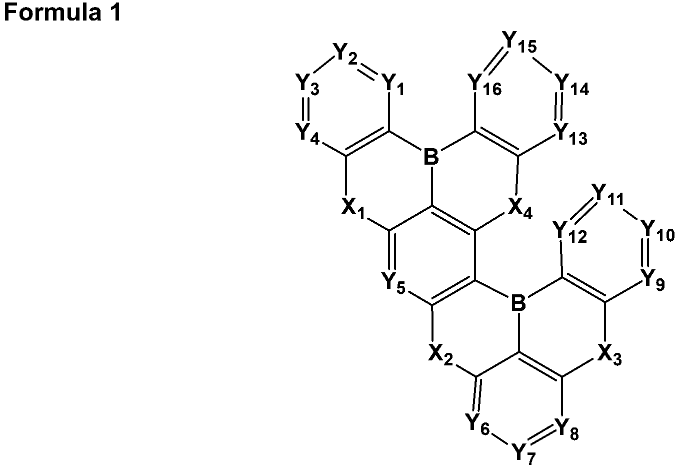

In Formula 1, X₁ to X₄ are each independently O, S, or Se, or represented by Formula 2, Y₁ to Y₁₆ are each independently CRₐ or N, and Rₐ is hydrogen, deuterium, a cyano group, a substituted or unsubstituted amino group, a substituted or unsubstituted alkyl group of 1 to 10 carbon atoms, a substituted or unsubstituted aryl group of 6 to 30 ring-forming carbon atoms, or a substituted or unsubstituted heteroaryl group of 2 to 30 ring-forming carbon atoms.

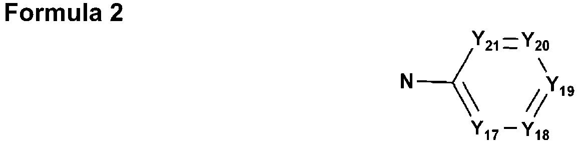

In Formula 2, Y₁₇ to Y₂₁ are each independently CR_{b} or N, and R_{b} is hydrogen, deuterium, a cyano group, a substituted or unsubstituted amino group, a substituted or unsubstituted alkyl group of 1 to 10 carbon atoms, a substituted or unsubstituted aryl group of 6 to 30 ring-forming carbon atoms, or a substituted or unsubstituted heteroaryl group of 2 to 30 ring-forming carbon atoms, if (e.g., when) none of X₁ to X₄ of Formula 1 is represented by Formula 2, at least one selected from among Y₁ to Y₁₆ of Formula 1 is N, and if (e.g., when) at least one selected from among X₁ to X₄ of Formula 1 is represented by Formula 2, at least one selected from among Y₁ to Y₁₆ of Formula 1 and Y₁₇ to Y₂₁ of Formula 2 is N.

In one or more embodiments, Formula 2 may be represented by Formula 2-1, or one selected from among Y₁₇ to Y₂₁ may be N, and the remainder may be CR_{b} in Formula 2.

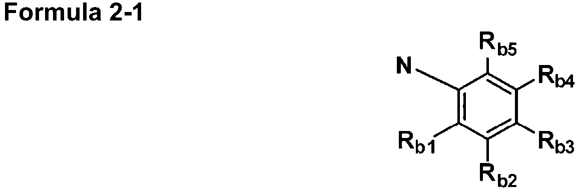

In Formula 2-1, R_{b1} to R_{b5} are each independently hydrogen, deuterium, a cyano group, a substituted or unsubstituted amino group, a substituted or unsubstituted alkyl group of 1 to 10 carbon atoms, a substituted or unsubstituted aryl group of 6 to 30 ring-forming carbon atoms, or a substituted or unsubstituted heteroaryl group of 2 to 30 ring-forming carbon atoms.

In one or more embodiments, one selected from among one selected from among Y₁ to Y₄, one selected from among Y₆ to Y₈, one selected from among Y₁₃ to Y₁₆, and Y₅ in Formula 1 may each be N, and the remainder may each independently be CRₐ, and X₁ to X₄ in Formula 1 may each independently be O, S, or Se, or represented by Formula 2-1.

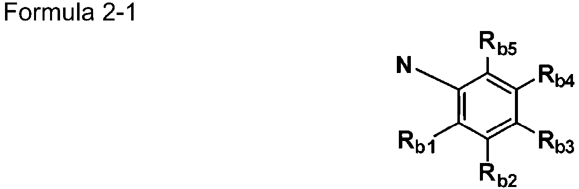

In Formula 2-1, R_{b1} to R_{b5} are each independently hydrogen, deuterium, a cyano group, a substituted or unsubstituted amino group, a substituted or unsubstituted alkyl group of 1 to 10 carbon atoms, a substituted or unsubstituted aryl group of 6 to 30 ring-forming carbon atoms, or a substituted or unsubstituted heteroaryl group of 2 to 30 ring-forming carbon atoms.

In one or more embodiments, if (e.g., when) Y₁ to Y₁₆ of Formula 1 are each independently CRₐ, at least one selected from among X₁ to X₄ may be represented by Formula 2, and in Formula 2, one selected from among Y₁₇ to Y₂₁ may be N, and the remainder may each independently be CR_{b}.

In one or more embodiments, at least one hydrogen atom in Formula 1 and Formula 2 may be substituted with deuterium.

The polycyclic compound represented by Formula 1 may be a blue emitting dopant.

The polycyclic compound represented by Formula 1 may be a thermally activated delayed fluorescence material.

According to one or more embodiments of the present disclosure, a light emitting element includes a first electrode, a second electrode on (e.g., arranged on) the first electrode, and a light emitting layer between (e.g., arranged between) the first electrode and the second electrode and including the polycyclic compound of one or more embodiments.

In one or more embodiments, the light emitting layer may further include at least one selected from among a second compound represented by Formula HT-1 and a third compound represented by Formula ET-1.

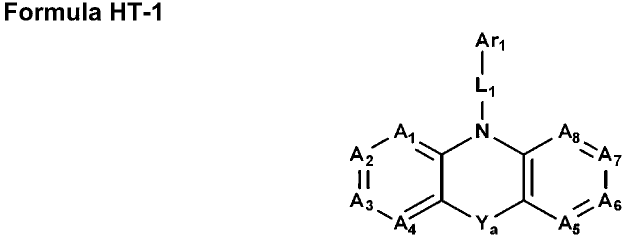

In Formula HT-1, A₁ to A₈ are each independently N or CR₅₁, L₁ is a direct linkage, a substituted or unsubstituted arylene group of 6 to 30 ring-forming carbon atoms, or a substituted or unsubstituted heteroarylene group of 2 to 30 ring-forming carbon atoms, Yₐ is a direct linkage, CR₅₂R₅₃, or SiR₅₄R₅₅, Ar₁ is a substituted or unsubstituted aryl group of 6 to 30 ring-forming carbon atoms or a substituted or unsubstituted heteroaryl group of 2 to 30 ring-forming carbon atoms, and R₅₁ to R₅₅ may each independently be hydrogen, deuterium, a halogen, a cyano group, a substituted or unsubstituted silyl group, a substituted or unsubstituted thio group, a substituted or unsubstituted oxy group, a substituted or unsubstituted amino group, a substituted or unsubstituted boron group, a substituted or unsubstituted alkyl group of 1 to 20 carbon atoms, a substituted or unsubstituted alkenyl group of 2 to 20 carbon atoms, a substituted or unsubstituted aryl group of 6 to 60 ring-forming carbon atoms, or a substituted or unsubstituted heteroaryl group of 2 to 60 ring-forming carbon atoms, and/or combined with an adjacent group to form a ring.

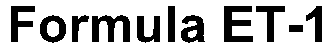

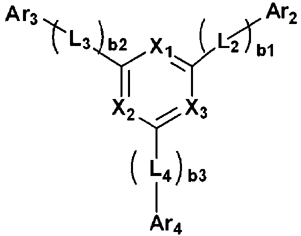

In Formula ET-1, at least one selected from among X₁ to X₃ is N, and the remainder are CR₅₆, R₅₆ is hydrogen, deuterium, a substituted or unsubstituted alkyl group of 1 to 20 carbon atoms, a substituted or unsubstituted aryl group of 6 to 60 ring-forming carbon atoms, or a substituted or unsubstituted heteroaryl group of 2 to 60 ring-forming carbon atoms, b1 to b3 are each independently an integer of 0 to 10, Ar₂ to Ar₄ are each independently hydrogen, deuterium, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and L₂ to L₄ are each independently a direct linkage, a substituted or unsubstituted arylene group of 6 to 30 ring-forming carbon atoms, or a substituted or unsubstituted heteroarylene group or 2 to 30 ring-forming carbon atoms.

In one or more embodiments, the light emitting layer may further include a fourth compound represented by Formula D-1.

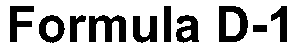

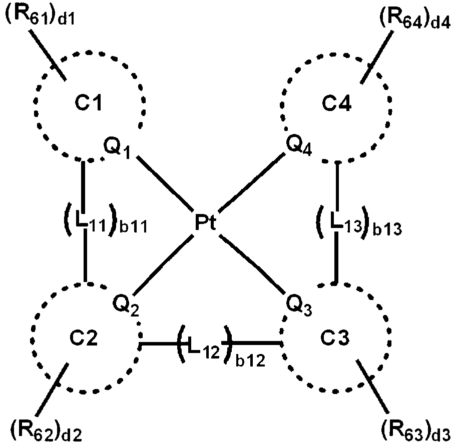

In Formula D-1, Q₁ to Q₄ are each independently C or N, C1 to C4 are each independently a substituted or unsubstituted hydrocarbon ring of 5 to 30 ring-forming carbon atoms or a substituted or unsubstituted heterocycle of 2 to 30 ring-forming carbon atoms, L₁₁ to L₁₃ are each independently a direct linkage, *-O-* , *-S-* , 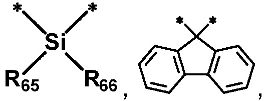 a substituted or unsubstituted alkylene group of 1 to 20 carbon atoms, a substituted or unsubstituted arylene group of 6 to 30 ring-forming carbon atoms, or a substituted or unsubstituted heteroarylene group of 2 to 30 ring-forming carbon atoms, b11 to b13 are each independently 0 or 1, R₆₁ to R₆₆ are each independently hydrogen, deuterium, a halogen, a cyano group, a substituted or unsubstituted silyl group, a substituted or unsubstituted thio group, a substituted or unsubstituted oxy group, a substituted or unsubstituted amino group, a substituted or unsubstituted boron group, a substituted or unsubstituted alkyl group of 1 to 20 carbon atoms, a substituted or unsubstituted alkenyl group of 2 to 20 carbon atoms, a substituted or unsubstituted aryl group of 6 to 60 ring-forming carbon atoms, or a substituted or unsubstituted heteroaryl group of 2 to 60 ring-forming carbon atoms, and d1 to d4 are each independently an integer of 0 to 4.

A fluorescence lifetime of the polycyclic compound may be about 3.0 microseconds (µs) or less.

The light emitting layer may be to emit delayed fluorescence.

The light emitting layer may be to emit blue color light.

According to one or more embodiments of the present disclosure, an electronic device includes a display module including a plurality of light emitting elements, wherein at least one selected from among the plurality of light emitting elements includes a first electrode, a second electrode on (e.g., arranged on) the first electrode, and a light emitting layer between (e.g., arranged between) the first electrode and the second electrode and including the polycyclic compound of one or more embodiments.

In one or more embodiments, the electronic device may further include at least one selected from among a processor, a memory, and a power module.

At least some of the above and other features of the invention are set out in the claims.

For example, one or more embodiments of the present disclosure provide a light emitting element that achieves high external quantum efficiency, excellent blue color purity, and extended operational lifetime by incorporating a polycyclic compound represented by Formula 1 as a thermally activated delayed fluorescence dopant. The specification further supports variations in heteroatom placement, substituent selection, and optional inclusion of host and sensitizer compounds (e.g., Formulas HT-1, ET-1, and D-1) to enhance charge balance and energy transfer within the light emitting layer. These features, together with the disclosed fluorescence lifetime of about 3.0 µs or less and optional deuteration, enable improved material stability and device reliability.

### BRIEF DESCRIPTION OF DRAWINGS

The accompanying drawings are included to provide a further understanding of the present disclosure and are incorporated in and constitute a part of this disclosure. The drawings illustrate embodiments of the present disclosure and, together with the description, serve to explain principles of the disclosure. Above and/or other aspects of the disclosure should become apparent and appreciated from the following description of embodiments taken in conjunction with the accompanying drawings. In the drawings:
FIG. 1 is a block diagram of an electronic device according to one or more embodiments of the present disclosure;
FIG. 2 illustrates schematic diagrams of electronic devices according to one or more embodiments of the present disclosure;
FIG. 3 is a plan view showing a display module according to one or more embodiments of the present disclosure;
FIG. 4 is a cross-sectional view showing a portion corresponding to the line I-I' in FIG. 3 according to one or more embodiments of the present disclosure;
FIG. 5 is a cross-sectional view schematically showing a light emitting element according to one or more embodiments of the present disclosure;
FIG. 6 is a cross-sectional view schematically showing a light emitting element according to one or more embodiments of the present disclosure;
FIG. 7 is a cross-sectional view schematically showing a light emitting element according to one or more embodiments of the present disclosure;
FIG. 8 is a cross-sectional view schematically showing a light emitting element according to one or more embodiments of the present disclosure;
FIG. 9 is a cross-sectional view schematically showing a light emitting element according to one or more embodiments of the present disclosure;
FIG. 10 is a cross-sectional view showing a display module according to one or more embodiments of the present disclosure;
FIG. 11 is a cross-sectional view showing a display module according to one or more embodiments of the present disclosure;
FIG. 12 is a cross-sectional view showing a display module according to one or more embodiments of the present disclosure;
FIG. 13 is a cross-sectional view showing a display module according to one or more embodiments of the present disclosure;
FIG. 14 is a perspective view of an electronic device according to one or more embodiments of the present disclosure;
FIG. 15 is a perspective view of an electronic device according to one or more embodiments of the present disclosure; and
FIG. 16 is a diagram showing an interior of a vehicle in which an electronic device according to one or more embodiments of the present disclosure is arranged.

### DETAILED DESCRIPTION

The present disclosure may be modified in one or more suitable ways and may take one or more suitable forms, and specific/example embodiments are illustrated in the drawings and will be described in more detail in the text. However, this is not intended to limit the present disclosure to a specific disclosure form, but should be understood to include all modifications, equivalents, or substitutes included in the teachings and technical scope of the disclosure.

In this disclosure, it will be understood that if (e.g., when) an element (or a region, a layer, a portion, and/or the like) is referred to as being "on", "connected to", or "coupled to" another element, it may be directly arranged on, connected to, or coupled to the other element, or one or more other elements may be arranged therebetween. In contrast, "directly on" may refer to that there are no additional layers, films, regions, plates, and/or the like, between the element and the other element. For example, "directly on" or "directly under" may refer to two layers or two members are arranged without utilizing an additional member such as an adhesive member therebetween.

In the present disclosure, like reference numerals or symbols refer to like elements throughout, and duplicative descriptions thereof may not be provided for conciseness. In the drawings, the thickness, ratio, and/or size of an element may be exaggerated or reduced for effectively describing the technical contents. As used herein, the term "and/or" or "or" or "/" may include any and all combinations of one or more of the associated listed elements.

It will be understood that, although the terms "first", "second", and/or the like may be used herein to describe one or more suitable elements, the elements are not to be limited by these terms. These terms are only used to distinguish one element, component, region, layer, or section from another element, component, region, layer, or section. For instance, a first element, component, region, layer, or section discussed herein could be termed a second element, component, region, layer, or section without departing from the scope and teaching of the disclosure. Similarly, a second element, component, region, layer, or section could be termed a first element, component, region, layer, or section. In this disclosure, the singular expressions "a", "an", "one", and "the" are intended to include the plural forms as well, unless the context clearly indicates otherwise. Further, the utilization of "may" when describing embodiments of the present disclosure refers to "one or more embodiments of the present disclosure".

In addition, the terms "below", "under", "on the lower side", "above", "over", "on the upper side", and/or the like may be used to describe the relationships between elements illustrated in the drawings. These terms are relative concepts and are described on the basis of the directions indicated in the drawings.

It will be further understood that the terms "comprise(s)/comprising", "include(s)/including", and/or "has(have)/having", if (e.g., when) used in this disclosure, specify the presence of stated features, numbers, steps, operations, elements, components, or combinations thereof, but do not preclude the possibility of the presence or addition of one or more other features, numbers, steps, operations, elements, components, and/or combinations thereof. Additionally, the terms "comprise(s)/comprising," "include(s)/including," "has(have)/having," or other similar terms include or support the terms "consisting of" and "consisting essentially of," indicating the presence of stated features, numbers, steps, operations, elements, and/or components, without or essentially without the presence of other features, numbers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

In this disclosure, the term "substituted or unsubstituted" may refer to being substituted or unsubstituted with at least one substituent selected from the group consisting of deuterium, a halogen, a cyano group, a nitro group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group. In addition, each of the illustrated substituents may be substituted or unsubstituted. For example, a biphenyl group may be interpreted as an aryl group or a phenyl group substituted with a phenyl group.

In this disclosure, the terms "forming a ring via the combination with an adjacent group", "combined with an adjacent group to form a ring", "bonded to an adjacent group to form ring", and/or the like may refer to forming a substituted or unsubstituted hydrocarbon ring or a substituted or unsubstituted heterocycle via the combination with an adjacent group. The hydrocarbon ring may include an aliphatic hydrocarbon ring and/or an aromatic hydrocarbon ring. The heterocycle may include an aliphatic heterocycle and/or an aromatic heterocycle. The hydrocarbon ring and the heterocycle may each be a monocycle or a polycycle. In one or more embodiments, the ring formed via the combination with an adjacent group may be combined with another ring to form a spiro structure.

In this disclosure, the term "adjacent group" may refer to a substituent substituted for an atom which is directly combined with an atom substituted with the corresponding substituent, another substituent substituted for an atom which is substituted with the corresponding substituent, or a substituent sterically positioned at the nearest position to the corresponding substituent. For example, in 1,2-dimethylbenzene, two methyl groups may be interpreted as "adjacent groups" to each other, and in 1,1-diethylcyclopentane, two ethyl groups may be interpreted as "adjacent groups" to each other. In addition, in 4,5-dimethylphenanthrene, two methyl groups may be interpreted as "adjacent groups" to each other.

In this disclosure, a halogen may be fluorine, chlorine, bromine, or iodine.

In this disclosure, an alkyl group may be linear or branched. The number of carbon atoms in the alkyl group may be 1 to 60, 1 to 30, 1 to 20, 1 to 10, or 1 to 6. Examples of the alkyl group may include methyl, ethyl, n-propyl, isopropyl, n-butyl, s-butyl, t-butyl, i-butyl, 2-ethylbutyl, 3,3-dimethylbutyl, n-pentyl, i-pentyl, neopentyl, t-pentyl, 1-methylpentyl, 3-methylpentyl, 2-ethylpentyl, 4-methyl-2-pentyl, n-hexyl, 1-methylhexyl, 2-ethylhexyl, 2-butylhexyl, n-heptyl, 1-methylheptyl, 2,2-dimethylheptyl, 2-ethylheptyl, 2-butylheptyl, n-octyl, t-octyl, 2-ethyloctyl, 2-butyloctyl, 2-hexyloctyl, 3,7-dimethyloctyl, n-nonyl, n-decyl, 2-ethyldecyl, 2-butyldecyl, 2-hexyldecyl, 2-octyldecyl, n-undecyl, n-dodecyl, 2-ethyldodecyl, 2-butyldodecyl, 2-hexyldocecyl, 2-octyldodecyl, n-tridecyl, n-tetradecyl, n-pentadecyl, n-hexadecyl, 2-ethylhexadecyl, 2-butylhexadecyl, 2-hexylhexadecyl, 2-octylhexadecyl, n-heptadecyl, n-octadecyl, n-nonadecyl, n-eicosyl, 2-ethyleicosyl, 2-butyleicosyl, 2-hexyleicosyl, 2-octyleicosyl, n-heneicosyl, n-docosyl, n-tricosyl, n-tetracosyl, n-pentacosyl, n-hexacosyl, n-heptacosyl, n-octacosyl, n-nonacosyl, n-triacontyl, and/or the like, without limitation.

In this disclosure, a cycloalkyl group may refer to a ring-type (kind) alkyl group. The number of carbon atoms in the cycloalkyl group may be 3 to 60, 3 to 30, 3 to 20, or 3 to 10. Examples of the cycloalkyl group include a cyclopropyl group, a cyclobutyl group, a cyclopentyl group, a cyclohexyl group, a 4-methylcyclohexyl group, a 4-t-butylcyclohexyl group, a cycloheptyl group, a cyclooctyl group, a cyclononyl group, a cyclodecyl group, a norbornyl group, a 1-adamantyl group, a 2-adamantyl group, an isobornyl group, a bicycloheptyl group, and/or the like, without limitation.

In this disclosure, an alkenyl group refers to a hydrocarbon group including one or more carbon-carbon double bonds in the middle or at the terminal of an alkyl group having 2 or more carbon atoms. The alkenyl group may be a linear chain or a branched chain. The number of carbon atoms in the alkenyl group is not specifically limited, for example, may be 2 to 60, 2 to 30, 2 to 20, or 2 to 10. Examples of the alkenyl group may include a vinyl group, a 1-butenyl group, a 1-pentenyl group, a 1,3-butadienyl aryl group, a styrenyl group, a styrylvinyl group, and/or the like, without limitation.

In this disclosure, an alkynyl group refers to a hydrocarbon group including one or more carbon-carbon triple bonds in the middle or at the terminal of an alkyl group having 2 or more carbon atoms. The alkynyl group may be a linear chain or a branched chain. The number of carbon atoms in the alkynyl group is not specifically limited, for example, may be 2 to 30, 2 to 20, or 2 to 10. Examples of the alkynyl group may include an ethynyl group, a propynyl group, and/or the like, without limitation.

In this disclosure, a hydrocarbon ring group refers to any functional group or substituent derived from an aliphatic hydrocarbon ring. The hydrocarbon ring group may be a saturated hydrocarbon ring group of 5 to 20 ring-forming carbon atoms.

In this disclosure, an aryl group refers to any functional group or substituent derived from an aromatic hydrocarbon ring. The aryl group may be a monocyclic aryl group or a polycyclic aryl group. The number of ring-forming carbon atoms in the aryl group may be 6 to 60, 6 to 30, 6 to 20, or 6 to 15. Examples of the aryl group may include phenyl, naphthyl, fluorenyl, anthracenyl, phenanthryl, biphenyl, terphenyl, quaterphenyl, quinquephenyl, sexiphenyl, triphenylenyl, pyrenyl, benzofluoranthenyl, chrysenyl, and/or the like, without limitation.

In this disclosure, a fluorenyl group may be substituted, and two substituents may be combined with each other to form a spiro structure. Examples of a substituted fluorenyl group are as follows, but embodiments of the present disclosure are not limited thereto.

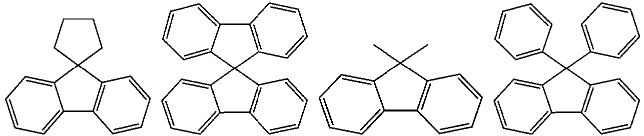

In this disclosure, a heterocyclic group refers to any functional group or substituent derived from a ring including one or more selected from among B, O, N, P, S, Si, and Se as heteroatoms. The heterocyclic group may include an aliphatic heterocyclic group and/or an aromatic heterocyclic group. The aromatic heterocyclic group may be a heteroaryl group. The aliphatic heterocyclic group and the aromatic heterocyclic group may each be a monocycle or a polycycle.

In this disclosure, the heterocyclic group may include one or more selected from among B, O, N, P, S, Si and Se as heteroatoms. If (e.g., when) the heterocyclic group includes two or more heteroatoms, the two or more heteroatoms may be the same or different. The heterocyclic group may be a monocyclic heterocyclic group or a polycyclic heterocyclic group and has the concept including a heteroaryl group. The number for ring-forming carbon atoms in the heterocyclic group may be 2 to 60, 2 to 30, 2 to 20, and 2 to 10.

In this disclosure, an aliphatic heterocyclic group may include one or more selected from among B, O, N, P, S, Si, and Se as heteroatoms. The number of ring-forming carbon atoms in the aliphatic heterocyclic group may be 2 to 30, 2 to 20, or 2 to 10. Examples of the aliphatic heterocyclic group may include an oxirane group, a thiirane group, a pyrrolidine group, a piperidine group, a tetrahydrofuran group, a tetrahydrothiophene group, a thiane group, a tetrahydropyran group, a 1,4-dioxane group, and/or the like, without limitation.

In this disclosure, a heteroaryl group may include one or more selected from among B, O, N, P, S, Si, and Se as heteroatoms. If (e.g., when) the heteroaryl group includes two or more heteroatoms, the two or more heteroatoms may be the same or different. The heteroaryl group may be a monocyclic heterocyclic group or polycyclic heterocyclic group. The number for ring-forming carbon atoms in the heteroaryl group may be 2 to 60, 2 to 30, 2 to 20, or 2 to 10. Examples of the heteroaryl group may include a thiophene group, a furan group, a pyrrole group, a imidazole group, a pyridine group, a bipyridine group, a pyrimidine group, a triazine group, a triazole group, an acridyl group, a pyridazine group, a pyrazinyl group, a quinoline group, a quinazoline group, a quinoxaline group, a phenoxazine group, a phthalazine group, a pyrido pyridine group, a pyrido pyrazine group, a pyrazino pyrazine group, a isoquinoline group, an indole group, a carbazole group, an N-arylcarbazole group, an N-heteroarylcarbazole group, an N-alkylcarbazole group, a benzoxazole group, a benzimidazole group, a benzothiazole group, a benzocarbazole group, a benzothiophene group, a dibenzothiophene group, a thienothiophene group, a benzofuran group, a phenanthroline group, a thiazole group, an isoxazole group, an oxazole group, an oxadiazole group, a thiadiazole group, a phenothiazine group, a dibenzosilole group, a dibenzofuran group, and/or the like, without limitation.

In this disclosure, the same explanation on the above-described aryl group may be applied to an arylene group except that the arylene group is a divalent group. The same explanation on the above-described heteroaryl group may be applied to a heteroarylene group except that the heteroarylene group is a divalent group.

In this disclosure, a silyl group includes an alkyl silyl group and/or an aryl silyl group. Examples of the silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, and/or the like, without limitation.

In this disclosure, the number of carbon atoms in a carbonyl group is not specifically limited, for example, may be 1 to 40, 1 to 30, or 1 to 20. For example, the carbonyl group may have the structures below, but embodiments of the present disclosure are not limited thereto.

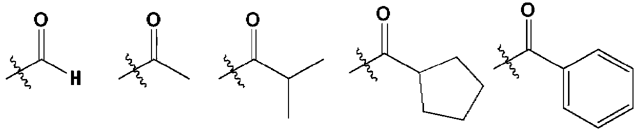

In this disclosure, the number of carbon atoms in a sulfinyl group or a sulfonyl group is not specifically limited, for example, may be 1 to 30. The sulfinyl group may include an alkyl sulfinyl group and/or an aryl sulfinyl group. The sulfonyl group may include an alkyl sulfonyl group and/or an aryl sulfonyl group.

In this disclosure, a thio group may include an alkyl thio group and/or an aryl thio group. The thio group may refer to the above-defined alkyl group or aryl group combined with a sulfur atom. Examples of the thio group may include a methylthio group, an ethylthio group, a propylthio group, a pentylthio group, a hexylthio group, an octylthio group, a dodecylthio group, a cyclopentylthio group, a cyclohexylthio group, a phenylthio group, a naphthylthio group, and/or the like, without limitation.

In this disclosure, an oxy group may refer to the above-defined alkyl group or aryl group combined with an oxygen atom. The oxy group may include an alkoxy group and/or an aryl oxy group. The alkoxy group may be a linear chain, a branched chain, or a cyclic chain. The number of carbon atoms in the alkoxy group is not specifically limited, for example, may be 1 to 20 or 1 to 10. Examples of the oxy group may include methoxy, ethoxy, n-propoxy, isopropoxy, butoxy, pentyloxy, hexyloxy, octyloxy, nonyloxy, decyloxy, benzyloxy, and/or the like. However, embodiments of the present disclosure are not limited thereto.

In this disclosure, a boron group may refer to the above-defined alkyl group or aryl group, combined with a boron atom. The boron group may include an alkyl boron group and/or an aryl boron group. Examples of the boron group may include a dimethyl boron group, a diethyl boron group, a t-butyl methyl boron group, a diphenyl boron group, a phenyl boron group, and/or the like, without limitation.

In this disclosure, the number of carbon atoms in an amino group is not specifically limited, for example, may be 1 to 30. The amino group may include an alkyl amino group and/or an aryl amino group. Examples of the amino group may include a methylamino group, a dimethylamino group, a phenylamino group, a diphenylamino group, a naphthylamino group, a 9-methyl-anthracenylamino group, and/or the like, without limitation.

In this disclosure, the alkyl group in an alkylthiol group, an alkylsulfoxy group, an alkylaryl group, an alkylamino group, an alkyl boron group, an alkyl silyl group, and an alkyl amino group may be the same as the examples of the alkyl group described above.

In this disclosure, the aryl group in an aryloxy group, an arylthio group, an arylsulfoxy group, an arylamino group, an aryl boron group, an aryl silyl group, or an aryl amino group may be the same as the examples of the aryl group described above.

In the disclosure, the phosphine oxide group may be substituted with, for example, at least one of the alkyl groups or aryl groups described above.

In the disclosure, the phosphine sulfide group may be substituted with, for example, at least one of the alkyl groups or aryl groups described above.

In this disclosure, a direct linkage may refer to a single bond.

In this disclosure, 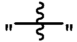 or "-*" refers to a position to be connected.

Hereinafter, embodiments of the present disclosure will be explained referring to the drawings.

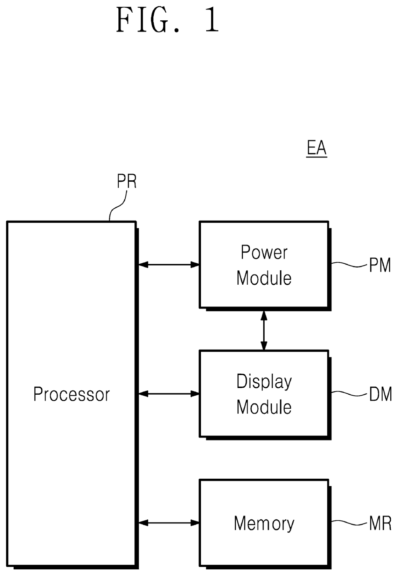

FIG. 1 is a block diagram of an electronic device according to one or more embodiments of the present disclosure. Referring to FIG. 1, an electronic device EA according to one or more embodiments may include a display module DM, a processor PR, a memory MR, and a power module PM.

The processor PR may include at least one of a central processing unit (CPU), an application processor (AP), a graphic processing unit (GPU), a communication processor (CP), an image signal processor (ISP), or a controller.

The memory MR may store data information necessary for operations of the processor PR and/or the display module DM. When the processor PR executes an application stored in the memory MR, an image data signal and/or an input control signal is transmitted to the display module DM, and the display module DM may process the received signals and output image information through a display screen. The display module DM may include a display panel that displays an image.

The power module PM may include a power supply module such as a power adapter or a battery device, and a power conversion module that converts power supplied by the power supply module to generate power desired or required for operations of the electronic device EA.

At least one selected from among the components of the electronic device EA described above may be included in the display module according to one or more embodiments, which will be described later, or in a display device of one or more embodiments including the display module. In one or more embodiments, some of individual modules functionally included in one module may be included in a display device and others may be provided separately from the display device. For example, in one or more embodiments, a display device may include the display module DM, and the processor PR, the memory MR, and the power module PM may be provided in the form of other devices within the electronic device EA other than the display device.

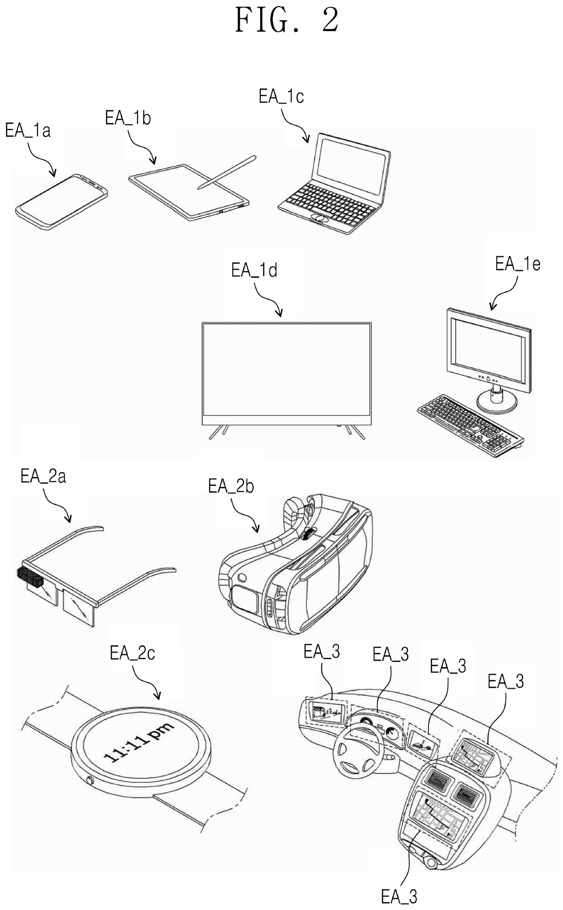

FIG. 2 illustrates schematic diagrams of various electronic devices according to one or more embodiments of the present disclosure.

Referring to FIG. 2, one or more suitable electronic devices including a display module according to one or more embodiments may include not only electronic devices for displaying images, such as a smart phone EA_1a, a tablet PC EA_1b, a laptop EA_1c, a TV EA_1d, and a desk monitor EA_1e, but also wearable electronic devices, such as smart glasses EA_2a, a head-mounted display EA_2b, and a smart watch EA_2c, as well as vehicle electronic devices EA_3, such as a dashboard, a center fascia, a Center Information Display (CID) arranged on the dashboard, and a room mirror display, of a vehicle.

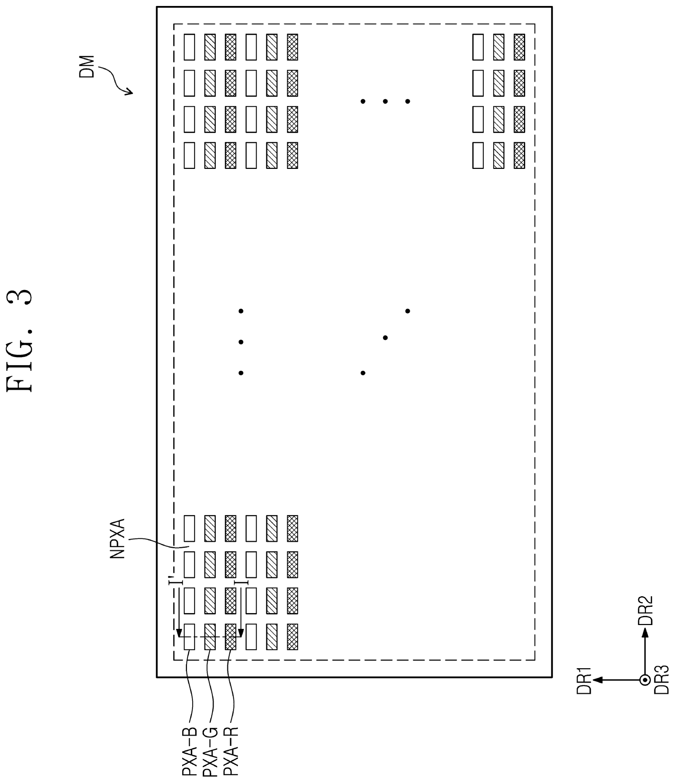

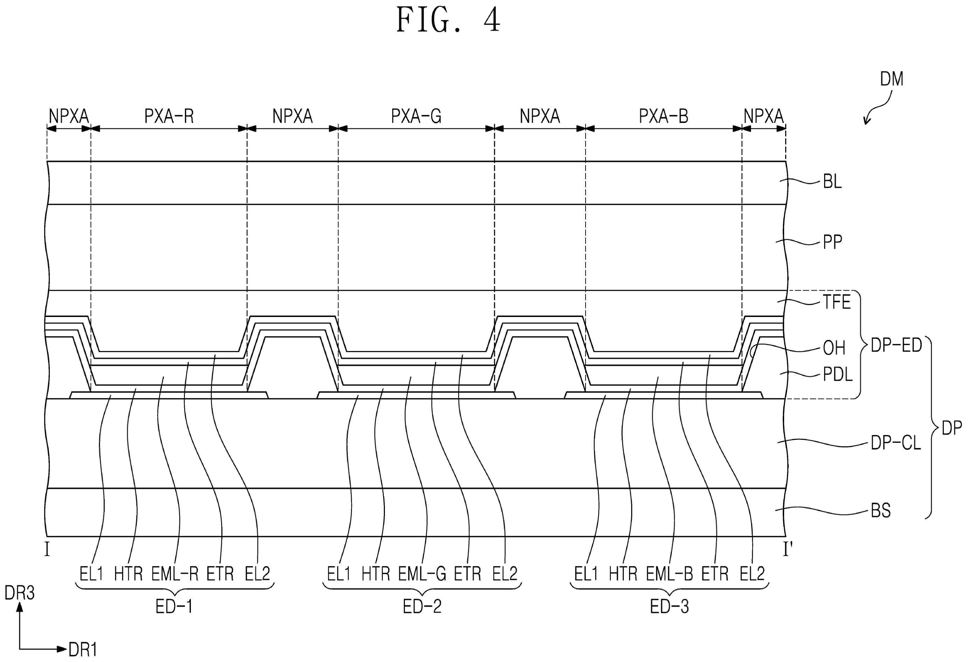

FIG. 3 is a plan view showing a display module DM according to one or more embodiments of the present disclosure. FIG. 4 is a cross-sectional view of the display module DM according to one or more embodiments of the present disclosure. For example, FIG. 4 is a cross-sectional view showing a portion corresponding to the line I-I' in FIG. 3.

The display module DM may include a plurality of light emitting elements ED-1, ED-2, and ED-3. In one or more embodiments, the display module DM may further include a display panel DP including the plurality of light emitting elements ED-1, ED-2, and ED-3 and an optical layer PP arranged on the display panel DP.

The display panel DP may include a base layer BS, a circuit layer DP-CL provided on the base layer BS, and a display element layer DP-ED. The display element layer DP-ED may include a pixel definition layer PDL, the light emitting elements ED-1, ED-2, and ED-3 arranged in the pixel definition layer PDL, and an encapsulation layer TFE arranged on the light emitting elements ED-1, ED-2, and ED-3.

The base layer BS may be a member providing a base surface on which the display element layer DP-ED is arranged. The base layer BS may be a glass substrate, a metal substrate, a plastic substrate, and/or the like. However, embodiments of the present disclosure are not limited thereto, and the base layer BS may be an inorganic layer, an organic layer, or a composite material layer.

In one or more embodiments, the circuit layer DP-CL may be arranged on the base layer BS, and the circuit layer DP-CL may include multiple transistors. Each of the transistors may include a control electrode, an input electrode, and an output electrode. For example, in one or more embodiments, the circuit layer DP-CL may include switching transistors and driving transistors for driving the light emitting elements ED-1, ED-2, and ED-3 of the display element layer DP-ED.

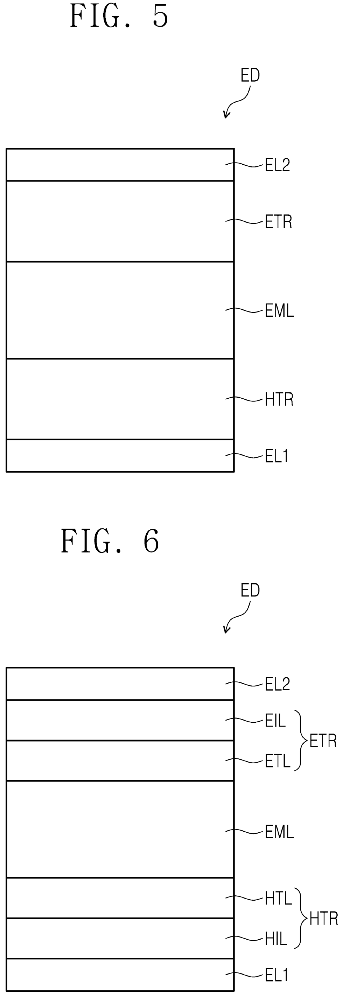

Each of the light emitting elements ED-1, ED-2, and ED-3 may independently have a structure selected from among structures of light emitting elements ED illustrated in FIG. 5 to FIG. 9, which will be explained later. Each of the light emitting elements ED-1, ED-2, and ED-3 may include a first electrode EL1, a hole transport region HTR, a respective light emitting layer EML-R, EML-G, or EML-B, an electron transport region ETR, and a second electrode EL2.

The optical layer PP may be arranged on the display panel DP to control the light reflected from the display panel DP due to external light. The optical layer PP may include, for example, a polarizing layer or a color filter layer. In one or more embodiments, the optical layer PP may not be provided in the display module DM.

On the optical layer PP, a base substrate BL may be arranged. The base substrate BL may be a member providing a base surface where the optical layer PP is arranged. The base substrate BL may be a glass substrate, a metal substrate, a plastic substrate, and/or the like. However, embodiments of the present disclosure are not limited thereto, and the base substrate BL may be an inorganic layer, an organic layer, or a composite material layer. In one or more embodiments, the base substrate BL may not be provided.

The display module DM according to one or more embodiments may further include a filling layer. The filling layer may be arranged between the display element layer DP-ED and the base substrate BL. The filling layer may be an organic layer. The filling layer may include at least one selected from among an acrylic resin, a silicon-based resin, and an epoxy-based resin.

In FIG. 4, shown is an embodiment in which respective light emitting layers EML-R, EML-G, and EML-B of light emitting elements ED-1, ED-2, and ED-3 are each arranged in an opening part OH defined in the pixel definition layer PDL, and the hole transport region HTR, the electron transport region ETR, and the second electrode EL2 are each provided as a common layer in all light emitting elements ED-1, ED-2, and ED-3. However, embodiments of the present disclosure are not limited thereto. Different from FIG. 4, in one or more embodiments, the hole transport region HTR and the electron transport region ETR may each be patterned and provided in the opening parts OH defined in the pixel definition layer PDL. For example, in one or more embodiments, the hole transport region HTR, the respective light emitting layers EML-R, EML-G, and EML-B, and the electron transport region ETR of the light emitting elements ED-1, ED-2, and ED-3 may be patterned by an inkjet printing method and provided.

The encapsulation layer TFE may cover the light emitting elements ED-1, ED-2, and ED-3. The encapsulation layer TFE may encapsulate the display element layer DP-ED. The encapsulation layer TFE may be a thin film encapsulation layer. The encapsulation layer TFE may be one layer or a stacked layer of multiple layers. The encapsulation layer TFE may include at least one insulating layer. The encapsulation layer TFE according to one or more embodiments may include at least one inorganic layer (hereinafter, encapsulating inorganic layer). In one or more embodiments, the encapsulation layer TFE may include at least one organic layer (hereinafter, encapsulating organic layer) and at least one encapsulating inorganic layer.

The encapsulating inorganic layer protects the display element layer DP-ED from moisture/oxygen, and the encapsulating organic layer protects the display element layer DP-ED from foreign materials such as dust particles. The encapsulating inorganic layer may include silicon nitride, silicon oxy nitride, silicon oxide, titanium oxide, and/or aluminium oxide, without specific limitation. The encapsulating organic layer may include an acrylic-based compound, an epoxy-based compound, and/or the like. In one or more embodiments, the encapsulating organic layer may include a photopolymerizable organic material, without specific limitation.

The encapsulation layer TFE may be arranged on the second electrode EL2 and may be arranged while filling the opening part OH.

Referring to FIG. 3 and FIG. 4, the display module DM may include a non-light emitting area NPXA and light emitting areas PXA-R, PXA-G, and PXA-B. The light emitting areas PXA-R, PXA-G, and PXA-B may be areas emitting light produced from the respective light emitting elements ED-1, ED-2, and ED-3. The display module DM may include a first light emitting area PXA-R, a second light emitting area PXA-G, and a third light emitting area PXA-B spaced and/or apart (e.g., spaced apart or separated) from one another on a plane.

The first to third light emitting areas PXA-R, PXA-G, and PXA-B may be areas separated by the pixel definition layer PDL. The non-light emitting area NPXA may be areas between neighboring light emitting areas PXA-R, PXA-G, and PXA-B and may be areas corresponding to the pixel definition layer PDL. In this disclosure, each of the light emitting areas PXA-R, PXA-G, and PXA-B may correspond to a pixel. The pixel definition layer PDL may divide the light emitting elements ED-1, ED-2, and ED-3. The respective light emitting layers EML-R, EML-G, and EML-B of the light emitting elements ED-1, ED-2, and ED-3 may be arranged and divided in the opening parts OH defined in the pixel definition layer PDL.

The light emitting areas PXA-R, PXA-G, and PXA-B may be divided into multiple groups according to the color of light produced from the light emitting elements ED-1, ED-2, and ED-3. In the display module DM according to one or more embodiments, shown in FIG. 3 and FIG. 4, three light emitting areas PXA-R, PXA-G, and PXA-B respectively emitting red color light, green color light, and blue color light (e.g., blue light) are illustrated. For example, the first light emitting area PXA-R may be referred to as a red light emitting area (i.e., red color light emitting area), the second light emitting area may be PXA-G referred to as a green light emitting area (i.e., green color light emitting area), and the third light emitting area PXA-B may be referred to as a blue light emitting area (i.e., blue color light emitting area).

In the display module DM according to one or more embodiments, a plurality of light emitting elements ED-1, ED-2, and ED-3 may be to emit light having different wavelength ranges. For example, in one or more embodiments, the display module DM may include a first light emitting element ED-1 emitting red color light, a second light emitting element ED-2 emitting green color light, and a third light emitting element ED-3 emitting blue color light. For example, in one or more embodiments, the red light emitting area PXA-R, the green light emitting area PXA-G, and the blue light emitting area PXA-B of the display module DM may respectively correspond to the first light emitting element ED-1, the second light emitting element ED-2, and the third light emitting element ED-3.

However, embodiments of the present disclosure are not limited thereto, and the first to third light emitting elements ED-1, ED-2, and ED-3 may be to emit light in substantially the same wavelength range, or at least one thereof may be to emit light in a different wavelength range. For example, in one or more embodiments, all the first to third light emitting elements ED-1, ED-2, and ED-3 may be to emit blue color light.

The light emitting areas PXA-R, PXA-G, and PXA-B in the display module DM according to one or more embodiments may be arranged in a stripe shape. Referring to FIG. 3, a plurality of first light emitting areas PXA-R may be arranged with each other along a second direction axis DR2, a plurality of second light emitting areas PXA-G may be arranged with each other along the second direction axis DR2, and a plurality of third light emitting areas PXA-B may be arranged with each other along the second direction axis DR2. In addition, the first light emitting areas PXA-R, the second light emitting areas PXA-G, and the third light emitting areas PXA-B may be arranged by turns along a first direction axis DR1.

In FIG. 3 and FIG. 4, the areas of the light emitting areas PXA-R, PXA-G, and PXA-B are shown similar, but embodiments of the present disclosure are not limited thereto. In one or more embodiments, the areas of the light emitting areas PXA-R, PXA-G, and PXA-B may be different from one another according to the wavelength range of light emitted. The areas of the light emitting areas PXA-R, PXA-G, and PXA-B may each refer to an area on a plane defined by the first direction axis DR1 and the second direction axis DR2 (e.g., the area in plan view).

The arrangement type (kind) of the light emitting areas PXA-R, PXA-G, and PXA-B is not limited to the configuration shown in FIG. 3, and the arrangement order of the first light emitting areas PXA-R, the second light emitting areas PXA-G, and the third light emitting areas PXA-B may be provided in one or more suitable combinations according to the properties of display quality desired or required for the display module DM and a display device including the same. For example, in one or more embodiments, the arrangement type (kind) of the light emitting areas PXA-R, PXA-G, and PXA-B may be a pentile (PENTILE^{®}) arrangement type (kind) (for example, an RGBG matrix, an RGBG structure, or an RGBG matrix structure), or a diamond (Diamond Pixel^{™}) arrangement type (kind) (e.g., a display (e.g., an OLED display) containing red, blue, and green (RGB) light emitting regions arranged in the shape of diamonds). PENTILE^{®} is a duly registered trademark of Samsung Display Co., Ltd. Diamond Pixel^{™} is a trademark of Samsung Display Co., Ltd.

In one or more, the areas of the light emitting areas PXA-R, PXA-G, and PXA-B may be different from one another. For example, in one or more embodiments, the area of the second light emitting area PXA-G, which is a green light emitting area, may be smaller than the area of the third light emitting area PXA-B, which is a blue light emitting area, but embodiments of the present disclosure are not limited thereto.

Hereinafter, FIG. 5 to FIG. 9 are each a cross-sectional view schematically showing a light emitting element according to one or more embodiments of the present disclosure. A light emitting element ED according to one or more embodiments may include a first electrode EL1, a hole transport region HTR, a light emitting layer EML, an electron transport region ETR, and a second electrode EL2, sequentially stacked (e.g., in the stated order).

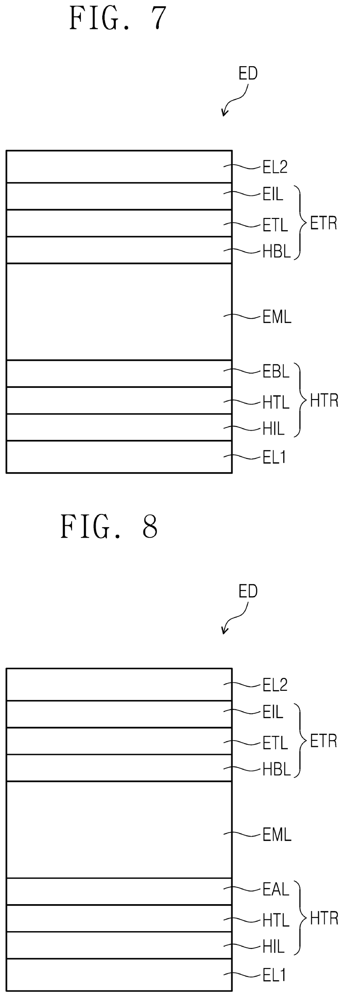

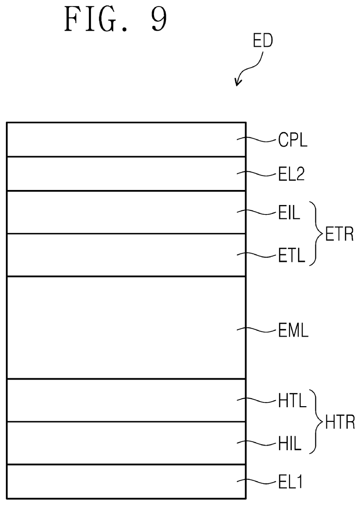

When compared to FIG. 5, FIG. 6 shows the cross-sectional view of a light emitting element ED of one or more embodiments, wherein a hole transport region HTR includes a hole injection layer HIL and a hole transport layer HTL, and an electron transport region ETR includes an electron injection layer EIL and an electron transport layer ETL. In addition, when compared to FIG. 5, FIG. 7 shows the cross-sectional view of a light emitting element ED of one or more embodiments, wherein a hole transport region HTR includes a hole injection layer HIL, a hole transport layer HTL, and an electron blocking layer EBL, and an electron transport region ETR includes an electron injection layer EIL, an electron transport layer ETL, and a hole blocking layer HBL. When compared to FIG. 5, FIG. 8 shows the cross-sectional view of a light emitting element ED of one or more embodiments, wherein a hole transport region HTR includes a hole injection layer HIL, a hole transport layer HTL, and a light emitting auxiliary layer EAL, and an electron transport region ETR includes an electron injection layer EIL, an electron transport layer ETL, and a hole blocking layer HBL. When compared to FIG. 6, FIG. 9 shows the cross-sectional view of a light emitting element ED of one or more embodiments, including a capping layer CPL arranged on the second electrode EL2.

The first electrode EL1 has conductivity (e.g., is a conductor). The first electrode EL1 may be formed using a metal material, a metal alloy, or a conductive compound. The first electrode EL1 may be an anode or a cathode. However, embodiments of the present disclosure are not limited thereto. In one or more embodiments, the first electrode EL1 may be a pixel electrode. The first electrode EL1 may be a transmissive electrode, a transflective electrode, or a reflective electrode. The first electrode EL1 may include at least one selected from among silver (Ag), magnesium (Mg), copper (Cu), aluminium (Al), platinum (Pt), palladium (Pd), gold (Au), nickel (Ni), neodymium (Nd), iridium (Ir), chromium (Cr), lithium (Li), calcium (Ca), lithium fluoride (LiF), molybdenum (Mo), titanium (Ti), tungsten (W), indium (In), tin (Sn), zinc (Zn), compounds of two or more selected therefrom, mixtures of two or more selected therefrom, and oxides thereof.

If (e.g., when) the first electrode EL1 is a transmissive electrode, the first electrode EL1 may include a transparent metal oxide such as indium tin oxide (ITO), indium zinc oxide (IZO), zinc oxide (ZnO), and indium tin zinc oxide (ITZO). If (e.g., when) the first electrode EL1 is a transflective electrode or a reflective electrode, the first electrode EL1 may include Ag, Mg, Cu, Al, Pt, Pd, Au, Ni, Nd, Ir, Cr, Li, Ca, LiF/Ca (stacked structure of LiF and Ca), LiF/Al (stacked structure of LiF and Al), Mo, Ti, W, a compound thereof, or a mixture thereof (for example, a mixture of Ag and Mg). In one or more embodiments, the first electrode EL1 may have a structure including multiple layers including a reflective layer or a transflective layer formed using one or more of the above materials, and a transmissive conductive layer formed using ITO, IZO, ZnO, or ITZO. For example, in one or more embodiments, the first electrode EL1 may include a three-layer structure of ITO/Ag/ITO. However, embodiments of the present disclosure are not limited thereto. The first electrode EL1 may include one of the above-described metal materials, a combination of two or more metal materials selected from among the above-described metal materials, or an oxide of the above-described metal materials. A thickness of the first electrode EL1 may be from about 700 ångströms (Å) to about 10,000 Å. For example, in one or more embodiments, the thickness of the first electrode EL1 may be from about 1,000 Å to about 3,000 Å.

The hole transport region HTR may be provided on the first electrode EL1. The hole transport region HTR may include at least one among the hole injection layer HIL, the hole transport layer HTL, the light emitting auxiliary layer EAL, and the electron blocking layer EBL. A thickness of the hole transport region HTR may be, for example, from about 50 Å to about 15,000 Å. The light emitting auxiliary layer EAL may also be referred to as a buffer layer.

The hole transport region HTR may have a single layer formed using a single material, a single layer formed using multiple different materials, or a multilayer structure including multiple layers formed using multiple different materials.

For example, in one or more embodiments, the hole transport region HTR may have the structure of a single layer of the hole injection layer HIL or the hole transport layer HTL and may have a structure of a single layer formed using a hole injection material and/or a hole transport material. In one or more embodiments, the hole transport region HTR may have a structure of a single layer formed using multiple different materials, or a structure stacked from the first electrode EL1 of hole injection layer HIL/hole transport layer HTL, hole injection layer HIL/hole transport layer HTL/light emitting auxiliary layer EAL, hole injection layer HIL/light emitting auxiliary layer EAL, hole transport layer HTL/light emitting auxiliary layer EAL, hole injection layer HIL/hole transport layer HTL/light emitting auxiliary layer EAL, or hole injection layer HIL/hole transport layer HTL/electron blocking layer EBL, without limitation.

The hole transport region HTR may be formed using one or more suitable methods such as a vacuum deposition method, a spin coating method, a casting method, a Langmuir-Blodgett (LB) method, an inkjet printing method, a laser printing method, and/or a laser induced thermal imaging (LITI) method.

In one or more embodiments, the hole transport region HTR may include a compound represented by Formula H-1.

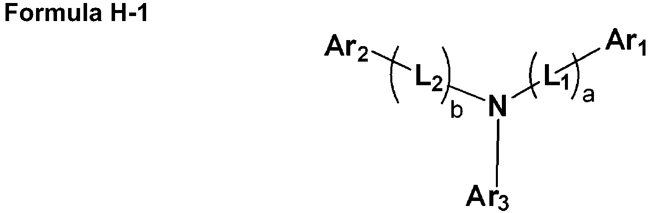

In Formula H-1, L₁ and L₂ may each independently be a direct linkage, a substituted or unsubstituted arylene group of 6 to 30 ring-forming carbon atoms, or a substituted or unsubstituted heteroarylene group of 2 to 30 ring-forming carbon atoms. "a" and "b" may each independently be an integer of 0 to 10. If (e.g., when) "a" or "b" is an integer of 2 or greater, multiple L₁(s) and/or multiple L₂(s) may each independently be a substituted or unsubstituted arylene group of 6 to 30 ring-forming carbon atoms or a substituted or unsubstituted heteroarylene group of 2 to 30 ring-forming carbon atoms.

In Formula H-1, Ar₁ and Ar₂ may each independently be a substituted or unsubstituted aryl group of 6 to 30 ring-forming carbon atoms or a substituted or unsubstituted heteroaryl group of 2 to 30 ring-forming carbon atoms. In addition, in Formula H-1, Ar₃ may be a substituted or unsubstituted aryl group of 6 to 30 ring-forming carbon atoms.

In one or more embodiments, the compound represented by Formula H-1 may be a monoamine compound. In one or more embodiments, the compound represented by Formula H-1 may be a diamine compound in which at least one selected from among Ar₁ to Ar₃ includes an amino group as a substituent. In one or more embodiments, the compound represented by Formula H-1 may be a carbazole-based compound in which at least one selected from among Ar₁ and Ar₂ includes a substituted or unsubstituted carbazole group, or a fluorene-based compound in which at least one selected from among Ar₁ and Ar₂ includes a substituted or unsubstituted fluorene group.

The compound represented by Formula H-1 may be any one selected from among compounds in Compound Group H. However, the compounds shown in Compound Group H are mere examples, and the compound represented by Formula H-1 is not limited to the compounds represented in Compound Group H.

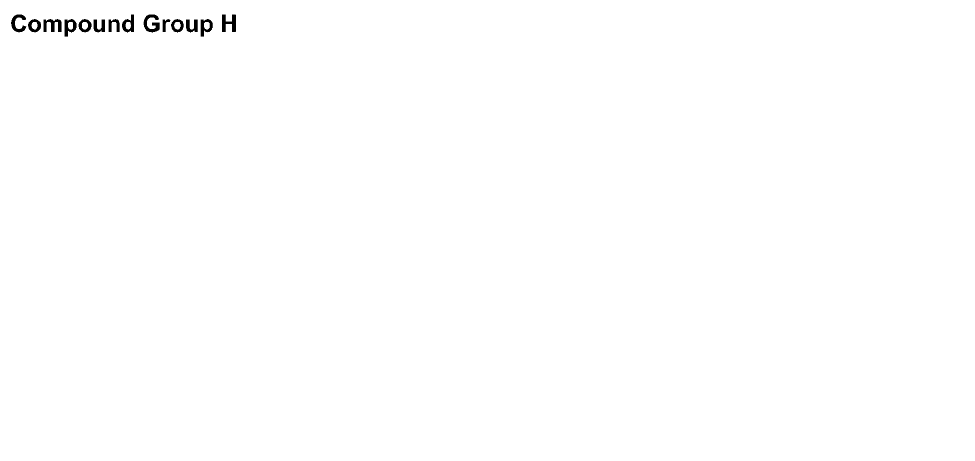

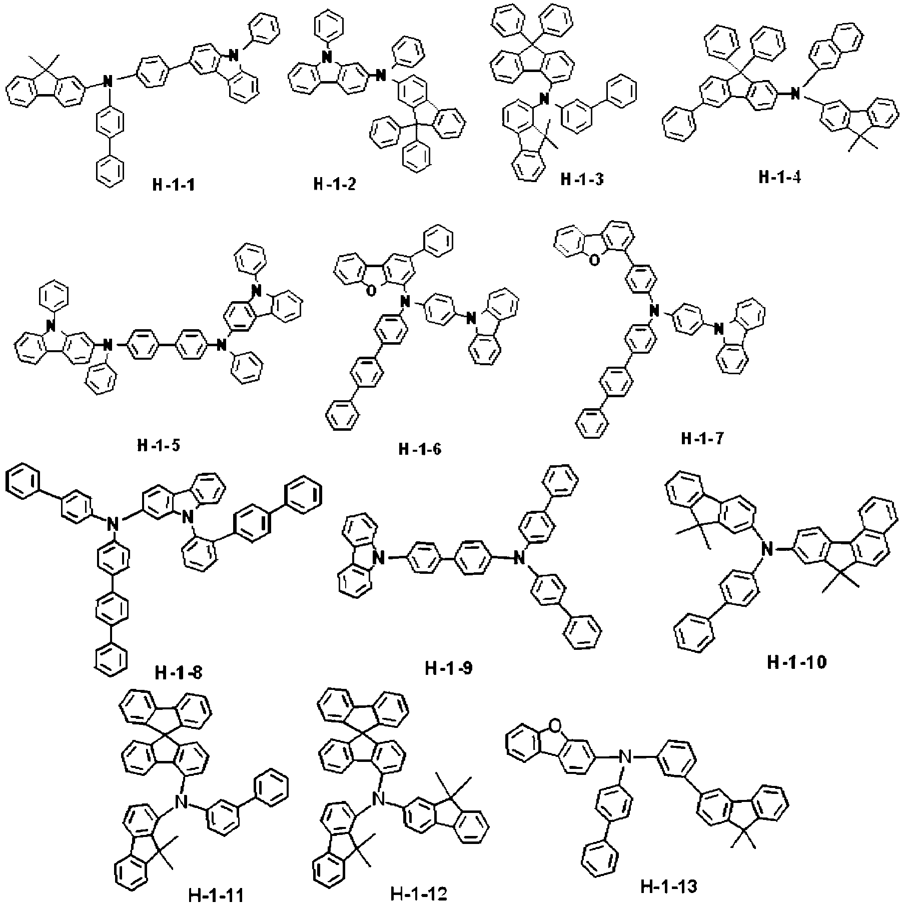

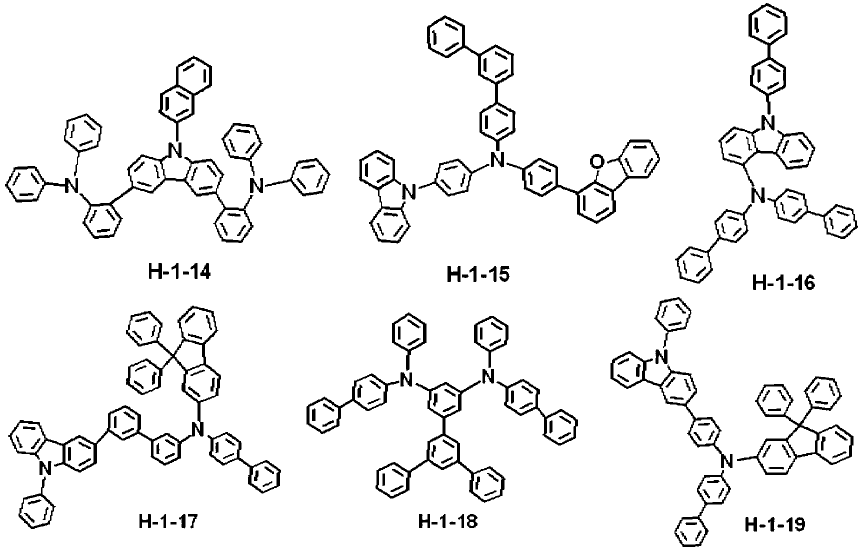

In one or more embodiments, the hole transport region HTR may include one or more selected from among a phthalocyanine compound such as copper phthalocyanine, N¹,N¹'-([1,1'-biphenyl]-4,4'-diyl)bis(N¹-phenyl-N⁴,N⁴-di-m-tolylbenzene-1,4-diamine) (DNTPD), 4,4',4"-[tris(3-methylphenyl)phenylamino] triphenylamine (m-MTDATA), 4,4',4"-tris(N,N-diphenylamino)triphenylamine (TDATA), 4,4',4"-tris[N-(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), N,N'-di(1-naphthalen-1-yl)-N,N'-diphenyl-benzidine (NPB), triphenylamine-containing polyetherketone (TPAPEK), 4-isopropyl-4'-methyldiphenyliodonium [tetrakis(pentafluorophenyl)borate], and dipyrazino[2,3-f:2',3'-h] quinoxaline-2,3,6,7,10,11-hexacarbonitrile (HAT-CN).

In one or more embodiments, the hole transport region HTR may include one or more selected from among carbazole derivatives such as N-phenyl carbazole and polyvinyl carbazole, fluorene-based derivatives, N,N'-bis(3-methylphenyl)-N,N'-diphenyl-[1,1'-biphenyl]-4,4'-diamine (TPD), triphenylamine-based derivatives such as 4,4',4"-tris(N-carbazolyl)triphenylamine (TCTA), N,N'-di(1-naphthalen-1-yl)-N,N'-diphenyl-benzidine (NPB), 4,4'-cyclohexylidene bis[N,N-bis(4-methylphenyl)benzeneamine] (TAPC), 4,4'-bis[N,N'-(3-tolyl)amino]-3,3'-dimethylbiphenyl (HMTPD), 1,3-bis(N-carbazolyl)benzene (mCP), and/or the like.

In one or more embodiments, the hole transport region HTR may include one or more selected from among 9-(4-tert-butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol-9-yl)benzene (mDCP), and/or the like.

The hole transport region HTR may include one or more of the compounds of the hole transport region in at least one selected from among the hole injection layer HIL, the hole transport layer HTL, the light emitting auxiliary layer EAL, and the electron blocking layer EBL.

A thickness of the hole transport region HTR may be from about 100 Å to about 10,000 Å, for example, from about 100 Å to about 5,000 Å. If (e.g., when) the hole transport region HTR includes the hole injection layer HIL, a thickness of the hole injection layer HIL may be, for example, from about 30 Å to about 1,000 Å. If (e.g., when) the hole transport region HTR includes the hole transport layer HTL, a thickness of the hole transport layer HTL may be from about 30 Å to about 1,000 Å. For example, if (e.g., when) the hole transport region HTR includes the electron blocking layer EBL, a thickness of the electron blocking layer EBL may be from about 10 Å to about 1,000 Å. If (e.g., when) the thicknesses of the hole transport region HTR, the hole injection layer HIL, the hole transport layer HTL, and the electron blocking layer EBL satisfy the above-described respective ranges, satisfactory hole transport properties may be achieved without substantial increase in driving voltage.

In one or more embodiments, the hole transport region HTR may further include a charge generating material to increase conductivity (e.g., electric conductivity), in addition to one or more of the above-described materials. The charge generating material may be dispersed uniformly (e.g., substantially uniformly) or non-uniformly in the hole transport region HTR. The charge generating material may be, for example, a p-dopant. The p-dopant may include at least one selected from among metal halide compounds, quinone derivatives, metal oxides, and cyano group-containing compounds, without limitation. For example, in one or more embodiments, the p-dopant may include one or more selected from among metal halide compounds such as Cul and Rbl, quinone derivatives such as tetracyanoquinodimethane (TCNQ) and 2,3,5,6-tetrafluoro-7,7',8,8'-tetracyanoquinodimethane (F4-TCNQ), metal oxides such as tungsten oxide and molybdenum oxide, cyano group-containing compounds such as dipyrazino[2,3-f: 2',3'-h] quinoxaline-2,3,6,7,10,11-hexacarbonitrile (HATCN) and 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), and/or the like, without limitation.

As described above, the hole transport region HTR may further include at least one among the light emitting auxiliary layer EAL and the electron blocking layer EBL in addition to the hole injection layer HIL and the hole transport layer HTL. The light emitting auxiliary layer EAL may compensate a resonance distance according to the wavelength of light emitted from the light emitting layer EML and may increase light emitting efficiency by controlling hole charge balance. In addition, light emitting auxiliary layer EAL may play the role of preventing or reducing electron injection into the hole transport region HTR. As materials included in the light emitting auxiliary layer EAL, materials which may be included in the hole transport region HTR may be used. The electron blocking layer EBL is a layer playing the role of blocking the injection of electrons from the electron transport region ETR into the hole transport region HTR.

In the light emitting element ED of one or more embodiments, the light emitting layer EML includes the polycyclic compound according to one or more embodiments. In the light emitting element ED of one or more embodiments, the light emitting layer EML may include a first compound, which is the polycyclic compound of one or more embodiments, and at least one compound selected from among a second compound and a third compound. In addition, in the light emitting element ED of one or more embodiments, the light emitting layer EML may further include a fourth compound. The second compound may include a fused ring of three rings including a nitrogen atom as a ring-forming atom. The third compound may include a hexagonal (e.g., 6-membered) ring group including at least one nitrogen atom as a ring-forming atom. The fourth compound may include an organometallic complex. The second to fourth compounds will be described in more detail later.

In this disclosure, the first compound may be referred to as the polycyclic compound of one or more embodiments. The polycyclic compound of one or more embodiments includes a boron-containing fused ring as a core structure. The polycyclic compound of one or more embodiments, which is the first compound, includes a core structure including two boron atoms as ring-forming atoms and including one or more other heteroatoms as ring-forming atoms in addition to the boron atoms. The core structure of the polycyclic compound of one or more embodiments includes a boron-containing hetero fused ring structure in the form of nine fused rings. The core structure of the polycyclic compound of one or more embodiments may be represented as including a heteroborine skeleton including two boron atoms as ring-forming atoms.

The polycyclic compound of one or more embodiments may include at least one nitrogen atom in a fused ring constituent ring that does not include boron as a ring-forming atom or may include a heterocycle including a nitrogen atom as a ring-forming atom as a substituent. For example, the polycyclic compound of one or more embodiments may include a pyridine derivative group as at least one of the rings forming the fused ring or may include a pyridyl group as the substituent of amine forming the core structure.

The polycyclic compound of one or more embodiments may exhibit thermally activated delayed fluorescence (TADF) light emitting characteristics by reverse intersystem crossing.

In addition, the polycyclic compound of one or more embodiments has a structure in which some of the carbons of the heteroborine skeleton are replaced by nitrogen, or a structure in which a pyridyl group is substituted for an amino group forming the heteroborine skeleton, thereby achieving harmony between an electron donating group and an electron withdrawing group, thereby exhibiting a short delayed fluorescence extinction (e.g., decay) time and excellent or suitable material stability. Accordingly, the light emitting element of one or more embodiments including the polycyclic compound of one or more embodiments may exhibit high light emitting efficiency and long-life characteristics.

The light emitting element ED of one or more embodiments includes the polycyclic compound of one or more embodiments. The polycyclic compound of one or more embodiments may be represented by Formula 1.

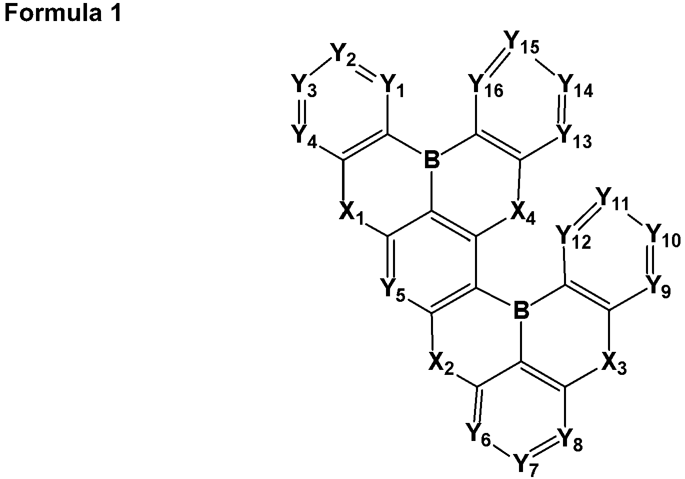

In Formula 1, X₁ to X₄ are each independently O, S, or Se, or represented by Formula 2. For example, in Formula 1, X₁ to X₄ may each independently be O, S, Se, or an amino group represented by Formula 2 (e.g., X₁ to X₄ may each independently be O, S, or Se, or an amino group represented by Formula 2). If (e.g., when) X₁ to X₄ are amino groups represented by Formula 2, the nitrogen atom of the amino group may be included at respective positions X₁ to X₄.

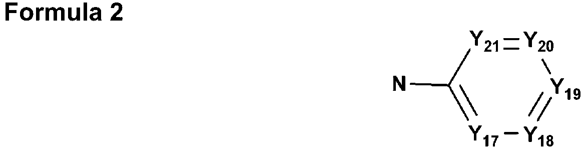

In the polycyclic compound represented by Formula 1, Y₁ to Y₁₆ are each independently CRₐ or N. Rₐ in CRₐ is hydrogen, deuterium, a cyano group, a substituted or unsubstituted amino group, a substituted or unsubstituted alkyl group of 1 to 10 carbon atoms, a substituted or unsubstituted aryl group of 6 to 30 ring-forming carbon atoms, or a substituted or unsubstituted heteroaryl group of 2 to 30 ring-forming carbon atoms.

In the amino group represented by Formula 2, Y₁₇ to Y₂₁ are each independently CR_{b} or N, and R_{b} in CR_{b} is hydrogen, deuterium, a cyano group, a substituted or unsubstituted amino group, a substituted or unsubstituted alkyl group of 1 to 10 carbon atoms, a substituted or unsubstituted aryl group of 6 to 30 ring-forming carbon atoms, or a substituted or unsubstituted heteroaryl group of 2 to 30 ring-forming carbon atoms.

In the polycyclic compound represented by Formula 1, if (e.g., when) none of X₁ to X₄ is represented by Formula 2, at least one selected from among Y₁ to Y₁₆ of Formula 1 is N. For example, in the polycyclic compound represented by Formula 1, if (e.g., when) X₁ to X₄ are each independently selected from among O, S, or Se, Formula 1 may have a structure in which one of ring-forming carbon atoms of the core structure of the polycyclic compound represented by Formula 1 is changed into N. In one or more embodiments, in the polycyclic compound represented by Formula 1, if (e.g., when) at least one selected from among X₁ to X₄ is represented by Formula 2, at least one selected from among Y₁ to Y₁₆ in Formula 1 and Y₁₇ to Y₂₁ in Formula 2 is N.

The amino group represented by Formula 2 may be represented by Formula 2-1.

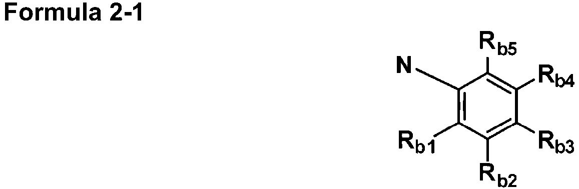

In one or more embodiments, the amine group represented by Formula 2 may be substituted with a pyridine group where one selected from among Y₁₇ to Y₂₁ in Formula 2 is N, and the remainder may each independently be CR_{b}.

In Formula 2-1, R_{b1} to R_{b5} are each independently hydrogen, deuterium, a cyano group, a substituted or unsubstituted amino group, a substituted or unsubstituted alkyl group of 1 to 10 carbon atoms, a substituted or unsubstituted aryl group of 6 to 30 ring-forming carbon atoms, or a substituted or unsubstituted heteroaryl group of 2 to 30 ring-forming carbon atoms.

In the polycyclic compound of one or more embodiments, one selected from among one selected from among Y₁ to Y₄, one selected from among Y₆ to Y₈, one selected from among Y₁₃ to Y₁₆, and Y₅ in Formula 1 may be N, and the remainder may each independently be CRₐ. In one or more embodiments, if (e.g., when) one selected from among one selected from among Y₁ to Y₄, one selected from among Y₆ to Y₈, one selected from among Y₁₃ to Y₁₆, and Y₅ in Formula 1 may be N, and the remainder may each independently be CRₐ, X₁ to X₄ may each independently be O, S, or Se, or represented by Formula 2-1.

For example, the polycyclic compound of one or more embodiments may be represented by any one selected from among Formulas 1-1A to 1-1E.

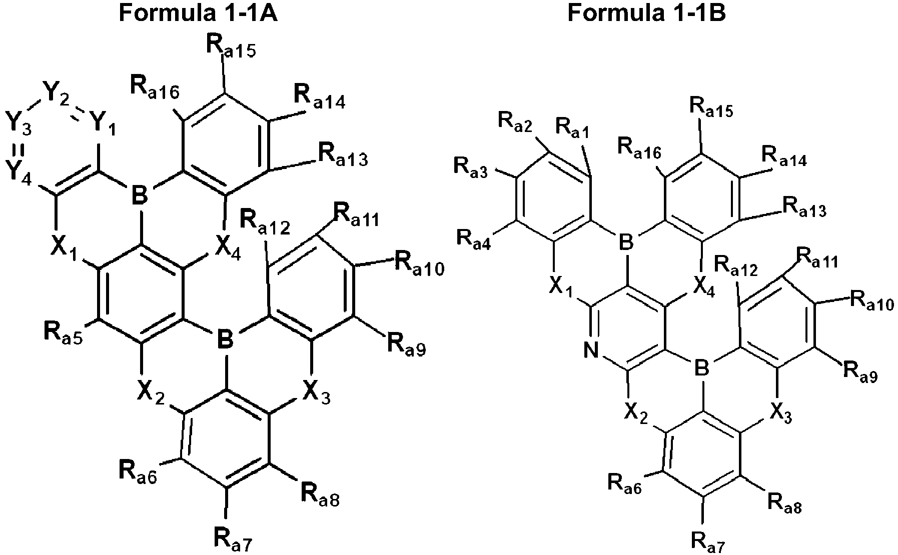

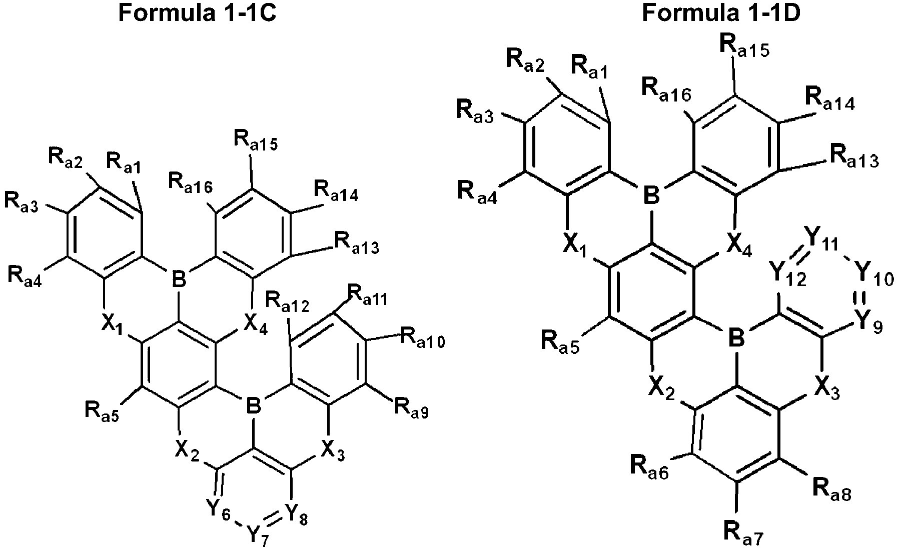

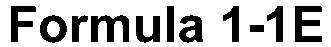

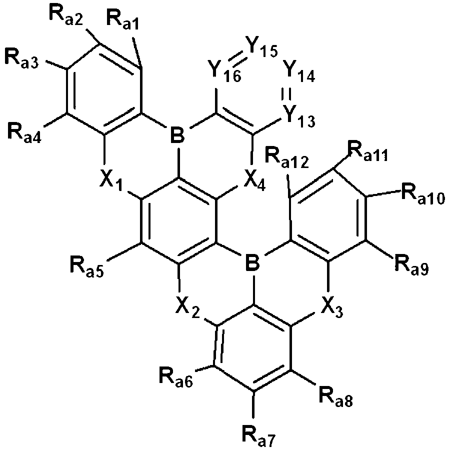

In Formula 1-1A, one selected from among Y₁ to Y₄ may be N, and the remainder may be CRₐ, in Formula 1-1C, one selected from among Y₆ to Y₈ may be N, and the remainder may be CRₐ, in Formula 1-1D, one selected from among Y₉ to Y₁₂ may be N, and the remainder may be CRₐ, and in Formula 1-1E, one selected from among Y₁₃ to Y₁₆ may be N, and the remainder may be CRₐ. In Formulas 1-1A, 1-1C, 1-1D, and 1-1E, the same content described in Formula 1 may be applied to Rₐ of CRₐ.

In Formulas 1-1A to 1-1E, Rₐ₁ to Rₐ₁₆ are each independently hydrogen, deuterium, a cyano group, a substituted or unsubstituted amino group, a substituted or unsubstituted alkyl group of 1 to 10 carbon atoms, a substituted or unsubstituted aryl group of 6 to 30 ring-forming carbon atoms, or a substituted or unsubstituted heteroaryl group of 2 to 30 ring-forming carbon atoms.

The polycyclic compound of one or more embodiments may be represented by Formula 1-2. In Formula 1-2, at least one selected from among X₁ to X₄ may be represented by Formula 2, and the remainder may each independently be O, S, or Se. In one or more embodiments, if (e.g., when) at least one selected from among X₁ to X₄ is represented by Formula 2, one selected from among Y₁₇ to Y₂₁ of Formula 2 may be N, and the remainder may be CR_{b}. The same content described in Formula 2 may be applied to R_{b}.

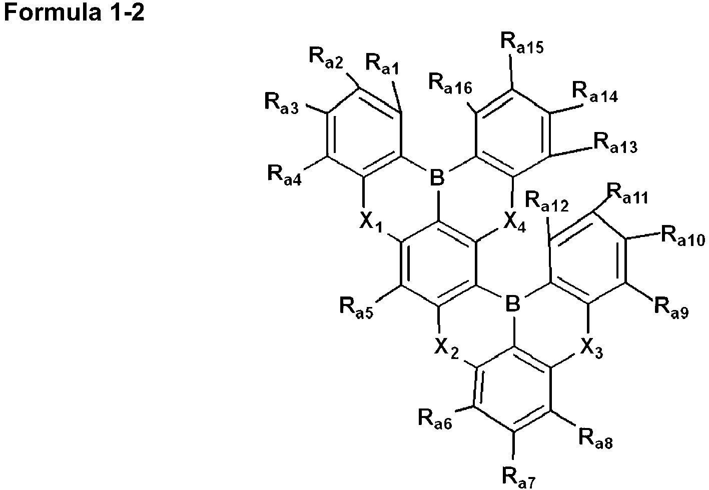

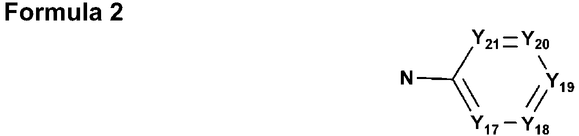

In the polycyclic compound of one or more embodiments, represented by Formula 1-2, Rₐ₁ to Rₐ₁₆ are each independently hydrogen, deuterium, a cyano group, a substituted or unsubstituted amino group, a substituted or unsubstituted alkyl group of 1 to 10 carbon atoms, a substituted or unsubstituted aryl group of 6 to 30 ring-forming carbon atoms, or a substituted or unsubstituted heteroaryl group of 2 to 30 ring-forming carbon atoms.

The polycyclic compound of one or more embodiments may be any one selected from among compounds in Compound Group 1. The light emitting element ED according to one or more embodiments may include at least one (e.g., may be any one) selected from among the compounds of Compound Group 1. In Compound Group 1, D is deuterium.

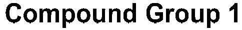

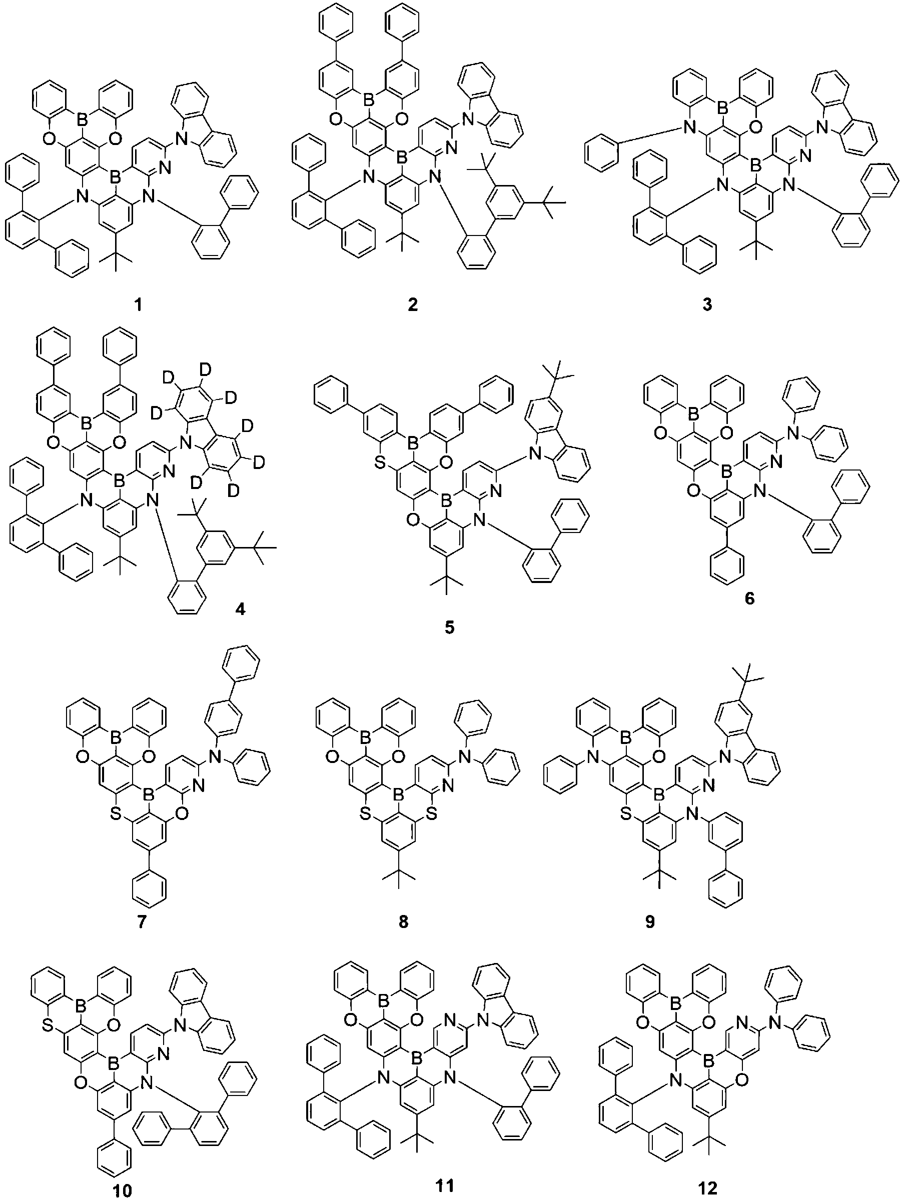

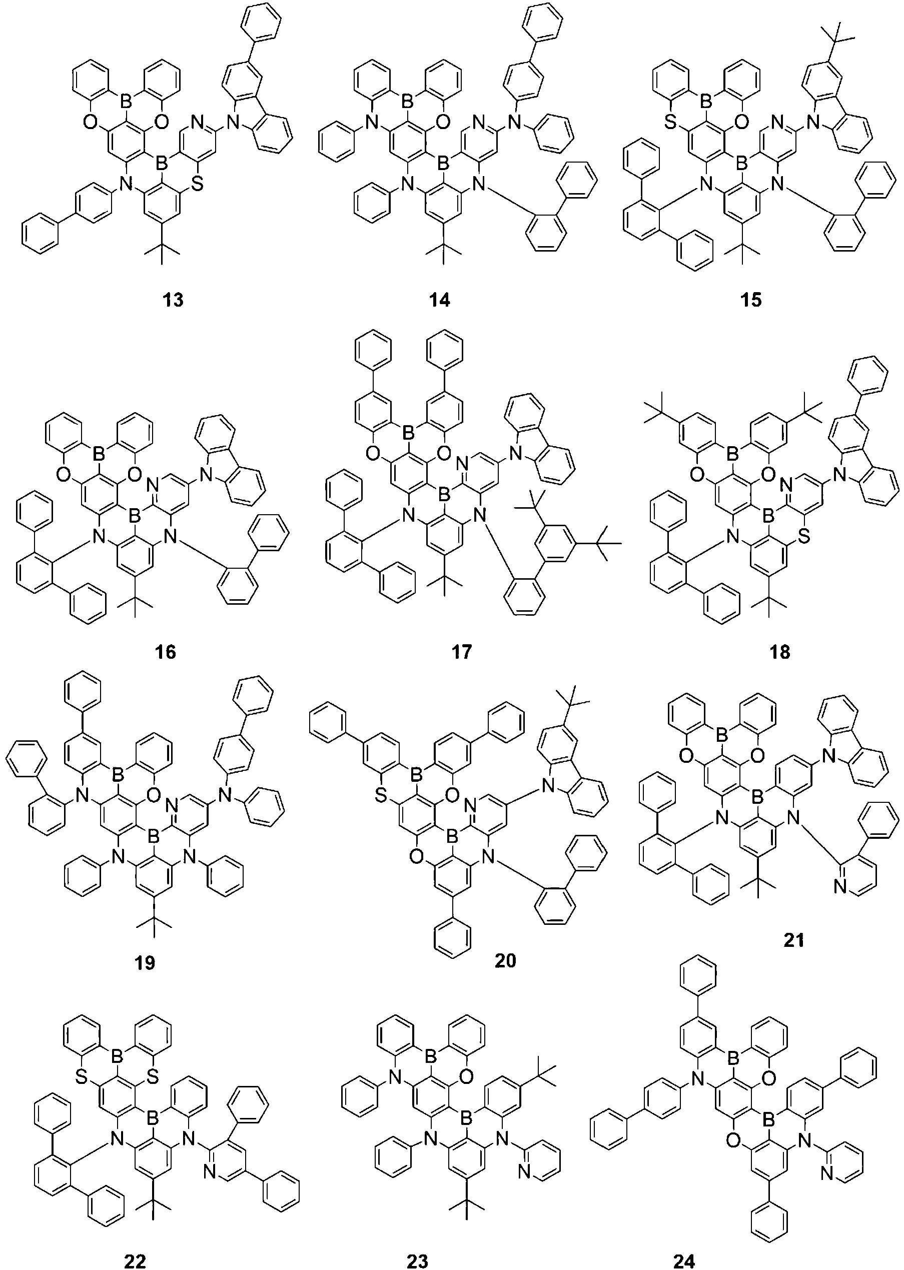

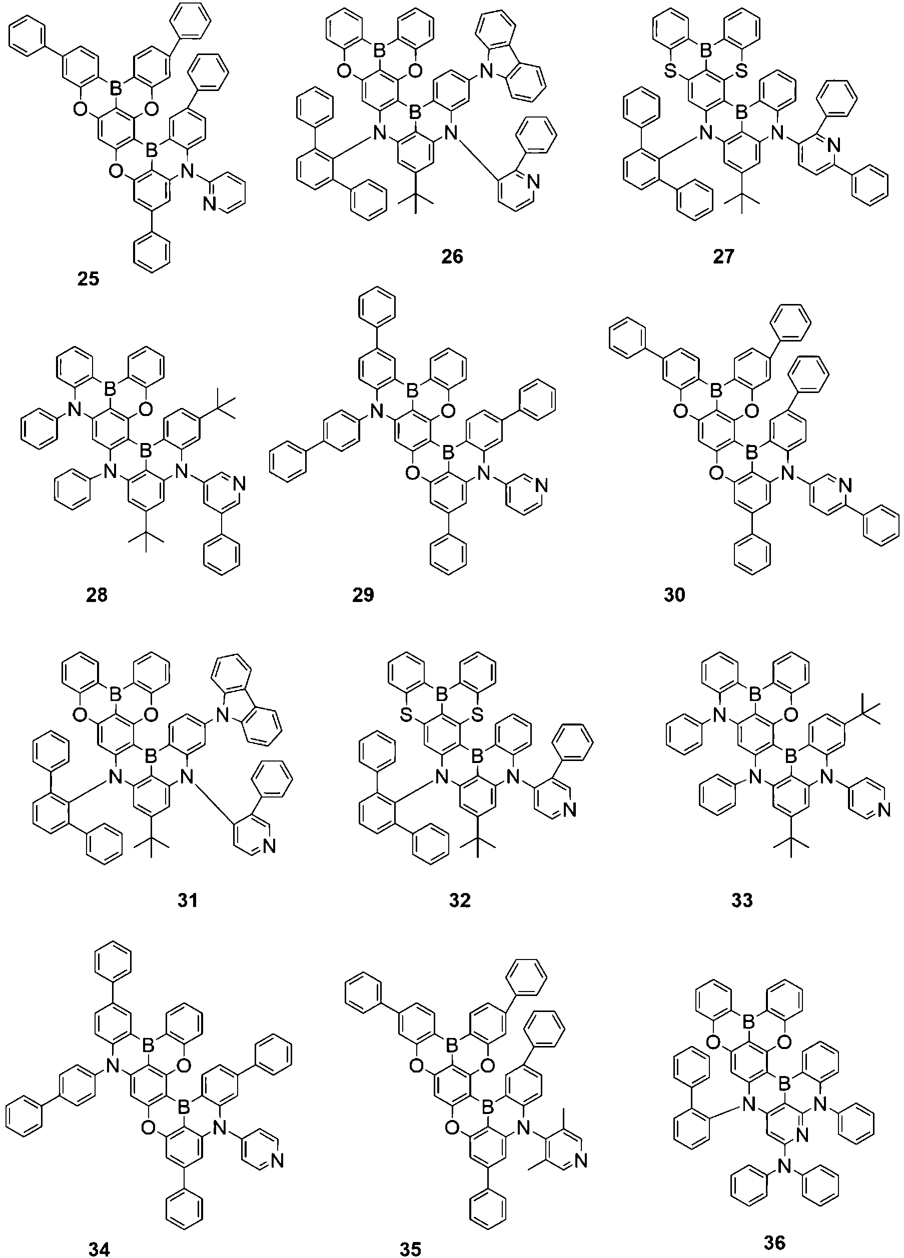

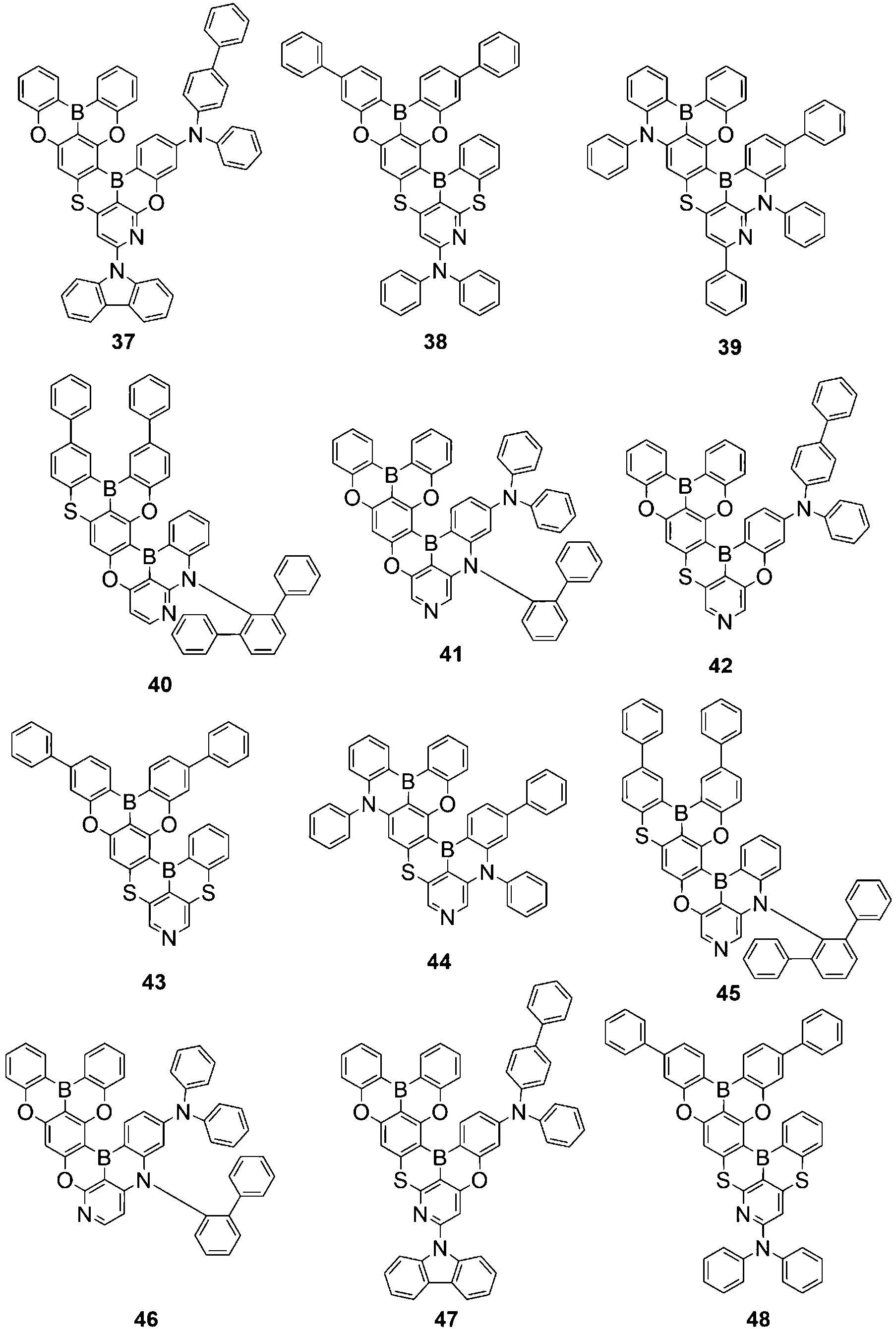

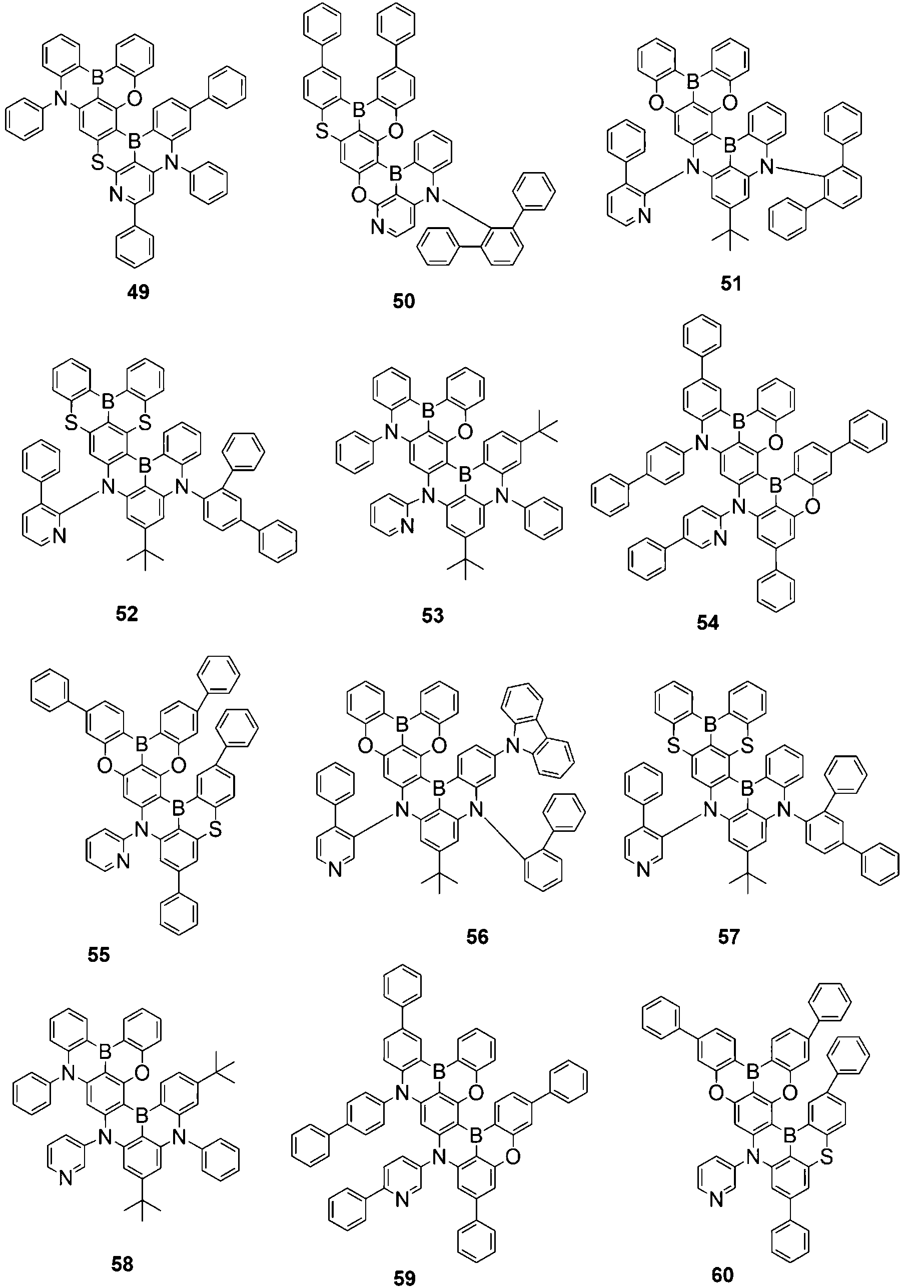

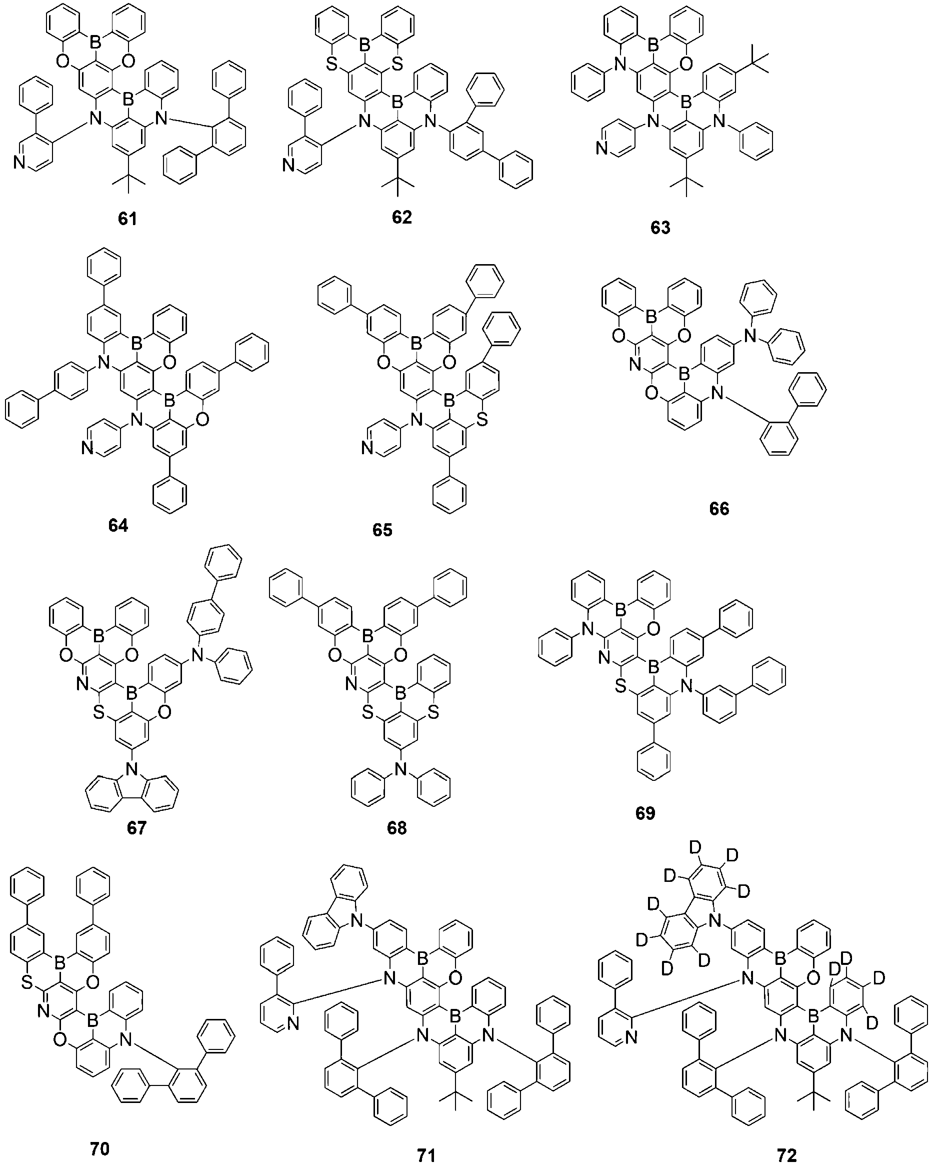

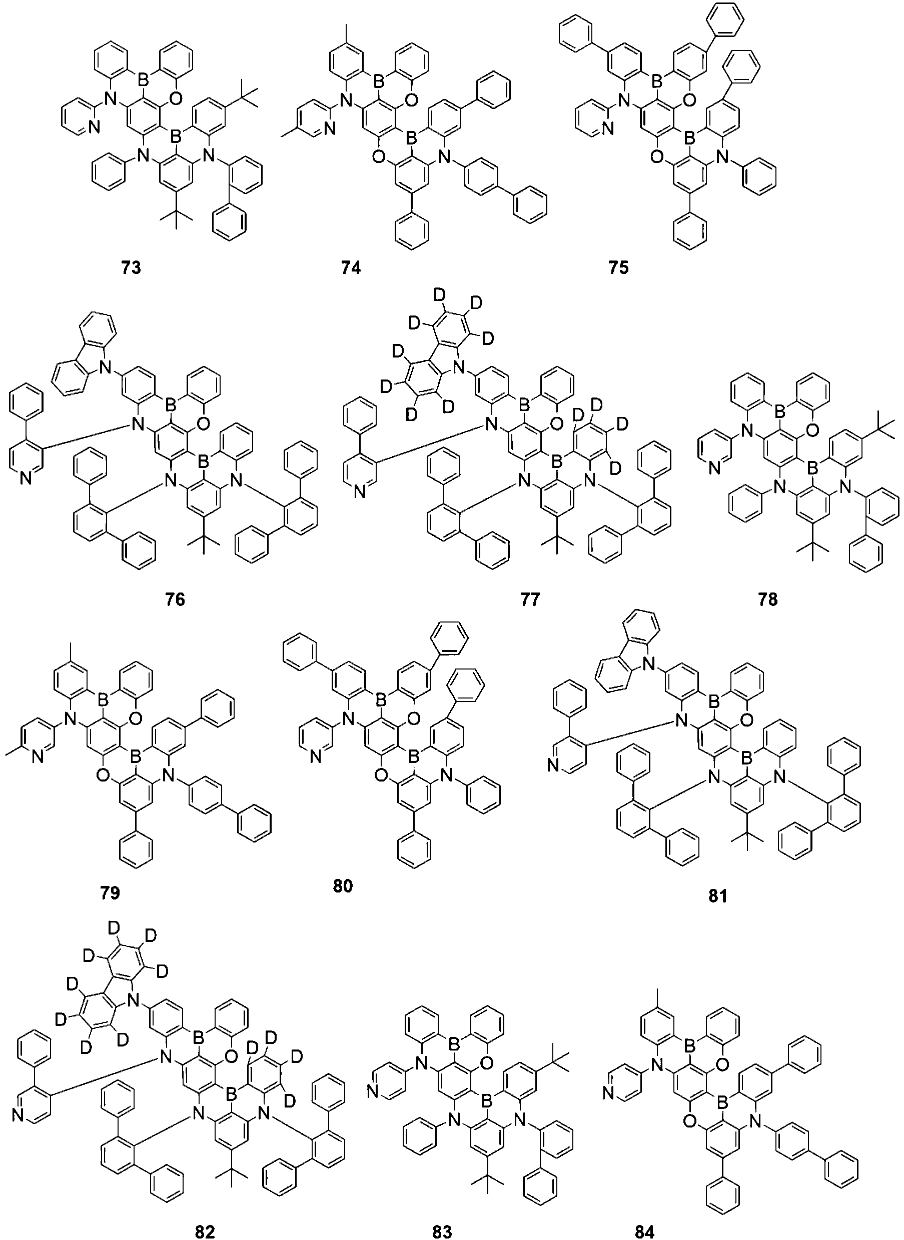

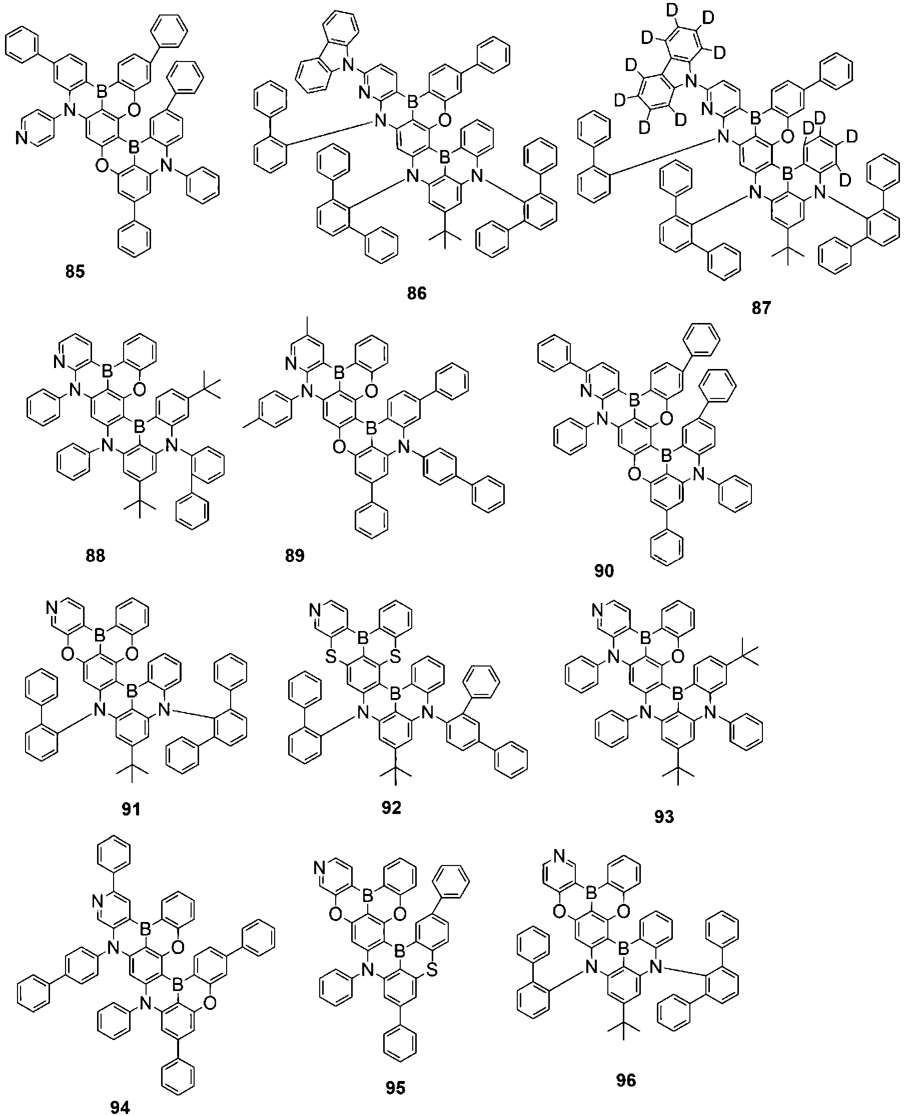

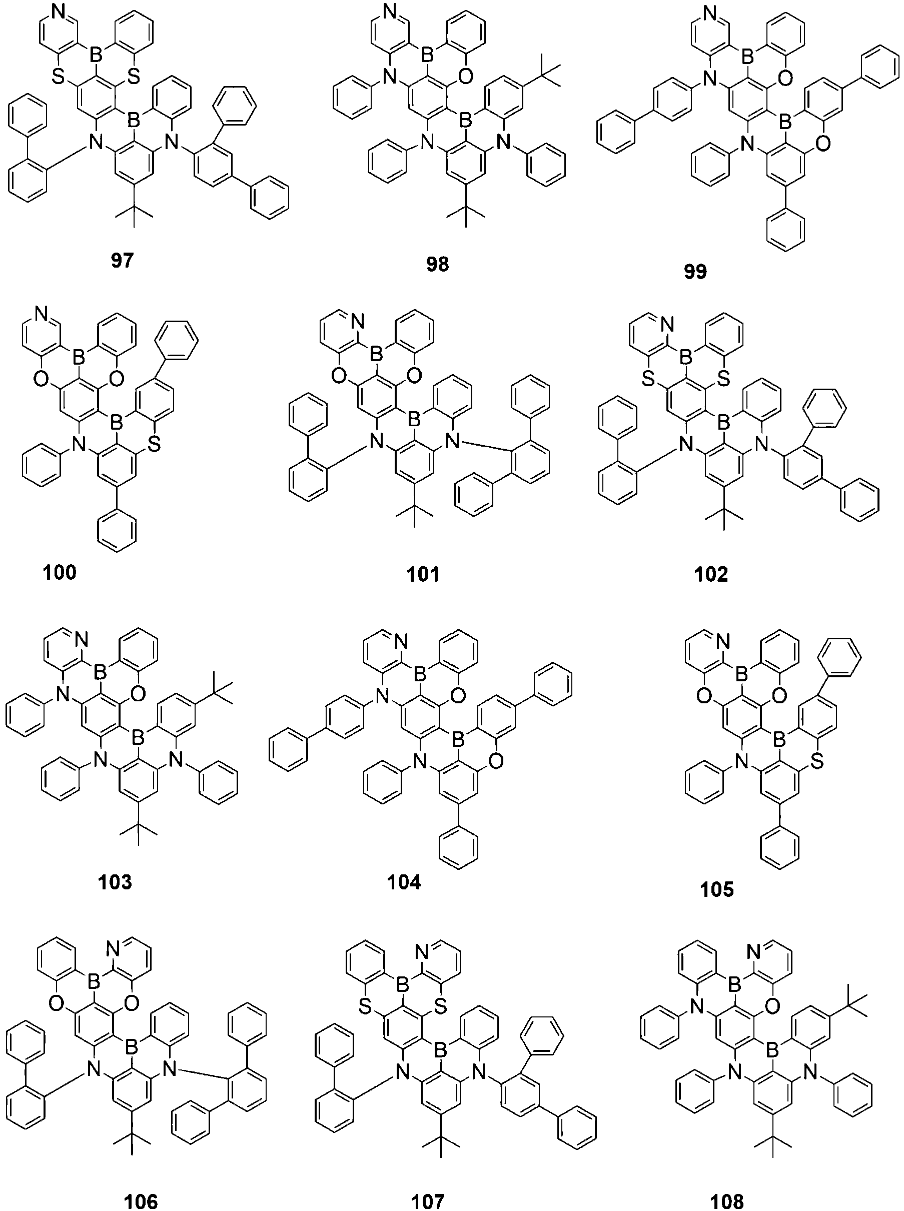

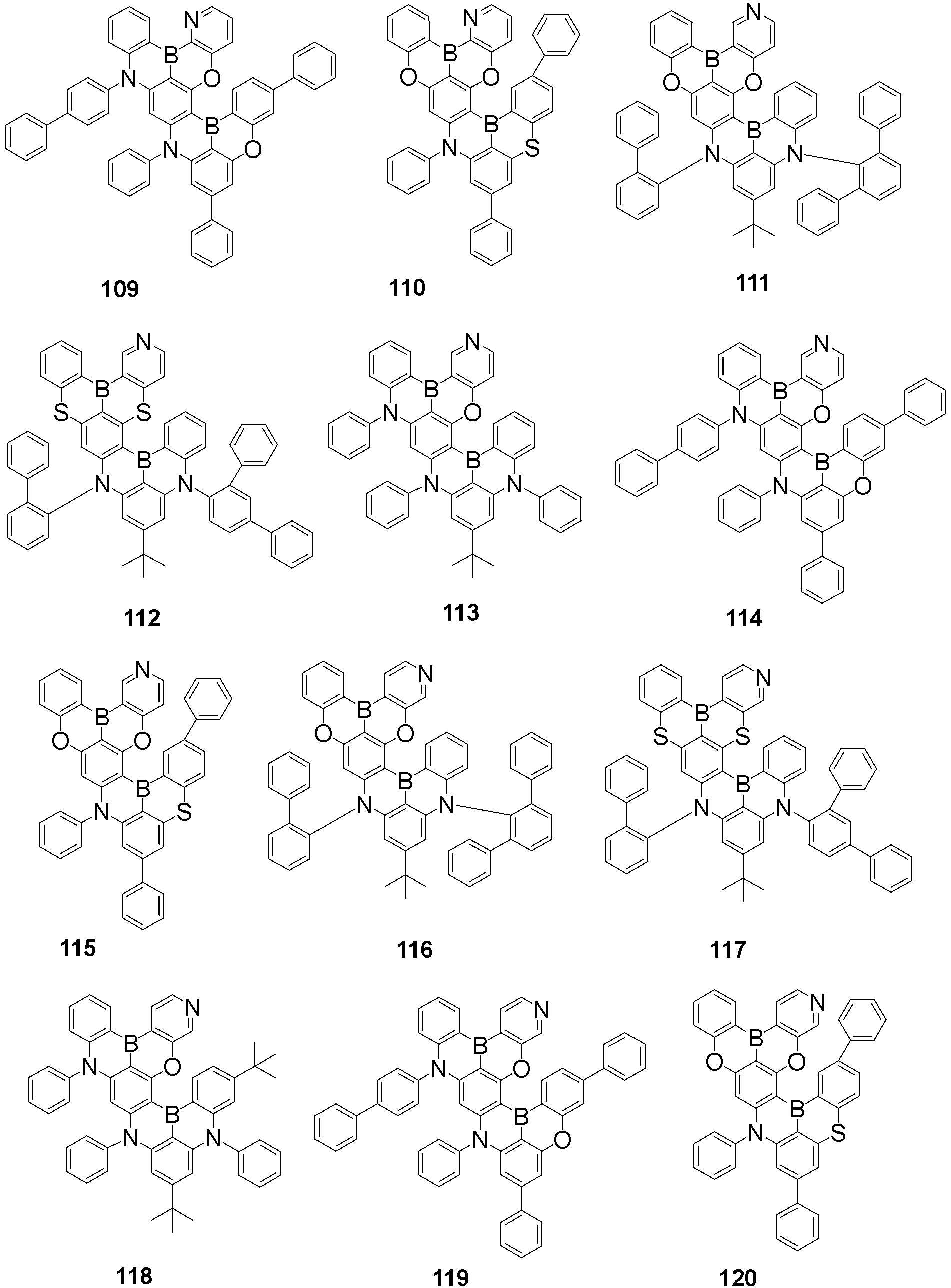

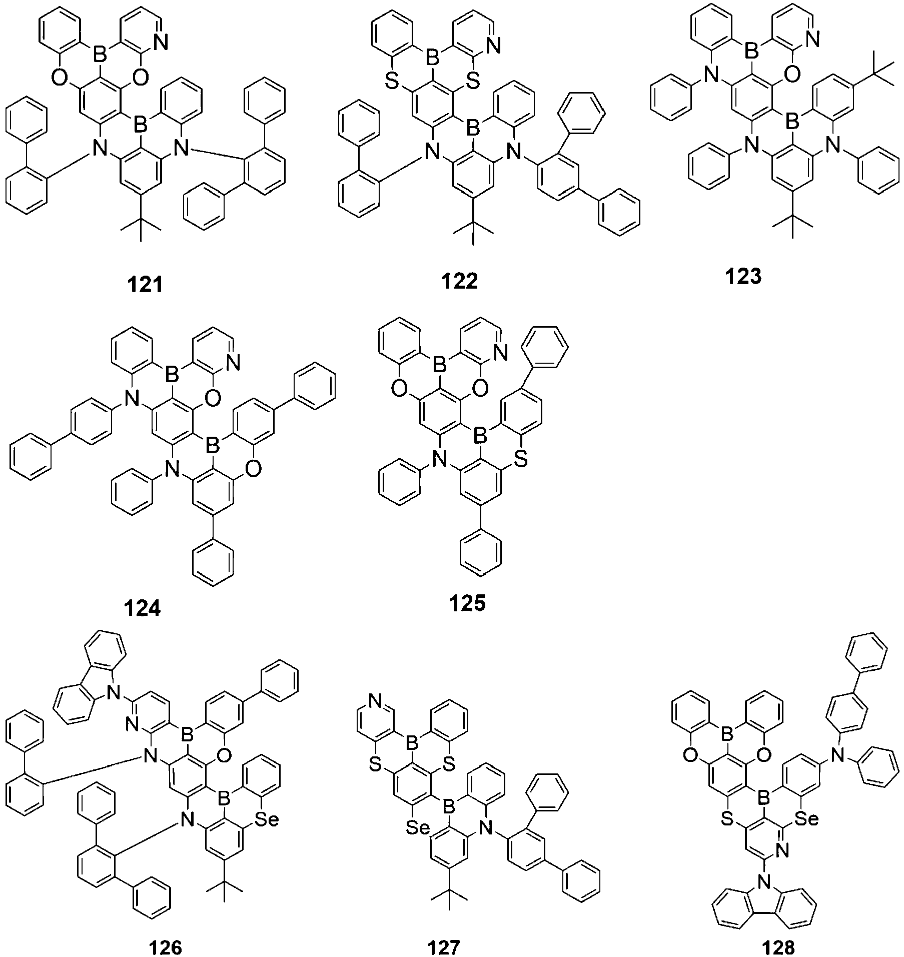

The polycyclic compound of one or more embodiments includes a boron-containing fused ring core including two boron atoms as ring-forming atoms, and may include N as a ring-forming atom of the core or may include a nitrogen-containing heteroaryl bonded to N of an amino group included as a ring-forming atom of the core. The polycyclic compound of one or more embodiments has a core structure of a fused heterocycle in which nine six-membered rings are fused.

The polycyclic compound of one or more embodiments may be used as a delayed fluorescence material. For example, the polycyclic compound of one or more embodiments may be used as a thermally activated delayed fluorescence (TADF) material. The polycyclic compound of one or more embodiments may exhibit a high fluorescence quantum yield. For example, the polycyclic compound of one or more embodiments may exhibit a high fluorescence quantum yield in a blue wavelength range having a maximum central wavelength of about 470 nm or less.

The polycyclic compound of one or more embodiments may exhibit excellent or suitable material stability by including a core structure of a fused ring in which nine six-membered rings are fused, and including N in the core structure, or including a pyridyl group as a substituent. In addition, the polycyclic compound of one or more embodiments may exhibit high emission efficiency and excellent or suitable life characteristics in a blue light wavelength range.

The light emitting element ED of one or more embodiments including the polycyclic compound according to one or more embodiments may exhibit high efficiency and long-life characteristics. The light emitting element ED of one or more embodiments including the polycyclic compound according to one or more embodiments having excellent or suitable emission efficiency and improved material stability in a light emitting layer may exhibit high light efficiency and excellent or suitable life characteristics.

The light emitting element ED of one or more embodiments including the polycyclic compound according to one or more embodiments may exhibit short fluorescence lifetime characteristics. The light emitting element ED of one or more embodiments may exhibit fluorescence lifetime characteristics of about 3.0 µs or less. Because the light emitting element ED of one or more embodiments has accelerated fluorescence lifetime characteristics of about 3.0 µs or less, the light emitting element of one or more embodiments may exhibit improved life characteristics.

In the light emitting element ED according to one or more embodiments, the light emitting layer EML may be a delayed fluorescence light emitting layer including a host and a dopant. For example, the light emitting layer EML may be to emit thermally activated delayed fluorescence. The polycyclic compound of one or more embodiments may be a thermally activated delayed fluorescence dopant.

The light emitting layer EML may include the polycyclic compound of one or more embodiments as a dopant. The polycyclic compound of one or more embodiments may be to emit blue color light. For example, the polycyclic compound of one or more embodiments may be a light emitting material having a maximum light emitting wavelength (e.g., peak emission wavelength) in a wavelength range of about 430 nm to about 490 nm. For example, the polycyclic compound of one or more embodiments may be a light emitting material having a maximum light emitting wavelength (e.g., peak emission wavelength) in a wavelength range of about 440 nm to about 470 nm.

In one or more embodiments, the light emitting layer EML includes the polycyclic compound of one or more embodiments and may further include at least one selected from among the second to fourth compounds. In one or more embodiments, the light emitting layer EML may include the second compound represented by Formula HT-1. For example, the second compound may be used as a hole transporting host material of the light emitting layer EML.

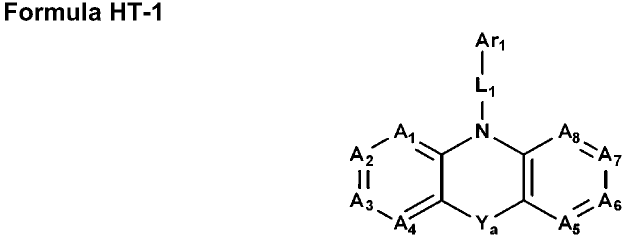

In Formula HT-1, A₁ to A₈ may each independently be N or CR₅₁. For example, in one or more embodiments, A₁ to A₈ may each be CR₅₁. In one or more embodiments, any one selected from among A₁ to A₈ is N, and the remainder may be CR₅₁.

In Formula HT-1, L₁ may be a direct linkage, a substituted or unsubstituted arylene group of 6 to 30 ring-forming carbon atoms, or a substituted or unsubstituted heteroarylene group of 2 to 30 ring-forming carbon atoms. For example, in one or more embodiments, L₁ may be a direct linkage, a substituted or unsubstituted divalent phenyl group, a substituted or unsubstituted divalent biphenyl group, or a substituted or unsubstituted divalent carbazole group, but embodiments of the present disclosure are not limited thereto.

In Formula HT-1, Yₐ may be a direct linkage, CR₅₂R₅₃, or SiR₅₄R₅₅. For example, in one or more embodiments, two 6-membered rings (e.g., two benzene rings) connected to the nitrogen atom of Formula HT-1 may be connected via a direct linkage, 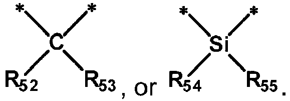 In Formula HT-1, if (e.g., when) Yₐ is a direct linkage, the second compound represented by Formula HT-1 may include a carbazole moiety.

In Formula HT-1, Ar₁ may be a substituted or unsubstituted aryl group of 6 to 30 ring-forming carbon atoms or a substituted or unsubstituted heteroaryl group of 2 to 30 ring-forming carbon atoms. For example, in one or more embodiments, Ar₁ may be a substituted or unsubstituted carbazole group, a substituted or unsubstituted dibenzofuran group, a substituted or unsubstituted dibenzothiophene group, or a substituted or unsubstituted biphenyl group, but embodiments of the present disclosure are not limited thereto.

In Formula HT-1, R₅₁ to R₅₅ may each independently be hydrogen, deuterium, a halogen, a cyano group, a substituted or unsubstituted silyl group, a substituted or unsubstituted thio group, a substituted or unsubstituted oxy group, a substituted or unsubstituted amino group, a substituted or unsubstituted boron group, a substituted or unsubstituted alkyl group of 1 to 20 carbon atoms, a substituted or unsubstituted alkenyl group of 2 to 20 carbon atoms, a substituted or unsubstituted aryl group of 6 to 60 ring-forming carbon atoms, or a substituted or unsubstituted heteroaryl group of 2 to 60 ring-forming carbon atoms. In one or more embodiments, one or more selected from among R₅₁ to R₅₅ may each independently be combined with an adjacent group to form a ring. For example, in one or more embodiments, R₅₁ to R₅₅ may each independently be hydrogen or deuterium. In one or more embodiments, R₅₁ to R₅₅ may each independently be an unsubstituted methyl group or an unsubstituted phenyl group.

In one or more embodiments, the second compound represented by Formula HT-1 may be any one selected from among compounds represented in Compound Group 2. The light emitting layer EML may include at least one selected from among the compounds represented in Compound Group 2 as a hole transporting host material.

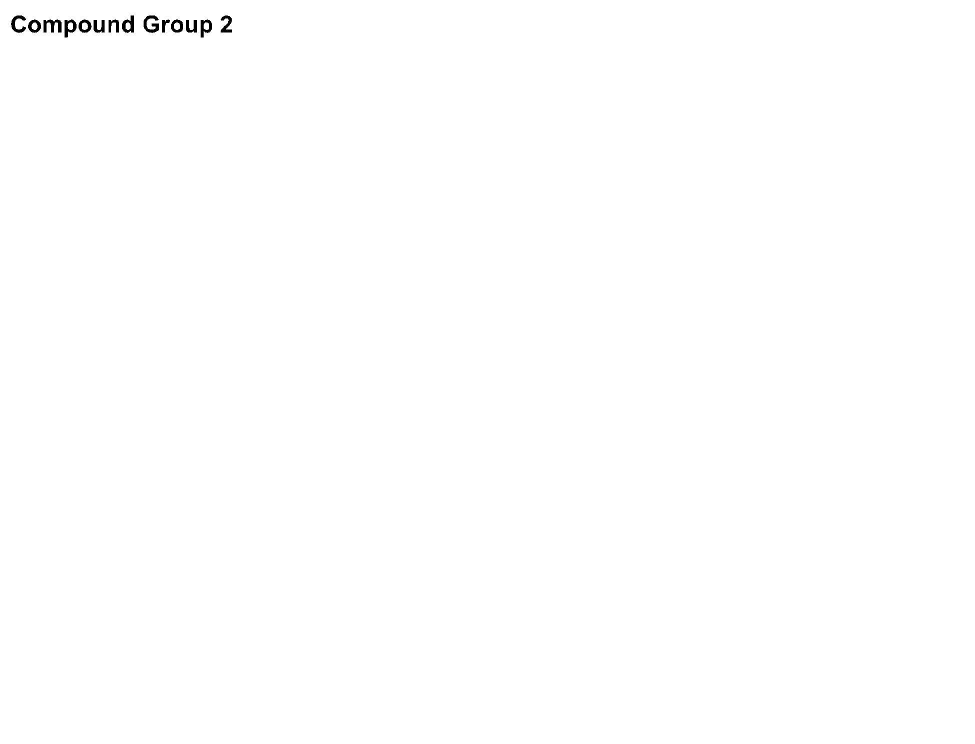

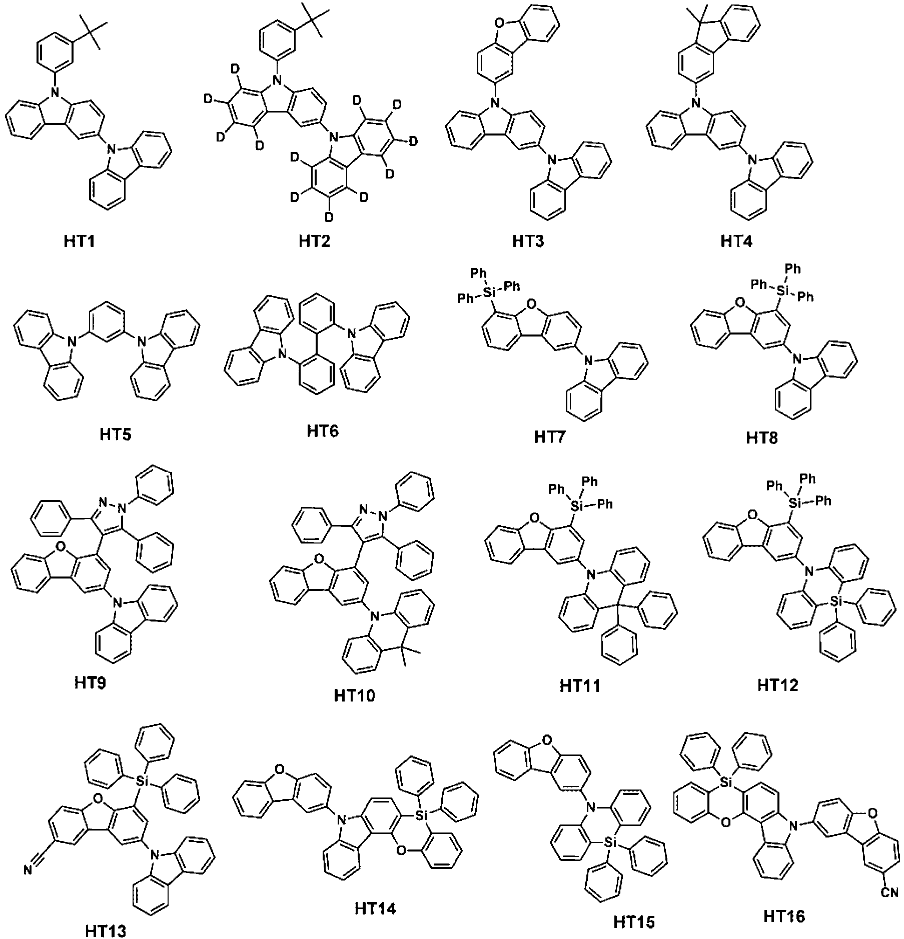

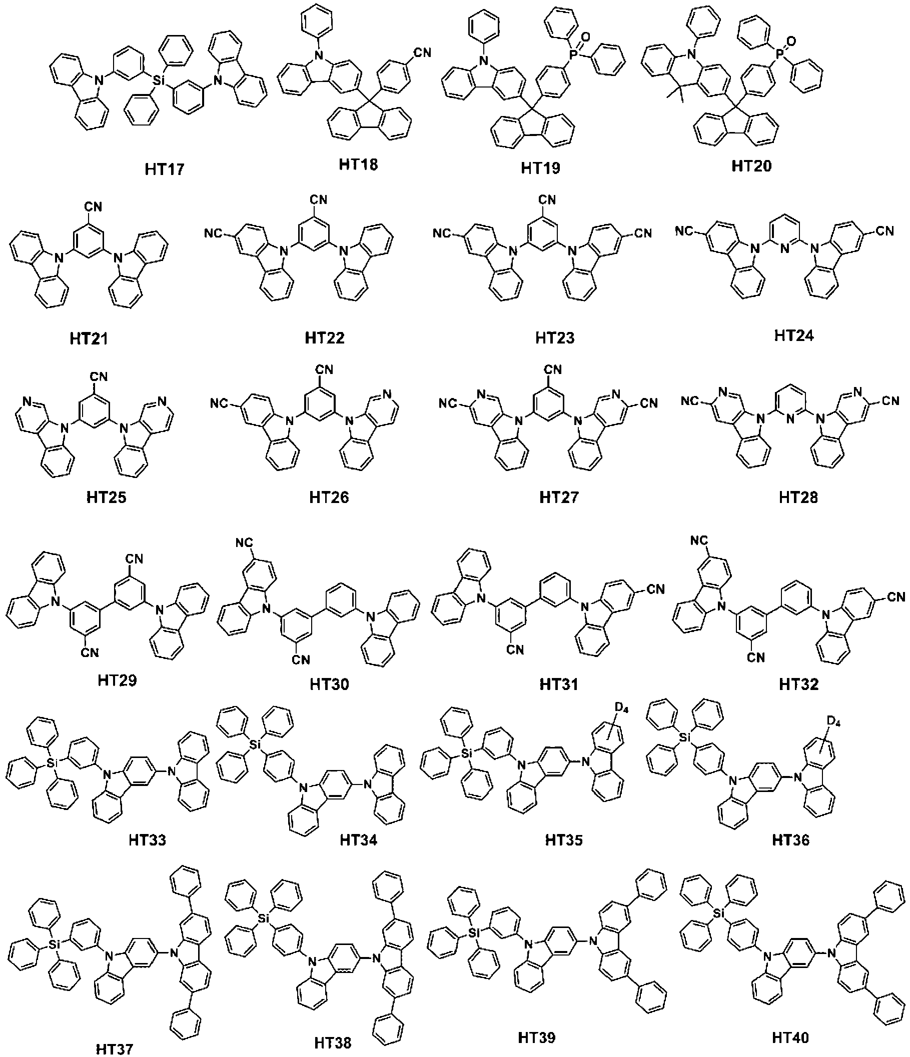

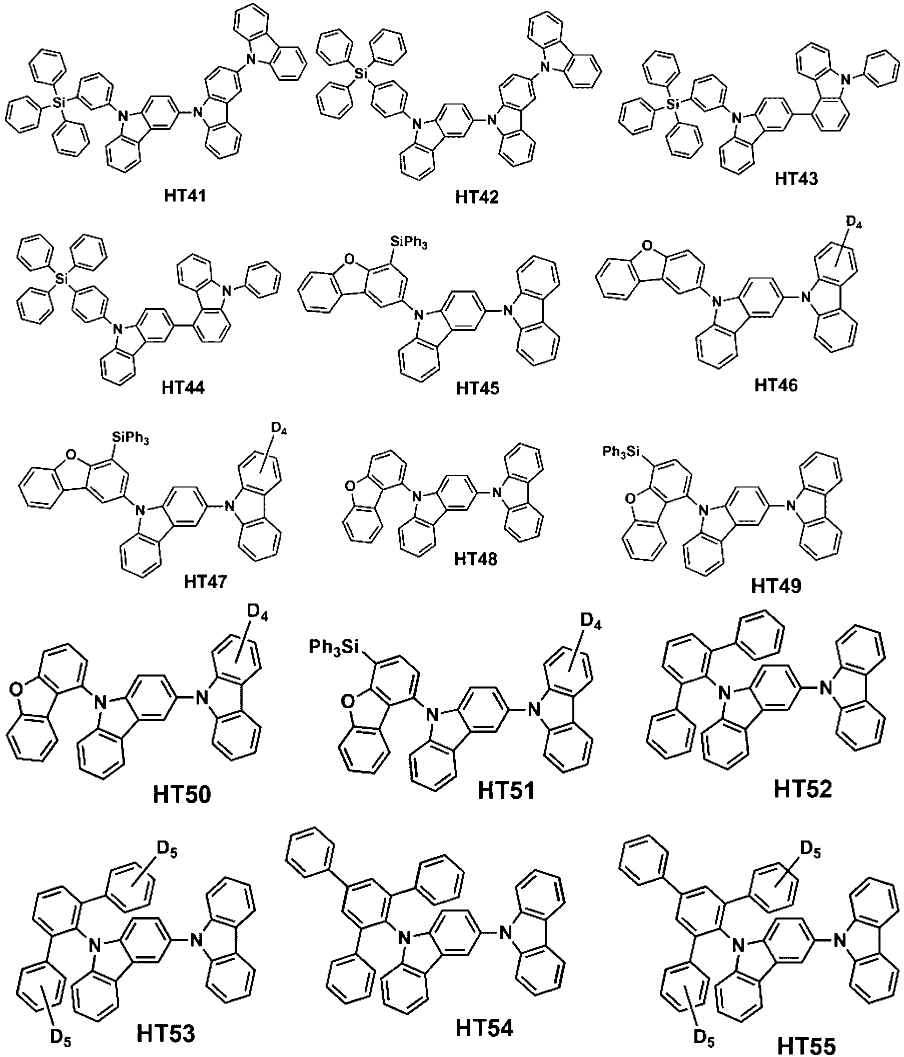

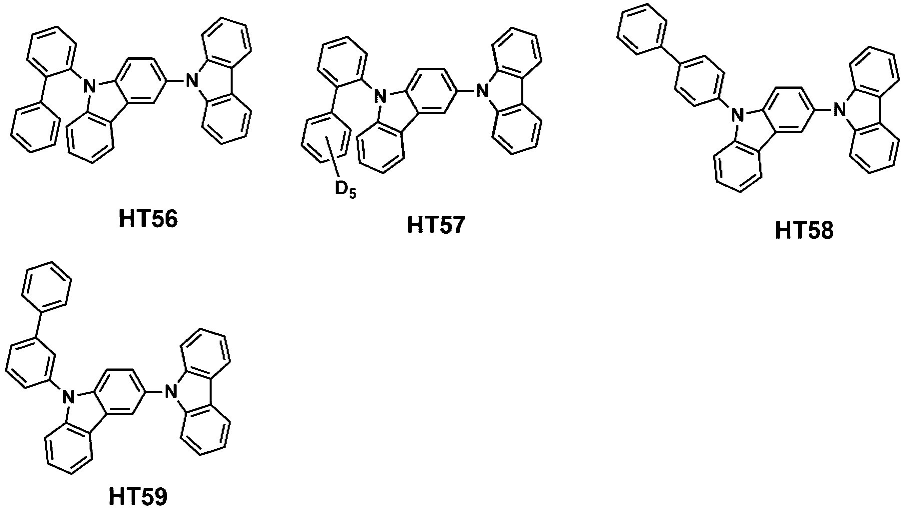

In the specific compounds represented in Compound Group 2, "D" refers to deuterium, and "Ph" may refer to a substituted or unsubstituted phenyl group. For example, in the specific compounds represented in Compound Group 2, "Ph" may be an unsubstituted phenyl group.

In one or more embodiments, the light emitting layer EML may include the third compound represented by Formula ET-1. For example, the third compound may be used as an electron transporting host material of the light emitting layer EML.

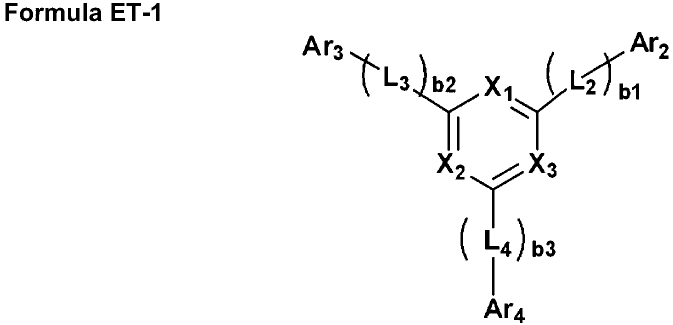

In Formula ET-1, at least one selected from among X₁ to X₃ may be N, and the remainder are CR₅₆. For example, in one or more embodiments, one selected from among X₁ to X₃ may be N, and the remainder two may each independently be CR₅₆. In these embodiments, the third compound represented by Formula ET-1 may include a pyridine moiety. In one or more embodiments, two selected from among X₁ to X₃ may be N, and the remainder one is CR₅₆. In these embodiments, the third compound represented by Formula ET-1 may include a pyrimidine moiety. In one or more embodiments, all X₁ to X₃ may be N. In these embodiments, the third compound represented by Formula ET-1 may include a triazine moiety.

In Formula ET-1, R₅₆ may be hydrogen, deuterium, a substituted or unsubstituted alkyl group of 1 to 20 carbon atoms, a substituted or unsubstituted aryl group of 6 to 60 ring-forming carbon atoms, or a substituted or unsubstituted heteroaryl group of 2 to 60 ring-forming carbon atoms.

In Formula ET-1, b1 to b3 may each independently be an integer of 0 to 10.

In Formula ET-1, Ar₂ to Ar₄ may each independently be hydrogen, deuterium, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms. For example, in one or more embodiments, Ar₂ to Ar₄ may be each independently substituted or unsubstituted phenyl groups or substituted or unsubstituted carbazole groups.

In Formula ET-1, L₂ to L₄ may each independently be a direct linkage, a substituted or unsubstituted arylene group of 6 to 30 ring-forming carbon atoms, or a substituted or unsubstituted heteroarylene group or 2 to 30 ring-forming carbon atoms. If (e.g., when) b1 to b3 are each an integer of 2 or greater, L₂ to L₄ each in plurality may each independently be a substituted or unsubstituted arylene group of 6 to 30 ring-forming carbon atoms or a substituted or unsubstituted heteroarylene group of 2 to 30 ring-forming carbon atoms.

In one or more embodiments, the third compound may be any one selected from among compounds in Compound Group 3. The light emitting element ED of one or more embodiments may include at least one selected from among the compounds in Compound Group 3.

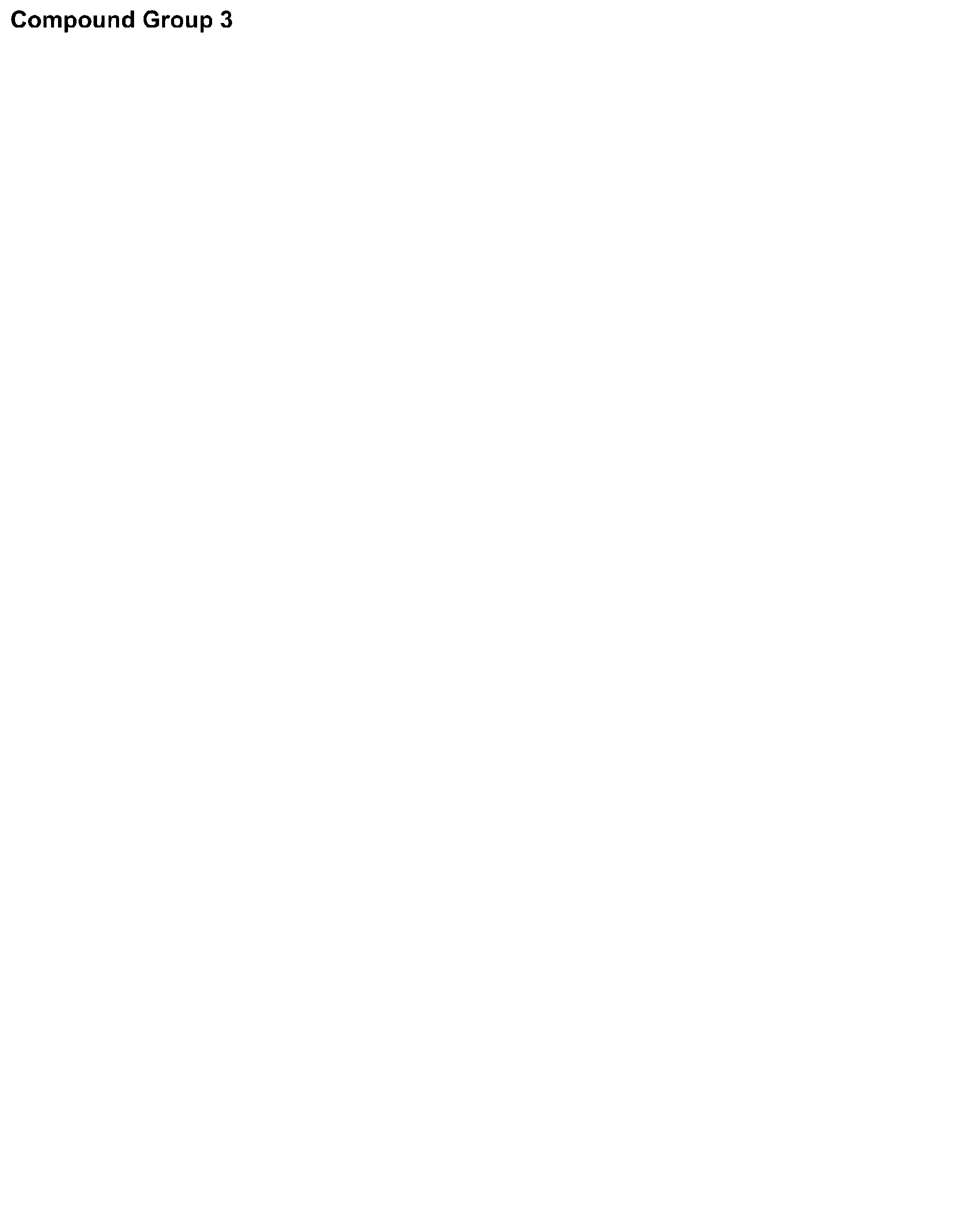

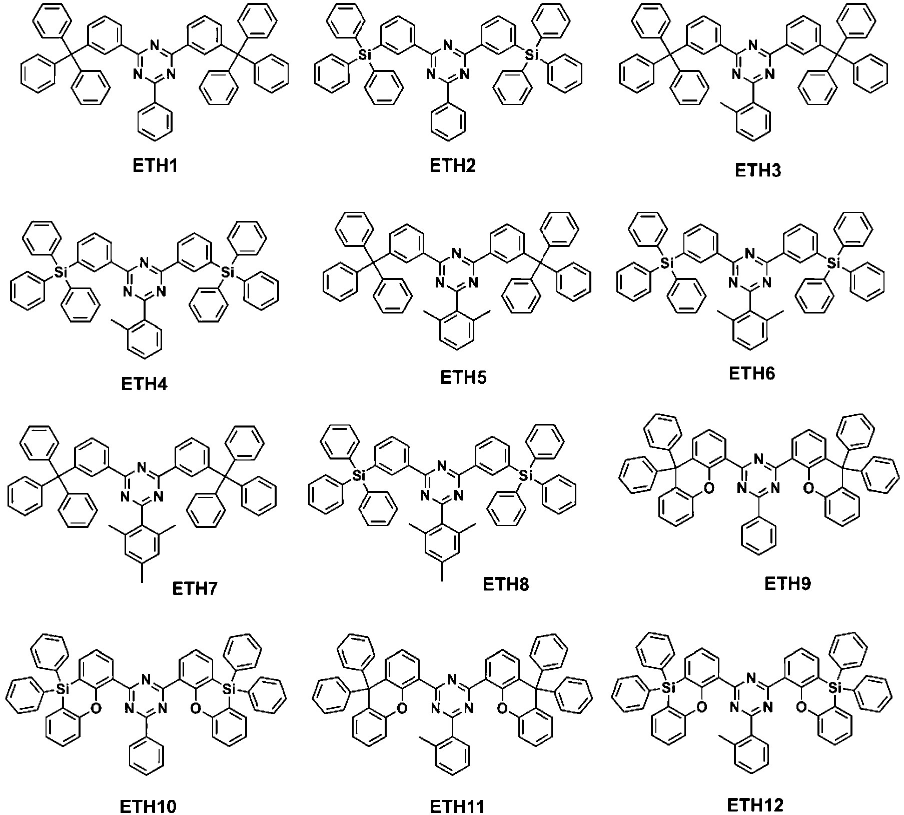

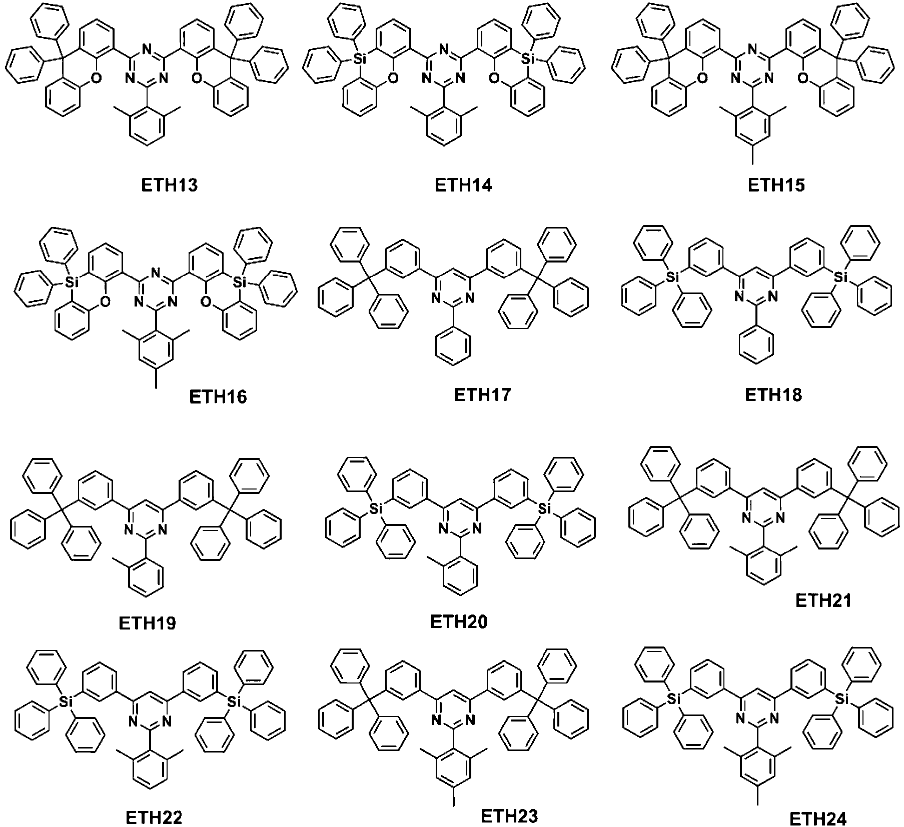

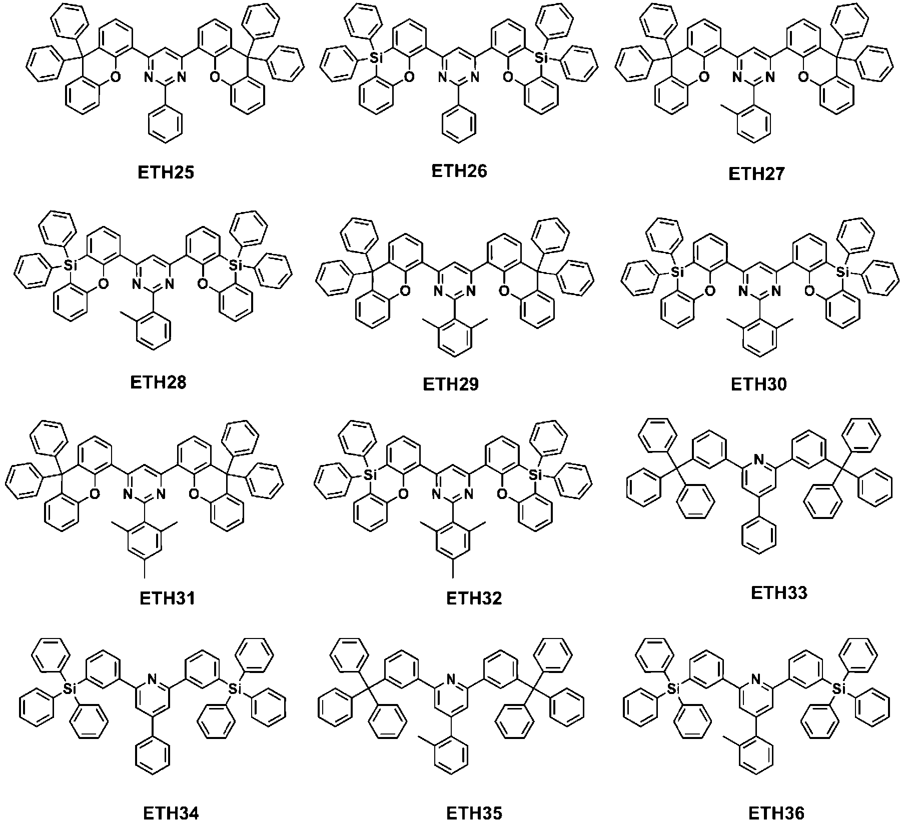

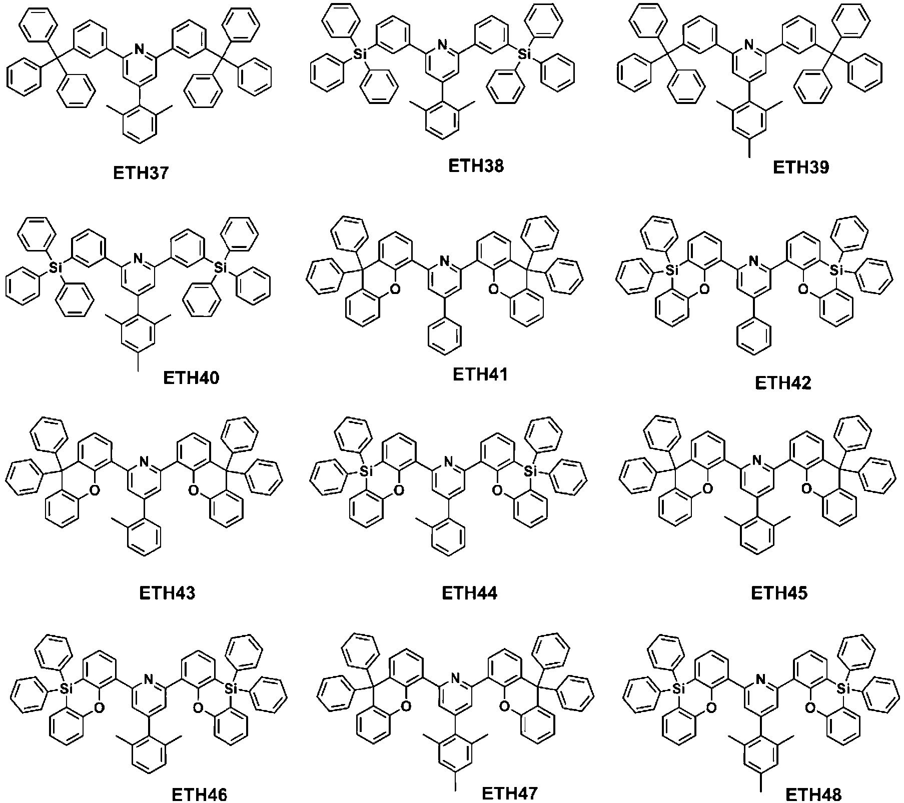

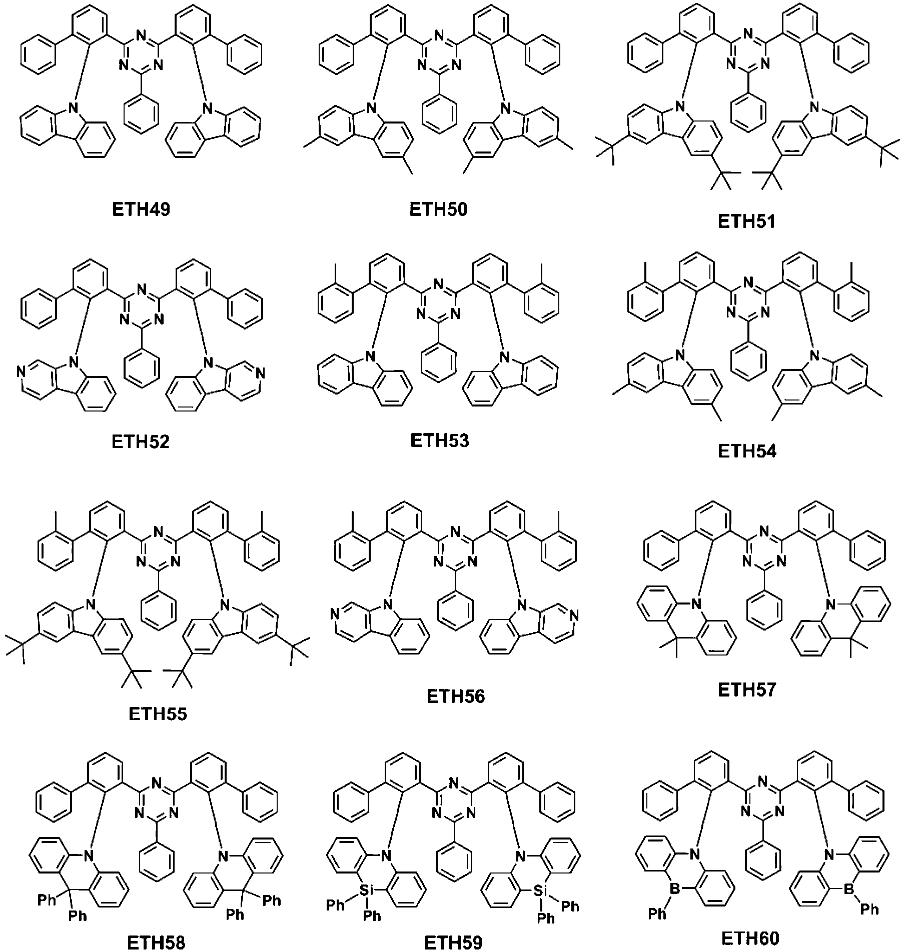

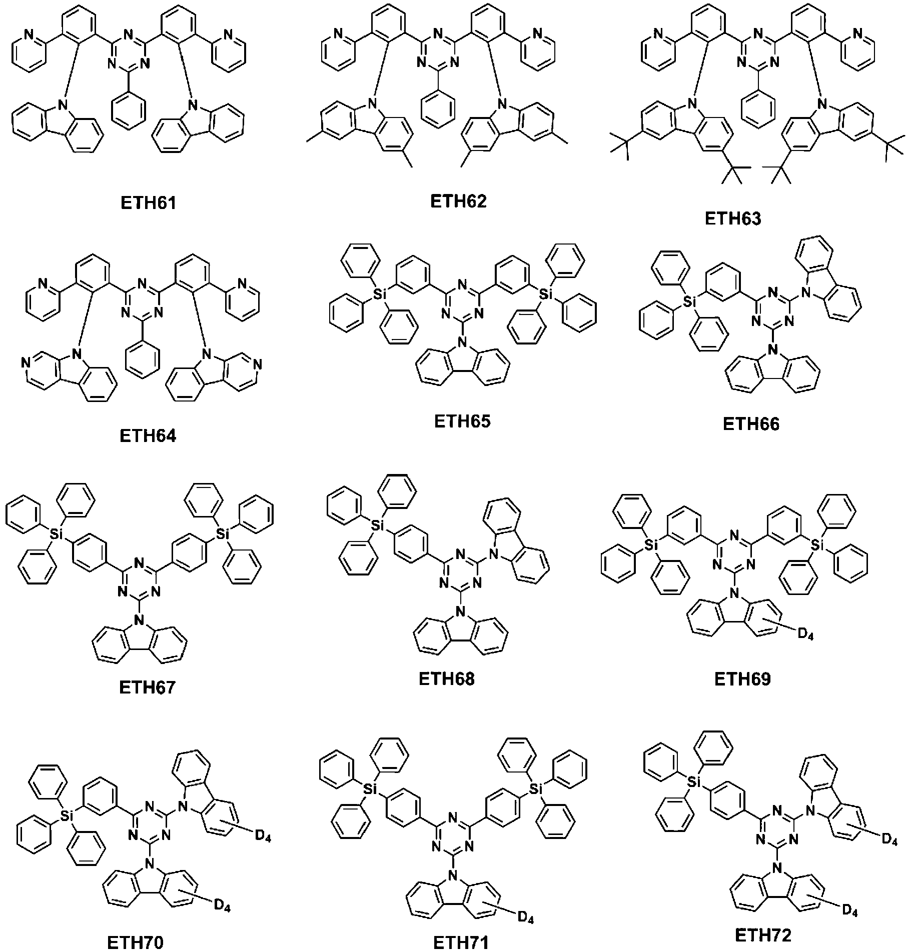

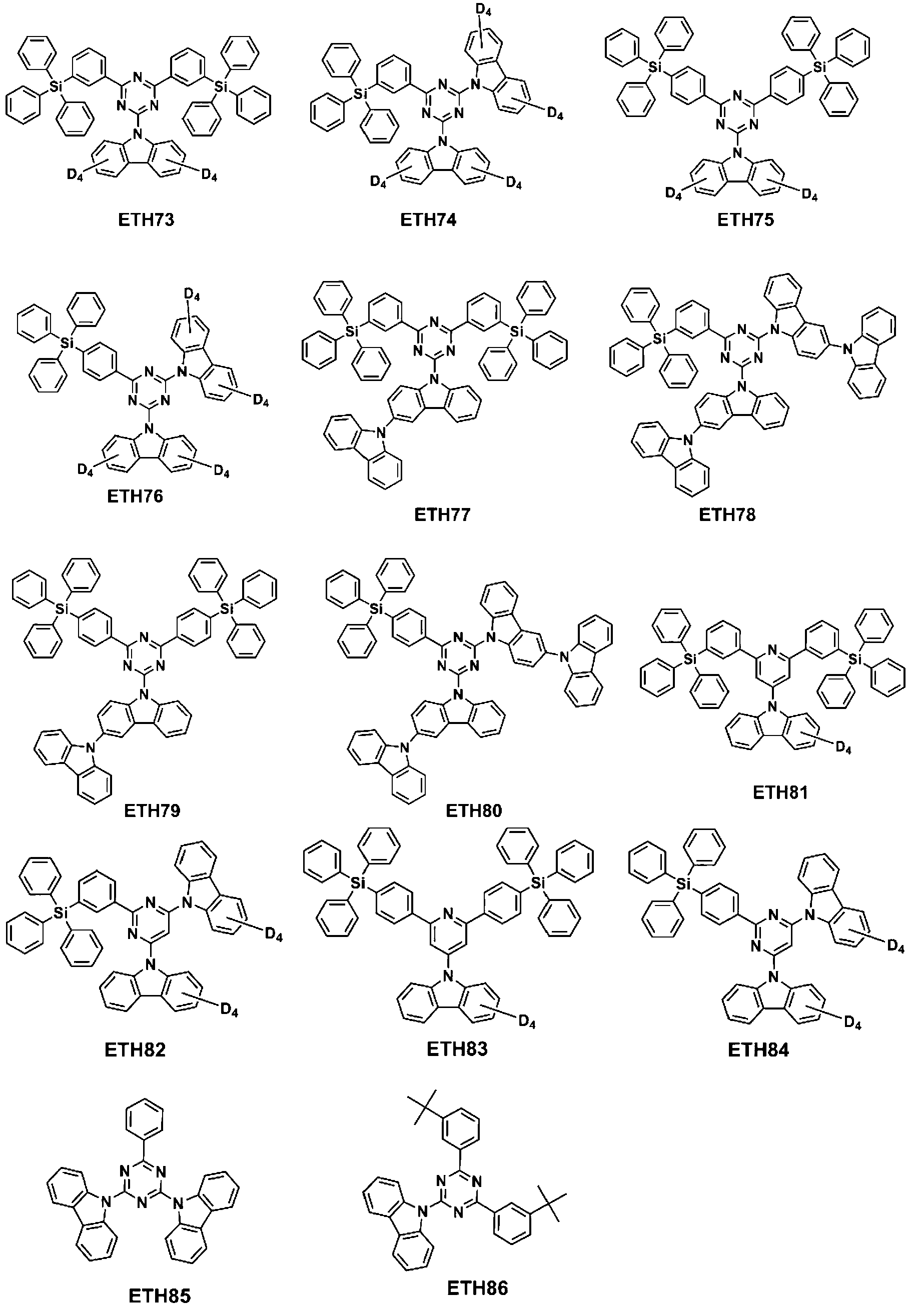

In the specific compounds represented in Compound Group 3, "D" refers to deuterium, and "Ph" refers to an unsubstituted phenyl group.

In one or more embodiments, the light emitting layer EML includes the second compound and the third compound, and the second compound and the third compound may form an exciplex. In the light emitting layer EML, an exciplex may be formed by a hole transporting host and an electron transporting host. In this regard, the triplet energy of the exciplex formed by the hole transporting host and the electron transporting host may correspond to a difference between the lowest unoccupied molecular orbital (LUMO) energy level of the electron transporting host and the highest occupied molecular orbital (HOMO) energy level of the hole transporting host.

For example, in one or more embodiments, the triplet (T1) energy level of the exciplex formed by the hole transporting host and the electron transporting host may be from about 2.4 eV to about 3.0 eV. In addition, the triplet energy of the exciplex may be a value smaller than the energy gap of each host material. The exciplex may have a triplet energy of about 3.0 eV or less, which is an energy gap between the hole transporting host and the electron transporting host.

In one or more embodiments, the light emitting layer EML may further include a fourth compound in addition to the first to third compounds described above. The fourth compound may be used as a phosphorescence sensitizer of the light emitting layer EML. Energy may be transferred from the fourth compound to the first compound, thereby arising light emission.

For example, in one or more embodiments, the light emitting layer EML may include an organometallic complex including Pt (platinum) as a central metal atom and ligands bonded to the central metal atom, as the fourth compound. In the light emitting element ED of one or more embodiments, the light emitting layer EML may include a compound represented by Formula D-1 as the fourth compound.

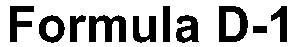

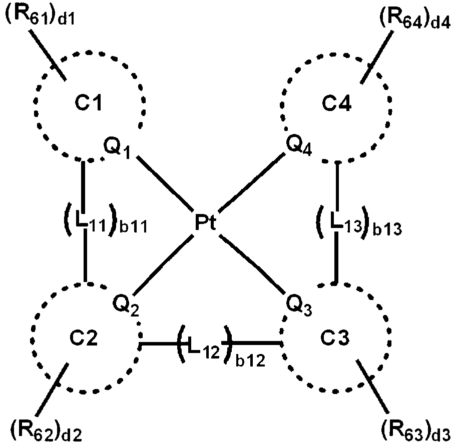

In Formula D-1, Q₁ to Q₄ may each independently be C or N. C1 to C4 may each independently be a substituted or unsubstituted hydrocarbon ring of 5 to 30 ring-forming carbon atoms or a substituted or unsubstituted heteroaryl group of 2 to 30 ring-forming carbon atoms.

In Formula D-1, L₁₁ to L₁₃ may each independently be a direct linkage, *-O-*, *-S-*, 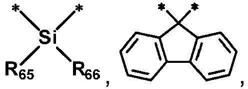 a substituted or unsubstituted alkylene group of 1 to 20 carbon atoms, a substituted or unsubstituted arylene group of 6 to 30 ring-forming carbon atoms, or a substituted or unsubstituted heteroarylene group of 2 to 30 ring-forming carbon atoms. In L₁₁ to L₁₃, "-*" refers to a connecting portion to one of C1 to C4.

In Formula D-1, b11 to b13 may each independently be 0 or 1. If (e.g., when) b11 is 0, C1 and C2 may not be connected to each other. If (e.g., when) b12 is 0, C2 and C3 may not be connected to each other. If (e.g., when) b13 is 0, C3 and C4 may not be connected to each other.

In Formula D-1, R₆₁ to R₆₆ may each independently be hydrogen, deuterium, a halogen, a cyano group, a substituted or unsubstituted silyl group, a substituted or unsubstituted thio group, a substituted or unsubstituted oxy group, a substituted or unsubstituted amino group, a substituted or unsubstituted boron group, a substituted or unsubstituted alkyl group of 1 to 20 carbon atoms, a substituted or unsubstituted alkenyl group of 2 to 20 carbon atoms, a substituted or unsubstituted aryl group of 6 to 60 ring-forming carbon atoms, or a substituted or unsubstituted heteroaryl group of 2 to 60 ring-forming carbon atoms. In one or more embodiments, one or more selected from among R₆₁ to R₆₆ may each independently be connected with an adjacent group to form a ring. In one or more embodiments, R₆₁ to R₆₆ may each independently be a substituted or unsubstituted methyl group or a substituted or unsubstituted t-butyl group.

In Formula D-1, d1 to d4 may each independently be an integer of 0 to 4. In Formula D-1, if (e.g., when) each of d1 to d4 is 0, the fourth compound may not be substituted by R₆₁ to R₆₄, respectively. An embodiment in which each of d1 to d4 is 4, and each of R₆₁(s) to R₆₄(s) is hydrogen, may be the same as an embodiment in which each of d1 to d4 is 0. If (e.g., when) each of d1 to d4 is an integer of 2 or greater, each of R₆₁ to R₆₄ respectively provided in plurality may be all the same, or at least one selected from among the plurality of R₆₁(s) to R₆₄(s) may be different.

In Formula D-1, C1 to C4 may each independently be a substituted or unsubstituted hydrocarbon ring or a substituted or unsubstituted heterocycle, represented by one selected from among C-1 to C-4.

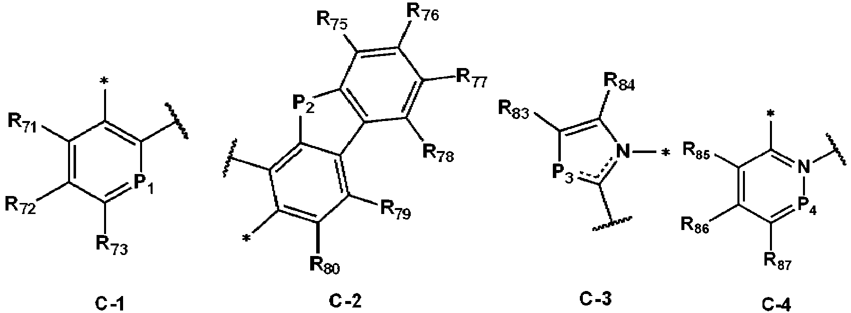

In C-1 to C-4, P₁ may be C-* or CR₇₄, P₂ may be N-* or NR₈₁, P₃ may be N-* or NR₈₂, and P₄ may be C-* or CR₈₈. R₇₁ to R₈₈ may each independently be a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and/or may each independently be bonded to an adjacent group to form a ring.

In addition, in C-1 to C-4, 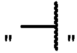 is a portion connected to the central metal atom Pt, and " -_{*} " corresponds to a portion connected to a neighboring ring group (C1 to C4) or a neighboring linker (L₁₁ to L₁₃).

The light emitting layer EML of one or more embodiments may include the first compound, which is the polycyclic compound, and at least one selected from among the second to fourth compounds. For example, in one or more embodiments, the light emitting layer EML may include the first compound, the second compound, and the third compound. In the light emitting layer EML, the second compound and the third compound may form an exciplex, and energy may be transferred from the exciplex to the first compound to arise light emission.

In one or more embodiments, the light emitting layer EML may include the first compound, the second compound, the third compound, and the fourth compound. In the light emitting layer EML, the second compound and the third compound may form an exciplex, and energy may be transferred from the exciplex to the fourth compound and the first compound to arise light emission. In one or more embodiments, the fourth compound may be a sensitizer. In the light emitting element ED of one or more embodiments, the fourth compound included in the light emitting layer EML may function as a sensitizer to transfer energy from the host to the first compound, which is a light emitting dopant. For example, in one or more embodiments, the fourth compound acting as an auxiliary dopant may accelerate the energy transfer to the first compound, which is a light emitting dopant, thereby increasing the light emission ratio of the first compound. Therefore, the light emitting layer EML of one or more embodiments may have improved emission efficiency. In addition, if (e.g., when) the energy transfer to the first compound is increased, the excitons formed in the light emitting layer EML may not accumulate inside the light emitting layer EML and quickly emit light, so that the deterioration of the light emitting element may be reduced. Therefore, the lifespan of the light emitting element ED of one or more embodiments may be improved.

The light emitting element ED of one or more embodiments may include all of the first compound, the second compound, the third compound, and the fourth compound, so that the light emitting layer EML includes a combination of two host materials and two dopant materials. In the light emitting element ED of one or more embodiments, the light emitting layer EML may exhibit excellent or suitable emission efficiency characteristics by concurrently (e.g., simultaneously) including two different hosts, which are the second compound and the third compound, the first compound emitting delayed fluorescence, and the fourth compound including an organometallic complex.

In one or more embodiments, the fourth compound represented by Formula D-1 may be any one selected from among compounds represented in Compound Group 4. The light emitting layer EML may include at least one selected from among the compounds represented in Compound Group 4 as a sensitizer material.

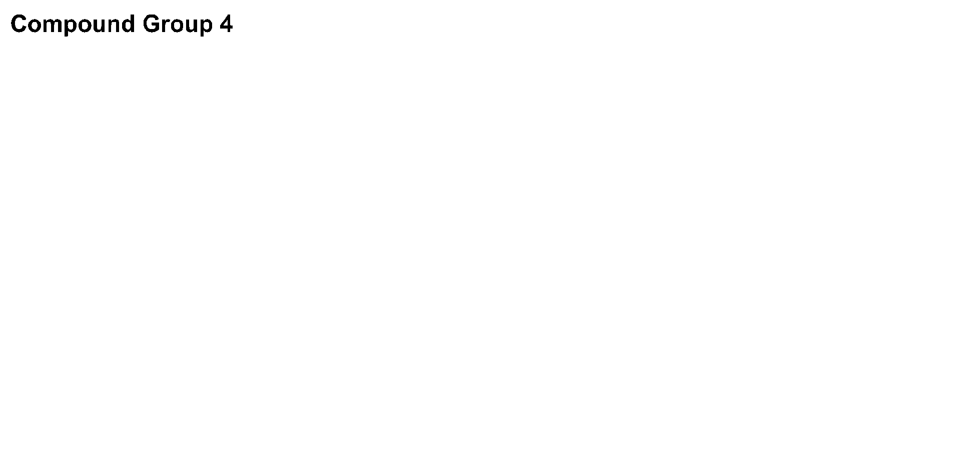

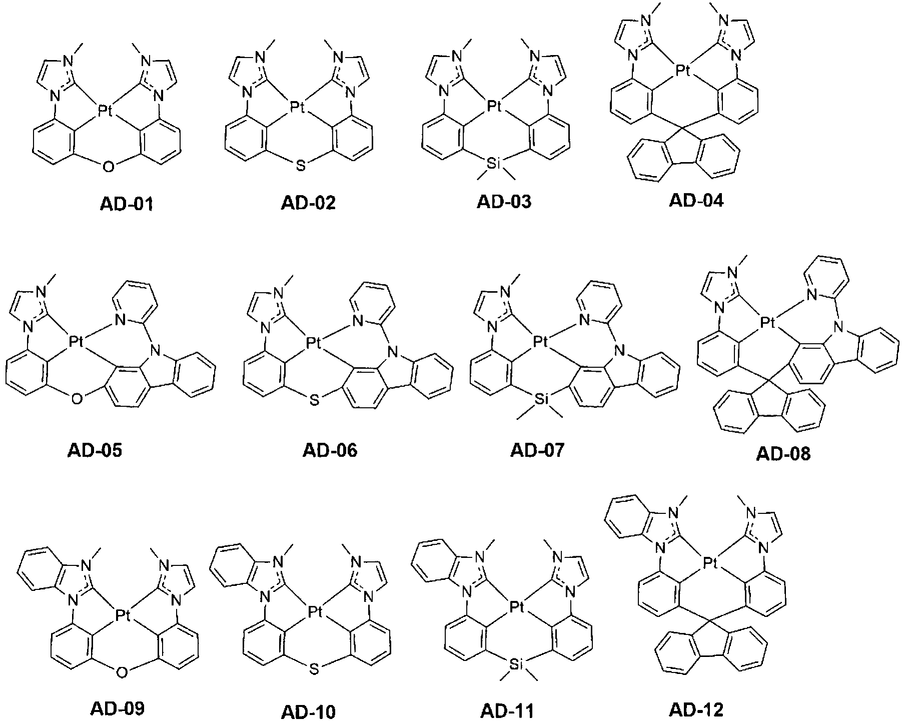

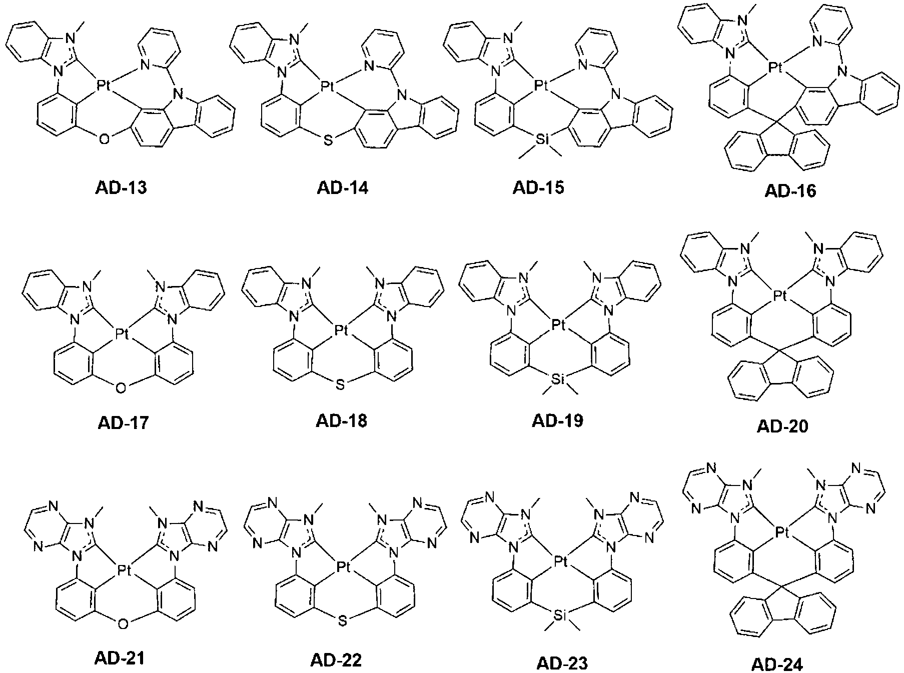

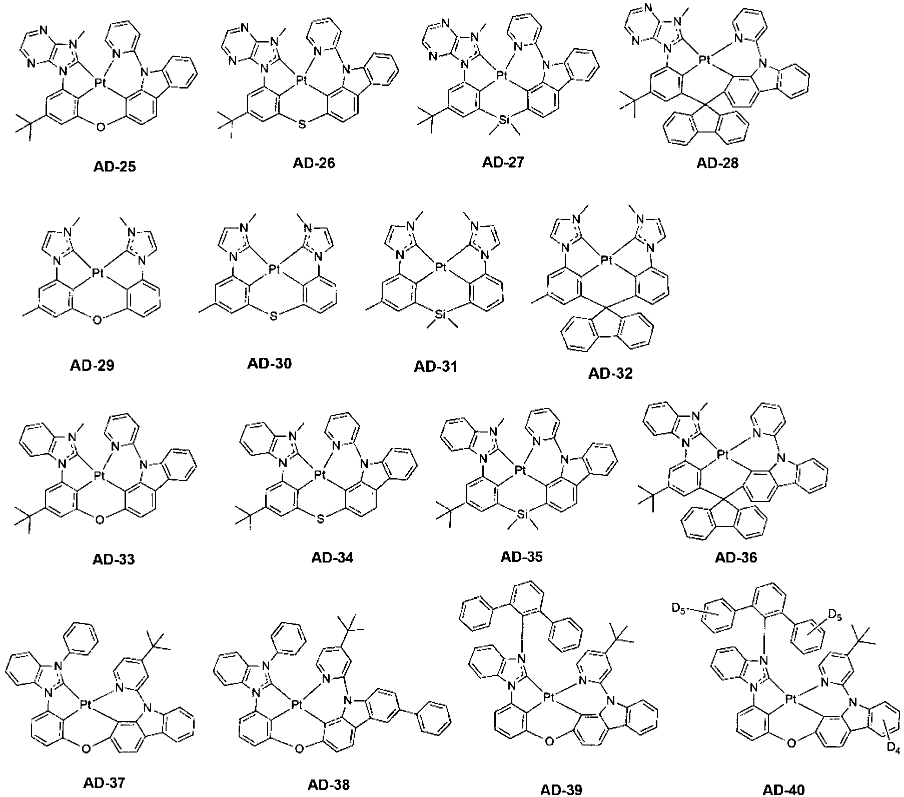

In the specific compounds represented in Compound Group 4, "D" refers to deuterium.

In the light emitting element ED of one or more embodiments, if (e.g., when) the light emitting layer EML includes all of the first compound, the second compound, and the third compound described above, the content (e.g., amount) of the first compound may be about 0.1 wt% to about 5 wt% based on the total weight of the first compound, the second compound, and the third compound. However, embodiments of the present disclosure are not limited thereto. When the content (e.g., amount) of the first compound satisfies the ratio described above, energy transfer from the second compound and the third compound to the first compound may be increased, and thus, the emission efficiency and the element lifespan may be increased.

The content (e.g., amounts) of the second compound and the third compound in the light emitting layer EML may be the remainder excluding the weight of the first compound described above. For example, in one or more embodiments, the sum of the content (e.g., amount) of the second compound and the content (e.g., amount) of the third compound in the light emitting layer EML may be about 65 wt% to about 95 wt% based on the total weight of the first compound, the second compound, and the third compound.

A weight ratio of the second compound to the third compound in the total weight of the second compound and the third compound may be about 3:7 to 7:3.

When the content (e.g., amount) of the second compound and the content (e.g., amount) of the third compound satisfy the above-described ratio, charge balance characteristic within the light emitting layer EML may be improved, so that the emission efficiency and the element lifespan may increase. When the content (e.g., amount) of the second compound and the content (e.g., amount) of the third compound deviates from the above-described ratio range, the charge balance within the light emitting layer EML may be broken, so that the emission efficiency may be reduced, and the element may easily deteriorate.

In one or more embodiments, when the light emitting layer EML includes the fourth compound, the content (e.g., amount) of the fourth compound may be about 10 wt% to about 30 wt% based on the total weight of the first compound, the second compound, the third compound, and the fourth compound in the light emitting layer EML. However, embodiments of the present disclosure are not limited thereto. When the content (e.g., amount) of the fourth compound satisfies the content (e.g., amount) range described above, energy transfer from the host to the first compound, which is a light emitting dopant, may be increased, thereby improving the light emitting ratio, and thus the emission efficiency of the light emitting layer EML may be improved. When the first compound, the second compound, the third compound, and the fourth compound included in the light emitting layer EML satisfy the content (e.g., amount) ratio ranges described above, excellent or suitable emission efficiency and long lifespan may be achieved.

The light emitting layer EML may have a thickness of, for example, about 100 Å to about 1,000 Å or about 100 Å to about 300 Å. The light emitting layer EML may have a single layer formed using a single material, a single layer formed using multiple different materials, or a multilayer structure having multiple layers formed using multiple different materials.

In each of the light emitting elements ED of embodiments illustrated in FIGS. 5 to 9, the light emitting layer EML may include the polycyclic compound of one or more embodiments described above as a dopant. In one or more embodiments, in each of the light emitting elements ED of embodiments illustrated in FIGS. 5 to 9, the light emitting layer EML may include the first compound, which is the polycyclic compound of one or more embodiments, and at least of the second compound represented by Formula HT-1 or the third compound represented by Formula ET-1. In one or more embodiments, in each of the light emitting elements ED of embodiments illustrated in FIGS. 5 to 9, the light emitting layer EML may include the first compound, which is the polycyclic compound of one or more embodiments, the second compound represented by Formula HT-1, the third compound represented by Formula ET-1, and the fourth compound represented by Formula D-1.

In the light emitting element ED of one or more embodiments, the light emitting layer EML may further include at least one selected from among anthracene derivatives, pyrene derivatives, fluoranthene derivatives, chrysene derivatives, dihydrobenzanthracene derivatives, and triphenylene derivatives. For example, in one or more embodiments, the light emitting layer EML may further include an anthracene derivative and/or a pyrene derivative.

In the light emitting element ED of one or more embodiments, shown in FIG. 5 to FIG.9, the light emitting layer EML may include a host and a dopant, and the light emitting layer EML may further include a compound represented by Formula E-1. The compound represented by Formula E-1 may be used as a fluorescence host material.

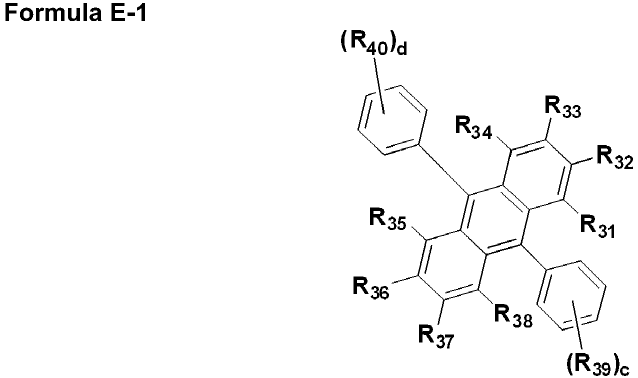

In Formula E-1, R₃₁ to R₄₀ may each independently be hydrogen, deuterium, a halogen, a substituted or unsubstituted silyl group, a substituted or unsubstituted thio group, a substituted or unsubstituted oxy group, a substituted or unsubstituted alkyl group of 1 to 10 carbon atoms, a substituted or unsubstituted alkenyl group of 2 to 10 carbon atoms, a substituted or unsubstituted aryl group of 6 to 30 ring-forming carbon atoms, or a substituted or unsubstituted heteroaryl group of 2 to 30 ring-forming carbon atoms, and/or combined with an adjacent group to form a ring. In one or more embodiments, one or more selected from among R₃₁ to R₄₀ may each independently be combined with an adjacent group to form a saturated hydrocarbon ring, an unsaturated hydrocarbon ring, a saturated heterocycle, or an unsaturated heterocycle.

In Formula E-1, "c" and "d" may each independently be an integer of 0 to 5.

The compound represent by Formula E-1 may be any one selected from among Compound E1 to Compound E19.

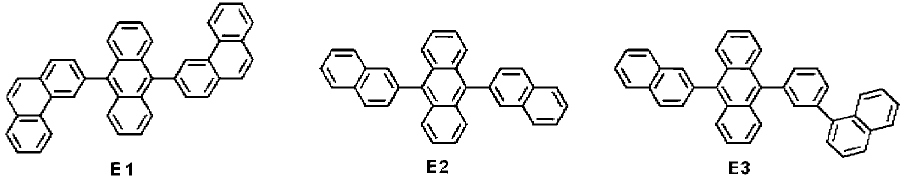

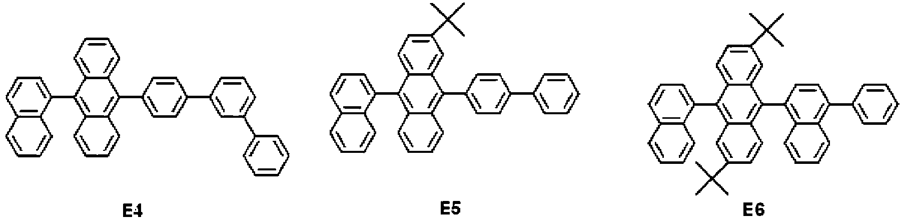

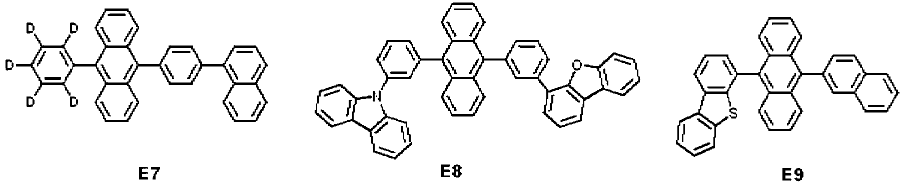

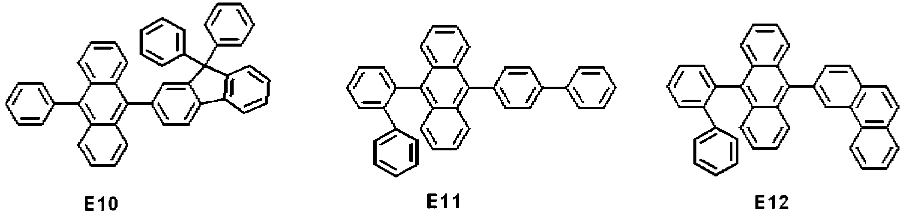

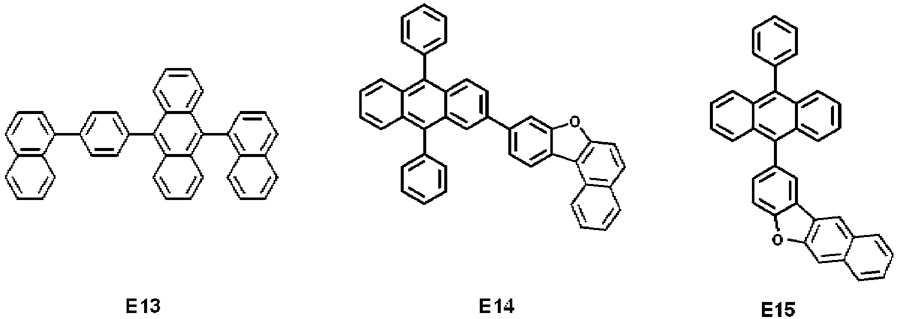

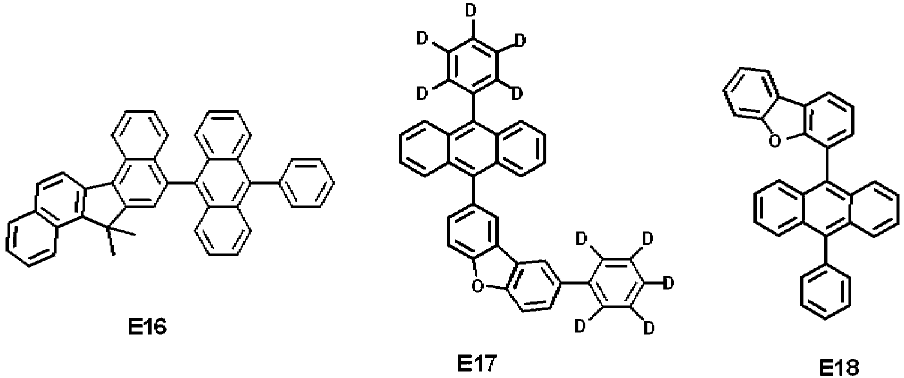

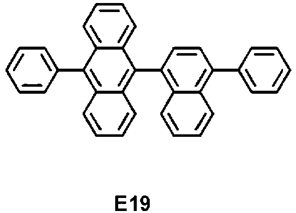

In one or more embodiments, the light emitting layer EML may further include a compound represented by Formula E-2a or Formula E-2b. The compound represented by Formula E-2a or Formula E-2b may be used as a host material in a phosphorescence light emitting layer.

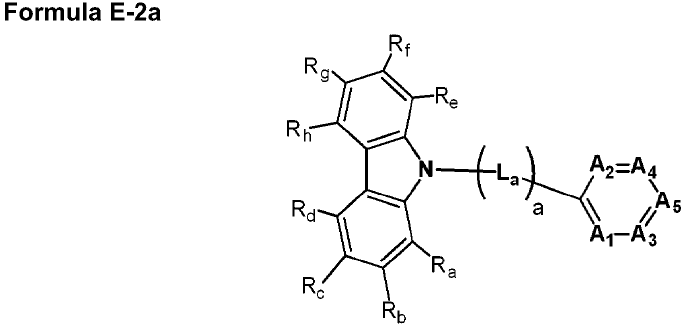

In Formula E-2a, "a" may be an integer of 0 to 10, Lₐ may be a direct linkage, a substituted or unsubstituted arylene group of 6 to 30 ring-forming carbon atoms, or a substituted or unsubstituted heteroarylene group of 2 to 30 ring-forming carbon atoms. If (e.g., when) "a" is an integer of 2 or greater, multiple Lₐ(s) may each independently be a substituted or unsubstituted arylene group of 6 to 30 ring-forming carbon atoms or a substituted or unsubstituted heteroarylene group of 2 to 30 ring-forming carbon atoms.

In addition, in Formula E-2a, A₁ to A₅ may each independently be N or CRᵢ. Rₐ to Rᵢ may each independently be hydrogen, deuterium, a substituted or unsubstituted amino group, a substituted or unsubstituted thio group, a substituted or unsubstituted oxy group, a substituted or unsubstituted alkyl group of 1 to 20 carbon atoms, a substituted or unsubstituted alkenyl group of 2 to 20 carbon atoms, a substituted or unsubstituted aryl group of 6 to 30 ring-forming carbon atoms, or a substituted or unsubstituted heteroaryl group of 2 to 30 ring-forming carbon atoms, and/or may be combined with an adjacent group to form a ring. In one or more embodiments, one or more selected from among Rₐ to Rᵢ may each independently be combined with an adjacent group to form a hydrocarbon ring or a heterocycle including N, 0, S, and/or the like as a ring-forming atom.

In one or more embodiments, in Formula E-2a, two or three selected from among A₁ to A₅ may be N, and the remainder are CRᵢ.

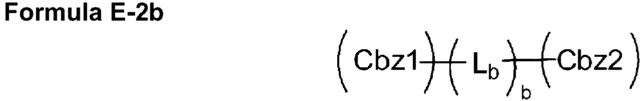

In Formula E-2b, Cbz1 and Cbz2 may each independently be an unsubstituted carbazole group or a carbazole group substituted with an aryl group of 6 to 30 ring-forming carbon atoms. L_{b} may be a direct linkage, a substituted or unsubstituted arylene group of 6 to 30 ring-forming carbon atoms, or a substituted or unsubstituted heteroarylene group of 2 to 30 ring-forming carbon atoms. "b" is an integer of 0 to 10, and if (e.g., when) "b" is an integer of 2 or greater, multiple L_{b}(s) may each independently be a substituted or unsubstituted arylene group of 6 to 30 ring-forming carbon atoms or a substituted or unsubstituted heteroarylene group of 2 to 30 ring-forming carbon atoms.

The compound represented by Formula E-2a or Formula E-2b may be any one selected from among compounds in Compound Group E-2. However, the compounds shown in Compound Group E-2 are merely examples, and the compound represented by Formula E-2a or Formula E-2b is not limited to the compounds represented in Compound Group E-2.

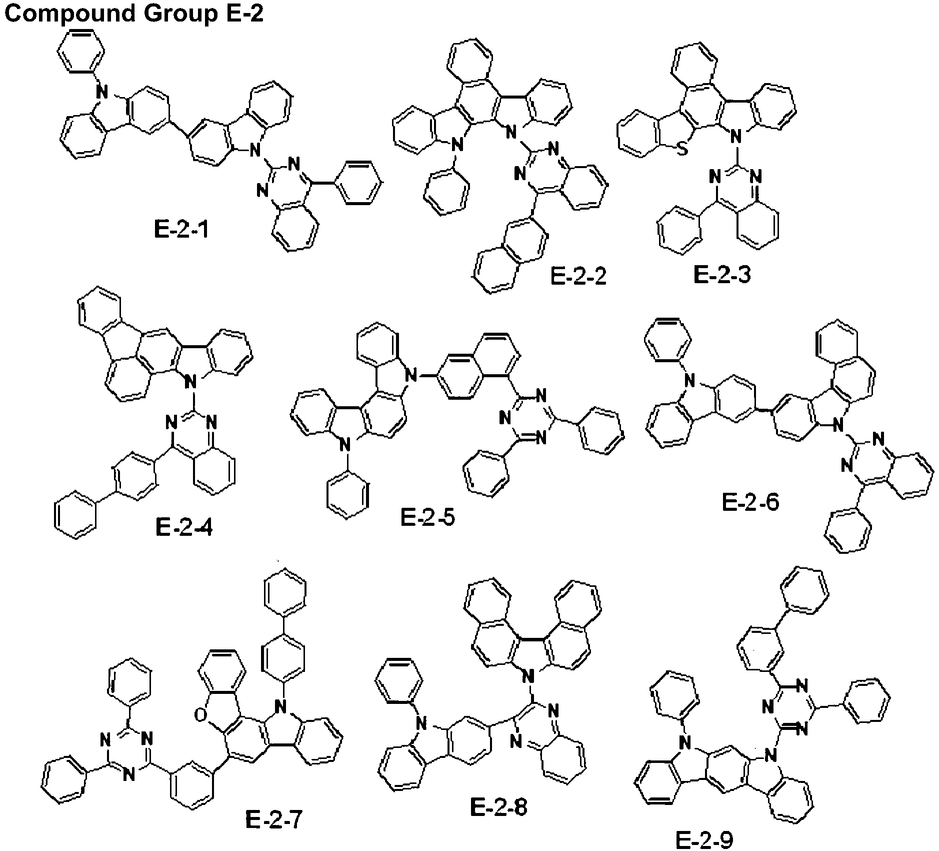

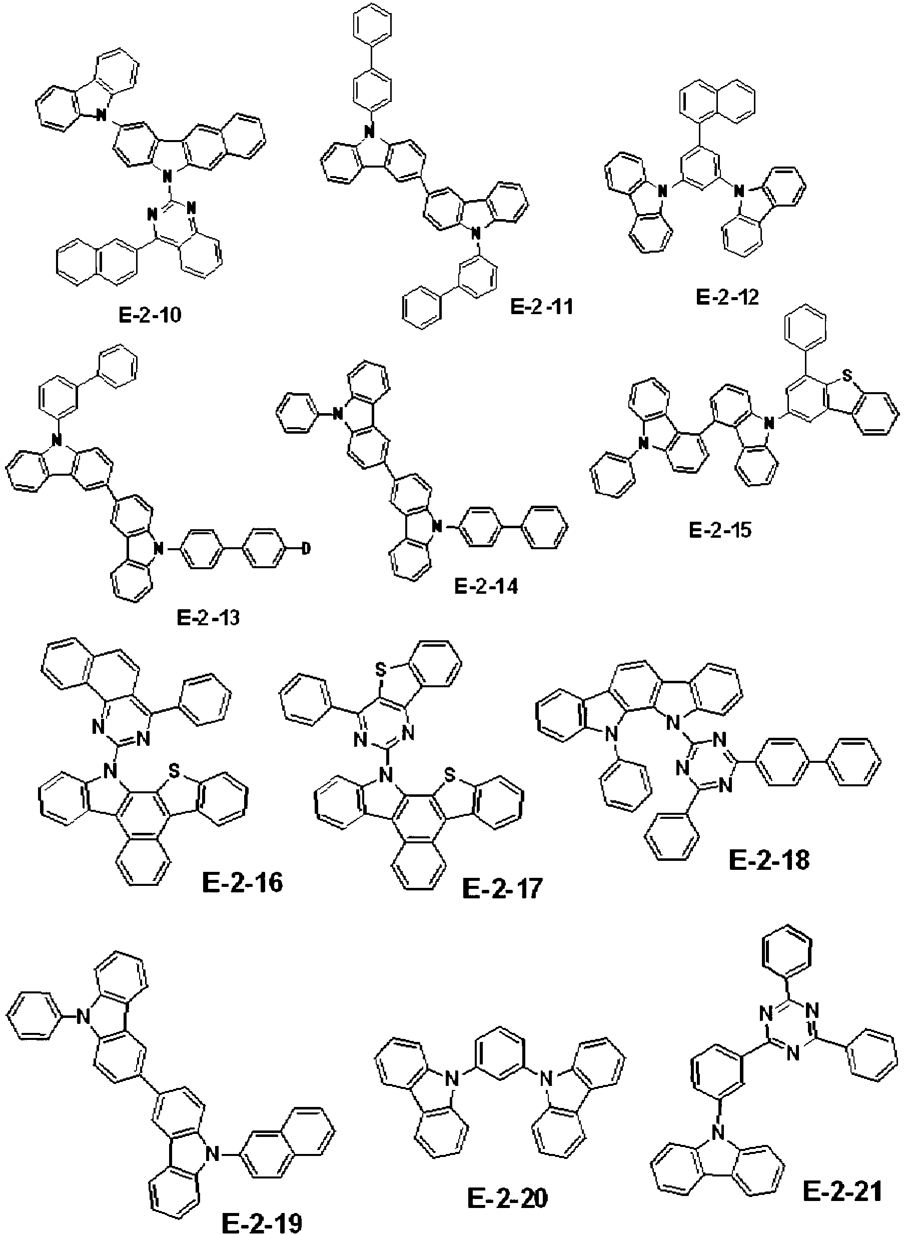

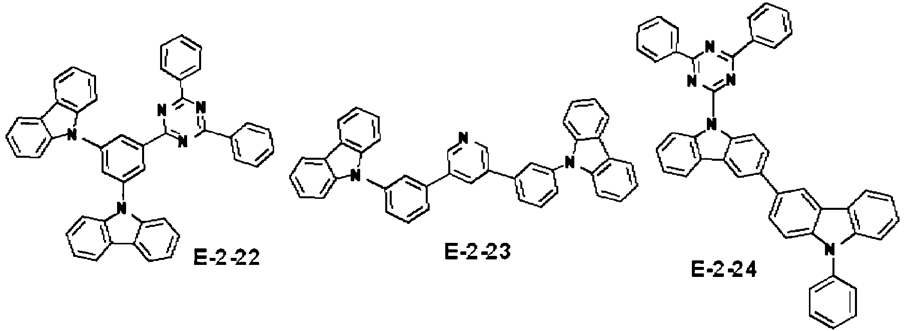

In one or more embodiments, the light emitting layer EML may further include a compound represented by Formula M-a. The compound represented by Formula M-a may be used as a phosphorescence dopant material.

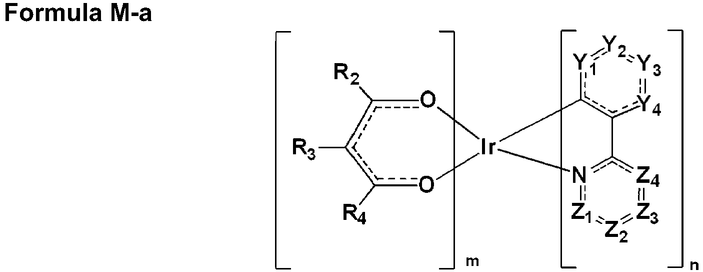

In Formula M-a, Y₁ to Y₄ and Z₁ to Z₄ may each independently be CR₁ or N, and R₁ to R₄ may each independently be hydrogen, deuterium, a substituted or unsubstituted amino group, a substituted or unsubstituted thio group, a substituted or unsubstituted oxy group, a substituted or unsubstituted alkyl group of 1 to 20 carbon atoms, a substituted or unsubstituted alkenyl group of 2 to 20 carbon atoms, a substituted or unsubstituted aryl group of 6 to 30 ring-forming carbon atoms, or a substituted or unsubstituted heteroaryl group of 2 to 30 ring-forming carbon atoms, and/or may be independently combined with an adjacent group to form a ring. In Formula M-a, "m" is 0 or 1, and "n" is 2 or 3. In Formula M-a, if (e.g., when) "m" is 0, "n" is 3, and if (e.g., when) "m" is 1, "n" is 2.

The compound represented by Formula M-a may be used as a phosphorescence dopant.

The compound represented by Formula M-a may be any one selected from among Compounds M-a1 to M-a25. However, Compounds M-a1 to M-a25 are mere examples, and the compound represented by Formula M-a is not limited to the compounds represented by Compounds M-a1 to M-a25.

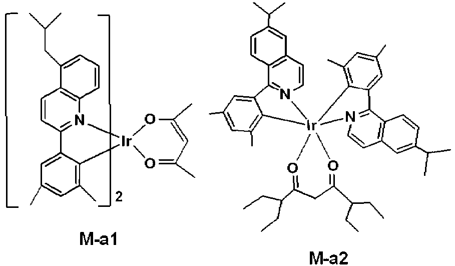

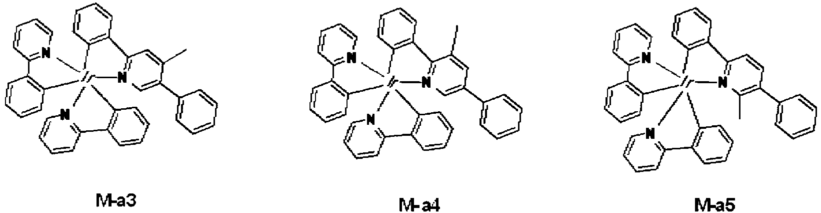

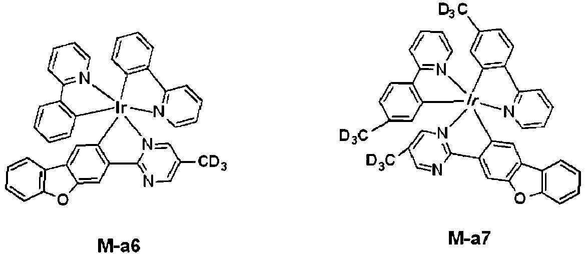

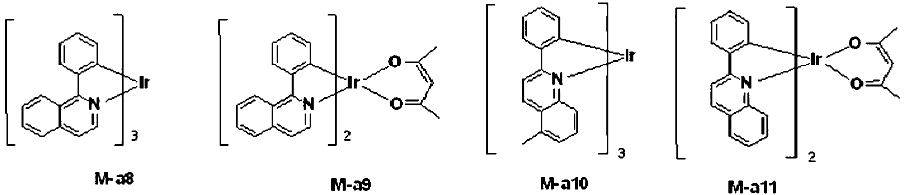

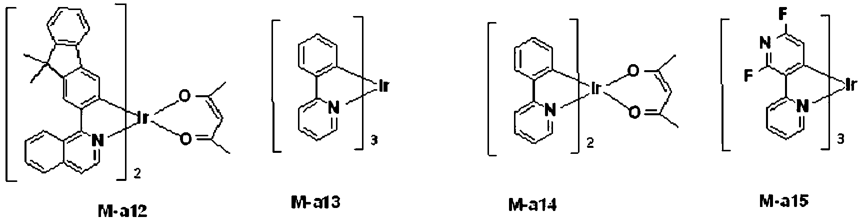

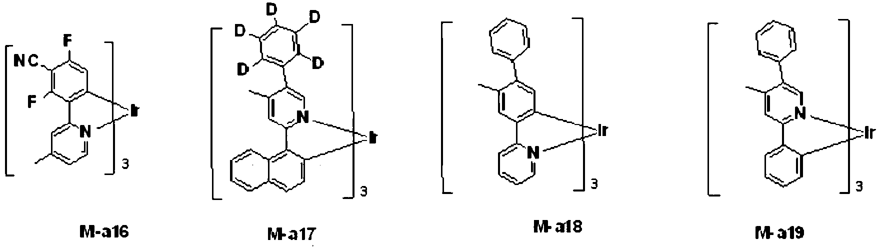

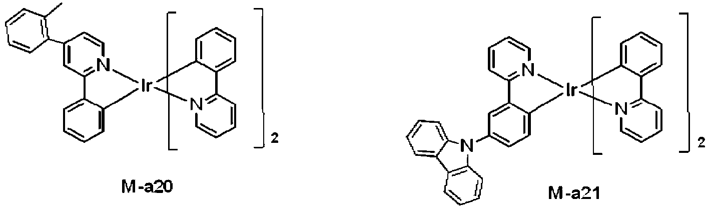

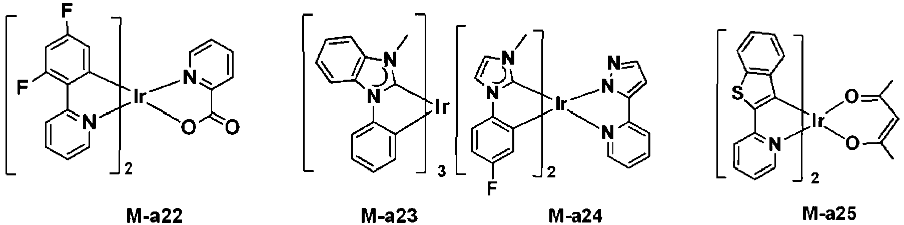

In one or more embodiments, the light emitting layer EML may further include one selected from among compounds represented by Formula F-a to Formula F-c. The compounds represented by Formula F-a to Formula F-c may be used as fluorescence dopant materials.

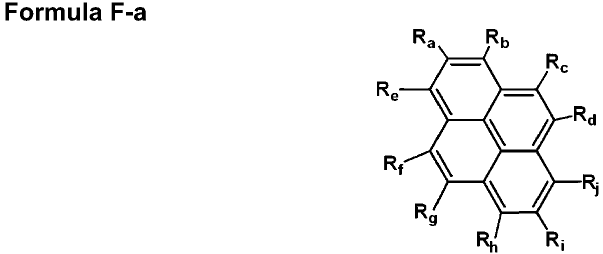

In Formula F-a, two selected from among Rₐ to Rⱼ may each independently be substituted with _{*}-NAr₁Ar₂. The remainder not substituted with _{*}-NAr₁Ar₂ among Rₐ to Rⱼ may each independently be hydrogen, deuterium, a halogen, a cyano group, a substituted or unsubstituted amino group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms.

In *-NAr₁Ar₂, Ar₁ and Ar₂ may each independently be a substituted or unsubstituted aryl group of 6 to 30 ring-forming carbon atoms or a substituted or unsubstituted heteroaryl group of 2 to 30 ring-forming carbon atoms. For example, in one or more embodiments, at least one selected from among Ar₁ and Ar₂ may be a heteroaryl group including O or S as a ring-forming atom.

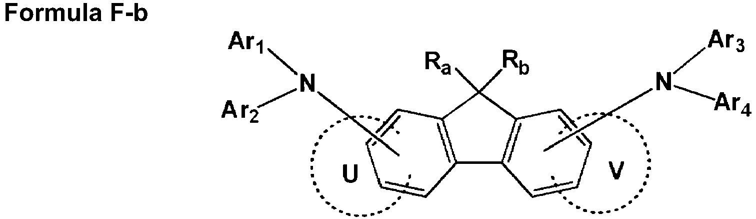

In Formula F-b, Rₐ and R_{b} may each independently be hydrogen, deuterium, a substituted or unsubstituted alkyl group of 1 to 20 carbon atoms, a substituted or unsubstituted alkenyl group of 2 to 20 carbon atoms, a substituted or unsubstituted aryl group of 6 to 30 ring-forming carbon atoms, or a substituted or unsubstituted heteroaryl group of 2 to 30 ring-forming carbon atoms, and/or may be combined with an adjacent group to form a ring. Ar₁ to Ar₄ may each independently be a substituted or unsubstituted aryl group of 6 to 30 ring-forming carbon atoms or a substituted or unsubstituted heteroaryl group of 2 to 30 ring-forming carbon atoms.

In Formula F-b, U and V may each independently be a substituted or unsubstituted hydrocarbon ring of 5 to 30 ring-forming carbon atoms or a substituted or unsubstituted heterocycle of 2 to 30 ring-forming carbon atoms. In one or more embodiments, at least one selected from among Ar₁ to Ar₄ may be a heteroaryl group including O or S as a ring-forming atom.

In Formula F-b, the number of rings represented by U and V may each independently be 0 or 1. For example, in Formula F-b, if (e.g., when) the number of U or V is 1, one ring forms a part of a fused ring at the designated part by U or V, and if (e.g., when) the number of U or V is 0, a ring is not present at the designated part by U or V. For example, if (e.g., when) the number of U is 0, and the number of V is 1, or if (e.g., when) the number of U is 1, and the number of V is 0, a fused ring having the fluorene core of Formula F-b may be a ring compound with four rings. In one or more embodiments, if (e.g., when) the number of both (e.g., simultaneously) U and V is 0, the fused ring of Formula F-b may be a ring compound with three rings. In one or more embodiments, if (e.g., when) the number of both (e.g., simultaneously) U and V is 1, a fused ring having the fluorene core of Formula F-b may be a ring compound with five rings.

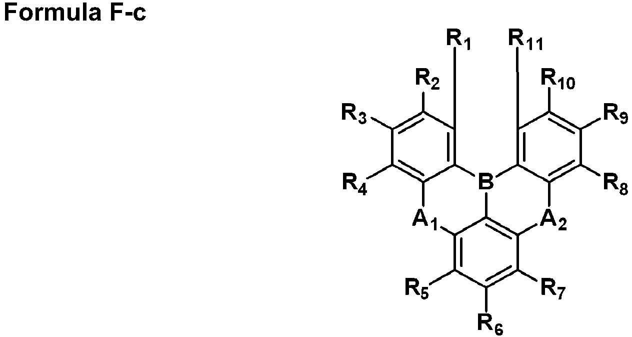

In Formula F-c, A₁ and A₂ may each independently be O, S, Se, or NRₘ, and Rₘ may be hydrogen, deuterium, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms. R₁ to R₁₁ may each independently be hydrogen, deuterium, a halogen, a cyano group, a substituted or unsubstituted amino group, a substituted or unsubstituted boron group, a substituted or unsubstituted oxy group, a substituted or unsubstituted thio group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and/or combined with an adjacent group to form a ring.

In one or more embodiments, in Formula F-c, A₁ and A₂ may each independently be combined with the substituents of an adjacent ring to form a fused ring. For example, if (e.g., when) A₁ and A₂ may each independently be NRₘ, in one or more embodiments, A₁ may be combined with R₄ or R₅ to form a ring. In one or more embodiments, A₂ may be combined with R₇ or R₈ to form a ring.

In one or more embodiments, the light emitting layer EML may include, as a suitable dopant material, one or more selected from among styryl derivatives (for example, 1,4-bis[2-(3-N- ethylcarbazolyl)vinyl]benzene (BCzVB), 4-(di-p-tolylamino)-4'-[(di-p-tolylamino)styryl]stilbene (DPAVB), N-(4-((E)-2-(6-((E)-4-(diphenylamino)styryl)naphthalen-2-yl)vinyl)phenyl)-N-phenylbenzenamine (N-BDAVBi), and 4,4'-bis[2-(4-(N,N-diphenylamino)phenyl)vinyl]biphenyl (DPAVBi)), perylene and derivatives thereof (for example, 2,5,8,11-tetra-t-butylperylene (TBP)), pyrene and derivatives thereof (for example, 1,1-dipyrene, 1,4-dipyrenylbenzene, and 1,4-bis(N,N-diphenylamino)pyrene), and/or the like.

In one or more embodiments, the light emitting layer EML may further include a suitable phosphorescence dopant material. For example, the phosphorescence dopant may use a metal complex including iridium (Ir), platinum (Pt), osmium (Os), gold (Au), titanium (Ti), zirconium (Zr), hafnium (Hf), europium (Eu), terbium (Tb), or thulium (Tm). For example, in one or more embodiments, iridium(III) bis(4,6-difluorophenylpyridinato-N,C2')picolinate (FIrpic), bis(2,4-difluorophenylpyridinato)-tetrakis(1-pyrazolyl)borate iridium(III) (FIr6), or platinum octaethyl porphyrin (PtOEP) may be used as the phosphorescence dopant. However, embodiments of the present disclosure are not limited thereto.

In one or more embodiments, the light emitting layer EML may include a quantum dot material (e.g., quantum dot). In one or more embodiments, the quantum dot includes a core, and the core of the quantum dot may be selected from among Group II-VI compounds, Group I-II-VI compounds, Group II-IV-VI compounds, Group I-II-IV-VI compounds, Group II-IV-V compounds, Group III-VI compounds, Group I-III-VI compounds, Group III-V compounds, Group III-II-V compounds, Group IV-VI compounds, Group IV elements, Group IV compounds, and combinations thereof.

The Group II-VI compound may be selected from the group consisting of: a binary compound selected from the group consisting of CdSe, CdTe, CdS, ZnS, ZnSe, ZnTe, ZnO, HgS, HgSe, HgTe, MgSe, MgS, and mixtures thereof; a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and mixtures thereof; a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, and mixtures thereof; and mixtures thereof.

The Group III-VI compound may include a binary compound such as In₂S₃ and/or In₂Se₃, a ternary compound such as InGaS₃ and/or InGaSe₃, or any combination thereof.

The Group I-III-VI compound may be selected from among a ternary compound selected from the group consisting of AgInS, AgInS₂, CulnS, CuInS₂, AgGaS₂, CuGaS₂, CuGaO₂, AgGaO₂, AgAlO₂, and mixtures thereof, and/or a quaternary compound such as AgInGaS₂ and/or CuInGaS₂.

The Group III-V compound may be selected from the group consisting of: a binary compound selected from the group consisting of GaN, GaP, GaAs, GaSb, AlN, AlP, AlAs, AlSb, InN, InP, InAs, InSb, and mixtures thereof; a ternary compound selected from the group consisting of GaNP, GaNAs, GaNSb, GaPAs, GaPSb, AINP, AlNAs, AlNSb, AlPAs, AlPSb, InGaP, InAlP, InNP, InNAs, InNSb, InPAs, InPSb, and mixtures thereof; a quaternary compound selected from the group consisting of GaAlNP, GaAlNAs, GaAlNSb, GaAlPAs, GaAlPSb, GaInNP, GaInNAs, GaInNSb, GaInPAs, GalnPSb, InAlNP, InAINAs, InAlNSb, InAIPAs, InAlPSb, and mixtures thereof; and mixtures thereof. In one or more embodiments, The Group III-V compound may further include Group II metals. For example, InZnP and/or the like may be selected as the Group III-II-V compound.

The Group IV-VI compound may be selected from the group consisting of: a binary compound selected from the group consisting of SnS, SnSe, SnTe, PbS, PbSe, PbTe, and mixtures thereof; a ternary compound selected from the group consisting of SnSeS, SnSeTe, SnSTe, PbSeS, PbSeTe, PbSTe, SnPbS, SnPbSe, SnPbTe, and mixtures thereof; a quaternary compound selected from the group consisting of SnPbSSe, SnPbSeTe, SnPbSTe, and mixtures thereof; and mixtures thereof. The Group IV element may be selected from the group consisting of Si, Ge, and a mixture thereof. The Group IV compound may be a binary compound selected from the group consisting of SiC, SiGe, and a mixture thereof.

Each element included in a multi-element compound such as the binary compound, the ternary compound, or the quaternary compound may exist in the particle at a substantially uniform concentration or a non-uniform concentration. For example, the chemical formula representing a semiconductor compound indicates the type (kind) of element included in the compound, and the element ratio in the compound may be different. For example, AgInGaS₂ may indicate AgInₓGa₁₋ₓS₂ (x is a real number between 0 and 1).

The quantum dot may have a single structure in which the concentration of each element contained in the quantum dot is substantially uniform, or a core-shell double structure. For example, a material contained in the core and a material contained in the shell may be different from each other.

The shell of the quantum dot may play the role of a protection layer for preventing or reducing the chemical deformation of the core to maintain semiconductor properties and/or a charging layer for imparting the quantum dot with electrophoretic properties. The shell may have a single layer or a multilayer. An interface between the core and the shell may have a concentration gradient in which the concentration of an element present in the shell decreases toward the core.

Examples of the shell of the quantum dot may include a metal oxide or non-metal oxide, a semiconductor compound, or combinations thereof. For example, the metal oxide or non-metal oxide may include a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, and/or NiO, or a ternary compound such as MgAl₂O₄, CoFe₂O₄, NiFe₂O₄, and/or CoMn₂O₄, but embodiments of the present disclosure are not limited thereto.

Also, the semiconductor compound suitable as a shell may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, and/or the like, but embodiments of the present disclosure are not limited thereto.

Each element included in the binary compound, the ternary compound, or other multi-element compound may exist in the particle at a substantially uniform or non-uniform concentration. For example, the chemical formula representing the multi-element compound indicates the type (kind) of element included in the compound, and the element ratio within the compound may be different.

The quantum dot may have a full width at half maximum (FWHM) of light emitting wavelength spectrum (e.g., emission spectrum) of about 45 nm or less, about 40 nm or less, or about 30 nm or less. Within this range, color purity or color reproducibility of the quantum dot may be improved. In addition, light emitted via such a quantum dot is emitted in all directions, and light view angle properties may be improved.

In addition, a shape of the quantum dot may be a generally used shapes in the art, without specific limitation. For example, the shape of spherical nanoparticle, pyramidal nanoparticle, multi-arm nanoparticle, cubic nanoparticle, nanotube, nanowire, nanofiber, nanoplate particle, and/or the like may be used.

Because the energy band gap of the quantum dots may be controlled or selected by controlling the size of the quantum dots and/or the element ratio in the quantum dot compound, light of one or more suitable wavelengths may be obtained from a quantum dot light emitting layer. Therefore, by using the quantum dots as described above (for example, using quantum dots of different sizes or having different element ratios in the quantum dot compound), a light emitting element that emits light of one or more suitable wavelengths may be achieved. For example, the size of the quantum dots and/or the element ratio in the quantum dot compound may be selected so that red color light, green color light, and/or blue color light is emitted. In addition, the quantum dots may be configured to emit white color light by combining light of one or more suitable colors.

In the light emitting element ED of one or more embodiments, as shown in FIG. 5 to FIG. 9, the electron transport region ETR may be provided on the light emitting layer EML. The electron transport region ETR may include at least one of the hole blocking layer HBL, the electron transport layer ETL, or the electron injection layer EIL. However, embodiments of the present disclosure are not limited thereto.

The electron transport region ETR may have a single layer formed using a single material, a single layer formed using multiple different materials, or a multilayer structure having multiple layers formed using multiple different materials.

For example, in one or more embodiments, the electron transport region ETR may have a single layer structure of the electron injection layer EIL or the electron transport layer ETL, or a single layer structure formed using an electron injection material and/or an electron transport material. In one or more embodiments, the electron transport region ETR may have a single layer structure formed using multiple different materials, or a structure stacked from the light emitting layer EML of electron transport layer ETL/electron injection layer EIL, or hole blocking layer HBL/electron transport layer ETL/electron injection layer EIL, without limitation. A thickness of the electron transport region ETR may be, for example, from about 1,000 Å to about 1,500 Å.

The electron transport region ETR may be formed using one or more suitable methods such as a vacuum deposition method, a spin coating method, a casting method, a Langmuir-Blodgett (LB) method, an inkjet printing method, a laser printing method, and/or a laser induced thermal imaging (LITI) method.

In one or more embodiments, the electron transport region ETR may include a compound represented by Formula ET-2.

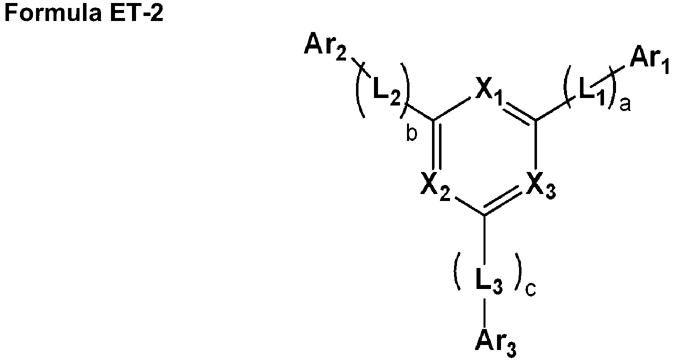

In Formula ET-2, at least one selected from among X₁ to X₃ may be N, and the remainder are CRₐ. Rₐ may be hydrogen, deuterium, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms. Ar₁ to Ar₃ may each independently be hydrogen, deuterium, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms.

In Formula ET-2, "a" to "c" may each independently be an integer of 0 to 10. In Formula ET-2, L₁ to L₃ may each independently be a direct linkage, a substituted or unsubstituted arylene group of 6 to 30 ring-forming carbon atoms, or a substituted or unsubstituted heteroarylene group of 2 to 30 ring-forming carbon atoms. In one or more embodiments, if (e.g., when) "a" to "c" are each an integer of 2 or greater, L₁ to L₃ each in plurality may each independently be a substituted or unsubstituted arylene group of 6 to 30 ring-forming carbon atoms or a substituted or unsubstituted heteroarylene group of 2 to 30 ring-forming carbon atoms.

In one or more embodiments, the electron transport region ETR may include an anthracene-based compound. However, embodiments of the present disclosure are not limited thereto, for example, in one or more embodiments, the electron transport region ETR may include, for example, one or more selected from among tris(8-hydroxyquinolinato)aluminium (Alq₃), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzimidazolyl-1-yl)phenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(biphenyl-4-yl)-4-phenyl-5-tert-butylphenyl-1,2,4-triazole (TAZ), 4-(naphthalen-1-yl)-3,5-diphenyl-4H-1,2,4-triazole (NTAZ), 2-(biphenyl-4-yl)-5-(4-tert-butylphenyl)-1,3,4-oxadiazole (tBu-PBD), bis(2-methyl-8-quinolinolato-N1,08)-(1,1'-biphenyl-4-olato)aluminium (BAlq), berylliumbis(benzoquinolin-10-olate (Bebq₂), 9,10-di(naphthalen-2-yl)anthracene (ADN), 1,3-bis[3,5-di(pyridin-3-yl)phenyl]benzene (BmPyPhB), and mixtures thereof, without limitation.

In one or more embodiments, the electron transport region ETR may include at least one selected from among Compounds ET1 to ET36.

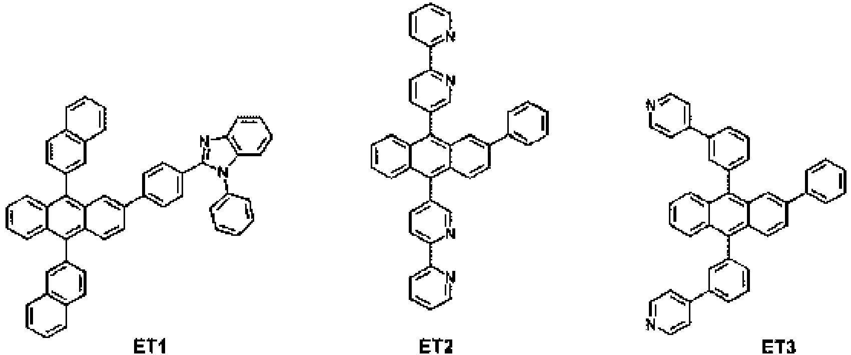

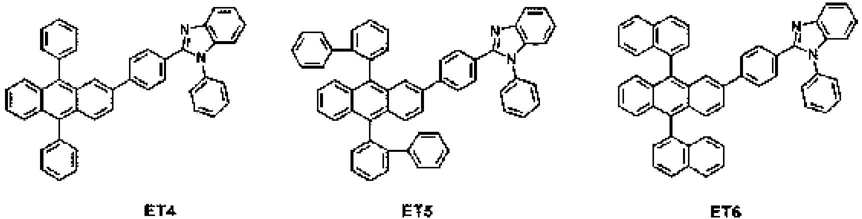

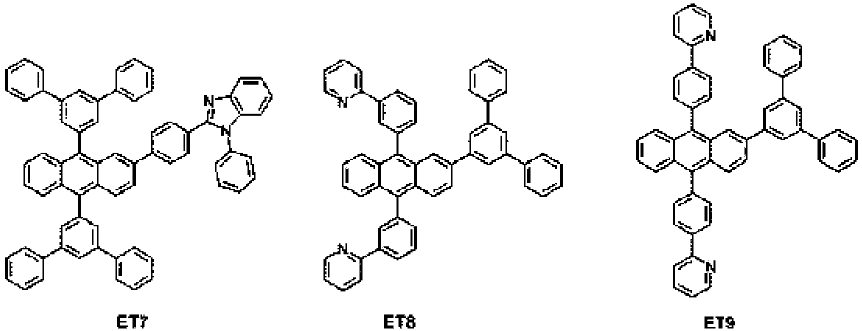

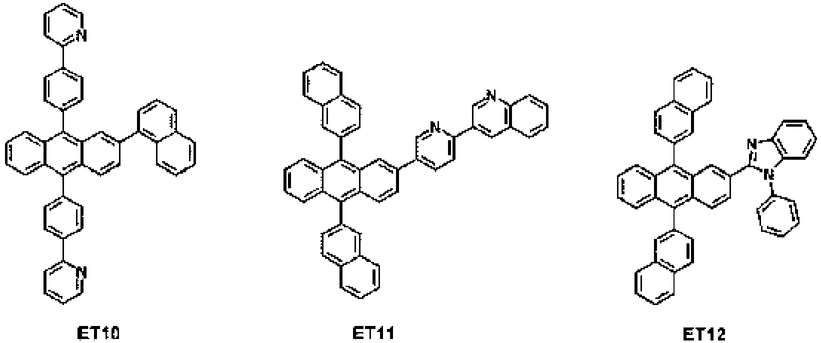

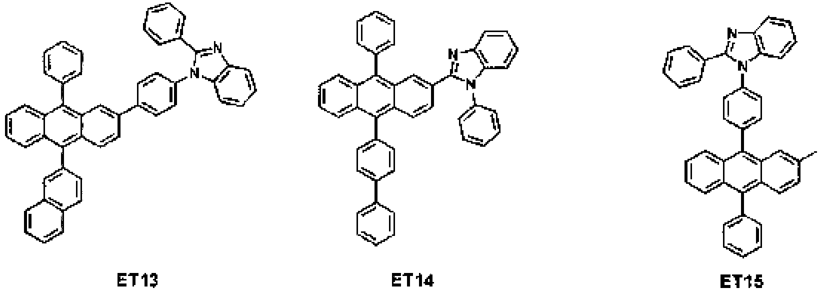

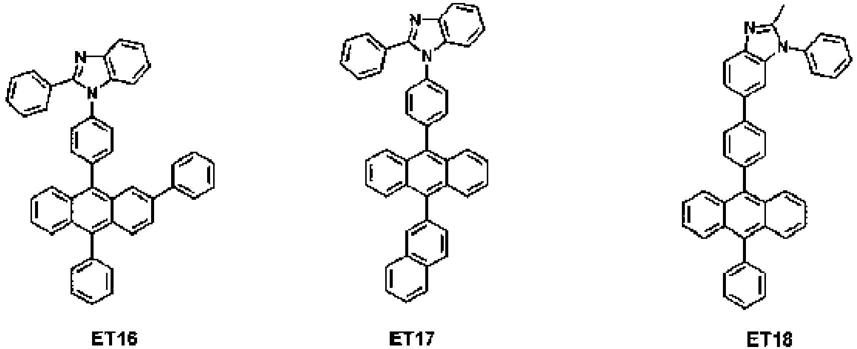

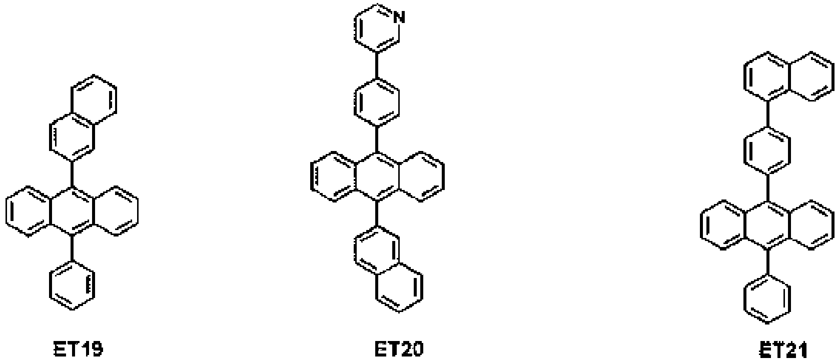

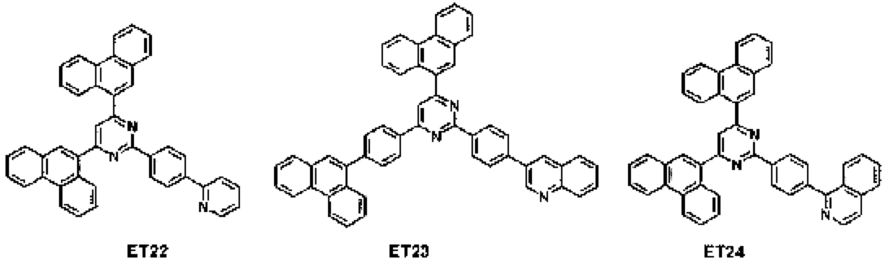

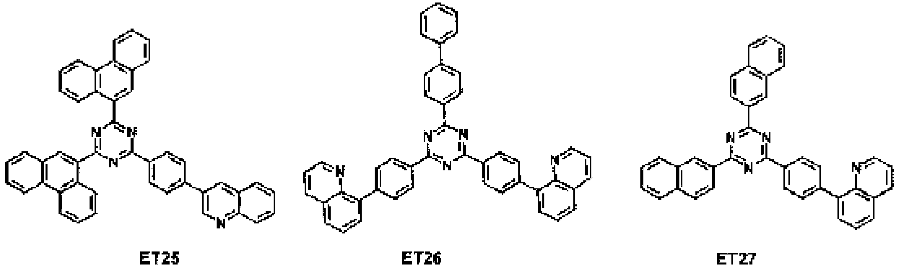

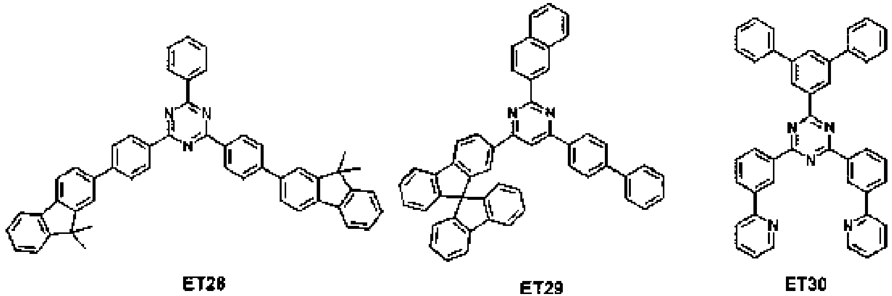

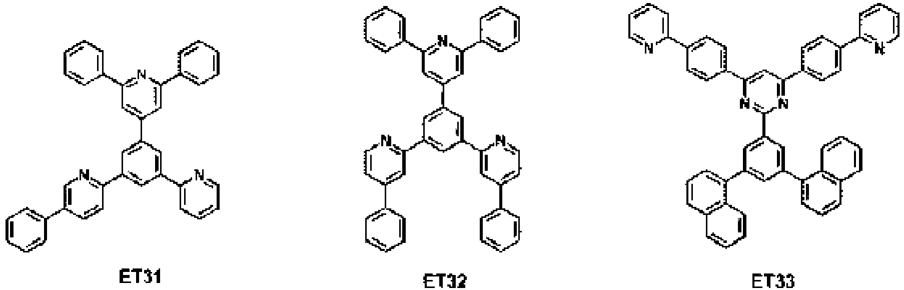

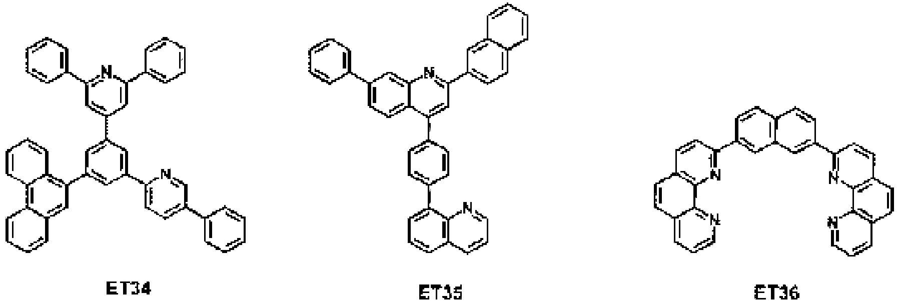

In one or more embodiments, the electron transport region ETR may include a metal halide such as LiF, NaCl, CsF, RbCl, Rbl, Cul, and/or KI, a lanthanide metal such as Yb, or a co-depositing material of the metal halide and the lanthanide metal. For example, in one or more embodiments, the electron transport region ETR may include KI:Yb, Rbl:Yb, LiF:Yb, and/or the like, as the co-depositing material. In one or more embodiments, the electron transport region ETR may use a metal oxide such as Li₂O and/or BaO, or lithium-8-hydroxyquinolinolate (Liq). However, embodiments of the present disclosure are not limited thereto. In one or more embodiments, the electron transport region ETR also may be formed using a mixture material of an electron transport material and an insulating organo metal salt. The organo metal salt may be a material having an energy band gap of about 4 eV or more. For example, the organo metal salt may include, for example, one or more selected from among metal acetates, metal benzoates, metal acetoacetates, metal acetylacetonates, and metal stearates.

In one or more embodiments, the electron transport region ETR may include at least one of 2,9-dimethyl-4,7-diphenyl-1,10-phenanthroline (BCP), diphenyl(4-(triphenylsilyl)phenyl)phosphine oxide (TSPO1), or 4,7-diphenyl-1,10-phenanthroline (Bphen) in addition to one or more of the aforementioned materials. However, embodiments of the disclosure are not limited thereto.

The electron transport region ETR may include one or more of the compounds of the electron transport region in at least one selected from among the electron injection layer EIL, the electron transport layer ETL, and the hole blocking layer HBL.

If (e.g., when) the electron transport region ETR includes the electron transport layer ETL, a thickness of the electron transport layer ETL may be from about 100 Å to about 1,000 Å, for example, from about 150 Å to about 500 Å. If (e.g., when) the thickness of the electron transport layer ETL satisfies the above-described range, satisfactory electron transport properties may be obtained without substantial increase in driving voltage. If (e.g., when) the electron transport region ETR includes the electron injection layer EIL, a thickness of the electron injection layer EIL may be from about 1 Å to about 100 Å, for example, from about 3 Å to about 90 Å. If (e.g., when) the thickness of the electron injection layer EIL satisfies the above-described range, satisfactory electron injection properties may be obtained without inducing substantial increase in driving voltage.

The second electrode EL2 may be provided on the electron transport region ETR. The second electrode EL2 may be a common electrode. The second electrode EL2 may be a cathode or an anode, but embodiments of the present disclosure are not limited thereto. For example, if (e.g., when) the first electrode EL1 is an anode, the second electrode EL2 may be a cathode, and if (e.g., when) the first electrode EL1 is a cathode, the second electrode EL2 may be an anode.

The second electrode EL2 may be a transmissive electrode, a transflective electrode, or a reflective electrode. If (e.g., when) the second electrode EL2 is a transmissive electrode, the second electrode EL2 may include a transparent metal oxide, for example, indium tin oxide (ITO), indium zinc oxide (IZO), zinc oxide (ZnO), indium tin zinc oxide (ITZO), and/or the like.

If (e.g., when) the second electrode EL2 is a transflective electrode or a reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, or a compound or a mixture thereof (for example, AgMg, AgYb, or MgYb). In one or more embodiments, the second electrode EL2 may have a multilayered structure including a reflective layer or a transflective layer formed using one or more of the above-described materials and a transparent conductive layer formed using ITO, IZO, ZnO, ITZO, and/or the like. For example, in one or more embodiments, the second electrode EL2 may include one of the aforementioned metal materials, a combination of two or more metal materials selected from among the aforementioned metal materials, or an oxide of the aforementioned metal materials.

In one or more embodiments, the second electrode EL2 may be connected with an auxiliary electrode. If (e.g., when) the second electrode EL2 is connected with the auxiliary electrode, the resistance of the second electrode EL2 may decrease.

On the second electrode EL2 in the light emitting element ED of one or more embodiments, the capping layer CPL may be further arranged. The capping layer CPL may include a multilayer or a single layer.

In one or more embodiments, the capping layer CPL may be an organic layer or an inorganic layer. For example, if (e.g., when) the capping layer CPL includes an inorganic material, the inorganic material may include an alkali metal compound such as LiF, an alkaline earth metal compound such as MgF₂, SiON, SiNₓ, SiO_{y}, and/or the like.

In one or more embodiments, if (e.g., when) the capping layer CPL includes an organic material, the organic material may include α-NPD, NPB, TPD, m-MTDATA, Alq₃, CuPc, N4,N4,N4',N4'-tetra(biphenyl-4-yl) biphenyl-4,4'-diamine (TPD15), 4,4',4"-tris(carbazole-9-yl) triphenylamine (TCTA), and/or the like, or may include an epoxy resin and/or an acrylate such as methacrylate. In one or more embodiments, the capping layer CPL may include at least one selected from among Compounds P1 to P5, but embodiments of the present disclosure are not limited thereto.

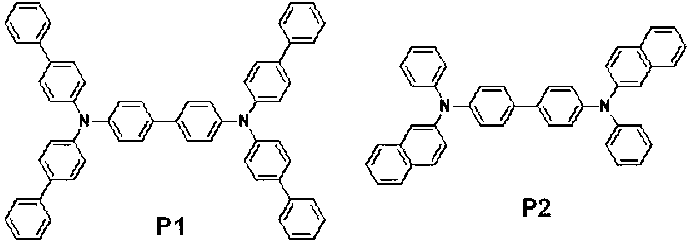

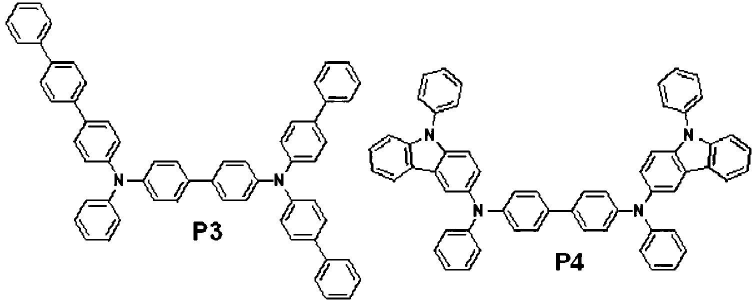

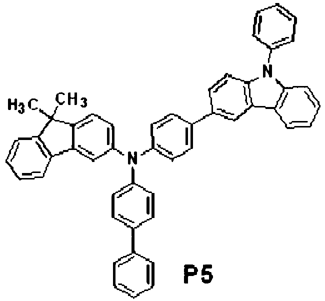

The refractive index of the capping layer CPL may be about 1.6 or more. for example, the refractive index of the capping layer CPL with respect to light in a wavelength range of about 550 nm to about 660 nm may be about 1.6 or more.

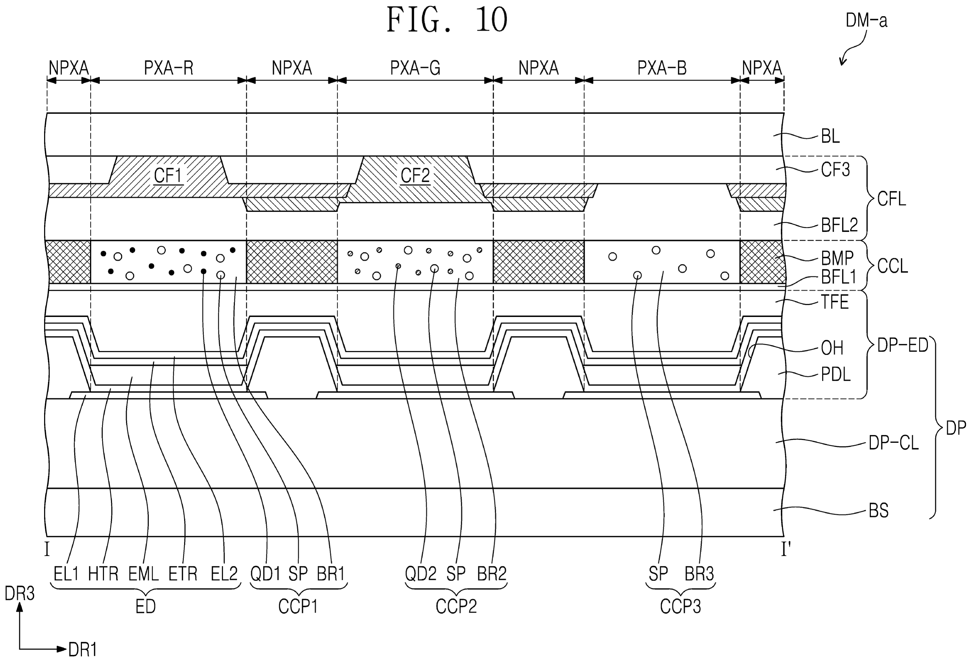

FIG. 10 to FIG. 13 are cross-sectional views each illustrating a display module according to one or more embodiments of the present disclosure. In the explanation on the display modules according to one or more embodiments referring to FIG. 10 to FIG. 13, the overlapping parts with the explanation of FIG. 1 to FIG. 9 will not be explained again, and the different features will be explained chiefly.

Referring to FIG. 10, a display module DM-a according to one or more embodiments may include a display panel DP including a display element layer DP-ED, a light control layer CCL arranged on the display panel DP, and a color filter layer CFL. In one or more embodiments shown in FIG. 10, the display panel DP may include a base layer BS, a circuit layer DP-CL provided on the base layer BS and the display element layer DP-ED, and the display element layer DP-ED may include a light emitting element ED.

The light emitting element ED may include a first electrode EL1, a hole transport region HTR arranged on the first electrode EL1, a light emitting layer EML arranged on the hole transport region HTR, an electron transport region ETR arranged on the light emitting layer EML, and a second electrode EL2 arranged on the electron transport region ETR. The same structure of each of the light emitting elements of FIG. 5 to FIG. 9 may be equally applied to the structure of the light emitting element ED shown in FIG. 10. The light emitting element ED illustrated in FIG. 10 includes the polycyclic compound of one or more embodiments. Accordingly, the light emitting element ED may exhibit high efficiency and long-life characteristics. In addition, the light emitting element ED of one or more embodiments may exhibit high light efficiency and long-life characteristics in a blue light emitting range.

Referring to FIG. 10, the light emitting layer EML may be arranged in an opening part OH defined in a pixel definition layer PDL. For example, the light emitting layer EML divided by the pixel definition layer PDL and correspondingly provided to each of light emitting areas PXA-R, PXA-G, and PXA-B may be to emit light in substantially the same wavelength range. In the display module DM-a according to one or more embodiments, the light emitting layer EML may be to emit blue color light. In one or more embodiments, the light emitting layer EML may be provided as a common layer for all light emitting areas PXA-R, PXA-G, and PXA-B.

The light control layer CCL may be arranged on the display panel DP. Although the light control layer CCL is shown as being arranged above the display element layer DP-ED in FIG. 10, embodiments of the disclosure are not limited thereto, for example, the light control layer CCL may be arranged below the display element layer DP-ED. The light control layer CCL may include a light converter. The light converter may be a quantum dot or a phosphor. The light converter may transform the wavelength of light provided and then emit the wavelength-transformed light. For example, the light control layer CCL may be a layer including a quantum dot or a layer including a phosphor.

The light control layer CCL may include multiple light control parts CCP1, CCP2, and CCP3. The light control parts CCP1, CCP2, and CCP3 may be separated from one another.

Referring to FIG. 10, a partition pattern BMP may be arranged between the separated light control parts CCP1, CCP2, and CCP3, but embodiments of the present disclosure are not limited thereto. In FIG. 10, the partition pattern BMP is shown not to be overlapped with the light control parts CCP1, CCP2, and CCP3, but, in one or more embodiments, at least a portion of the edge of each of the light control parts CCP1, CCP2, and CCP3 may be overlapped with the partition pattern BMP.

In one or more embodiments, the light control layer CCL may include a first light control part CCP1 including a first quantum dot QD1 converting first color light provided from the light emitting element ED into second color light, a second light control part CCP2 including a second quantum dot QD2 converting the first color light into third color light, and a third light control part CCP3 transmitting the first color light.

In one or more embodiments, the first light control part CCP1 may provide red color light, which is the second color light, and the second light control part CCP2 may provide green color light, which is the third color light. The third light control part CCP3 may be to transmit and provide blue color light, which is the first color light provided from the light emitting element ED. For example, the first quantum dot QD1 may be a red quantum dot to emit red color light, and the second quantum dot QD2 may be a green quantum dot to emit green color light. On the quantum dots QD1 and QD2, the same content on quantum dots described above may be applied.

In one or more embodiments, the light control layer CCL may further include a scatterer SP. The first light control part CCP1 may include the first quantum dot QD1 and the scatterer SP, the second light control part CCP2 may include the second quantum dot QD2 and the scatterer SP, and the third light control part CCP3 may not include (e.g., may exclude) a (e.g., any) quantum dot but include the scatterer SP.

The scatterer SP may be an inorganic particle. For example, the scatterer SP may include at least one selected from among TiO₂, ZnO, Al₂O₃, SiO₂, and hollow silica. The scatterer SP may include at least one selected from among TiO₂, ZnO, Al₂O₃, SiO₂, and hollow silica or may be a mixture of two or more materials selected from among TiO₂, ZnO, Al₂O₃, SiO₂, and hollow silica.

The first light control part CCP1, the second light control part CCP2, and the third light control part CCP3 may respectively include base resins BR1, BR2, and BR3 dispersing the quantum dots QD1 and QD2 and the scatterer SP, accordingly. In one or more embodiments, the first light control part CCP1 may include the first quantum dot QD1 and the scatterer SP dispersed in a first base resin BR1, the second light control part CCP2 may include the second quantum dot QD2 and the scatterer SP dispersed in a second base resin BR2, and the third light control part CCP3 may include the scatterer particle SP dispersed in a third base resin BR3.

The base resins BR1, BR2, and BR3 are mediums in which the quantum dots QD1 and QD2 and the scatterer SP are dispersed accordingly and may be composed of one or more suitable resin compositions which may be generally referred to as a binder. For example, the base resins BR1, BR2, and BR3 may be each independently selected from acrylic resins, urethane-based resins, silicone-based resins, epoxy-based resins, and/or the like. The base resins BR1, BR2, and BR3 may be each a transparent resin. In one or more embodiments, the first base resin BR1, the second base resin BR2, and the third base resin BR3 may be the same or different from each other.

The light control layer CCL may include a barrier layer BFL1. The barrier layer BFL1 may play the role of blocking the penetration of moisture and/or oxygen (hereinafter, will be referred to as "humidity/oxygen"). The barrier layer BFL1 may be arranged on the light control parts CCP1, CCP2, and CCP3 and may block the exposure of the light control parts CCP1, CCP2, and CCP3 to humidity/oxygen. The barrier layer BFL1 may cover the light control parts CCP1, CCP2, and CCP3. In one or more embodiments, the color filter layer CFL, which will be explained later, may include a barrier layer BFL2 arranged on the light control parts CCP1, CCP2, and CCP3.

The barrier layers BFL1 and BFL2 may each include at least one inorganic layer. For example, in one or more embodiments, the barrier layers BFL1 and BFL2 may be formed by including an inorganic material. For example, the barrier layers BFL1 and BFL2 may each independently be formed by including silicon nitride, aluminium nitride, zirconium nitride, titanium nitride, hafnium nitride, tantalum nitride, silicon oxide, aluminium oxide, titanium oxide, tin oxide, cerium oxide, and/or silicon oxynitride, or a metal thin film securing light transmittance. The barrier layers BFL1 and BFL2 may each independently further include an organic film. The barrier layers BFL1 and BFL2 may be composed of a single layer of multiple layers.

In the display module DM-a according to one or more embodiments, the color filter layer CFL may be arranged on the light control layer CCL. For example, in one or more embodiments, the color filter layer CFL may be arranged directly on the light control layer CCL. In these embodiments, the barrier layer BFL2 may not be provided.

The color filter layer CFL may include filters CF1, CF2, and CF3. The color filter layer CFL may include a first filter CF1 transmitting the second color light, a second filter CF2 transmitting the third color light, and a third filter CF3 transmitting the first color light. For example, in one or more embodiments, the first filter CF1 may be a red filter, the second filter CF2 may be a green filter, and the third filter CF3 may be a blue filter. Each of the filters CF1, CF2, and CF3 may include a polymer photosensitive resin and a pigment and/or a dye. For example, in one or more embodiments, the first filter CF1 may include a red pigment and/or a red dye, the second filter CF2 may include a green pigment and/or a green dye, and the third filter CF3 may include a blue pigment and/or a blue dye.

However, embodiments of the present disclosure are not limited thereto, for example, in one or more embodiments, the third filter CF3 may not include (e.g., may exclude) any pigment or any dye. The third filter CF3 may include a polymer photosensitive resin and not include a pigment or a dye. The third filter CF3 may be transparent. In one or more embodiments, the third filter CF3 may be formed using a transparent photosensitive resin.

In addition, in one or more embodiments, the first filter CF1 and the second filter CF2 may be yellow filters. The first filter CF1 and the second filter CF2 may be provided in one body without distinction.

In one or more embodiments, the color filter layer CFL may further include a light blocking part. The light blocking part may be a black matrix. The light blocking part may be formed by including an organic light blocking material and/or an inorganic light blocking material, each including a black pigment and/or a black dye. The light blocking part may prevent or reduce light leakage phenomenon and divide the boundaries among adjacent filters CF1, CF2, and CF3. In addition, in one or more embodiments, the light blocking part may be formed as a blue filter.

The first to third filters CF1, CF2, and CF3 may be arranged to correspond to the first light emitting area PXA-R, the second light emitting area PXA-G, and the third light emitting area PXA-B, respectively.

On the color filter layer CFL, a base substrate BL may be arranged. The base substrate BL may be a member providing a base surface on which the color filter layer CFL, the light control layer CCL, and/or the like are arranged. The base substrate BL may be a glass substrate, a metal substrate, a plastic substrate, and/or the like. However, embodiments of the present disclosure are not limited thereto, and the base substrate BL may be an inorganic layer, an organic layer, or a composite material layer. In one or more embodiments, the base substrate BL may not be provided.

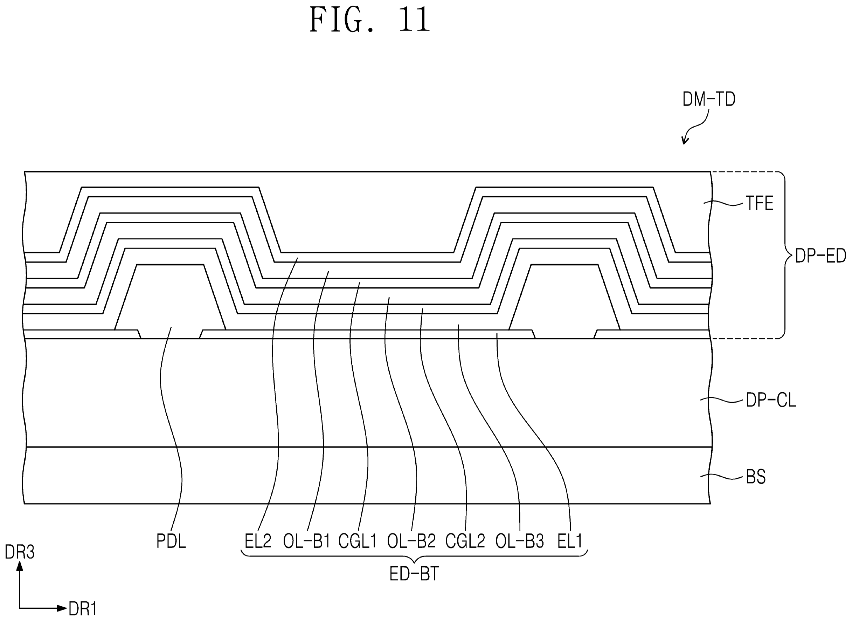

FIG. 11 is a cross-sectional view showing a portion of a display module according to one or more embodiments of the present disclosure. In a display module DM-TD according to one or more embodiments, a light emitting element ED-BT may include a plurality of light emitting structures OL-B1, OL-B2, and OL-B3. At least one selected from among the plurality of light emitting structures OL-B1, OL-B2, and OL-B3 includes the polycyclic compound of one or more embodiments. Accordingly, the light emitting element ED-BT may exhibit high efficiency and long-life characteristics. In addition, the light emitting element ED-BT of one or more embodiments may exhibit high light efficiency and long-life characteristics in a blue light emitting range.

The light emitting element ED-BT may include oppositely arranged first electrode EL1 and second electrode EL2 and the plurality of light emitting structures OL-B1, OL-B2, and OL-B3 stacked in order in a thickness direction and provided between the first electrode EL1 and the second electrode EL2. Each of the light emitting structures OL-B1, OL-B2, and OL-B3 may include a light emitting layer EML (FIG. 5), and a hole transport region HTR and an electron transport region ETR, arranged with the light emitting layer EML (FIG. 5) therebetween. For example, the light emitting element ED-BT included in the display module DM-TD according to one or more embodiments may be a light emitting element of a tandem structure including a plurality of light emitting layers.

In one or more embodiments shown in FIG. 11, light emitted from the light emitting structures OL-B1, OL-B2, and OL-B3 may be all blue color light. However, embodiments of the present disclosure are not limited thereto, for example, in one or more embodiments, the wavelength ranges of light emitted from the light emitting structures OL-B1, OL-B2, and OL-B3 may be different from one another. For example, in one or more embodiments, the light emitting element ED-BT including the plurality of light emitting structures OL-B1, OL-B2, and OL-B3 emitting light in different wavelength ranges may be to emit white color light.

Between neighboring light emitting structures OL-B1, OL-B2, and OL-B3, charge generating layers CGL1 and CGL2 may be respectively arranged. In one or more embodiments shown in FIG. 11, the charge generating layers CGL1 and CGL2 may include a first charge generating layer CGL1 arranged between the first light emitting structure OL-B1 and the second light emitting structure OL-B2, and a second charge generating layer CGL2 arranged between the second light emitting structure OL-B2 and the third light emitting structure OL-B3. The first and second charge generating layers CGL1 and CGL2 may each independently include a p-type (kind) charge generating layer and/or an n-type (kind) charge generating layer.

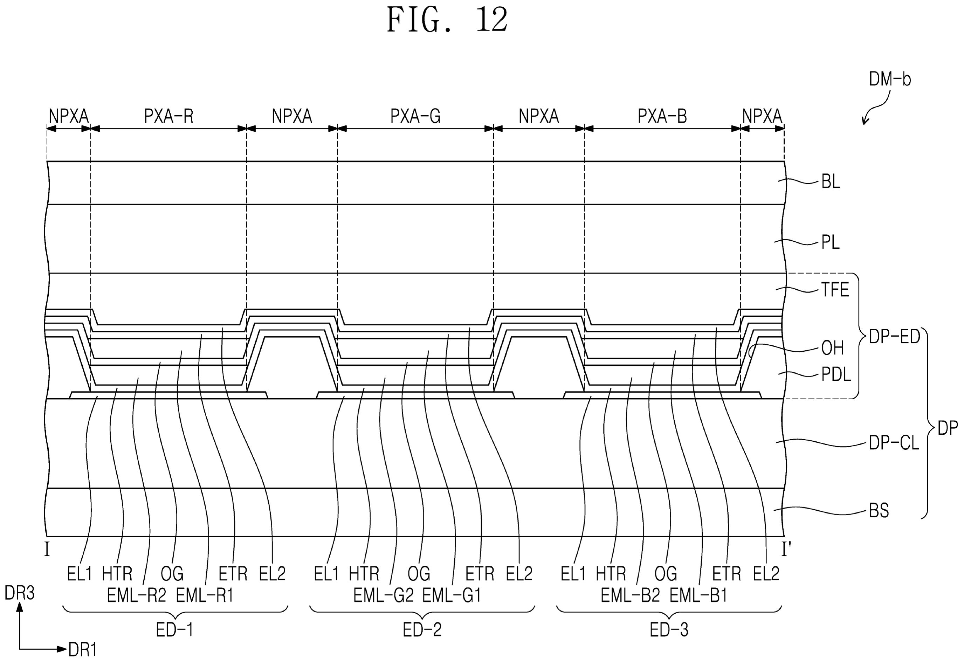

Referring to FIG. 12, a display module DM-b according to one or more embodiments may include light emitting elements ED-1, ED-2, and ED-3, in each of which two light emitting layers are stacked. At least one selected from among the light emitting elements ED-1, ED-2, and ED-3 includes the polycyclic compound of one or more embodiments. Accordingly, the light emitting elements ED-1, ED-2, and ED-3 may exhibit high efficiency and long-life characteristics. In addition, the display module DM-b of one or more embodiments may exhibit high light efficiency and long-life characteristics in a blue light emission range.

Compared to the display module DM of one or more embodiments, shown in FIG. 3 and FIG. 4, embodiments shown in FIG. 12 are different in that the first to third light emitting elements ED-1, ED-2, and ED-3 each include two light emitting layers stacked in a thickness direction. In each of the first to third light emitting elements ED-1, ED-2, and ED-3, two light emitting layers may be to emit light in substantially the same wavelength range.

According to one or more embodiments, the first light emitting element ED-1 may include a first red light emitting layer EML-R1 and a second red light emitting layer EML-R2. The second light emitting element ED-2 may include a first green light emitting layer EML-G1 and a second green light emitting layer EML-G2. In addition, the third light emitting element ED-3 may include a first blue light emitting layer EML-B1 and a second blue light emitting layer EML-B2. A light emitting auxiliary part OG may be arranged between the first red light emitting layer EML-R1 and the second red light emitting layer EML-R2, between the first green light emitting layer EML-G1 and the second green light emitting layer EML-G2, and between the first blue light emitting layer EML-B1 and the second blue light emitting layer EML-B2. In this regard, at least one of the first blue light emitting layer EML-B1 or the second blue light emitting layer EML-B2 may include the polycyclic compound of embodiments.

The light emitting auxiliary part OG may include a single layer or a multilayer. The light emitting auxiliary part OG may include a charge generating layer. For example, the light emitting auxiliary part OG may include an electron transport region, a charge generating layer, and a hole transport region stacked in order. The light emitting auxiliary part OG may be provided as a common layer across all the first to third light emitting elements ED-1, ED-2, and ED-3. However, embodiments of the present disclosure are not limited thereto, for example, in one or more embodiments, the light emitting auxiliary part OG may be patterned and provided in an opening part OH defined in a pixel definition layer PDL.

The first red light emitting layer EML-R1, the first green light emitting layer EML-G1, and the first blue light emitting layer EML-B1 may each be arranged between the light emitting auxiliary part OG and the electron transport region ETR. The second red light emitting layer EML-R2, the second green light emitting layer EML-G2 and the second blue light emitting layer EML-B2 may each be arranged between the hole transport region HTR and the light emitting auxiliary part OG.

For example, in one or more embodiments, the first light emitting element ED-1 may include a first electrode EL1, a hole transport region HTR, the second red light emitting layer EML-R2, the light emitting auxiliary part OG, the first red light emitting layer EML-R1, an electron transport region ETR, and a second electrode EL2, stacked in order. The second light emitting element ED-2 may include a first electrode EL1, the hole transport region HTR, the second green light emitting layer EML-G2, the light emitting auxiliary part OG, the first green light emitting layer EML-G1, the electron transport region ETR, and the second electrode EL2, stacked in order. The third light emitting element ED-3 may include a first electrode EL1, the hole transport region HTR, the second blue light emitting layer EML-B2, the light emitting auxiliary part OG, the first blue light emitting layer EML-B1, the electron transport region ETR, and the second electrode EL2, stacked in order.

An optical auxiliary layer PL may be arranged on a display element layer DP-ED. The optical auxiliary layer PL may include a polarization layer. The optical auxiliary layer PL may be arranged on a display panel DP and may control reflected light at the display panel DP by external light. In one or more embodiments, the optical auxiliary layer PL may not be provided in the display module DM-b.

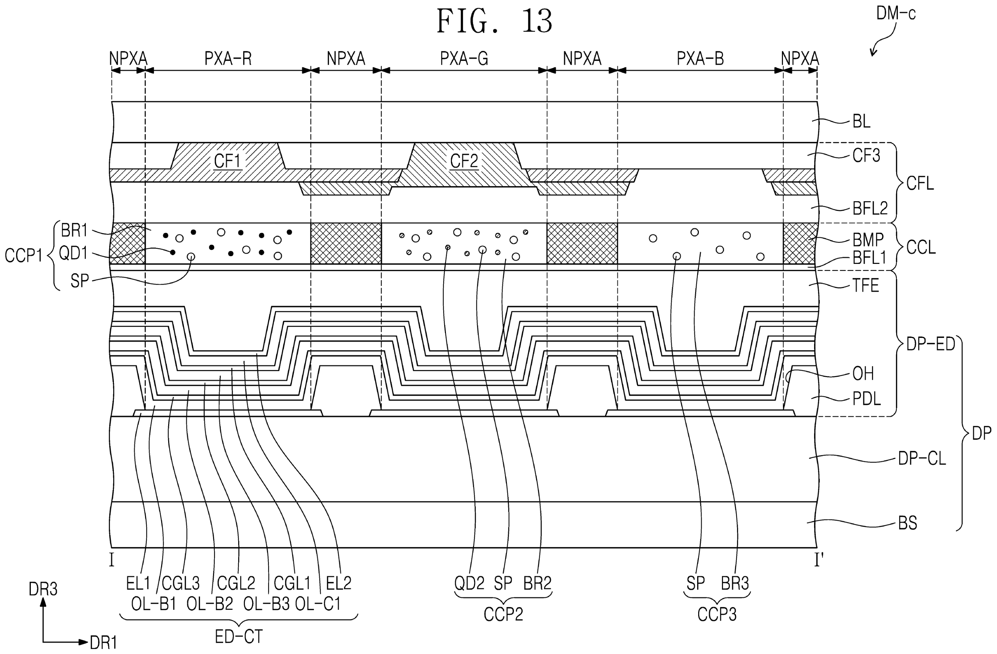

Different from FIG. 11 and FIG. 12, a display module DM-c according to one or more embodiments, shown in FIG. 13, is shown to include four light emitting structures OL-B1, OL-B2, OL-B3, and OL-C1. A light emitting element ED-CT may include oppositely arranged first electrode EL1 and second electrode EL2, and first to fourth light emitting structures OL-B1, OL-B2, OL-B3, and OL-C1 stacked in order in a thickness direction between the first electrode EL1 and the second electrode EL2. At least one selected from among the first to fourth light emitting structures OL-B1, OL-B2, OL-B3, and OL-C1 includes the polycyclic compound of one or more embodiments. Accordingly, the light emitting element ED-CT may exhibit high efficiency and long-life characteristics. In addition, the light emitting element ED-CT of one or more embodiments may exhibit high light efficiency and long-life characteristics in a blue light emitting range.

Between neighboring first to fourth light emitting structures OL-B1, OL-B2, OL-B3, and OL-C1, charge generating layers CGL3, CGL2, and CGL1 may be respectively arranged. In one or more embodiments, among the four light emitting structures, the first to third light emitting structures OL-B1, OL-B2, and OL-B3 emit blue color light, and the fourth light emitting structure OL-C1 may be to emit green color light. However, embodiments of the present disclosure are not limited thereto, for example, in one or more embodiments, the first to fourth light emitting structures OL-B1, OL-B2, OL-B3, and OL-C1 may be to emit different wavelengths of light. The charge generating layers CGL3, CGL2, and CGL1 respectively arranged between neighboring light emitting structures OL-B1, OL-B2, OL-B3, and OL-C1 may each include a p-type (kind) charge generating layer and/or an n-type (kind) charge generating layer.

In one or more embodiments, an electronic device may include a display device including a plurality of light emitting elements, and a control part for controlling the display device. In one or more embodiments, in the electronic device, at least one selected from among the plurality of light emitting elements may include the polycyclic compound of one or more embodiments described above in a light emitting layer.

The electronic device of one or more embodiments may be a device activated according to electrical signals. The electronic device of one or more embodiments may include one or more display devices including the display modules according to one or more embodiments described with reference to FIG. 3, FIGS. 10 to 13, and/or the like. For example, the electronic device may include large-size display devices such as televisions, monitors, and outside billboards, and/or medium- and small-size display devices such as personal computers, laptop computers, personal digital terminals, display devices for automobiles, game consoles, portable electronic devices, and cameras.

The electronic device of one or more embodiments may include a display module including the polycyclic compound of one or more embodiments, and may exhibit high efficiency and long-life characteristics. The electronic device of one or more embodiments may have improved display efficiency and display lifespan and may exhibit excellent or suitable display quality.

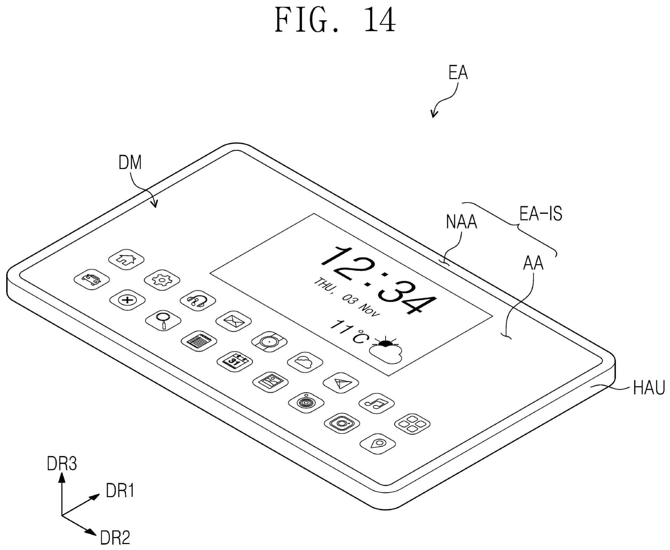

FIG. 14 illustrates a tablet terminal as an embodiment of an electronic device EA. The electronic device EA of one or more embodiments may include a display module DM according to one or more embodiments. For example, electronic modules, a camera module, a power module, and/or the like, mounted on a main board may be arranged in a bracket/housing HAU together with the display module DM to configure the tablet terminal.

The electronic device EA of one or more embodiments illustrated in FIG. 14 includes the display module of one or more embodiments described with reference to FIG. 3, FIGS. 10 to 13, and/or the like.

In one or more embodiments, the electronic device EA including the display module DM may have a flat display surface, as shown in FIG. 14, but embodiments of the present disclosure are not limited thereto. In one or more embodiments, the electronic device EA may also include a curved display surface or a three-dimensional display surface. For example, the three-dimensional display surface may include a plurality of display areas pointing in different directions and may also include a bent display surface. The electronic device EA according to these embodiments may be a flexible electronic device. The flexible electronic device may be a foldable electronic device that is foldable.

As shown in FIG. 14, a display surface EA-IS may include an active area AA on which an image is displayed and a bezel area NAA adjacent to the active area AA. The bezel area NAA is an area where an image is not displayed. FIG. 14 illustrates icon images as embodiments of the image. The active area AA may be referred to as a display area of the display module DM, and the bezel area NAA may be referred to as a non-display area of the display module DM.

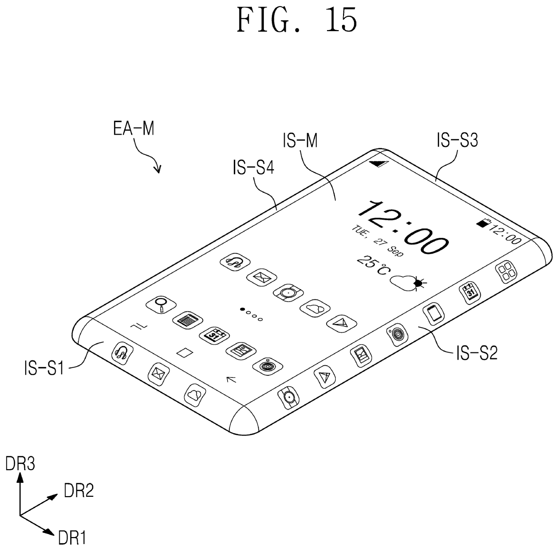

FIG. 15 illustrates a portable terminal as an embodiment of an electronic device EA-M according to one or more embodiments. Referring to FIG. 15, the electronic device EA-M according to one or more embodiments may include a plurality of display surfaces. The electronic device EA-M of one or more embodiments may include display surfaces IS-M, IS-S1, IS-S2, IS-S3, and IS-S4, having different main display directions.

In one or more embodiments, the electronic device EA-M may be a three-dimensional display device including an upper display surface IS-M and a plurality of side display surfaces IS-S1, IS-S2, IS-S3, and IS-S4. Each of the plurality of side display surfaces IS-S1, IS-S2, IS-S3, and IS-S4 may be a display surface extending from one side of the upper display surface IS-M. In one or more embodiments, the electronic device EA-M may include a main display surface that mainly provides images in one direction and a plurality of sub-display surfaces that provide images in a direction different from the one direction. In an embodiment of the electronic device EA-M illustrated in FIG. 15, the main display surface may be the upper display surface IS-M, and the sub-display surfaces may be the side display surfaces IS-S1, IS-S2, IS-S3, and IS-S4.

The side display surfaces IS-S1, IS-S2, IS-S3, and IS-S4 may each have a display surface that is not parallel to the upper display surface IS-M. The plurality of side display surfaces IS-S1, IS-S2, IS-S3, and IS-S4 may be display areas that are each bent and extended from one side of the upper display surface IS-M, and for example, the plurality of side display surfaces IS-S1, IS-S2, IS-S3, and IS-S4 may be bending display areas.

The electronic device EA-M illustrated in FIG. 15 may include the display modules according to one or more embodiments described with reference to FIG. 3, FIGS. 10 to 13, and/or the like.

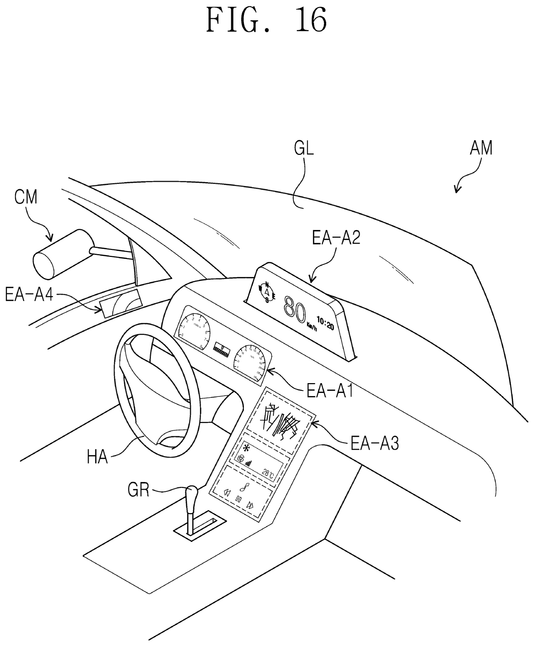

FIG. 16 is a diagram showing a vehicle AM in which first to fourth electronic devices EA-A1, EA-A2, EA-A3, and EA-A4 are arranged. At least one selected from among the first to fourth electronic devices EA-A1, EA-A2, EA-A3, and EA-A4 includes the display module of embodiments described with reference to FIG. 3 and FIGS. 10 to 13.

In FIG. 16, a car is illustrated as a vehicle AM, but this is an example, and the first to fourth electronic devices EA-A1, EA-A2, EA-A3, and EA-A4 may be arranged on other transportation apparatuses such as a bicycle, a motorcycle, a train, a ship, and an airplane.

At least one selected from among the first to fourth electronic devices EA-A1, EA-A2, EA-A3, and EA-A4 may include the light emitting element ED of embodiments described with reference to FIGS. 5 to 9. At least one selected from among the first to fourth electronic devices EA-A1, EA-A2, EA-A3, and EA-A4 includes the polycyclic compound of one or more embodiments. Accordingly, the first to fourth electronic devices EA-A1, EA-A2, EA-A3, and EA-A4 including the polycyclic compound of one or more embodiments may have improved display efficiency and display lifespan. In addition, the first to fourth electronic devices EA-A1, EA-A2, EA-A3, and EA-A4 including the polycyclic compound of one or more embodiments may exhibit excellent or suitable display quality.

Referring to FIG. 16, the vehicle AM may include a steering wheel HA and a gear GR for motion control and may include a front window GL arranged in the front of the vehicle AM (e.g., toward a driver).

The first electronic device EA-A1 may be a digital cluster that displays first information of the vehicle AM. The first information may include a first scale indicating the driving speed of the vehicle AM, a second scale indicating the engine revolutions per minute (RPM), and an image indicating the fuel condition. The first scale and the second scale may be displayed as digital images. In one or more embodiments illustrated in FIG. 16, the first electronic device EA-A1 may be arranged in a first area overlapping the steering wheel HA. However, embodiments of the present disclosure are not limited thereto, and the first electronic device EA-A1 may be arranged on the entire dashboard or may be separately arranged in a portion opposite to (e.g., facing) a driver seat and a portion opposite to (e.g., facing) a passenger seat, respectively.

The second electronic device EA-A2 may be arranged in a second area between the driver seat and the front window GL. For example, the second electronic device EA-A2 may be a head-up display (HUD) that displays second information of the vehicle AM. In one or more embodiments, the second electronic device EA-A2 may be optically transparent. The second information may include a digital number indicating the driving speed of the vehicle AM and may further include information such as the current time. In one or more embodiments, the second information of the second electronic device EA-A2 may be projected and displayed on the front window GL. A display surface of the second electronic device EA-A2 may face the driver seat. In one or more embodiments, the second electronic device EA-A2 may provide an image in the direction of the front window GL.

The third electronic device EA-A3 may be arranged in a third area adjacent to the gear GR. For example, the third electronic device EA-A3 may be a vehicle information guide display (Center Information Display (CID)) arranged between the driver seat and the passenger seat and displaying third information. The passenger seat may be a seat spaced from the driver seat with the gear GR therebetween. The third information may include information about road conditions (for example, navigation information), music or radio playback, dynamic image playback, temperature inside the vehicle AM, and/or the like.

The fourth electronic device EA-A4 may be arranged in a fourth area separate from the steering wheel HA and the gear GR and adjacent to a side of the vehicle AM. For example, the fourth electronic device EA-A4 may be a digital side mirror that displays fourth information. The fourth electronic device EA-A4 may display an image of the outside of the vehicle AM captured by a camera module CM arranged on the outside of the vehicle AM. The fourth information may include an image of the outside of the vehicle AM.

The first to fourth information described above are embodiments, and the first to fourth electronic devices EA-A1, EA-A2, EA-A3, and EA-A4 may further display information about the inside and outside of the vehicle. The first to fourth information may include different information from one another. However, embodiments of the present disclosure are not limited thereto, for example, some pieces of information of the first to fourth information may include the same information.

FIGS. 14 to 16 present embodiments of electronic devices or embodiments including electronic devices, and the display module including the light emitting element including the polycyclic compound of one or more embodiments may be employed in other electronic devices without departing from the concept and teaching of the disclosure.

Hereinafter, the polycyclic compound according to one or more embodiments of the disclosure and the light emitting element of one or more embodiments will be specifically described with reference to examples and comparative examples. However, the examples shown herein are examples to help understanding of the disclosure, and the scope of the disclosure is not limited thereto.

### Examples

### 1. Synthesis of Polycyclic Compounds of Embodiments

A synthetic method of the polycyclic compound according to one or more embodiments will be explained, in particular, by illustrating the synthetic methods of Compounds 1, 2, 3, 21, 31, 36, 51, 61, 69, 71, 86, 113, and 126. In addition, the synthetic methods of the polycyclic compounds explained hereinafter are mere examples, and the synthetic method of the polycyclic compound according to one or more embodiments of the disclosure is not limited to the examples provided herein.

### (1) Synthesis of Compound 1

Polycyclic Compound 1 according to one or more embodiments may be synthesized according to, for example, the steps of Reaction Scheme 1.

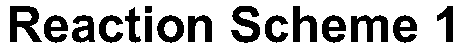

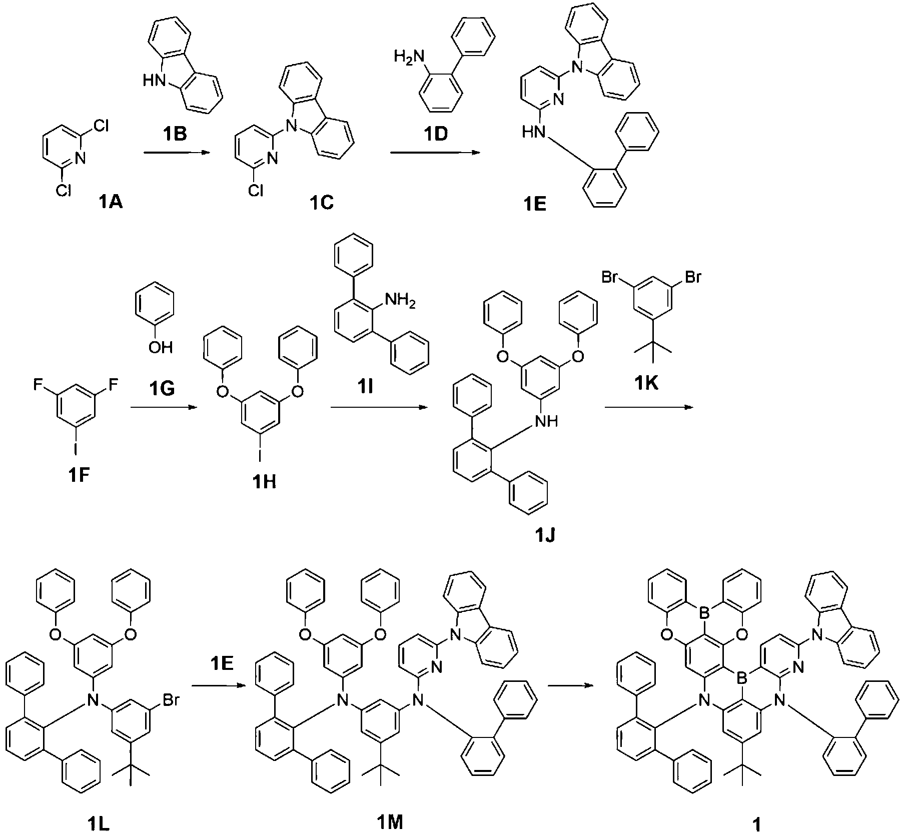

### Synthesis of Intermediate 1C

Under an argon (Ar) atmosphere, 2,6-dichloropyridine (1A) (20 g), carbazole (1B) (23 g), Cs₂CO₃ (66 g), and 1-methyl-2-pyrrolidone (270 mL) were added to a 1000 mL three-necked flask and stirred and heated at about 150 °C for about 16 hours. After cooling to room temperature, water was added thereto, the resultant was extracted with CH₂Cl₂, organic layers were collected and dried over anhydrous MgSO₄, and the solvent was distilled off under reduced pressure. The residue was purified by silica gel column chromatography to obtain 19.6 g (yield 52%) of Intermediate 1C. The mass number of Intermediate 1C measured by Fast Atom Bombardment - Mass spectrometry (FAB-MS) was 279.

### Synthesis of Intermediate 1E

Under an argon atmosphere, Intermediate 1C (19.6 g), 2-aminobiphenyl (1D) (18 g), bis (dibenzylideneacetone)palladium(0) (Pd (dba)₂, 1.2 g), 2-dicyclohexylphosphino-2',6'-dimethoxybiphenyl (SPhos, 1.7 g), sodium tert-butoxide (NaOtBu, 10 g), and toluene (350 mL) were added to a 1000 mL three-necked flask and heated and stirred at about 70 °C for about 24 hours. After cooling to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 18.2 g (yield 63%) of Intermediate 1E. The mass number of Intermediate 1E measured by FAB-MS was 412.

### Synthesis of Intermediate 1H

Under an argon atmosphere, 1,3-difluoro-5-iodobenzene (1F) (30 g), phenol (1G) (30 g), K₂CO₃ (52 g), and 1-methyl-2-pyrrolidone (400 mL) were added to a 1000 mL three-necked flask and heated and stirred at about 160 °C for about 32 hours. After cooling to room temperature, water was added thereto, and the resultant was extracted with CH₂Cl₂. Organic layers were collected and dried over anhydrous MgSO₄, and the solvent was distilled off under reduced pressure. The residue was purified by silica gel column chromatography to obtain 35 g (yield 70%) of Intermediate 1H. The mass number of Intermediate 1H measured by FAB-MS was 404.

### Synthesis of Intermediate 1J

Under an argon atmosphere, Intermediate 1H (35 g), [1,1':3',1"-terphenyl]-2'-amine (Intermediate 11) (26 g), bis(dibenzylideneacetone)palladium(0) (Pd(dba)₂, 0.52 g), tri-tert-butylphosphonium tetrafluoroborate (0.52 g), sodium tert-butoxide (NaOtBu, 13 g), and toluene (400 mL) were added to a 1000 mL three-necked flask and heated and stirred at about 100 °C for about 6 hours. After cooling to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 41 g (yield 90%) of Intermediate 1J. The mass number of Intermediate 1J measured by FAB-MS was 506.

### Synthesis of Intermediate 1L

Under an argon atmosphere, Intermediate 1J (41 g), 1,3-dibromo-5-tert-butylbenzene (1K) (71 g), Cul (15.4 g), and K₂CO₃ (34 g) were added to a 500 mL 3-necked flask and heated and stirred at about 230 °C for about 32 hours. After cooling to room temperature, water was added thereto, and the resultant was extracted with CH₂Cl₂. Organic layers were collected and dried over anhydrous MgSO₄, and the solvent was distilled off under reduced pressure. After purification by silica gel column chromatography, 20.3 g (yield 35%) of Intermediate 1L was obtained. The mass number of Intermediate 1L measured by FAB-MS was 717.

### Synthesis of Intermediate 1M

Under an argon atmosphere, Intermediate 1L (6 g), Intermediate 1E (4.1 g), bis(dibenzylideneacetone)palladium(0) (Pd(dba)₂, 0.096 g), tri-tert-butylphosphonium tetrafluoroborate (0.097 g), sodium tert-butoxide (NaOtBu, 1.2 g), and toluene (80 mL) were added to a 300 mL three-necked flask and heated and stirred at about 100 °C for about 6 hours. After cooling to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 7.2 g (yield 82%) of Intermediate 1M. The mass number of Intermediate 1M measured by FAB-MS was 1047.

### Synthesis of Compound 1

Under an argon atmosphere, Intermediate 1M (7.2 g) was added to a 500 mL 3-necked flask, dissolved in o-dichlorobenzene (ODCB, 200 mL), and cooled to about 0 °C in an ice bath. After that, boron triiodide (BI₃, 16 g) and pyridine (4.9 g) were added thereto, heated and stirred at about 190 °C for about 3 hours, cooled to about 0 °C in an ice bath, and N,N-diisopropylethylamine (DIPEA, 30 mL) was added thereto. After returning to room temperature, the reaction solution was filtered through silica gel, and the solvent in the filtrate was distilled off under reduced pressure. The crude product thus obtained was purified by silica gel column chromatography to obtain 1.1 g (yield 15%) of Compound 1. The molecular weight of Compound 1 measured by FAB-MS was 1063.

### (2) Synthesis of Compound 2

Polycyclic Compound 2 according to one or more embodiments may be synthesized according to, for example, the steps of Reaction Scheme 2.

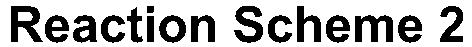

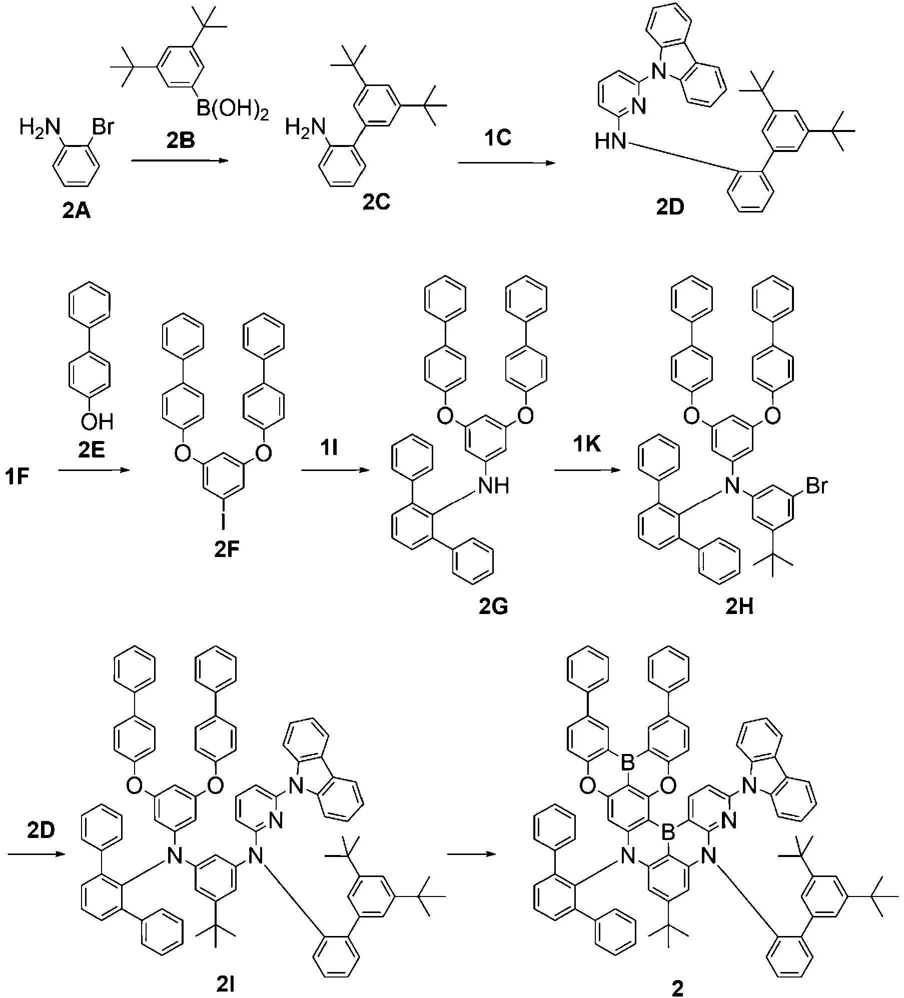

### Synthesis of Intermediate 2C

Under an argon atmosphere, 2-bromoaniline (2A) (10 g), 3,5-di-tert-butylboronic acid (2B) (27 g), tetrakis(triphenylphosphine)palladium(0) (Pd(PPh₃)₄, 0.67 g), K₂CO₃ (16 g), and toluene/ethanol/H₂O (150/60/30 mL) were added to a 500 mL three-necked flask and stirred and heated at about 80 °C for about 24 hours. After returning to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 13.6 g (yield 83%) of Intermediate 2C. The mass number of Intermediate 2C measured by FAB-MS was 281.

### Synthesis of Intermediate 2D

Under an argon atmosphere, Intermediate 2C (13.6 g), Intermediate 1C (9 g), bis(dibenzylideneacetone)palladium(0) (Pd(dba)₂, 0.56 g), 2-dicyclohexylphosphino-2',6'-dimethoxybiphenyl (SPhos, 0.8 g), sodium tert-butoxide (NaOtBu, 4.7 g), and toluene (150 mL) were added to a 500 mL three-necked flask and stirred and heated at about 70 °C for about 24 hours. After returning to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 11.3 g (yield 67%) of Intermediate 2D. The mass number of Intermediate 2D measured by FAB-MS was 524.

### Synthesis of Intermediate 2F

Under an argon atmosphere, Intermediate 1F (10 g), 4-phenylphenol (17 g), Cs₂CO₃ (54 g), and 1-methyl-2-pyrrolidone (300 mL) were added to a 1000 mL three-necked flask and heated and stirred at about 160 °C for about 32 hours. After returning to room temperature, water was added thereto, and the resultant was extracted with CH₂Cl₂. Organic layers were collected and dried over anhydrous MgSO₄, and the solvent was distilled off under reduced pressure. The residue was purified by silica gel column chromatography to obtain 18.5 g (yield 82%) of Intermediate 2F. The mass number of Intermediate 2F measured by FAB-MS was 540.

### Synthesis of Intermediate 2G

Under an argon atmosphere, Intermediate 2F (18.5 g), Intermediate 1I (10.1 g), bis(dibenzylideneacetone)palladium(0) (Pd(dba)₂, 0.2 g), tri-tert-butylphosphonium tetrafluoroborate (0.2 g), sodium tert-butoxide (NaOtBu, 4.9 g), and toluene (200 mL) were added to a 500 mL three-necked flask and stirred and heated at about 100 °C for about 6 hours. After returning to room temperature, water was added thereto, and the resultant was extracted with toluene. Organic layers were collected and dried over anhydrous MgSO₄, and the solvent was distilled off under reduced pressure. After purification by silica gel column chromatography, 19.8 g (yield 88%) of Intermediate 2G was obtained. The mass number of Intermediate 2G measured by FAB-MS was 658.

### Synthesis of Intermediate 2H

Under an argon atmosphere, Intermediate 2G (19.8 g), Intermediate 1K (26 g), Cul (5.7 g), and K₂CO₃ (12.5 g) were added to a 300 mL three-necked flask and heated and stirred at about 230 °C for about 32 hours. After returning to room temperature, water was added thereto, and the resultant was extracted with CH₂Cl₂. Organic layers were collected and dried over anhydrous MgSO₄, and the solvent was distilled off under reduced pressure. The residue was purified by silica gel column chromatography to obtain 7.8 g (yield 30%) of Intermediate 2H. The mass number of Intermediate 2H measured by FAB-MS was 869.

### Synthesis of Intermediate 2I

Under an argon atmosphere, Intermediate 2H (7.8 g), Intermediate 2D (5.6 g), bis(dibenzylideneacetone)palladium(0) (Pd(dba)₂, 0.10 g), tri-tert-butylphosphonium tetrafluoroborate (0.10 g), sodium tert-butoxide (NaOtBu, 1.2 g), and toluene (100 mL) were added to a 300 mL three-necked flask and stirred and heated at about 100 °C for about 6 hours. After returning to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 9.4 g (yield 80%) of Intermediate 2I. The mass number of Intermediate 2I measured by FAB-MS was 1311.

### Synthesis of Compound 2

Under an argon atmosphere, Intermediate 2I (9.4 g) was added to a 500 mL three-necked flask, dissolved in o-dichlorobenzene (ODCB, 200 mL), and cooled to about 0 °C in an ice bath, and boron triiodide (BI₃, 17 g) and pyridine (5.1 g) were added thereto and stirred and heated at about 190 °C for about 3 hours. After that, the reaction solution was cooled to about 0 °C in an ice bath, and N,N-diisopropylethylamine (DIPEA, 30 mL) was added thereto. After returning to room temperature, the reaction solution was filtered through silica gel, and the solvent in the filtrate was distilled off under reduced pressure. The crude product thus obtained was purified by silica gel column chromatography to obtain 1.7 g (yield 18%) of Compound 2. The molecular weight of Compound 2 measured by FAB-MS was 1327.

### (3) Synthesis of Compound 3

Polycyclic Compound 3 according to one or more embodiments may be synthesized according to, for example, the steps of Reaction Scheme 3.

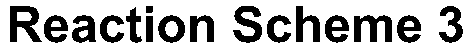

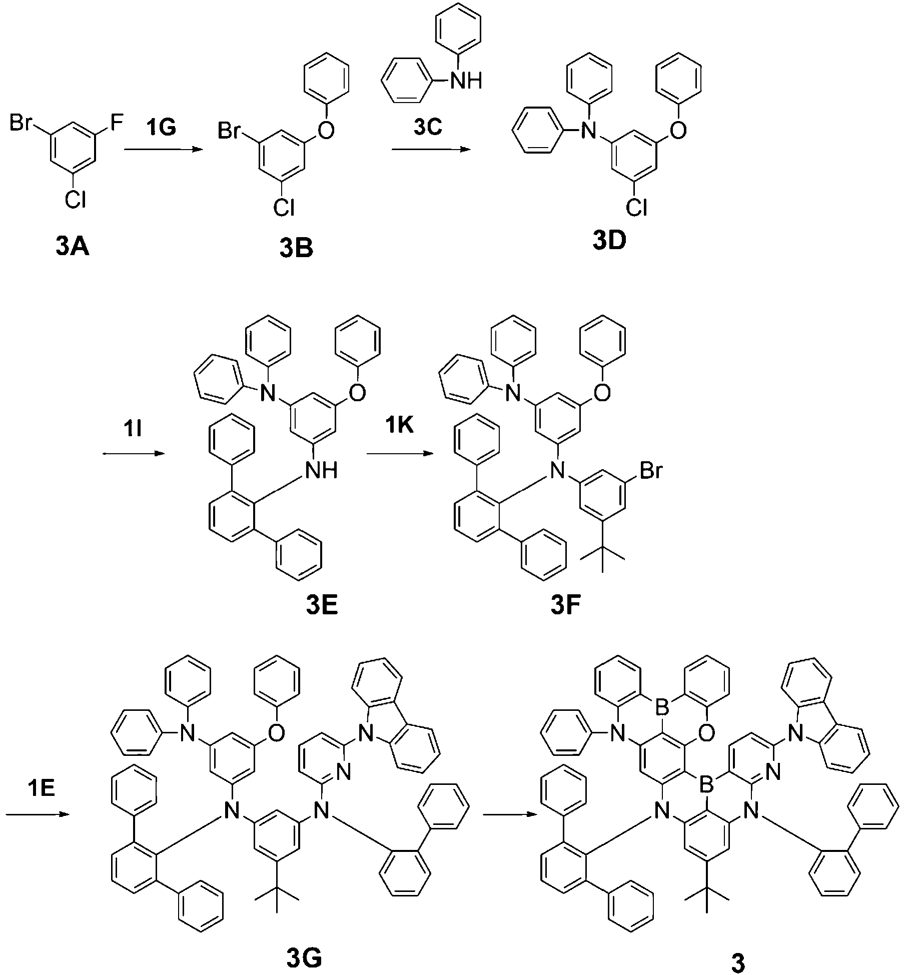

### Synthesis of Intermediate 3B

Under an argon atmosphere, 1-bromo-3-chloro-5-fluorobenzene (3A) (20 g), Intermediate 1G (13.4 g), Cs₂CO₃ (62 g), and 1-methyl-2-pyrrolidone (300 mL) were added to a 1000 mL three-necked flask and stirred and heated at about 140 °C for about 32 hours. After returning to room temperature, water was added thereto, the resultant was extracted with CH₂Cl₂, organic layers were collected and dried over anhydrous MgSO₄, and the solvent was distilled off under reduced pressure. After purification by silica gel column chromatography, 23.3 g (yield 86%) of Intermediate 3B was obtained. The mass number of Intermediate 3B measured by FAB-MS was 284.

### Synthesis of Intermediate 3D

Under an argon atmosphere, Intermediate 3B (10 g), diphenylamine (3C) (9 g), palladium(II) acetate (Pd(OAc)₂, 0.24 g), 4,5-bis(diphenylphosphino)-9,9-dimethylxanthene (Xantphos, 0.61 g), sodium tert-butoxide (NaOtBu, 5.1 g), and toluene (150 mL) were added to a 500 mL three-necked flask and stirred and heated at about 110 °C for about 24 hours. After returning to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 12 g (yield 92%) of Intermediate 3D. The mass number of Intermediate 3D measured by FAB-MS was 372.

### Synthesis of Intermediate 3E

Under an argon atmosphere, Intermediate 3D (12 g), Intermediate 1I (9.5 g), bis(dibenzylideneacetone)palladium(0) (Pd(dba)₂, 0.19 g), tri-tert-butylphosphonium tetrafluoroborate (0.19 g), sodium tert-butoxide (NaOtBu, 4.6 g), and toluene (150 mL) were added to a 500 mL three-necked flask and stirred and heated at about 110 °C for about 24 hours. After returning to room temperature, water was added thereto, and the resultant was extracted with toluene. Organic layers were collected and dried over anhydrous MgSO₄, and the solvent was distilled off under reduced pressure. After purification by silica gel column chromatography, 16.1 g (yield 86%) of Intermediate 3E was obtained. The mass number of Intermediate 3E measured by FAB-MS was 581.

### Synthesis of Intermediate 3F

Under an argon atmosphere, Intermediate 3E (16.1 g), Intermediate 1K (24 g), Cul (5.3 g), and K₂CO₃ (11.5 g) were added to a 300 mL three-necked flask and heated and stirred at about 230 °C for about 32 hours. After returning to room temperature, water was added thereto, the resultant was extracted with CH₂Cl₂, organic layers were collected and dried over anhydrous MgSO₄, and the solvent was distilled off under reduced pressure. The residue was purified by silica gel column chromatography to obtain 7.9 g (yield 36%) of Intermediate 3F. The mass number of Intermediate 3F measured by FAB-MS was 792.

### Synthesis of Intermediate 3G

Under an argon atmosphere, Intermediates 3F (7.9 g) and 1E (4.9 g), bis(dibenzylideneacetone)palladium(0) (Pd(dba)₂, 0.057 g), tri-tert-butylphosphonium tetrafluoroborate (0.057 g), sodium tert-butoxide (NaOtBu, 1.5 g), and toluene (80 mL) were added to a 200 mL three-necked flask and heated and stirred at about 100 °C for about 6 hours. After returning to room temperature, water was added thereto, and the resultant was extracted with toluene. Organic layers were collected and dried over anhydrous MgSO₄, and the solvent was distilled off under reduced pressure. The residue was purified by silica gel column chromatography to obtain Intermediate 3G (10 g, yield 90%). The mass number of Intermediate 3G measured by FAB-MS was 1122.

### Synthesis of Compound 3

Under an Ar atmosphere, Intermediate 3G (10 g) was placed in a 500 mL 3-necked flask, dissolved in o-dichlorobenzene (ODCB, 200 mL), and cooled to about 0 °C in an ice bath, and boron triiodide (BI₃, 21 g) and pyridine (5.3 g) were added thereto, and stirred and heated at about 190 °C for about 3 hours. The resultant was cooled to about 0 °C in an ice bath, and N,N-diisopropylethylamine (DIPEA, 30 mL) was added thereto. After returning to room temperature, the reaction solution was filtered with silica gel, and the solvent in the filtrate was distilled off under reduced pressure. The crude product thus obtained was purified by silica gel column chromatography to obtain 1.4 g (yield 14%) of Compound 3. The molecular weight of Compound 3 measured by FAB-MS was 1138.

### (4) Synthesis of Compound 21

Polycyclic Compound 21 according to one or more embodiments may be synthesized according to, for example, the steps of Reaction Scheme 4.

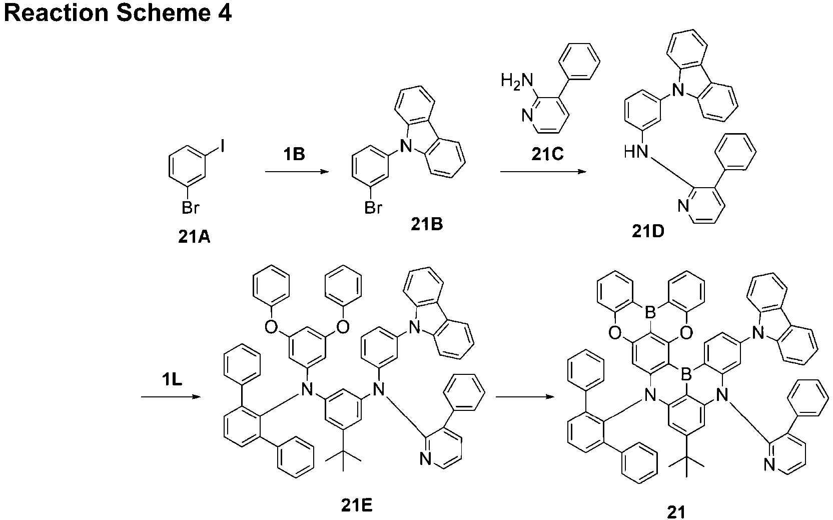

### Synthesis of Intermediate 21B

Under an argon atmosphere, 1-bromo-3-iodobenzene (21A) (30 g), Intermediate 1B (17.7 g), palladium(II) acetate (Pd (OAc)₂, 0.71 g), 4,5-bis (diphenylphosphino)-9,9-dimethylxanthene (Xantphos, 1.8 g), sodium tert-butoxide (NaOtBu, 13 g), and toluene (400 mL) were added to a 1000 mL three-necked flask and stirred and heated at about 100 °C for about 24 hours. After returning to room temperature, water was added thereto, the resultant was extracted with toluene, organic layers were collected and dried over anhydrous MgSO₄, and the solvent was distilled off under reduced pressure. After purification by silica gel column chromatography, 27.2 g (yield 80%) of Intermediate 21B was obtained. The mass number of Intermediate 21B measured by FAB-MS was 322.

### Synthesis of Intermediate 21D

Under an argon atmosphere, Intermediate 21B (27.3 g), Intermediate 21C (20 g), bis(dibenzylideneacetone)palladium(0) (Pd(dba)₂, 0.98 g), (±)-2,2'-bis(diphenylphosphino)-1,1'-binaphthyl (BINAP) (2.1 g), sodium tert-butoxide (NaOtBu, 12.2 g), and toluene (400 mL) were added to a 1000 mL three-necked flask and stirred and heated at about 100 °C for about 6 hours. After returning to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 29.2 g (yield 84%) of Intermediate 21D. The mass number of Intermediate 21D measured by FAB-MS was 412.

### Synthesis of Intermediate 21E

Under an argon atmosphere, Intermediate 21D (4.1 g), Intermediate 1L (6 g), bis(dibenzylideneacetone)palladium(0) (Pd(dba)₂, 0.048 g), tri-tert-butylphosphonium tetrafluoroborate (0.049 g), sodium tert-butoxide (NaOtBu, 1.2 g), and toluene (80 mL) were added to a 200 mL three-necked flask and stirred and heated at about 100 °C for about 6 hours. After returning to room temperature, water was added thereto, the resultant was extracted with toluene, organic layers were collected and dried over anhydrous MgSO₄, and the solvent was distilled off under reduced pressure. Purification by silica gel column chromatography was performed to obtain 7.7 g (yield 82%) of Intermediate 21E. The mass number of Intermediate 21E measured by FAB-MS was 1122.

### Synthesis of Compound 21

Under an argon atmosphere, Intermediate 21E (7.7 g) was placed in a 500 mL three-necked flask, dissolved in o-dichlorobenzene (ODCB, 200 mL), and cooled to about 0 °C in an ice bath, and boron triiodide (BI₃, 17 g) and pyridine (5.2 g) were added thereto and stirred with heating at about 190 °C for about 3 hours. After that, the reaction solution was cooled to about 0 °C in an ice bath, and N,N-diisopropylethylamine (DIPEA, 30 mL) was added thereto. After returning to room temperature, the reaction solution was filtered through silica gel, and the solvent of the filtrate was distilled off under reduced pressure. The crude product thus obtained was purified by silica gel column chromatography to obtain 1.2 g (yield 14%) of Compound 21. The molecular weight of Compound 21 measured by FAB-MS was 1063.

### (5) Synthesis of Compound 31

Polycyclic Compound 31 according to one or more embodiments may be synthesized according to, for example, the steps of Reaction Scheme 5.

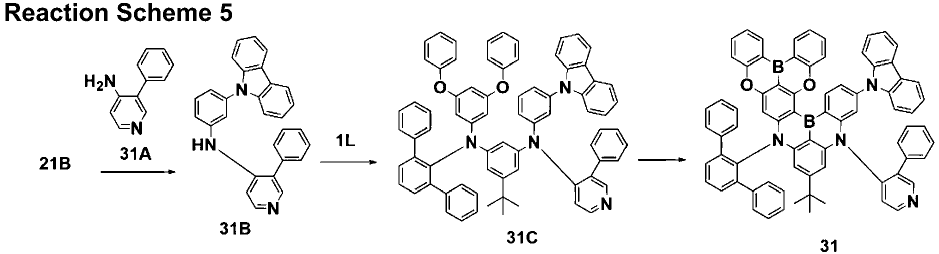

### Synthesis of Intermediate 31B

Under an argon atmosphere, Intermediate 21B (10 g), Intermediate 31A (7.4 g), bis(dibenzylideneacetone)palladium(0) (Pd(dba)₂, 0.36 g), (±)-BINAP (0.77 g), sodium tert-butoxide (NaOtBu, 4.4 g), and toluene (150 mL) were added to a 500 mL three-necked flask and stirred and heated at about 100 °C for about 6 hours. After returning to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 10 g (yield 81%) of Intermediate 31B. The mass number of Intermediate 31B measured by FAB-MS was 412.

### Synthesis of Intermediate 31C

Under an argon atmosphere, Intermediate 31B (4.1 g), Intermediate 1L (6 g), bis(dibenzylideneacetone)palladium(0) (Pd(dba)₂, 0.48 g), tri-tert-butylphosphonium tetrafluoroborate (0.49 g), sodium tert-butoxide (NaOtBu, 1.2 g), and toluene (80 mL) were added to a 200 mL three-necked flask and heated and stirred at about 100 °C for about 6 hours. After returning to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 8 g (yield 85%) of Intermediate 31C. The mass number of Intermediate 31C measured by FAB-MS was 1122.

### Synthesis of Compound 31

Under an argon atmosphere, Intermediate 31C (8 g) was placed in a 500 mL three-necked flask, dissolved in o-dichlorobenzene (ODCB, 200 mL), and cooled to about 0 °C in an ice bath, and boron triiodide (BI₃, 18 g) and pyridine (5.4 g) were added thereto, and stirred with heating at about 190 °C for about 3 hours. After that, the reaction solution was cooled to about 0 °C in an ice bath, and N,N-diisopropylethylamine (DIPEA, 30 mL) was added thereto. After returning to room temperature, the reaction solution was filtered through silica gel, and the solvent in the filtrate was distilled off under reduced pressure. The crude product thus obtained was purified by silica gel column chromatography to obtain 1.3 g (yield 16%) of Compound 31. The molecular weight of Compound 31 measured by FAB-MS was 1063.

### (6) Synthesis of Compound 36

Polycyclic Compound 36 according to one or more embodiments may be synthesized according to, for example, the steps of Reaction Scheme 6.

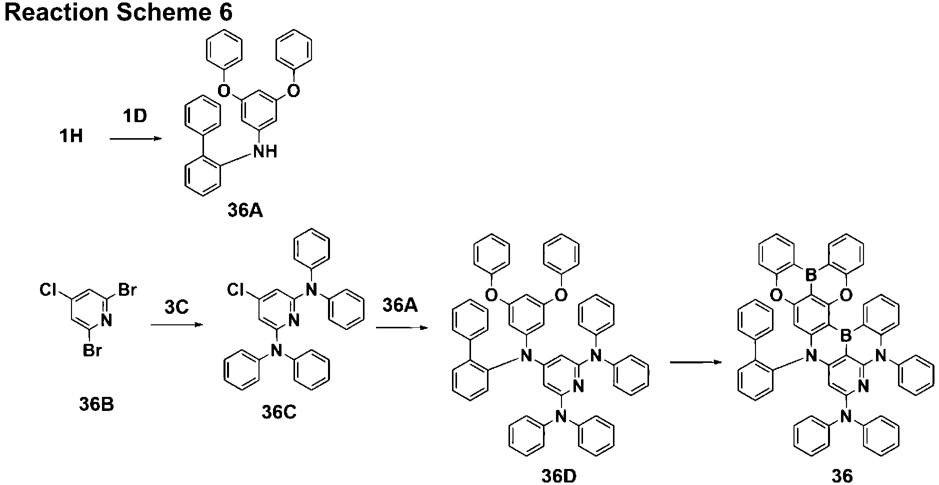

### Synthesis of Intermediate 36A

Under an argon atmosphere, Intermediate 1H (6 g), Intermediate 1D (3.7 g), bis(dibenzylideneacetone)palladium(0) (Pd(dba)₂, 0.18 g), (±)-BINAP (0.39 g), sodium tert-butoxide (NaOtBu, 2.2 g), and toluene (100 mL) were added to a 300 mL three-necked flask and stirred and heated at about 100 °C for about 6 hours. After returning to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 6.1 g (yield 92%) of Intermediate 36A. The mass number of Intermediate 36A measured by FAB-MS was 430.

### Synthesis of Intermediate 36C

Under an argon atmosphere, Intermediate 36B (6 g), Intermediate 3C (7.5 g), bis(dibenzylideneacetone)palladium(0) (Pd(dba)₂, 0.38 g), 2-dicyclohexylphosphino-2',6'-dimethoxybiphenyl (SPhos, 0.54 g), sodium tert-butoxide (NaOtBu, 6.4 g), and toluene (200 mL) were added to a 500 mL three-necked flask and stirred and heated at about 60 °C for about 24 hours. After returning to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 6.1 g (yield 62%) of Intermediate 36C. The mass number of Intermediate 36C measured by FAB-MS was 448.

### Synthesis of Intermediate 36D

Under an argon atmosphere, Intermediate 36C (5 g), Intermediate 36A (5.7 g), bis(dibenzylideneacetone)palladium(0) (Pd(dba)₂, 0.06 g), tri-tert-butylphosphonium tetrafluoroborate (0.06 g), sodium tert-butoxide (NaOtBu, 1.6 g), and toluene (80 mL) were added to a 200 mL three-necked flask and stirred and heated at about 110 °C for about 6 hours. After returning to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 8.1 g (yield 86%) of Intermediate 36D. The mass number of Intermediate 36D measured by FAB-MS measurement was 841.

### Synthesis of Compound 36

Under an argon atmosphere, Intermediate 36D (8.1 g) was placed in a 500 mL three-necked flask, dissolved in o-dichlorobenzene (ODCB, 200 mL), and cooled to about 0 °C in an ice bath, and boron triiodide (BI₃, 22.6 g) and pyridine (6.8 g) were added thereto, and stirred and heated at about 190 °C for about 3 hours. After that, the reaction solution was cooled to about 0 °C in an ice bath, and N,N-diisopropylethylamine (DIPEA, 35 mL) was added thereto. After returning to room temperature, the reaction solution was filtered through silica gel, and the solvent of the filtrate was distilled off under reduced pressure. The crude product thus obtained was purified by silica gel column chromatography to obtain 1.2 g (yield 15%) of Compound 36. The molecular weight of Compound 36 measured by FAB-MS was 857.

### (7) Synthesis of Compound 51

Polycyclic Compound 51 according to one or more embodiments may be synthesized according to, for example, the steps of Reaction Scheme 7.

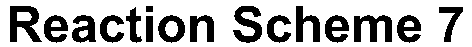

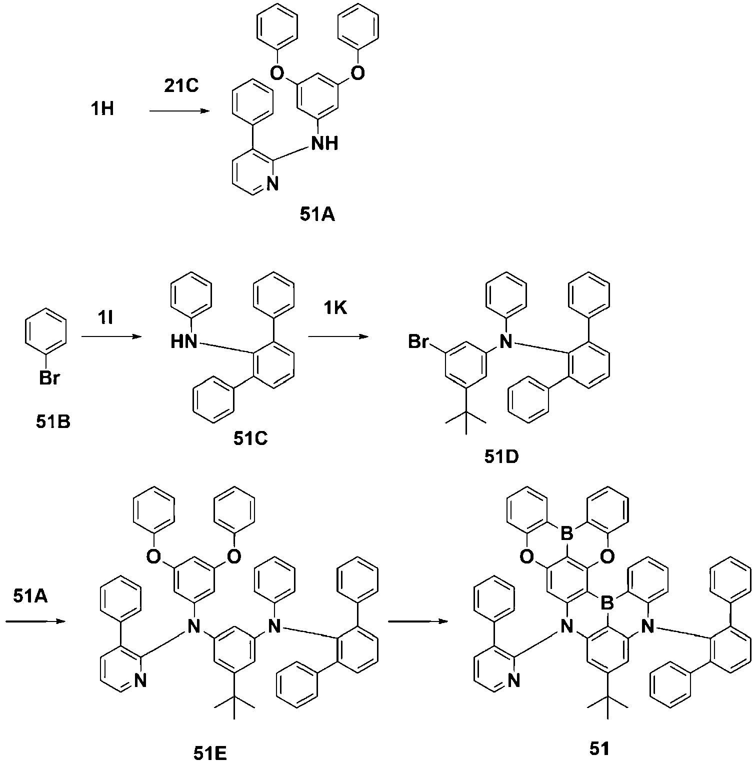

### Synthesis of Intermediate 51A

Under an argon atmosphere, Intermediate 1H (5 g), Intermediate 21C (3.1 g), bis(dibenzylideneacetone)palladium(0) (Pd(dba)₂, 0.15 g), (±)-BINAP (0.32 g), sodium tert-butoxide (NaOtBu, 1.9 g), and toluene (80 mL) were added to a 200 mL three-necked flask and stirred and heated at about 100 °C for about 6 hours. After returning to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 4.8 g (yield 86%) of Intermediate 51A. The mass number of Intermediate 51A measured by FAB-MS was 431.

### Synthesis of Intermediate 51C

Under an argon atmosphere, bromobenzene (51B) (15 g), Intermediate 1I (26 g), bis(dibenzylideneacetone)palladium(0) (Pd(dba)₂, 0.54 g), tri-tert-butylphosphonium tetrafluoroborate (0.55 g), sodium tert-butoxide (NaOtBu, 13 g), and toluene (400 mL) were added to a 1000 mL three-necked flask and stirred and heated at about 100 °C for about 6 hours. After returning to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 27.6 g (yield 90%) of Intermediate 51C. The mass number of Intermediate 51C measured by FAB-MS was 321.

### Synthesis of Intermediate 51D

Under an argon atmosphere, Intermediate 51C (27.6 g), Intermediate 1K (75 g), Cul (16.3 g), and K₂CO₃ (36 g) were added to a 500 mL three-necked flask, and heated and stirred at about 230 °C for about 32 hours. After returning to room temperature, water was added thereto, the resultant was extracted with CH₂Cl₂, organic layers were collected and dried over anhydrous MgSO₄, and the solvent was distilled off under reduced pressure. After purification by silica gel column chromatography, 14.6 g (yield 32%) of Intermediate 51D was obtained. The mass number of Intermediate 51D measured by FAB-MS was 533.

### Synthesis of Intermediate 51E

Under an argon atmosphere, Intermediate 51D (5 g), Intermediate 51A (4.8 g), bis(dibenzylideneacetone)palladium(0) (Pd(dba)₂, 0.054 g), tri-tert-butylphosphonium tetrafluoroborate (0.055 g), sodium tert-butoxide (NaOtBu, 1.3 g), and toluene (80 mL) were added to a 200 mL three-necked flask and heated and stirred at about 100 °C for about 6 hours. After returning to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 7 g (yield 85%) of Intermediate 51E. The mass number of Intermediate 51E measured by FAB-MS was 882.

### Synthesis of Compound 51

Under an argon atmosphere, Intermediate 51E (7 g) was placed in a 500 mL three-necked flask, dissolved in o-dichlorobenzene (ODCB, 200 mL), and cooled to about 0 °C in an ice bath, and boron triiodide (BI₃, 18.6 g) and pyridine (5.6 g) were added thereto, and stirred and heated at about 190 °C for about 3 hours. After that, the reaction solution was cooled to about 0 °C in an ice bath, and N,N-diisopropylethylamine (DIPEA, 30 mL) was added thereto. After returning to room temperature, the reaction solution was filtered through silica gel, and the solvent in the filtrate was distilled off under reduced pressure. The crude product thus obtained was purified by silica gel column chromatography to obtain 1.3 g (yield 18%) of Compound 51. The molecular weight of Compound 51 measured by FAB-MS was 898.

### (8) Synthesis of Compound 61

Polycyclic Compound 61 according to one or more embodiments may be synthesized according to, for example, the steps of Reaction Scheme 8.

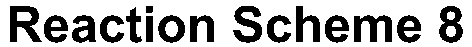

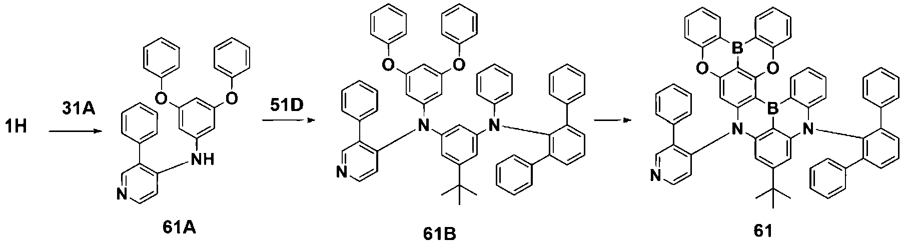

### Synthesis of Intermediate 61A

Under an argon atmosphere, Intermediate 1H (5 g), Intermediate 31A (3.1 g), bis(dibenzylideneacetone)palladium(0) (Pd(dba)₂, 0.15 g), (±)-BINAP (0.32 g), sodium tert-butoxide (NaOtBu, 1.9 g), and toluene (80 mL) were added to a 200 mL three-necked flask and stirred and heated at about 100 °C for about 6 hours. After returning to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 4.5 g (yield 82%) of Intermediate 61A. The mass number of Intermediate 61A measured by FAB-MS was 431.

### Synthesis of Intermediate 61B

Under an argon atmosphere, Intermediate 61A (4.5 g), Intermediate 51D (4.6 g), bis(dibenzylideneacetone)palladium(0) (Pd(dba)₂, 0.05 g), tri-tert-butylphosphonium tetrafluoroborate (0.05 g), sodium tert-butoxide (NaOtBu, 1.2 g), and toluene (80 mL) were added to a 200 mL three-necked flask and stirred and heated at about 100 °C for about 6 hours. After returning to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 5.9 g (yield 78%) of Intermediate 61B. The mass number of Intermediate 61B measured by FAB-MS was 882.

### Synthesis of Compound 61

Under an argon atmosphere, Intermediate 61B (5.9 g) was added to a 500 mL three-necked flask, dissolved in o-dichlorobenzene (ODCB, 200 mL), and cooled to about 0 °C in an ice bath, and boron triiodide (BI₃, 15.7 g) and pyridine (4.8 g) were added thereto, and stirred and heated at about 190 °C for about 3 hours. After that, the reaction solution was cooled to about 0 °C in an ice bath, and N,N-diisopropylethylamine (DIPEA, 25 mL) was added thereto. After returning to room temperature, the reaction solution was filtered through silica gel, and the solvent in the filtrate was distilled off under reduced pressure. The crude product thus obtained was purified by silica gel column chromatography to obtain 0.9 g (yield 15%) of Compound 61. The molecular weight of Compound 61 measured by FAB-MS was 898.

### (9) Synthesis of Compound 69

Polycyclic Compound 69 according to one or more embodiments may be synthesized according to, for example, the steps of Reaction Scheme 9.

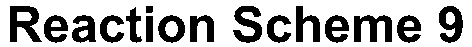

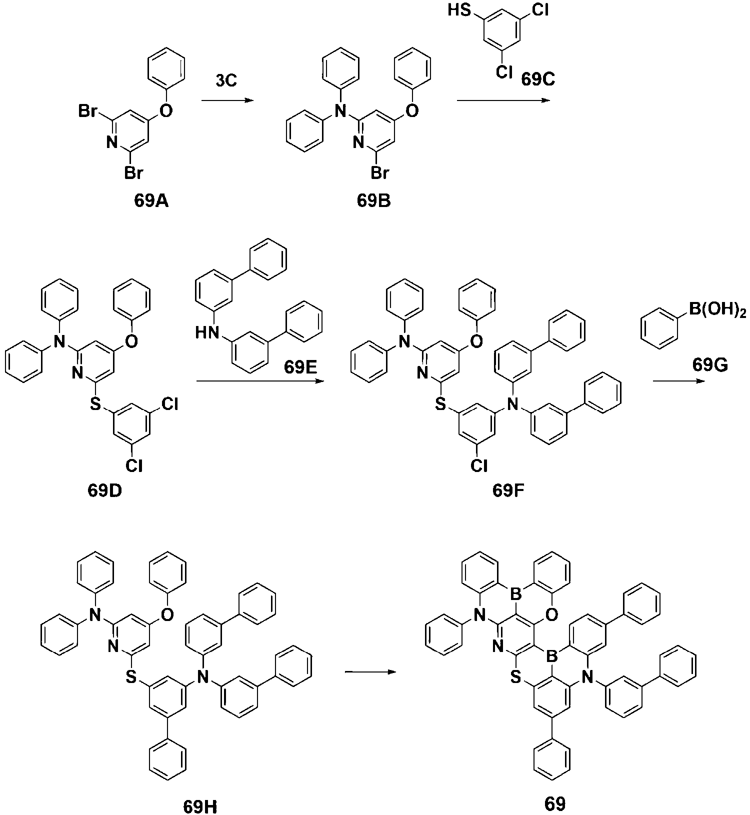

### Synthesis of Intermediate 69B

Under an argon atmosphere, Intermediate 69A (50 g), Intermediate 3C (12.9 g), bis(dibenzylideneacetone)palladium(0) (Pd(dba)₂, 2.6 g), tri-tert-butylphosphonium tetrafluoroborate (2.6 g), sodium tert-butoxide (NaOtBu, 15 g), and toluene (400 mL) were added to a 1 L three-necked flask and heated and stirred at about 80 °C for about 6 hours. After returning to room temperature, water was added thereto, and the resultant was extracted with toluene. Organic layers were dried all at once over anhydrous MgSO₄, and the solvent was distilled off under reduced pressure. The residue was purified by silica gel column chromatography to obtain 22.2 g (yield 70%) of Intermediate 69B. The mass number of Intermediate 69B measured by FAB-MS was 417.

### Synthesis of Intermediate 69D

Under an argon atmosphere, Intermediate 69B (22.2 g), Intermediate 69C (9.5 g), CuBr (0.76 g), 1,2,3,4-tetrahydro-8-quinolinol (0.71 g), Cs₂CO₃ (26 g), and dimethylformamide (200 mL) were added to a 500 mL three-necked flask and stirred and heated at about 130 °C for about 32 hours. After returning to room temperature, water was added thereto, and the resultant was extracted with CH₂Cl₂. Organic layers were dried all at once over anhydrous MgSO₄, and the solvent was distilled off under reduced pressure. The residue was purified by silica gel column chromatography to obtain 22.3 g (yield 82%) of Intermediate 69D. The mass number of Intermediate 69D measured by FAB-MS was 515.

### Synthesis of Intermediate 69F

Under an argon atmosphere, Intermediate 69D (22.3 g), Intermediate 69E (14 g), bis(dibenzylideneacetone)palladium(0) (Pd(dba)₂, 0.50 g), tri-tert-butylphosphonium tetrafluoroborate (0.50 g), sodium tert-butoxide (NaOtBu, 6.2 g), and toluene (150 mL) were added to a 500 mL three-necked flask and stirred and heated at about 110 °C for about 12 hours. After returning to room temperature, water was added thereto, the resultant was extracted with toluene, organic layers were dried all at once over anhydrous MgSO₄, and the solvent was distilled off under reduced pressure. The residue was purified by silica gel column chromatography to obtain 12 g (yield 35%) of Intermediate 69F. The mass number of Intermediate 69F measured by FAB-MS was 800.

### Synthesis of Intermediate 69H

Under an argon atmosphere, Intermediate 69F (12 g), phenylboronic acid (Intermediate 69G) (3.8 g), bis[di-tert-butyl(4-dimethylaminophenyl)phosphine]dichloropalladium(II) (PdCl₂(Amphos)₂, 0.11 g), K₂CO₃ (4.1 g), and toluene/ethanol/H₂O (100/40/20 mL) were added to a 200 mL three-necked flask and stirred and heated at about 80 °C for about 24 hours. After returning to room temperature, water was added thereto, the resultant was extracted with toluene, and organic layers were dried all at once over anhydrous MgSO₄, and the solvent was distilled off under reduced pressure. Purification by silica gel column chromatography was performed, and 10.5 g (yield 83%) of Intermediate 69H was obtained. The mass number of Intermediate 69H measured by FAB-MS was 842.

### Synthesis of Compound 69

Under an argon atmosphere, Intermediate 69H (10.5 g) was added to a 1 L three-necked flask, dissolved in o-dichlorobenzene (ODCB, 300 mL), and cooled to about 0 °C in an ice bath, and boron triiodide (BI₃, 29 g) and pyridine (8.8 g) were added thereto, stirred and heated at about 190 °C for about 3 hours, and cooled to about 0 °C in an ice bath. N,N-diisopropylethylamine (DIPEA, 45 mL) was added thereto. After returning to room temperature, the reaction solution was filtered through silica gel, and the solvent in the filtrate was distilled off under reduced pressure. The crude product thus obtained was purified by silica gel column chromatography to obtain 1.3 g (yield 12%) of Compound 69. The molecular weight of Compound 69 measured by FAB-MS was 858.

### (10) Synthesis of Compound 71

Polycyclic Compound 71 according to one or more embodiments may be synthesized according to, for example, the steps of Reaction Scheme 10.

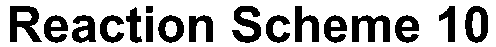

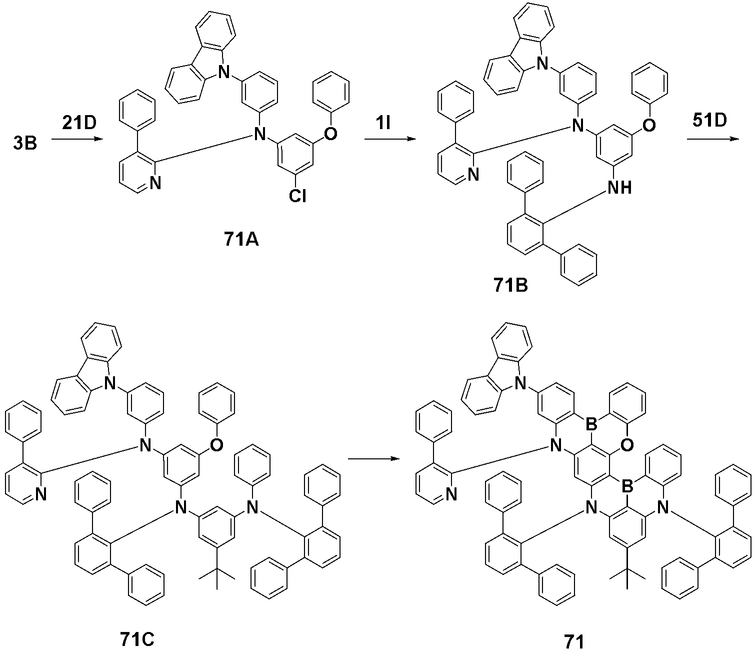

### Synthesis of Intermediate 71A

Under an argon atmosphere, Intermediate 3B (10 g), Intermediate 21D (17.4 g), palladium(II) acetate (Pd(OAc)₂, 0.23 g), 4,5-bis(diphenylphosphino)-9,9-dimethylxanthene (Xantphos, 0.61 g), sodium tert-butoxide (NaOtBu, 5 g), and toluene (200 mL) were added to a 500 mL three-necked flask and stirred and heated at about 110 °C for about 24 hours. After returning to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 18 g (yield 83%) of Intermediate 71A. The mass number of Intermediate 71A measured by FAB-MS was 614.

### Synthesis of Intermediate 71B

Under an argon atmosphere, Intermediate 71A (18 g), Intermediate 1I (8.6 g), bis(dibenzylideneacetone)palladium(0) (Pd(dba)₂, 0.16 g), tri-tert-butylphosphonium tetrafluoroborate (0.17 g), sodium tert-butoxide (NaOtBu, 4.2 g), and toluene (150 mL) were added to a 500 mL three-necked flask and stirred and heated at about 110 °C for about 6 hours. After returning to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 19.3 g (yield 80%) of Intermediate 71B. The mass number of Intermediate 71B measured by FAB-MS was 823.

### Synthesis of Intermediate 71C

Under an argon atmosphere, Intermediate 71B (19.3 g), Intermediate 51D (18.7 g), Cul (4.4 g), and K₂CO₃ (10 g) were added to a 300 mL three-necked flask and stirred and heated at about 230 °C for about 32 hours. After returning to room temperature, water was added thereto, and the resultant was extracted with CH₂Cl₂. Organic layers were collected and dried over anhydrous MgSO₄, and the solvent was distilled off under reduced pressure. After purification by silica gel column chromatography, 6 g (yield 20%) of Intermediate 71C was obtained. The mass number of Intermediate 71C measured by FAB-MS was 1275.

### Synthesis of Compound 71

Under an argon atmosphere, Intermediate 71C (6 g) was placed in a 300 mL three-necked flask, dissolved in o-dichlorobenzene (ODCB, 200 mL), and cooled to about 0 °C in an ice bath, and boron triiodide (BI₃, 11 g) and pyridine (3.3 g) were added thereto and stirred and heated at about 190 °C for about 3 hours. After that, the reaction solution was cooled to about 0 °C in an ice bath, and N,N-diisopropylethylamine (DIPEA, 20 mL) was added thereto. After returning to room temperature, the reaction solution was filtered through silica gel, and the solvent in the filtrate was distilled off under reduced pressure. The crude product thus obtained was purified by silica gel column chromatography to obtain 1 g (yield 16%) of Compound 71. The molecular weight of Compound 71 measured by FAB-MS was 1290.

### (11) Synthesis of Compound 86

Polycyclic Compound 86 according to one or more embodiments may be synthesized according to, for example, the steps of Reaction Scheme 11.

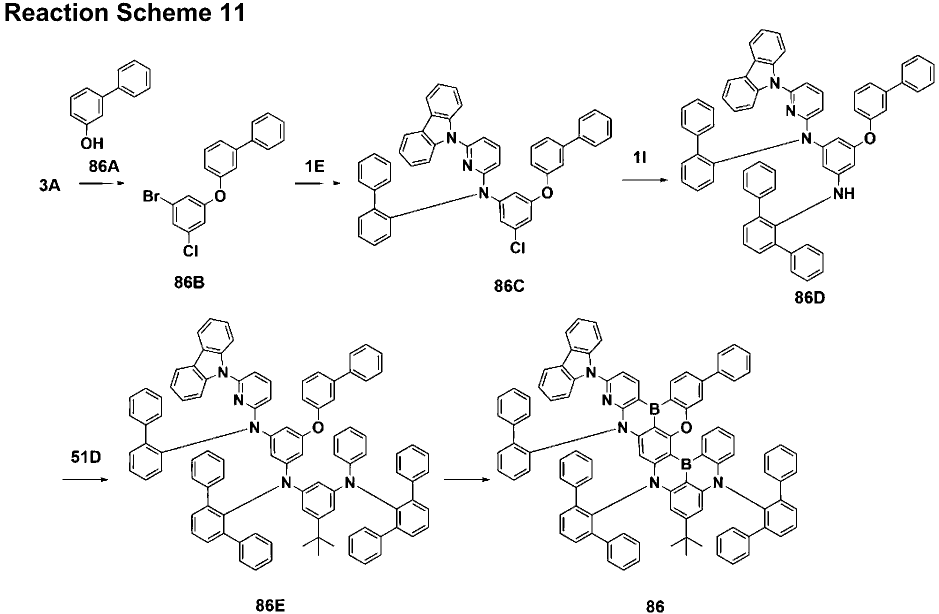

### Synthesis of Intermediate 86B

Under an argon atmosphere, Intermediate 3A (15 g), 3-phenylphenol (86A) (14.6 g), Cs₂CO₃ (47 g), and 1-methyl-2-pyrrolidone (300 mL) were added to a 1000 mL three-necked flask and stirred and heated at about 140 °C for about 16 hours. After returning to room temperature, water was added thereto, the resultant was extracted with CH₂Cl₂, organic layers were collected and dried over anhydrous MgSO₄, and the solvent was distilled off under reduced pressure. After purification by silica gel column chromatography, 21.6 g (yield 84%) of Intermediate 86B was obtained. The mass number of Intermediate 86B measured by FAB-MS was 360.

### Synthesis of Intermediate 86C

Under an argon atmosphere, Intermediate 86B (15 g), Intermediate 1E (18.5 g), palladium(II) acetate (Pd(OAc)₂, 0.25 g), 4,5-bis(diphenylphosphino)-9,9-dimethylxanthene (Xantphos, 0.65 g), sodium tert-butoxide (NaOtBu, 5.1 g), and toluene (150 mL) were added to a 500 mL three-necked flask and stirred and heated at about 110 °C for about 24 hours. After returning to room temperature, water was added thereto, and the resultant was extracted with toluene. Organic layers were collected and dried over anhydrous MgSO₄, and the solvent was distilled off under reduced pressure. The residue was purified by silica gel column chromatography to obtain 22.3 g (yield 86%) of Intermediate 86C. The mass number of Intermediate 86C measured by FAB-MS was 690.

### Synthesis of Intermediate 86D

Under an argon atmosphere, Intermediate 86C (22.3 g), Intermediate 11 (8.7 g), bis(dibenzylideneacetone)palladium(0) (Pd(dba)₂, 0.19 g), tri-tert-butylphosphonium tetrafluoroborate (0.19 g), sodium tert-butoxide (NaOtBu, 4.3 g), and toluene (150 mL) were added to a 500 mL three-necked flask and stirred and heated at about 110 °C for about 12 hours. After returning to room temperature, water was added thereto, the resultant was extracted with toluene, organic layers were collected and dried over anhydrous MgSO₄, and the solvent was distilled off under reduced pressure. Purification by silica gel column chromatography was performed to obtain 24.4 g (yield 84%) of Intermediate 86D. The mass number of Intermediate 86D measured by FAB-MS was 899.

### Synthesis of Intermediate 86E

Under an argon atmosphere, Intermediate 86D (24.4 g), Intermediate 51D (21.7 g), Cul (5.2 g), and K₂CO₃ (11 g) were added to a 300 mL three-necked flask and heated and stirred at about 230 °C for about 32 hours. After returning to room temperature, water was added thereto, the resultant was extracted with CH₂Cl₂, organic layers were collected and dried over anhydrous MgSO₄, and the solvent was distilled off under reduced pressure. Purification by silica gel column chromatography was performed to obtain 6.6 g (yield 18%) of Intermediate 86E. The mass number of Intermediate 86E measured by FAB-MS was 1351.

### Synthesis of Compound 86

Under an argon atmosphere, Intermediate 86E (6.6 g) was added to a 300 mL three-necked flask, dissolved in o-dichlorobenzene (ODCB, 200 mL), and cooled to about 0 °C in an ice bath, and boron triiodide (BI₃, 11.5 g) and pyridine (3.5 g) were added thereto, and stirred while heating at about 190 °C for about 3 hours. After that, the reaction solution was cooled to about 0 °C in an ice bath, and N,N-diisopropylethylamine (DIPEA, 20 mL) was added thereto. After returning to room temperature, the reaction solution was filtered through silica gel, and the solvent in the filtrate was distilled off under reduced pressure. The crude product thus obtained was purified by silica gel column chromatography to obtain 1.1 g (yield 17%) of Compound 86. The molecular weight of Compound 86 measured by FAB-MS was 1366.

### (12) Synthesis of Compound 113

Polycyclic Compound 113 according to one or more embodiments may be synthesized according to, for example, the steps of Reaction Scheme 12.

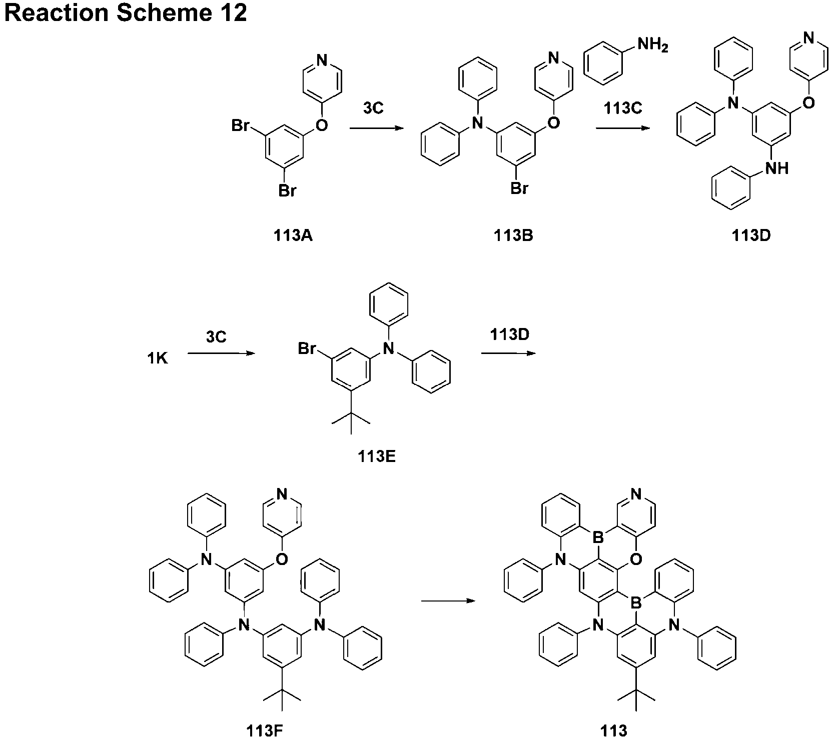

### Synthesis of Intermediate 113B

Under an argon atmosphere, Intermediate 113A (25 g), Intermediate 3C (6.4 g), bis(dibenzylideneacetone)palladium(0) (Pd(dba)₂, 1.3 g), tri-tert-butylphosphonium tetrafluoroborate (1.3 g), sodium tert-butoxide (NaOtBu, 7.3 g), and toluene (150 mL) were added to a 500 mL three-necked flask and stirred and heated at about 80 °C for about 8 hours. After returning to room temperature, water was added thereto, and the resultant was extracted with toluene. Organic layers were dried all at once over anhydrous MgSO₄, and the solvent was distilled off under reduced pressure. The residue was purified by silica gel column chromatography to obtain 7.9 g (yield 50%) of Intermediate 113B. The mass number of Intermediate 113B measured by FAB-MS was 417.

### Synthesis of Intermediate 113D

Under an argon atmosphere, Intermediate 113B (7.9 g), Intermediate 113C (2.4 g), bis(dibenzylideneacetone)palladium(0) (Pd(dba)₂, 0.22 g), (±)-BINAP (0.47 g), sodium tert-butoxide (NaOtBu, 2.7 g), and toluene (80 mL) were added to a 200 mL three-necked flask and stirred and heated at about 110 °C for about 6 hours. After returning to room temperature, water was added thereto, the resultant was extracted with toluene, organic layers were dried all at once over anhydrous MgSO₄, and the solvent was distilled off under reduced pressure. The residue was purified by silica gel column chromatography to obtain 7.1 g (yield 87%) of Intermediate 113D. The mass number of Intermediate 113D measured by FAB-MS was 412.

### Synthesis of Intermediate 113E

Under an argon atmosphere, Intermediate 1K (10 g), Intermediate 3C (5.8 g), palladium(II) acetate (Pd(OAc)₂, 0.23 g), 4,5-bis(diphenylphosphino)-9,9-dimethylxanthene (Xantphos, 0.59 g), sodium tert-butoxide (NaOtBu, 5 g), and toluene (130 mL) were added to a 300 mL three-necked flask and heated and stirred at about 110 °C for about 24 hours. After returning to room temperature, water was added thereto, the resultant was extracted with toluene, organic layers were dried all at once over anhydrous MgSO₄, and the solvent was distilled off under reduced pressure. The residue was purified by silica gel column chromatography to obtain 9.4 g (yield 72%) of Intermediate 113E. The mass number of Intermediate 113E measured by FAB-MS was 380.

### Synthesis of Intermediate 113F

Under an argon atmosphere, Intermediate 113D (7 g), Intermediate 113E (6.2 g), bis(dibenzylideneacetone)palladium(0) (Pd(dba)₂, 0.19 g), tri-tert-butylphosphonium tetrafluoroborate (0.19 g), sodium tert-butoxide (NaOtBu, 2.4 g), and toluene (100 mL) were added to a 300 mL three-necked flask and stirred and heated at about 100 °C for about 6 hours. After returning to room temperature, water was added thereto, the resultant was extracted with toluene, organic layers were dried all at once over anhydrous MgSO₄, and the solvent was distilled off under reduced pressure. Purification by silica gel column chromatography was performed to obtain 9.6 g (yield 81%) of Intermediate 113F. The mass number of Intermediate 113F measured by FAB-MS was 729.

### Synthesis of Compound 113

Under an argon atmosphere, Intermediate 113F (9.6 g) was added to a 500 mL three-necked flask, dissolved in o-dichlorobenzene (ODCB, 250 mL), and cooled to about 0 °C in an ice bath, and boron triiodide (BI₃, 31 g) and pyridine (9.4 g) were added thereto, and heated and stirred at about 190 °C for about 3 hours. The reaction solution was cooled to about 0 °C in an ice bath, and N,N-diisopropylethylamine (DIPEA, 45 mL) was added thereto. After returning to room temperature, the reaction solution was filtered through silica gel, and the filtrate solvent was distilled off under reduced pressure. The crude product thus obtained was purified by silica gel column chromatography to obtain 1 g (yield 10%) of Compound 113. The molecular weight of Compound 113 measured by FAB-MS was 745.

### (13) Synthesis of Compound 126

Polycyclic Compound 126 according to one or more embodiments may be synthesized according to, for example, the steps of Reaction Scheme 13.

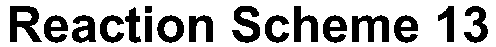

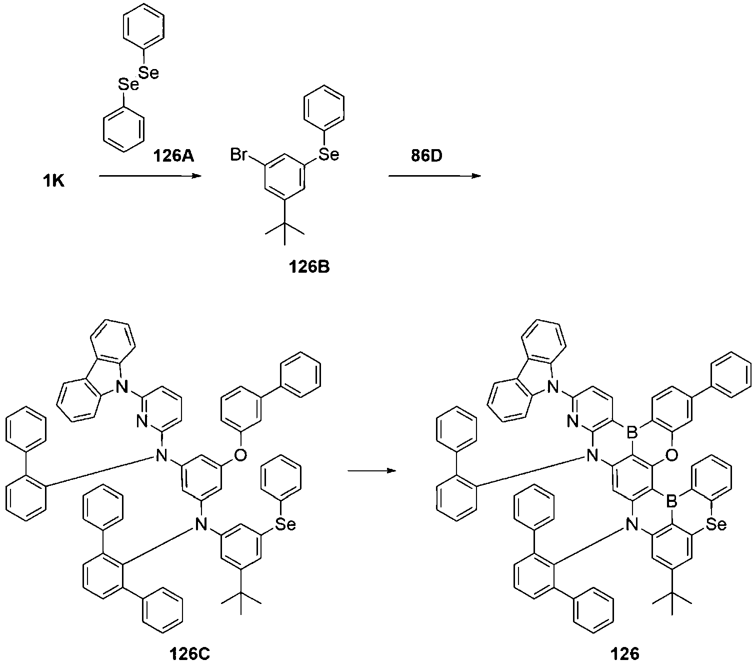

### Synthesis of Intermediate 126B

Under an argon atmosphere, Intermediate 1K (60 g), Intermediate 126A (32 g), potassium tert-butoxide (KOtBu, 35 g), and dimethyl sulfoxide (DMSO) were added to a 500 mL three-necked flask and stirred and heated at about 80 °C for about 6 hours. After returning to room temperature, water was added thereto, the resultant was extracted with CH₂Cl₂, organic layers were dried all at once over anhydrous MgSO₄, and the solvent was distilled off under reduced pressure. After purification by silica gel column chromatography, 25.8 g (yield 68%) of Intermediate 126B was obtained. The mass number of Intermediate 126B measured by FAB-MS was 368.

### Synthesis of Intermediate 126C

Under an argon atmosphere, Intermediate 126B (25.8 g), Intermediate 86D (30 g), Cul (6.4 g), and K₂CO₃ (14 g) were added to a 300 mL three-necked flask and heated and stirred at about 230 °C for about 32 hours. After returning to room temperature, water was added thereto, the resultant was extracted with CH₂Cl₂, organic layers were dried all at once over anhydrous MgSO₄, and the solvent was distilled off under reduced pressure. After purification by silica gel column chromatography, 8.3 g (yield 21%) of Intermediate 126C was obtained. The mass number of Intermediate 126C measured by FAB-MS was 1186.

### Synthesis of Compound 126

Under an argon atmosphere, Intermediate 126C (8.3 g) was placed in a 500 mL three-necked flask, dissolved in o-dichlorobenzene (ODCB, 200 mL), and cooled to about 0 °C in an ice bath. Boron triiodide (BI₃, 16.4 g) and pyridine (5 g) were added thereto and heated and stirred at about 190 °C for about 3 hours, and cooled to about 0 °C in an ice bath. N,N-diisopropylethylamine (DIPEA, 30 mL) was added thereto. After returning to room temperature, the reaction solution was filtered through silica gel, and the filtrate solvent was distilled off under reduced pressure. The crude product thus obtained was purified by silica gel column chromatography to obtain 0.78 g (yield 9%) of Compound 126. The molecular weight of Compound 126 measured by FAB-MS was 1202.

### 2. Manufacture and Evaluation of Light Emitting Elements

### (1) Manufacture of Light Emitting Elements

Light emitting elements including the polycyclic compounds of embodiments or Comparative Compounds in light emitting layers were each manufactured by a method provided herein. The polycyclic compounds of embodiments were respectively used as a light emitting layer dopant material to manufacture light emitting elements of Examples 1 to 13. Comparative Examples 1 to 9 were manufactured respectively using Comparative Compounds X-1 to X-9 as a light emitting layer dopant material.

A glass substrate on which ITO was patterned to a thickness of about 150 nm as a first electrode was ultrasonically cleaned with isopropyl alcohol and then with pure water for about 5 minutes each. After ultrasonic cleaning, UV irradiation was performed for about 30 minutes and ozone treatment was performed. After that, HAT-CN was deposited to a thickness of about 10 nm, α-NPD to a thickness of about 80 nm, and mCP to a thickness of about 5 nm, sequentially to form a hole transport region.

Then, the Example compound or the Comparative Compound and mCBP were co-deposited to form a light emitting layer to a thickness of about 20 nm. The Example Compound or the Comparative Compound and mCBP were co-deposited at a weight ratio of about 1:99. The Example Compound or the Comparative Compound was used as a dopant material in the manufacture of the light emitting element.

After that, TPBi to a thickness of about 30 nm and LiF to a thickness of about 0.5 nm were sequentially deposited to form an electron transport region.

Then, Al was deposited to a thickness of about 100 nm to form a second electrode.

In the embodiments, the hole transport region, the light emitting layer, the electron transport region, and the second electrode were each formed using a vacuum deposition device.

The compounds used in the respective light emitting layers of the Examples and Comparative Examples are shown in Table 1.

**Table 1**

| Division | Compound | Division | Compound |
|---|---|---|---|
| Exampl e 1 | 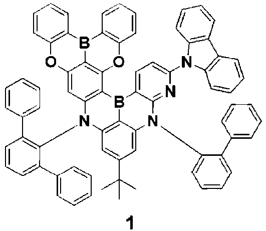 | Exampl e 2 | 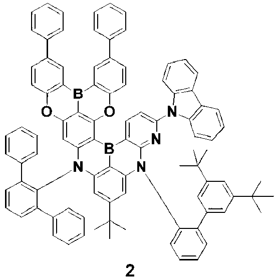 |
| Exampl e 3 | 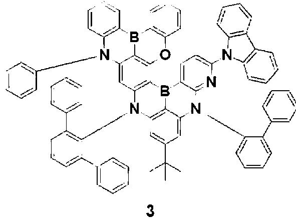 | Exampl e 4 | 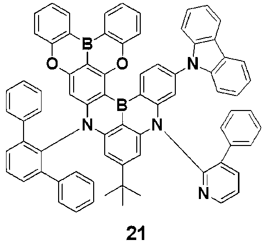 |
| Exampl e 5 | 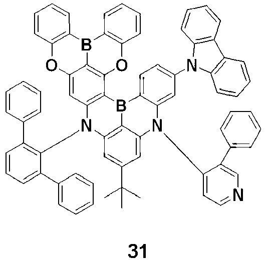 | Exampl e 6 | 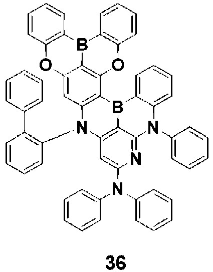 |
| Exampl e 7 | 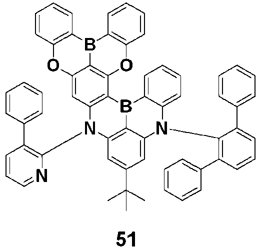 | Exampl e 8 | 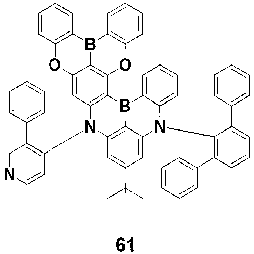 |
| Exampl e 9 | 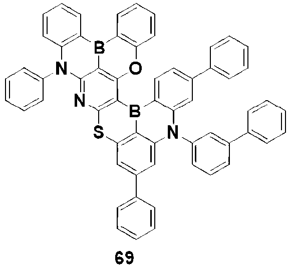 | Exampl e 10 | 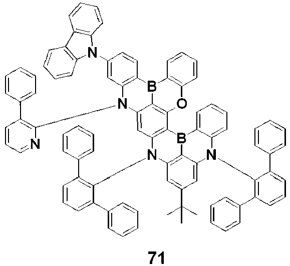 |
| Exampl e 11 | 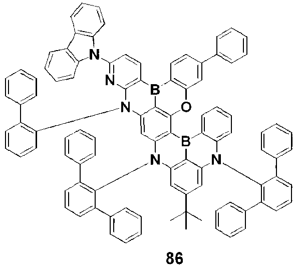 | Exampl e 12 | 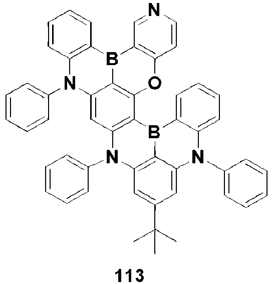 |
| Exampl e 13 | 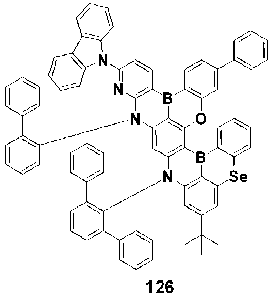 | | |
| Compar ative Exampl e 1 | 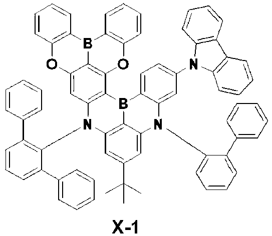 | Compar ative Exampl e 2 | 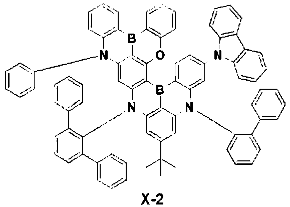 |
| Compar ative Exampl e 3 | 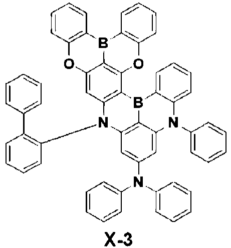 | Compar ative Exampl e 4 | 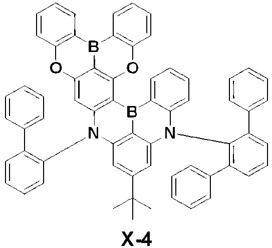 |
| Compar ative Exampl e 5 | 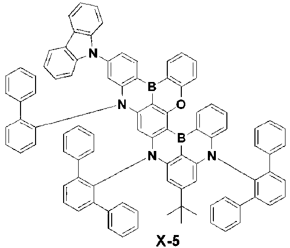 | Compar ative Exampl e 6 | 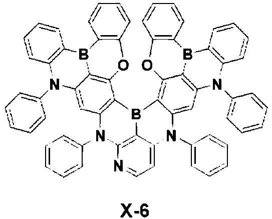 |
| Compar ative Exampl e 7 | 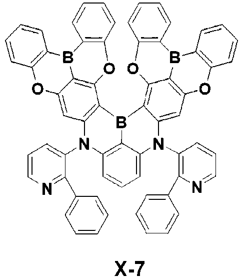 | Compar ative Exampl e 8 | 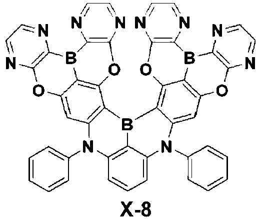 |
| Compar ative Exampl e 9 | 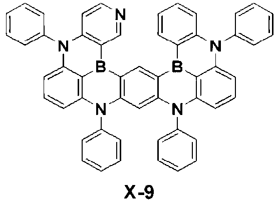 | | |

Besides, the other compounds used for the manufacture of the light emitting elements are as follows.

### Materials used for the manufacture of light emitting elements

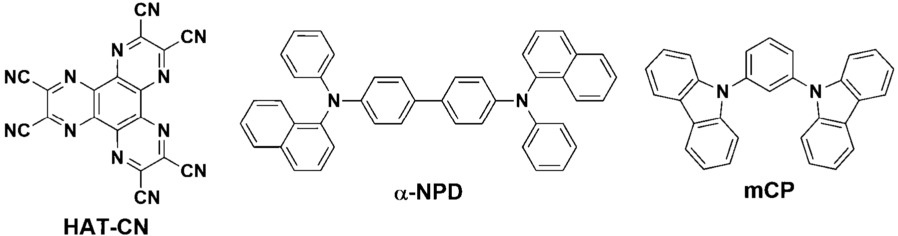

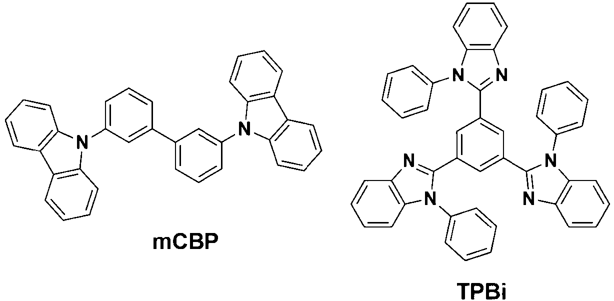

### (2) Evaluation of Light Emitting Elements

Table 2 shows the evaluation results of the light emitting elements of the Examples and Comparative Examples. Table 2 shows the relative element lifespan (LT50), maximum external quantum yield (EQEₘₐₓ), and fluorescence lifetime (τ) for each of the light emitting elements of the Examples and Comparative Examples.

The relative element lifespan (LT50) is expressed as the half-life, which is the time taken for the initial luminance of about 900 cd/m² to deteriorate to about 50% of the luminance when continuously driven, with the value of Comparative Example 9 set as 1.0. The voltage and current density of each of the organic electroluminescent devices were measured using a source meter (Keithley Instrument, 2400 series), and the luminance and external quantum efficiency were measured using an external quantum efficiency measuring device C9920-12 from Hamamatsu Photonics. The fluorescence lifetime was measured using a fluorescence lifetime measuring device from Hamamatsu Photonics.

**Table 2**

| Element manufacturi ng example | Dopant material | Relative element lifespan (LT50) | EQEₘₐₓ (%) | Fluorescence lifetime (τ) |
|---|---|---|---|---|
| | | | | (µs) |
| Example 1 | Compound 1 | 2.0 | 20.2 | 2.8 |
| Example 2 | Compound 2 | 2.1 | 20.4 | 2.6 |
| Example 3 | Compound 3 | 2.0 | 20.8 | 2.9 |
| Example 4 | Compound 21 | 2.1 | 20.5 | 2.8 |
| Example 5 | Compound 31 | 2.1 | 19.8 | 2.8 |
| Example 6 | Compound 36 | 2.0 | 20.0 | 2.7 |
| Example 7 | Compound 51 | 2.0 | 18.5 | 2.9 |
| Example 8 | Compound 61 | 1.9 | 18.2 | 2.9 |
| Example 9 | Compound 69 | 1.9 | 20.0 | 2.9 |
| Example 10 | Compound 71 | 2.1 | 19.5 | 2.5 |
| Example 11 | Compound 86 | 2.2 | 20.0 | 2.9 |
| Example 12 | Compound 113 | 2.1 | 20.1 | 2.8 |
| Example 13 | Compound 126 | 2.2 | 20.5 | 2.4 |
| Comparativ e Example 1 | Compound X-1 | 1.8 | 18.1 | 4.1 |
| Comparativ e Example 2 | Compound X-2 | 1.7 | 18.0 | 3.8 |
| Comparativ e Example 3 | Compound X-3 | 1.8 | 17.2 | 4.0 |
| Comparativ e Example 4 | Compound X-4 | 1.7 | 17.1 | 3.9 |
| Comparativ e Example 5 | Compound X-5 | 1.8 | 17.6 | 3.6 |
| Comparativ e Example 6 | Compound X-6 | 0.9 | 17.5 | 3.2 |
| Comparativ e Example 7 | Compound X-7 | 0.8 | 17.3 | 3.3 |
| Comparativ e Example 8 | Compound X-8 | 0.9 | 17.7 | 3.2 |
| Comparativ e Example 9 | Compound X-9 | 1.0 | 18.0 | 4.8 |

Referring to the results of Table 2, the light emitting elements of the Examples each showed increased relative element lifespan characteristics and high maximum external quantum yield (EQEₘₐₓ) characteristics compared to the light emitting elements of the Comparative Examples. In addition, the light emitting elements of the Examples each showed shorter fluorescence lifetime characteristics compared to the light emitting elements of the Comparative Examples. For example, it can be confirmed that the light emitting elements of the Examples each showed long element lifespan and high efficiency characteristics compared to the light emitting elements of the Comparative Examples. In the cases of the Comparative Compounds used in Comparative Examples 1 to 5, there is a difference in that Comparative Compounds have a skeleton of the core structure of the heteroborine included in the Examples, but some of the carbon in the heteroborine core skeleton is not converted to nitrogen, or the pyridyl group is not substituted for the amino group in the heteroborine skeleton. Accordingly, Comparative Examples 1 to 5 showed characteristics in which both (e.g., simultaneously) the element lifespan and the luminescence efficiency were reduced compared to the Examples.

In the cases of the Comparative Compounds used in Comparative Examples 6 to 8, there is a difference in that two di-oxaborine skeletons are additionally fused on the skeleton of the core structure of the heteroborine included in the Example Compounds. Comparative Examples 6 to 8 showed significantly reduced element lifespan characteristics compared to the Examples. Without being bound by any theory, it is thought that the reduced element lifespan characteristics of the Comparative Examples are because the Comparative Compounds X-6 to X-8 respectively used in Comparative Examples 6 to 8 each have relatively greater acceptor characteristics compared to the Example Compounds, so that electron trapping in the Comparative Example elements is accelerated.

Comparative Compound X-9 used in Comparative Example 9 is different in having a modified DABNA core structure that is different from the core structure of the heteroborine included in the Example Compounds. Without being bound by any theory, it is thought that the light emitting element of Comparative Example 9 shows reduced element lifespan characteristics because the fluorescence lifetime thereof is prolonged due to the characteristics of Comparative Compound X-9 having the different core structure.

The polycyclic compound of one or more embodiments includes a boron-containing fused ring core containing two boron atoms, a structure in which some of the carbon in the fused ring core skeleton is converted to nitrogen, or a structure in which a pyridyl group is substituted for an amino group forming the boron-containing fused ring core skeleton. The polycyclic compound of one or more embodiments may have a fused ring core structure including nitrogen as a ring-forming atom or including an amino group substituted with a pyridyl group as a core skeleton, and may have a short fluorescence lifetime due to increased absorbance. Accordingly, the polycyclic compound of one or more embodiments may exhibit improved lifetime characteristics and excellent or suitable light emitting efficiency characteristics. In addition, the polycyclic compound of one or more embodiments may be used as a thermally activated delayed fluorescence material. The light emitting element of one or more embodiments, including the polycyclic compound of one or more embodiments in the light emitting layer, may exhibit excellent or suitable emission efficiency characteristics in a blue light emitting range and may exhibit long-life characteristics.

The electronic device including the light emitting element including the polycyclic compound of one or more embodiments may exhibit excellent or suitable reliability characteristics according to the long-life characteristics of the light emitting element. In addition, the electronic device of one or more embodiments, including the light emitting element including the polycyclic compound of one or more embodiments with improved emission efficiency, may exhibit improved characteristics in luminance characteristics and display quality.

The light emitting element of one or more embodiments may show high efficiency and long-life characteristics by including the polycyclic compound of one or more embodiments in a light emitting layer.

The polycyclic compound of one or more embodiments may contribute to the increase of light efficiency and lifespan of the light emitting element.

The electronic device of one or more embodiments may show excellent or suitable display quality and improved reliability properties.

The foregoing description and examples should collectively demonstrate that the disclosed polycyclic compounds, when incorporated as dopants in light emitting layers, enable thermally activated delayed fluorescence with short fluorescence lifetimes (≤3.0 µs) and high external quantum efficiency in the blue emission range. The examples should further confirm that structural variations-such as heteroatom substitution, pyridyl incorporation, and optional deuteration-contribute to improved material stability and device longevity. In combination with host and sensitizer systems described herein, these compounds provide balanced charge transport and efficient energy transfer, resulting in enhanced luminance and extended operational lifetime for light emitting elements and electronic devices.

In the present disclosure, expressions such as "at least one of," "one of," and "selected from," when preceding a list of elements, modify the entire list of elements and do not modify the individual elements of the list. For example, "at least one of a, b, or c," "at least one selected from among a, b, and c," "at least one selected from among a to c," and/or the like, may indicate only a, only b, only c, both (e.g., simultaneously) a and b, both (e.g., simultaneously) a and c, both (e.g., simultaneously) b and c, all of a, b, and c, or variations thereof. The "/" utilized herein may be interpreted as "and" or as "or" depending on the situation.

As utilized herein, the terms "substantially," "about," or similar terms are used as terms of approximation and not as terms of degree, and are intended to account for the inherent deviations in measured or calculated values that would be recognized by those of ordinary skill in the art. "About" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, ± 20%, ± 10%, or ± 5% of the stated value. Also, it should be understood that, even if the terms "about," "approximately," or "substantially" are not expressly recited in a given element (e.g., a claim element), the scope of such element is intended to include variations that are insubstantial or within the understanding of one of ordinary skill in the art. For example, numerical values and ranges provided herein are intended to include tolerances and measurement uncertainties that would be recognized by those skilled in the art, and the elements (e.g., claim elements) should be construed accordingly to encompass such equivalents.

In the context of the present application and unless otherwise defined, the terms "use," "using," and "used" may be considered synonymous with the terms "utilize," "utilizing," and "utilized," respectively.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein.

The light emitting element, the display module, the display device, the electronic device, a device for manufacturing the same, or any other relevant apparatuses/devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random-access memory

(RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

In the present disclosure, each suitable feature of the various embodiments of the disclosure may be combined or combined with each other, partially or entirely, and may be technically interlocked and operated in various suitable ways, and each embodiment may be implemented independently of each other or in conjunction with each other in any suitable manner unless otherwise stated or implied.

In the above, description has been made with reference to one or more embodiments of the disclosure, but those skilled or of ordinary skill in the art may understand that one or more suitable modifications and changes may be made to the disclosure insofar as such modifications and changes do not depart from the technical scope of the disclosure set forth in the appended claims.

Therefore, the technical scope of the disclosure is not to be limited to the content stated in the detailed description of the disclosure, but should be determined by the claims and equivalents thereof.

## Claims

1. A light emitting element (ED), comprising:
a first electrode (EL1);
a second electrode (EL2) on the first electrode (EL1); and
a light emitting layer (EML) between the first electrode (EL1) and the second electrode (EL2) and comprising a first compound represented by Formula 1: 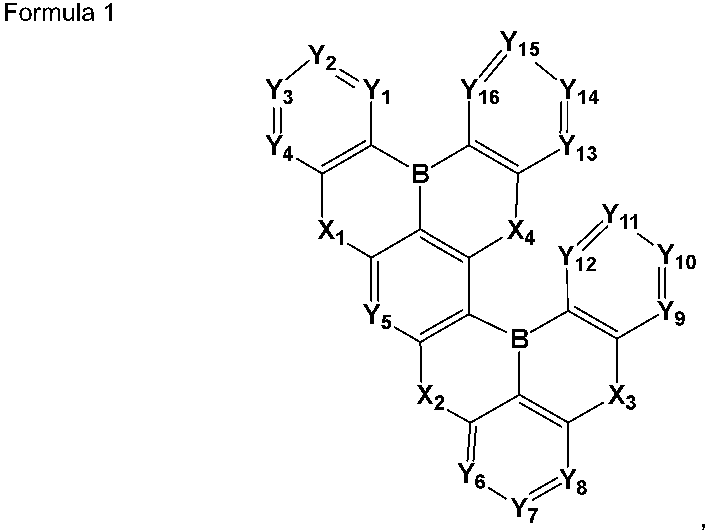
wherein, in Formula 1,
X₁ to X₄ are each independently O, S, or Se, or represented by Formula 2,
Y₁ to Y₁₆ are each independently CRₐ or N, and
Rₐ is hydrogen, deuterium, a cyano group, a substituted or unsubstituted amino group, a substituted or unsubstituted alkyl group of 1 to 10 carbon atoms, a substituted or unsubstituted aryl group of 6 to 30 ring-forming carbon atoms, or a substituted or unsubstituted heteroaryl group of 2 to 30 ring-forming carbon atoms: 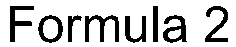 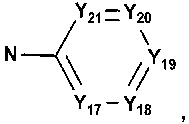
in Formula 2,
Y₁₇ to Y₂₁ are each independently CR_{b} or N, and
R_{b} is hydrogen, deuterium, a cyano group, a substituted or unsubstituted amino group, a substituted or unsubstituted alkyl group of 1 to 10 carbon atoms, a substituted or unsubstituted aryl group of 6 to 30 ring-forming carbon atoms, or a substituted or unsubstituted heteroaryl group of 2 to 30 ring-forming carbon atoms,
when none of X₁ to X₄ of Formula 1 is represented by Formula 2, then at least one selected from among Y₁ to Y₁₆ of Formula 1 is N, and
when at least one selected from among X₁ to X₄ of Formula 1 is represented by Formula 2, at least one selected from among Y₁ to Y₁₆ of Formula 1 and Y₁₇ to Y₂₁ of Formula 2 is N.

2. The light emitting element (ED) of claim 1, wherein the light emitting layer (EML) further comprises at least one selected from among a second compound represented by Formula HT-1 and a third compound represented by Formula ET-1: 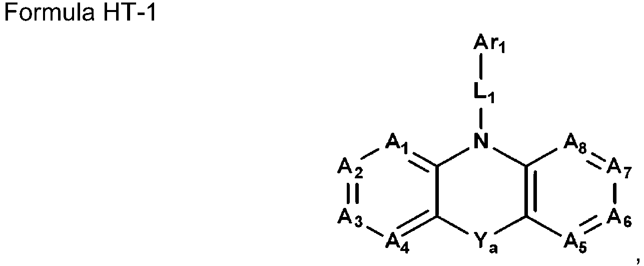 wherein, in Formula HT-1,
A₁ to As are each independently N or CR₅₁,
L₁ is a direct linkage, a substituted or unsubstituted arylene group of 6 to 30 ring-forming carbon atoms, or a substituted or unsubstituted heteroarylene group of 2 to 30 ring-forming carbon atoms,
Yₐ is a direct linkage, CR₅₂R₅₃, or SiR₅₄R₅₅,
Ar₁ is a substituted or unsubstituted aryl group of 6 to 30 ring-forming carbon atoms or a substituted or unsubstituted heteroaryl group of 2 to 30 ring-forming carbon atoms, and
R₅₁ to R₅₅ are each independently hydrogen, deuterium, a halogen, a cyano group, a substituted or unsubstituted silyl group, a substituted or unsubstituted thio group, a substituted or unsubstituted oxy group, a substituted or unsubstituted amino group, a substituted or unsubstituted boron group, a substituted or unsubstituted alkyl group of 1 to 20 carbon atoms, a substituted or unsubstituted alkenyl group of 2 to 20 carbon atoms, a substituted or unsubstituted aryl group of 6 to 60 ring-forming carbon atoms, or a substituted or unsubstituted heteroaryl group of 2 to 60 ring-forming carbon atoms, and/or combined with an adjacent group to form a ring, 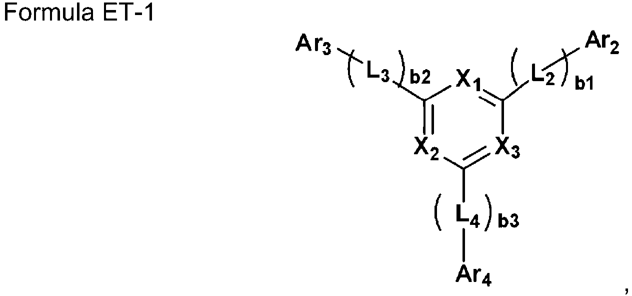 and
wherein, in Formula ET-1,
at least one selected from among X₁ to X₃ is N, and the remainder are CR₅₆,
R₅₆ is hydrogen, deuterium, a substituted or unsubstituted alkyl group of 1 to 20 carbon atoms, a substituted or unsubstituted aryl group of 6 to 60 ring-forming carbon atoms, or a substituted or unsubstituted heteroaryl group of 2 to 60 ring-forming carbon atoms,
b1 to b3 are each independently an integer of 0 to 10,
Ar₂ to Ar₄ are each independently hydrogen, deuterium, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and
L₂ to L₄ are each independently a direct linkage, a substituted or unsubstituted arylene group of 6 to 30 ring-forming carbon atoms, or a substituted or unsubstituted heteroarylene group or 2 to 30 ring-forming carbon atoms, optionally wherein the light emitting layer (EML) further comprises a fourth compound represented by Formula D-1: 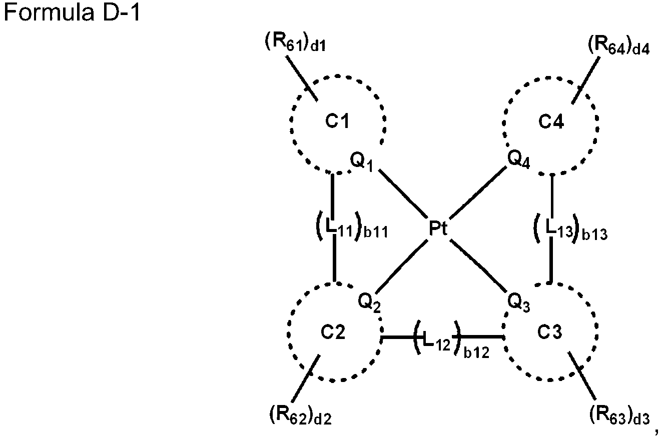 and
wherein, in Formula D-1,
Q₁ to Q₄ are each independently C or N,
C1 to C4 are each independently a substituted or unsubstituted hydrocarbon ring of 5 to 30 ring-forming carbon atoms or a substituted or unsubstituted heterocycle of 2 to 30 ring-forming carbon atoms,
L₁₁ to L₁₃ are each independently a direct linkage, *-o-* , *-s-*, 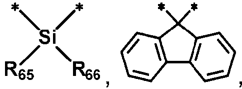 a substituted or unsubstituted alkylene group of 1 to 20 carbon atoms, a substituted or unsubstituted arylene group of 6 to 30 ring-forming carbon atoms, or a substituted or unsubstituted heteroarylene group of 2 to 30 ring-forming carbon atoms,
b11 to b13 are each independently 0 or 1,
R₆₁ to R₆₆ are each independently hydrogen, deuterium, a halogen, a cyano group, a substituted or unsubstituted silyl group, a substituted or unsubstituted thio group, a substituted or unsubstituted oxy group, a substituted or unsubstituted amino group, a substituted or unsubstituted boron group, a substituted or unsubstituted alkyl group of 1 to 20 carbon atoms, a substituted or unsubstituted alkenyl group of 2 to 20 carbon atoms, a substituted or unsubstituted aryl group of 6 to 60 ring-forming carbon atoms, or a substituted or unsubstituted heteroaryl group of 2 to 60 ring-forming carbon atoms, and
d1 to d4 are each independently an integer of 0 to 4.

3. The light emitting element (ED) of claim 1 or claim 2, wherein a fluorescence lifetime of the first compound is 3.0 µs or less.

4. The light emitting element (ED) of any one of claims 1 to 3, wherein:
(i) the light emitting layer (EML) is to emit delayed fluorescence; and/or
(ii) the light emitting layer (EML) is to emit blue color light.

5. The light emitting element (ED) of any one of claims 1 to 5, wherein
one selected from among one selected from among Y₁ to Y₄, one selected from among Y₆ to Y₈, one selected from Y₁₃ to Y₁₆, and Y₅ in Formula 1 is N, and the remainder are each independently CRₐ,
X₁ to X₄ in Formula 1 are each independently O, S, or Se, or represented by Formula 2-1: 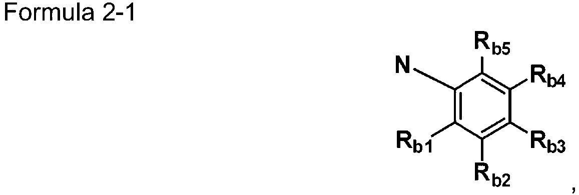
in Formula 2-1,
R_{b1} to R_{b5} being each independently hydrogen, deuterium, a cyano group, a substituted or unsubstituted amino group, a substituted or unsubstituted alkyl group of 1 to 10 carbon atoms, a substituted or unsubstituted aryl group of 6 to 30 ring-forming carbon atoms, or a substituted or unsubstituted heteroaryl group of 2 to 30 ring-forming carbon atoms.

6. The light emitting element (ED) of any one of claims 1 to 5, wherein
in the first compound of Formula 1 where Y₁ to Y₁₆ are each independently CRₐ,
at least one selected from X₁ to X₄ of Formula 1 is represented by the Formula 2, and
one selected from among Y₁₇ to Y₂₁ in Formula 2 is N, and the remainder are each independently CR_{b}.

7. The light emitting element (ED) of any one of claims 1 to 6, wherein at least one hydrogen atom of the first compound is substituted with deuterium.

8. The light emitting element (ED) of any one of claims 1 to 4, wherein the first compound comprises at least one selected from among compounds in Compound Group 1: 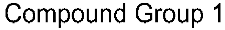 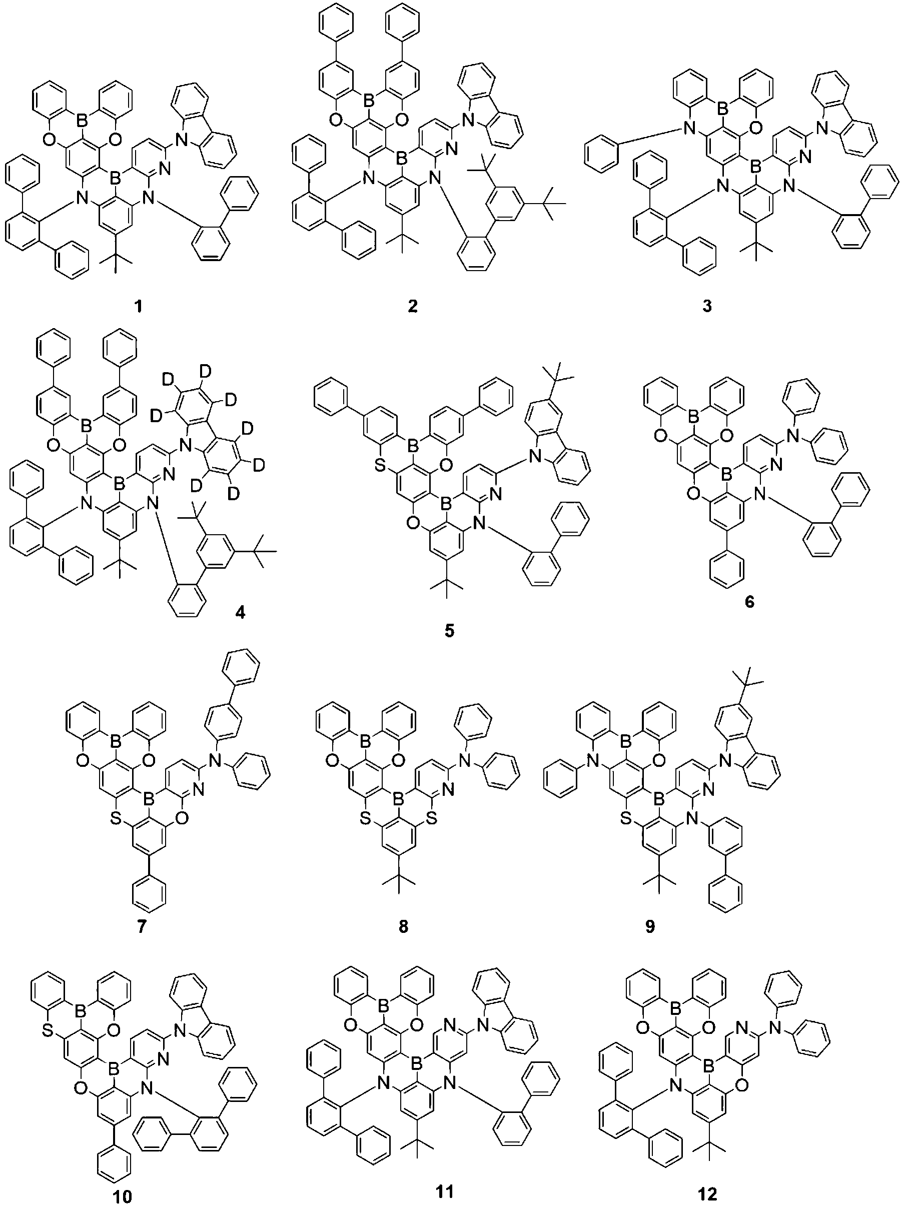 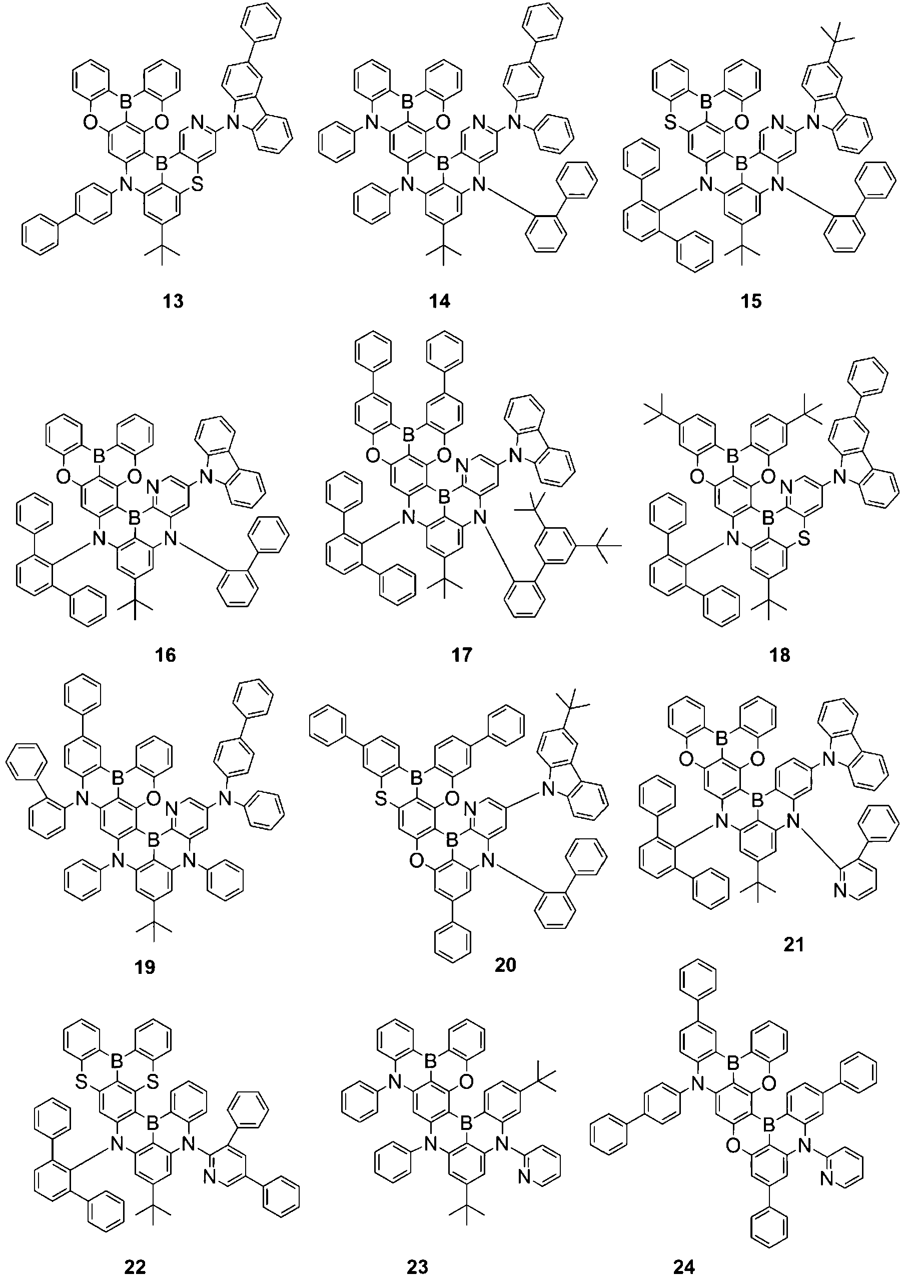 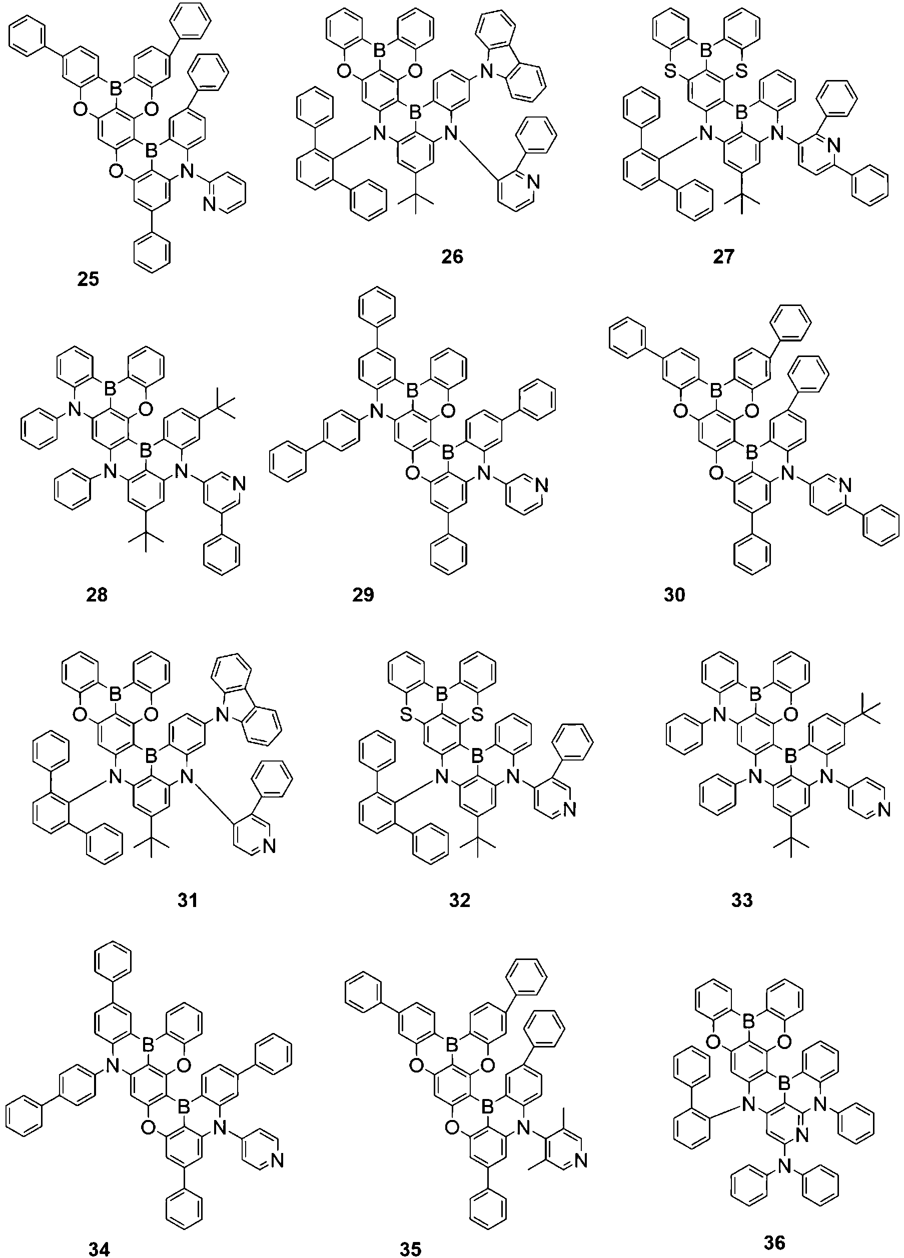 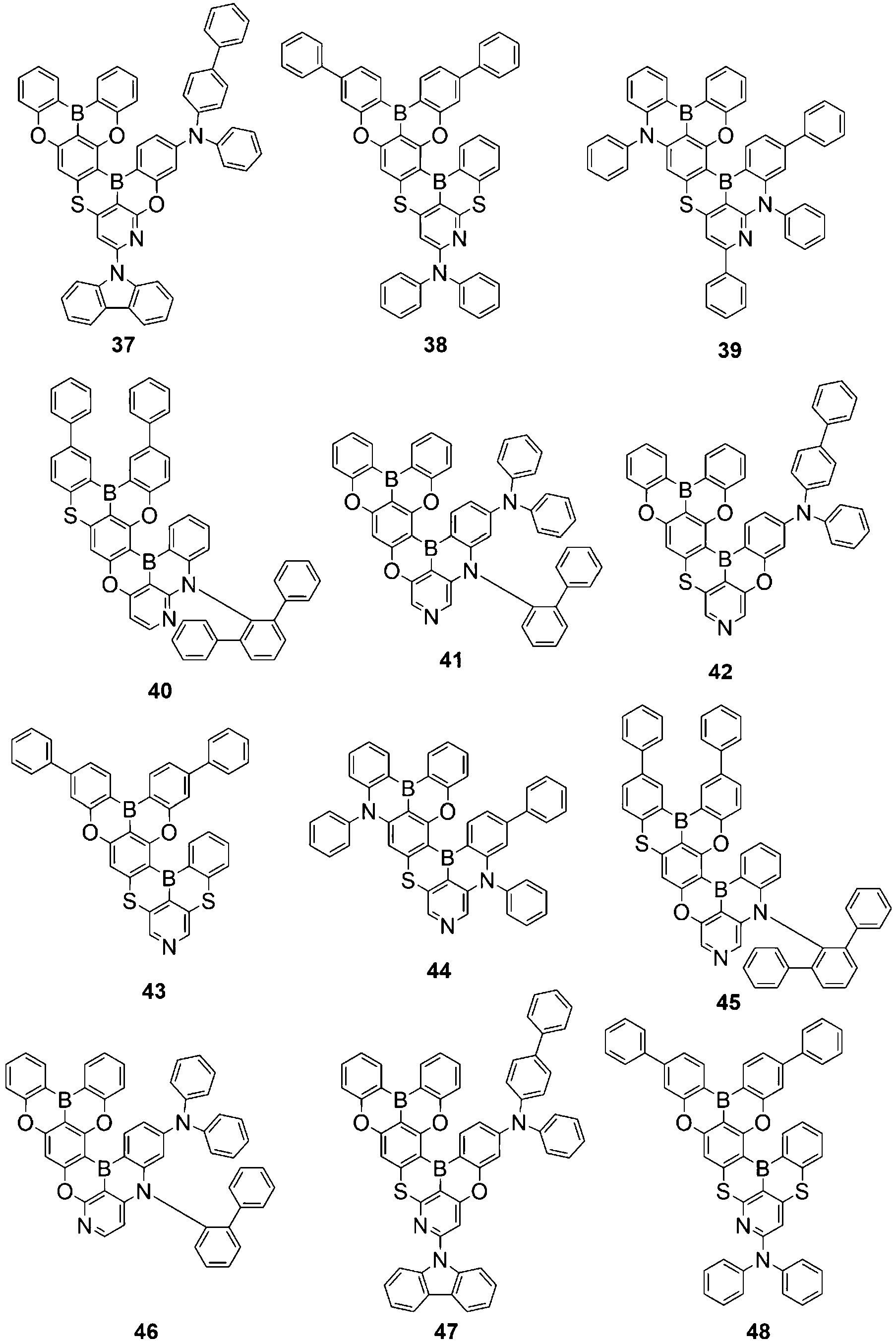 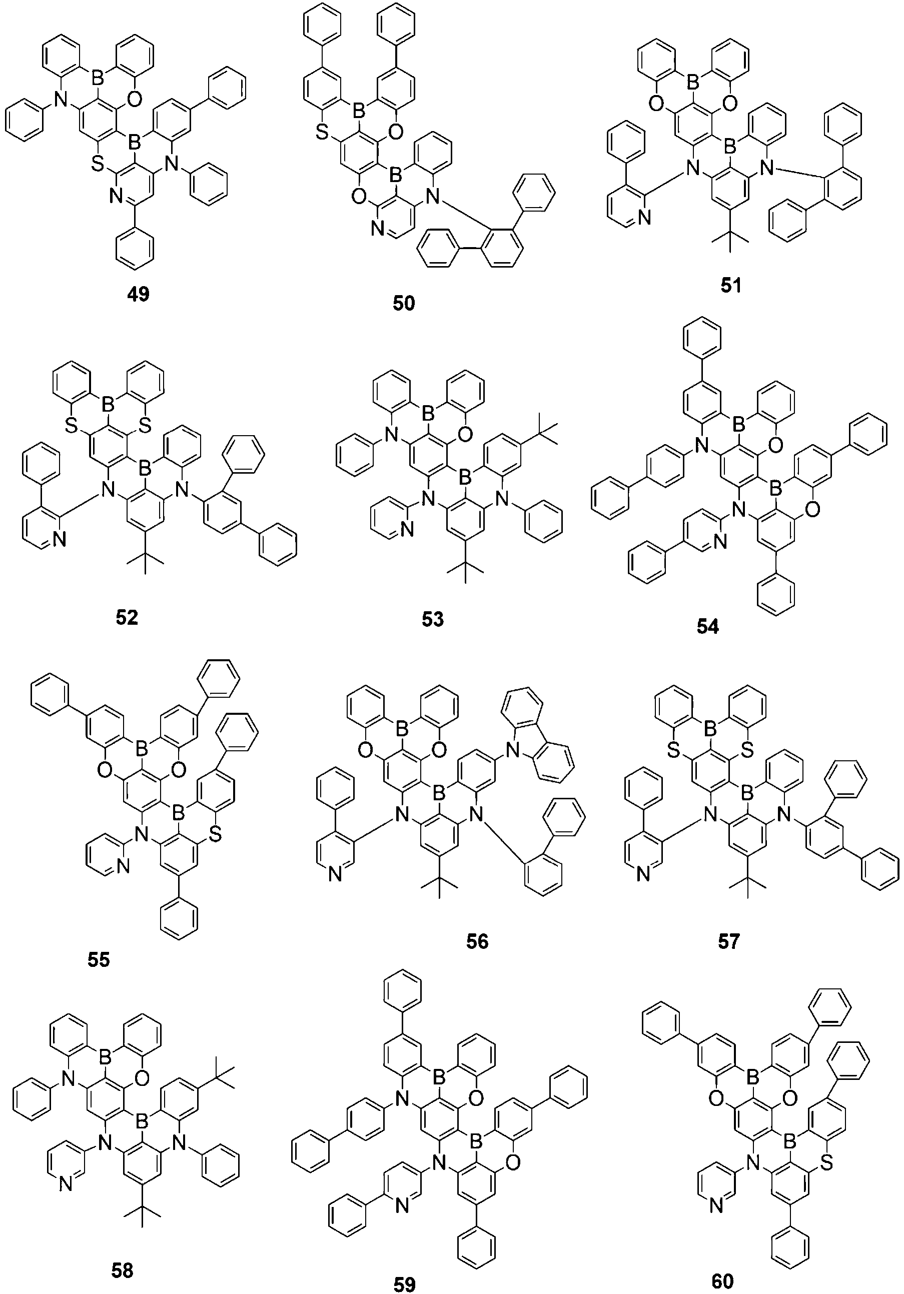 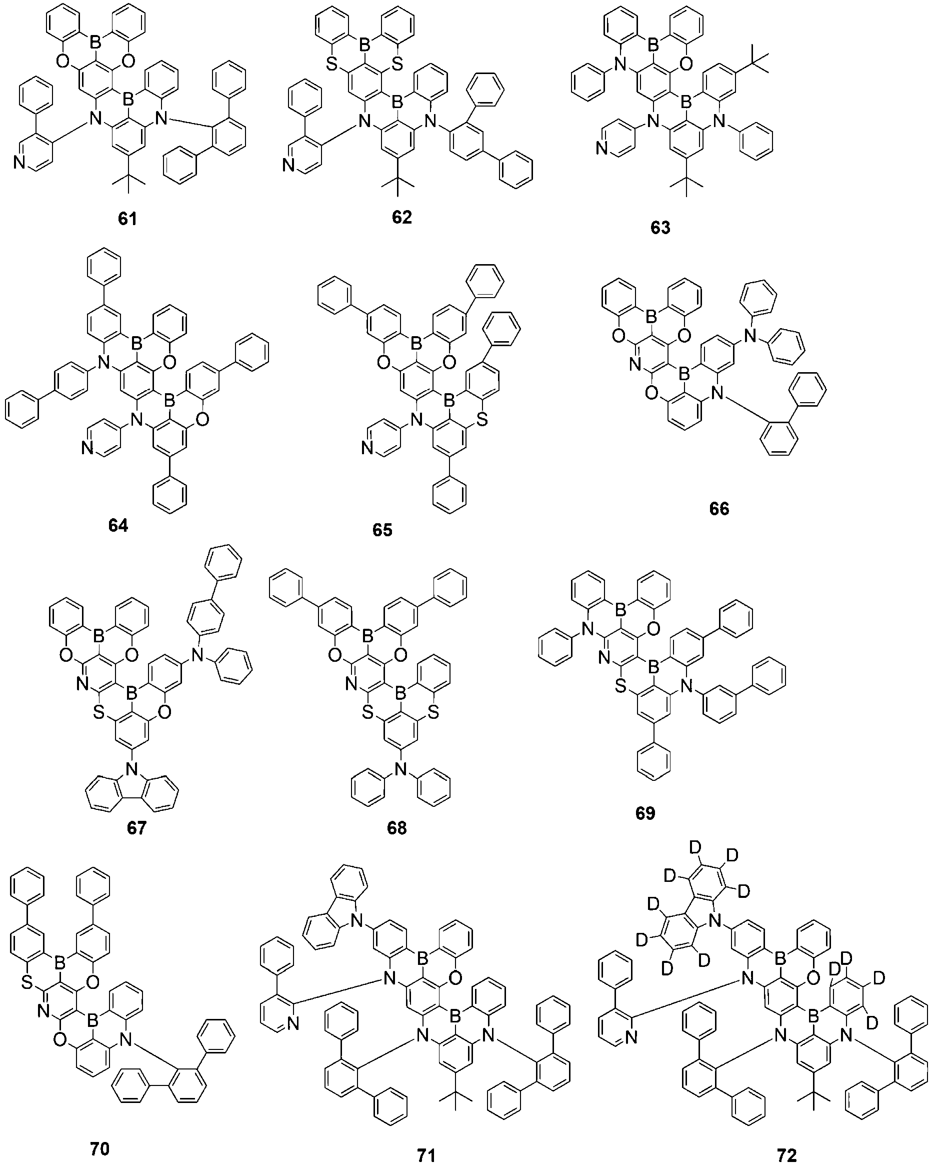 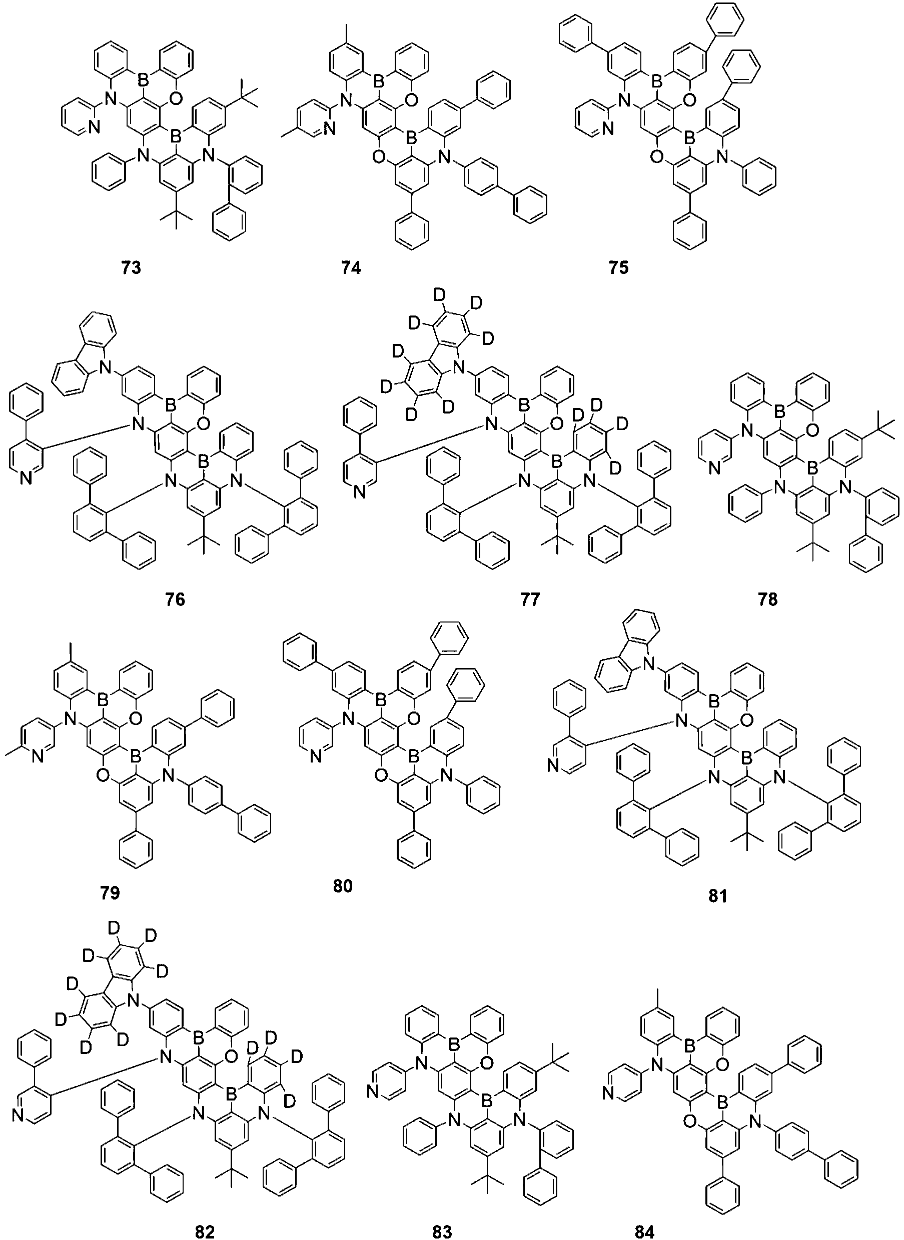 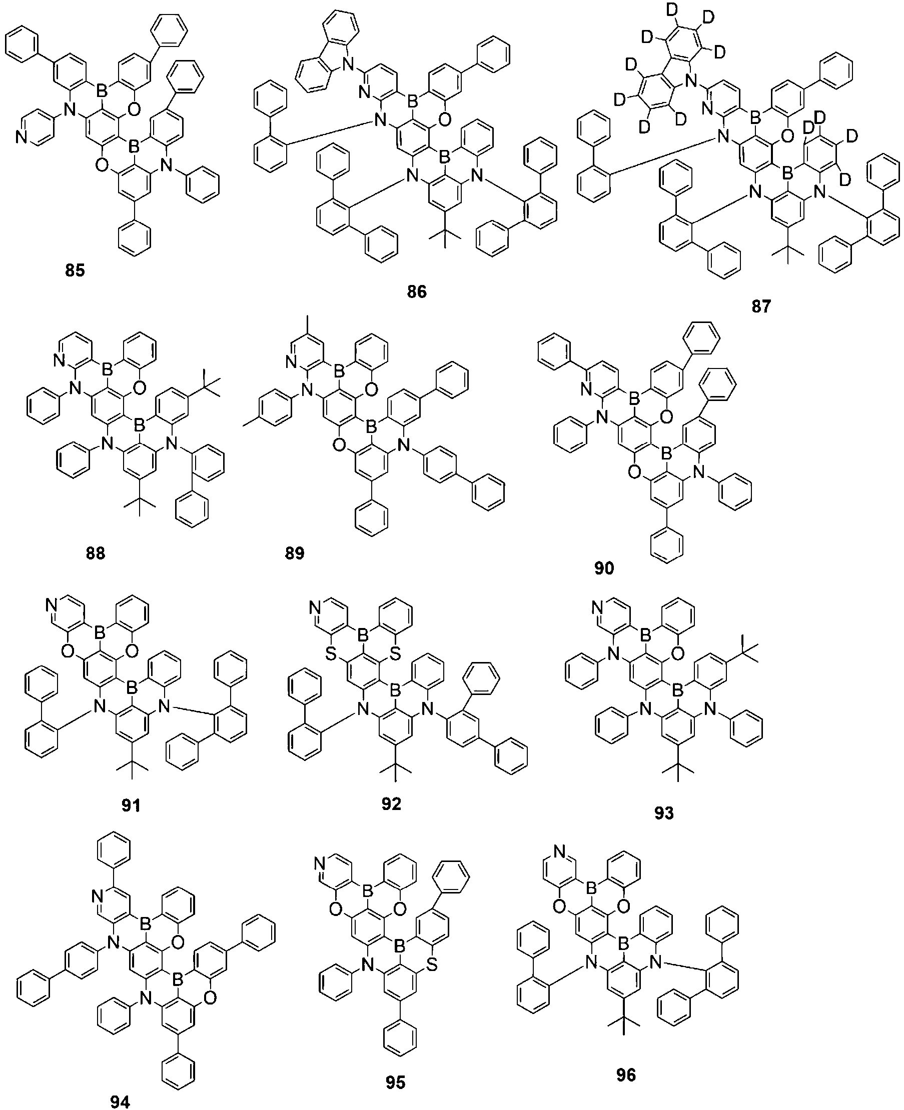 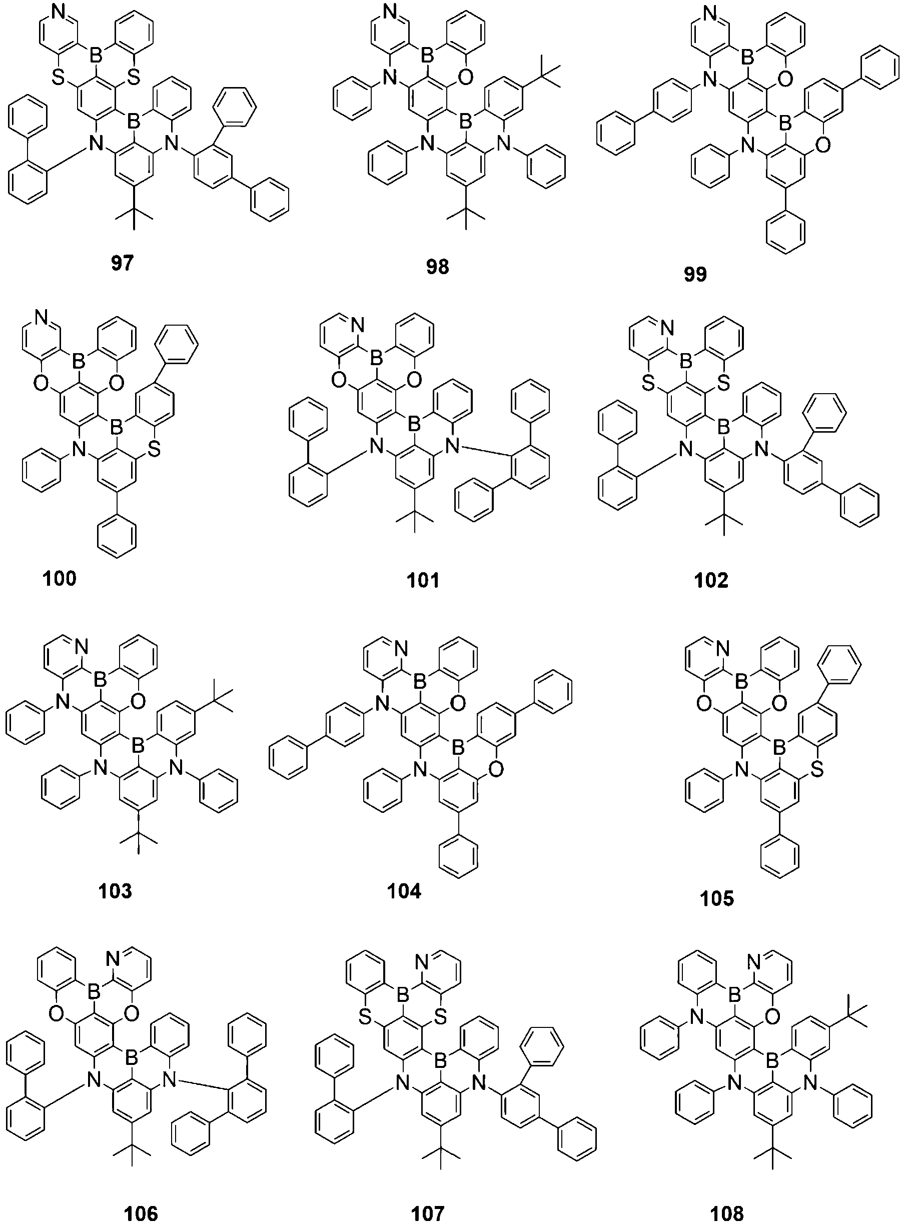 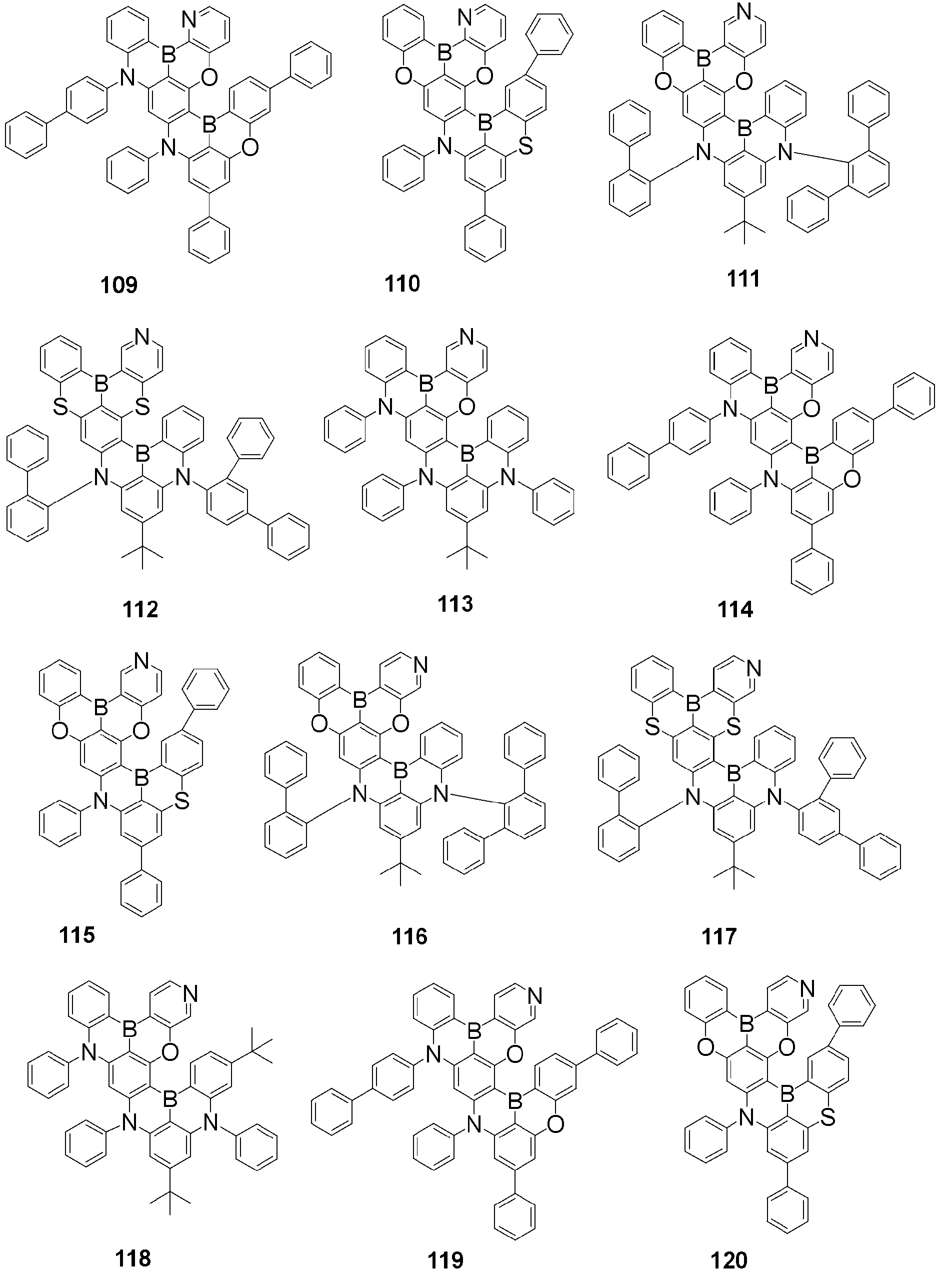 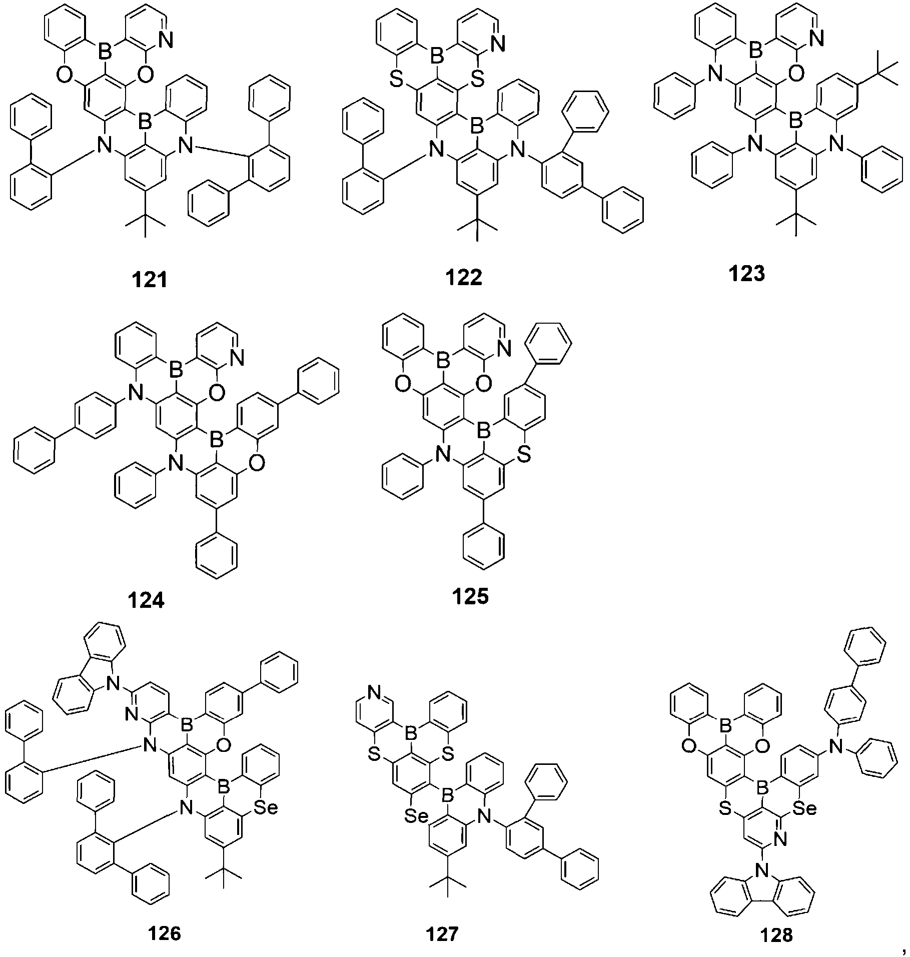 in Compound Group 1, D being deuterium.

9. A polycyclic compound represented by Formula 1: 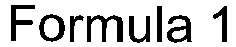 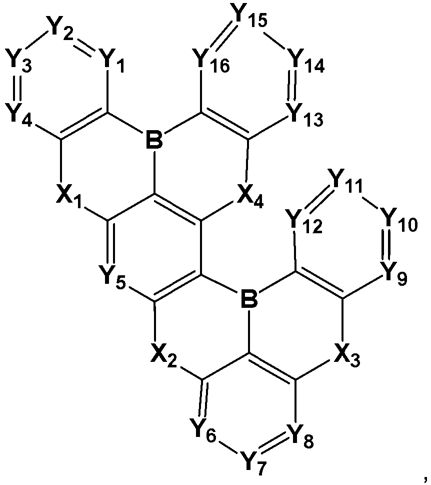 wherein, in Formula 1,
X₁ to X₄ are each independently O, S, or Se, or represented by Formula 2,
Y₁ to Y₁₆ are each independently CRₐ or N, and
Rₐ is hydrogen, deuterium, a cyano group, a substituted or unsubstituted amino group, a substituted or unsubstituted alkyl group of 1 to 10 carbon atoms, a substituted or unsubstituted aryl group of 6 to 30 ring-forming carbon atoms, or a substituted or unsubstituted heteroaryl group of 2 to 30 ring-forming carbon atoms: 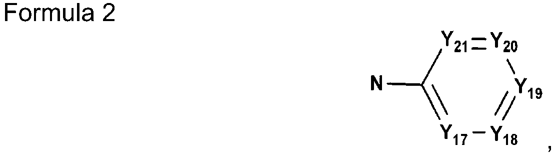 and
wherein, in Formula 2,
Y₁₇ to Y₂₁ are each independently CR_{b} or N, and
R_{b} is hydrogen, deuterium, a cyano group, a substituted or unsubstituted amino group, a substituted or unsubstituted alkyl group of 1 to 10 carbon atoms, a substituted or unsubstituted aryl group of 6 to 30 ring-forming carbon atoms, or a substituted or unsubstituted heteroaryl group of 2 to 30 ring-forming carbon atoms,
when none of X₁ to X₄ of Formula 1 is represented by Formula 2, then at least one selected from among Y₁ to Y₁₆ of Formula 1 is N, and
when at least one selected from among X₁ to X₄ of Formula 1 is represented by Formula 2, at least one selected from among Y₁ to Y₁₆ of Formula 1 and Y₁₇ to Y₂₁ of Formula 2 is N.

10. The polycyclic compound of claim 9, wherein Formula 2 is represented by Formula 2-1, or one selected from among Y₁₇ to Y₂₁ is N, and the remainder are each independently CR_{b} in Formula 2: 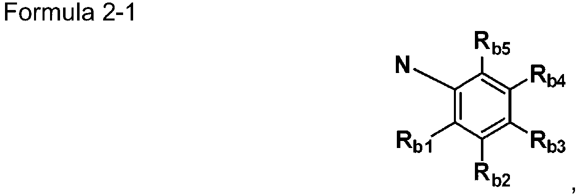 in Formula 2-1,
R_{b1} to R_{b5} being each independently hydrogen, deuterium, a cyano group, a substituted or unsubstituted amino group, a substituted or unsubstituted alkyl group of 1 to 10 carbon atoms, a substituted or unsubstituted aryl group of 6 to 30 ring-forming carbon atoms, or a substituted or unsubstituted heteroaryl group of 2 to 30 ring-forming carbon atoms.

11. The polycyclic compound of claim 9, wherein
one selected from among one selected from among Y₁ to Y₄, one selected from among Y₆ to Y₈, one selected from among Y₁₃ to Y₁₆, and Y₅ in Formula 1 is N, and the remainder are each independently CRₐ,
X₁ to X₄ in Formula 1 are each independently O, S, or Se, or represented by Formula 2-1: 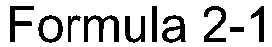 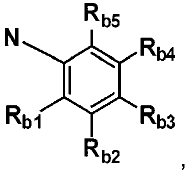
in Formula 2-1,
R_{b1} to R_{b5} being each independently hydrogen, deuterium, a cyano group, a substituted or unsubstituted amino group, a substituted or unsubstituted alkyl group of 1 to 10 carbon atoms, a substituted or unsubstituted aryl group of 6 to 30 ring-forming carbon atoms, or a substituted or unsubstituted heteroaryl group of 2 to 30 ring-forming carbon atoms.

12. The polycyclic compound of claim 9, wherein
when Y₁ to Y₁₆ of Formula 1 are each independently CRₐ, at least one selected from among X₁ to X₄ is represented by Formula 2, and
in Formula 2, one selected from among Y₁₇ to Y₂₁ is N, and the remainder are each independently CR_{b}.

13. The polycyclic compound of any one of claims 9 to 12, wherein:
(i) at least one hydrogen atom in Formula 1 and Formula 2 is substituted with deuterium; and/or
(ii) the polycyclic compound is a blue emitting dopant; and/or
(iii) the polycyclic compound is a thermally activated delayed fluorescence material.

14. The polycyclic compound of claim 9, wherein the polycyclic compound is any one selected from among compounds in Compound Group 1: 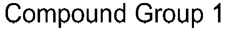 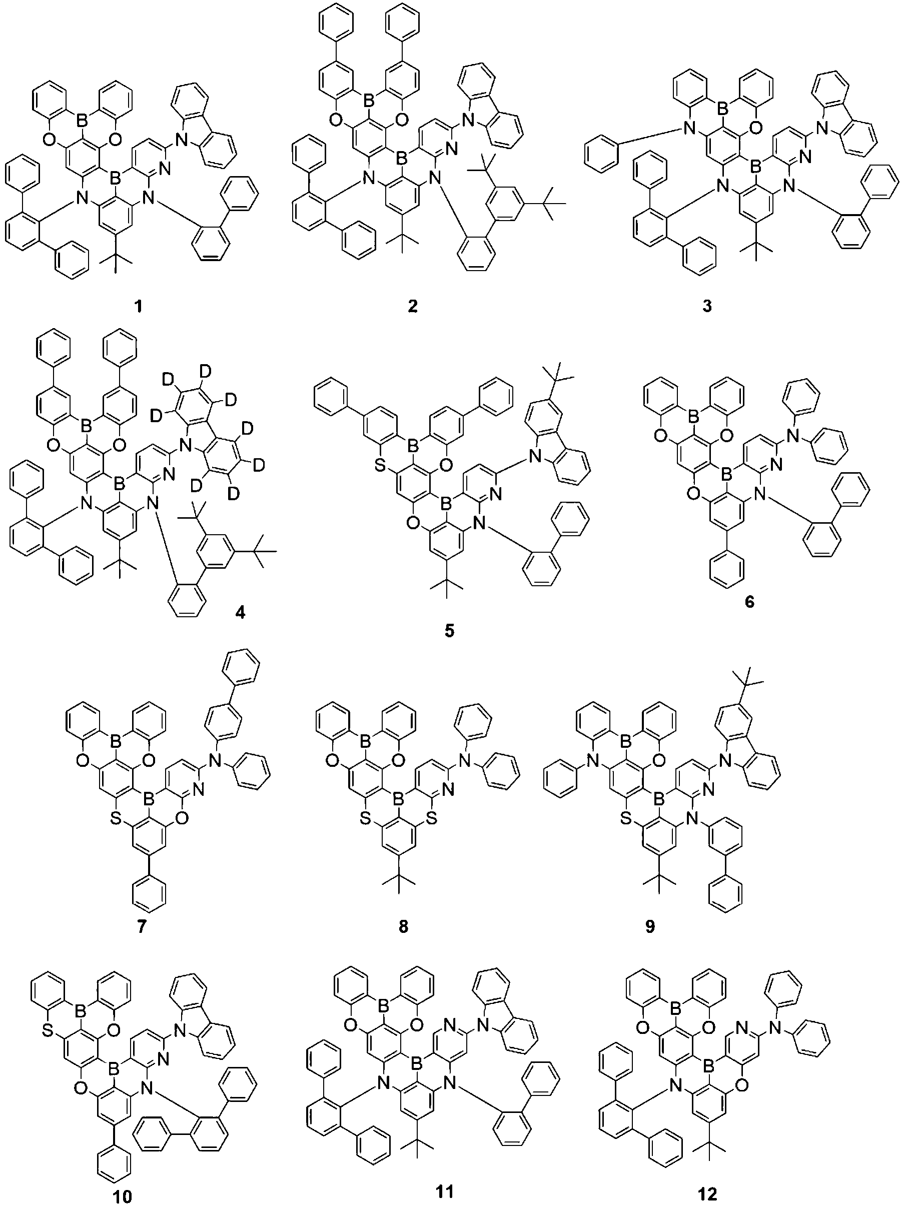 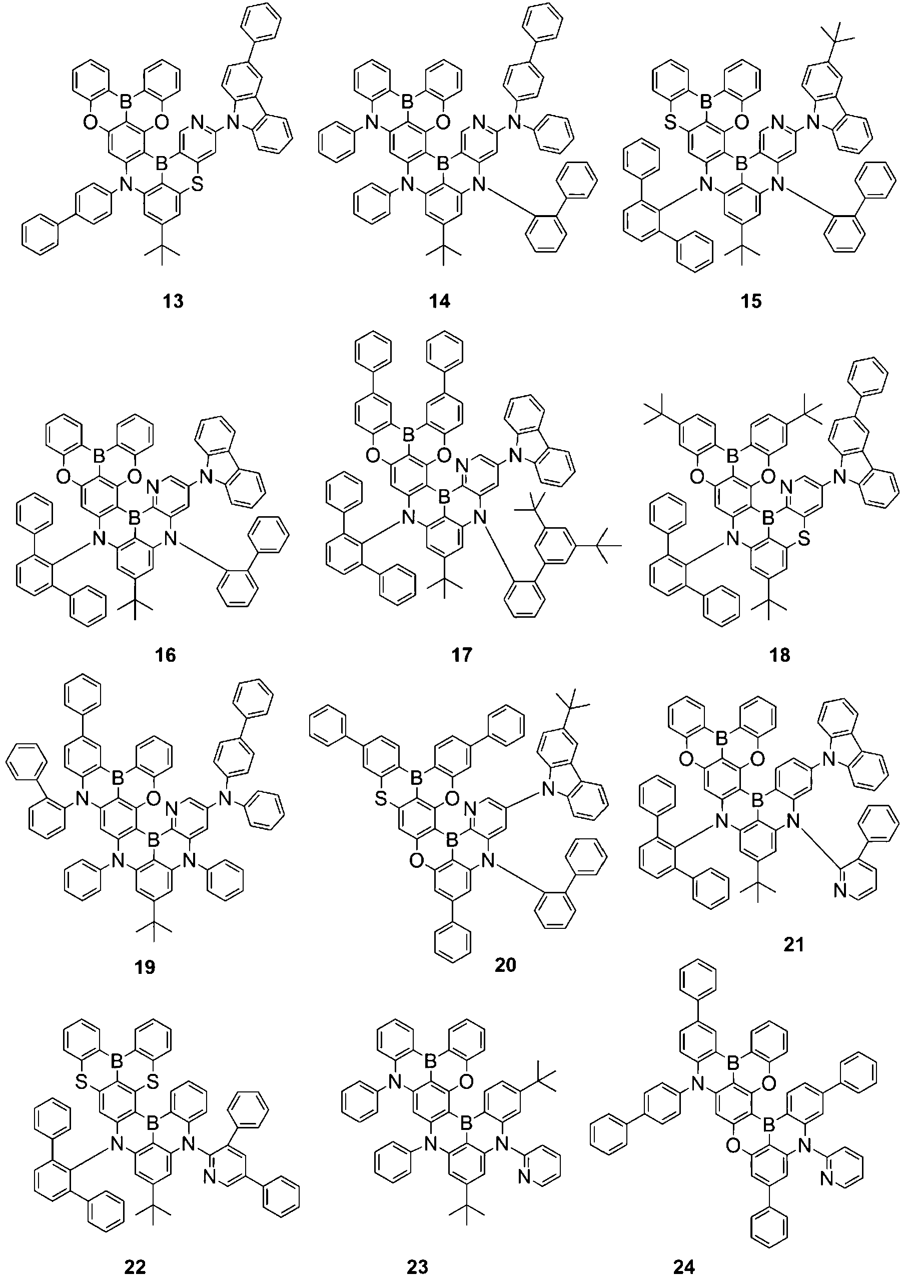 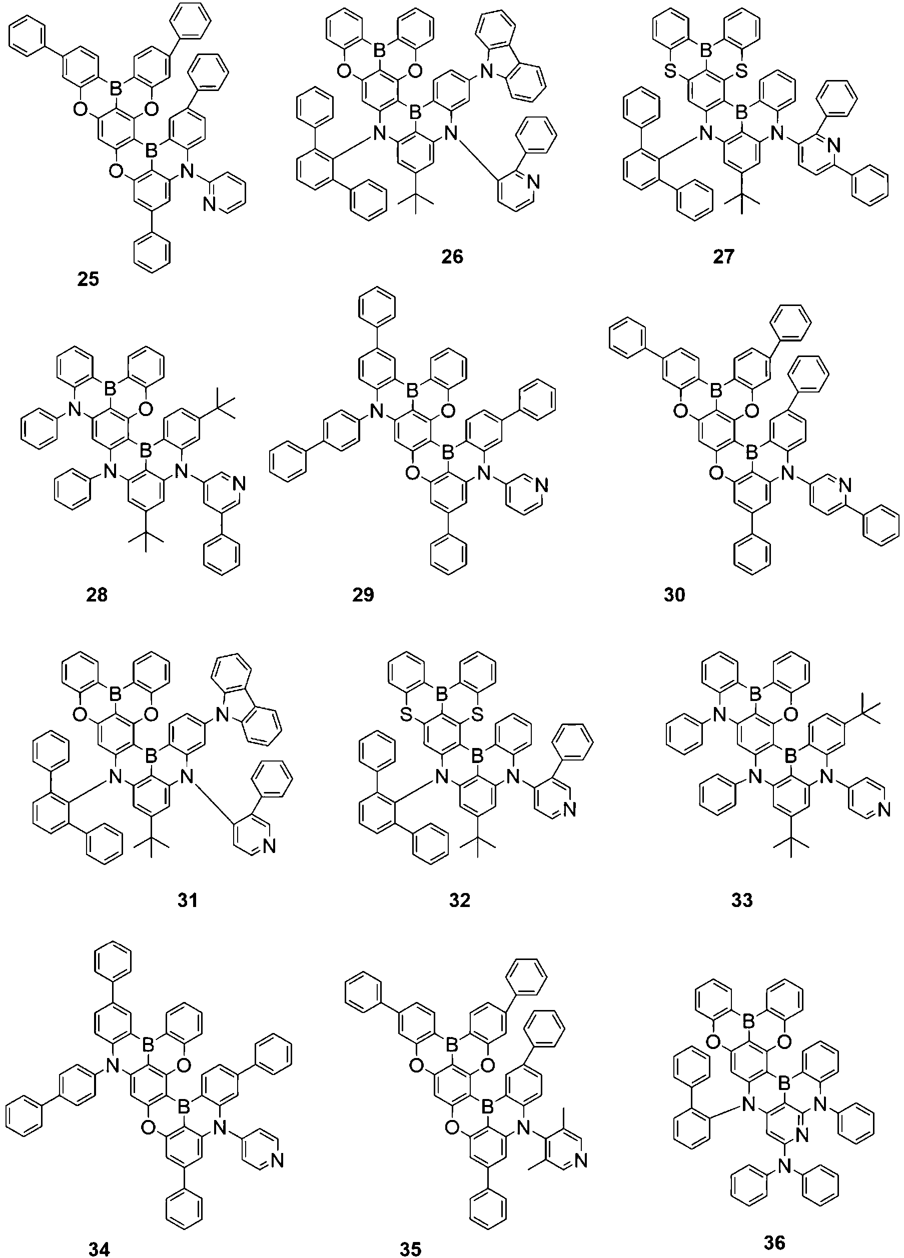 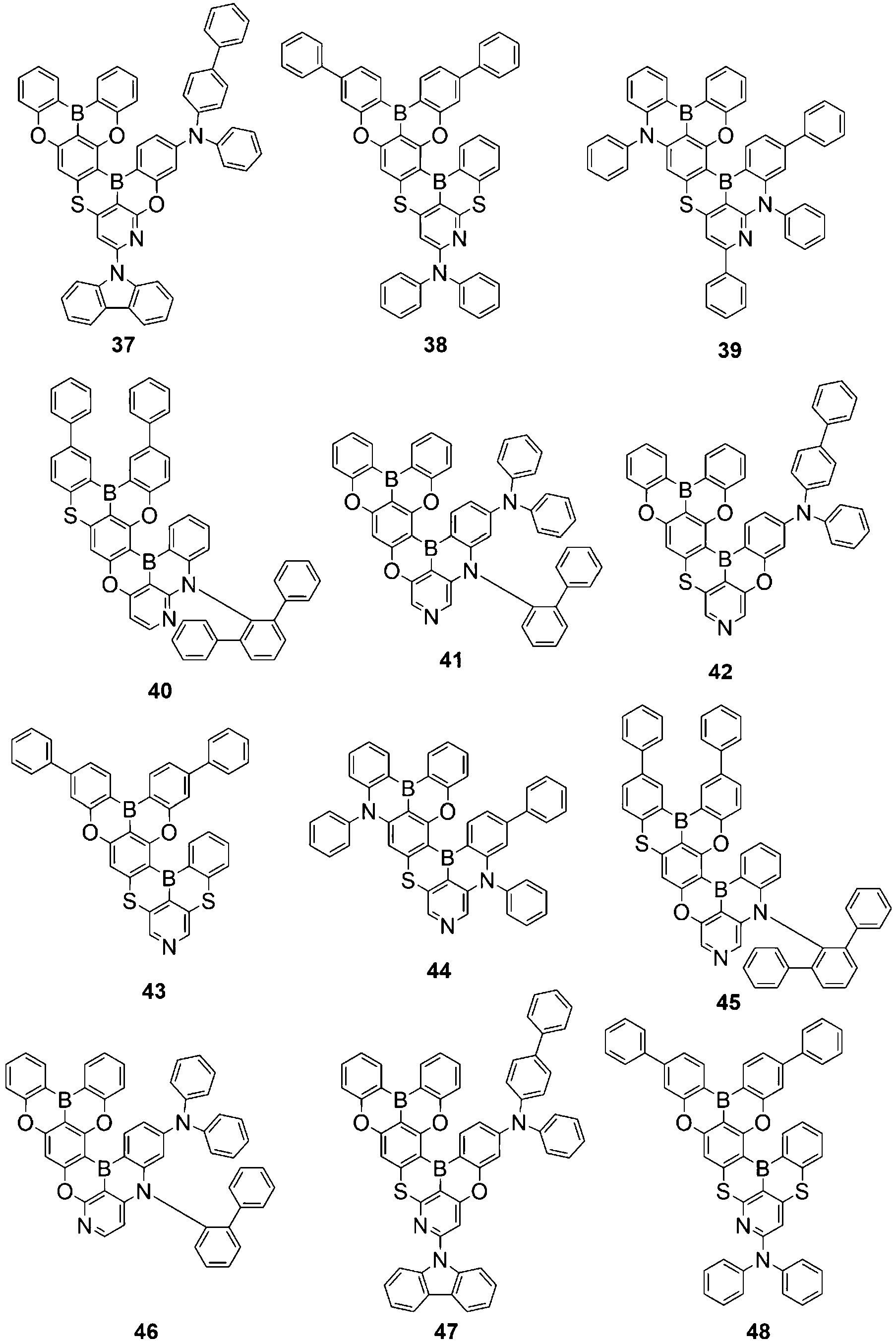 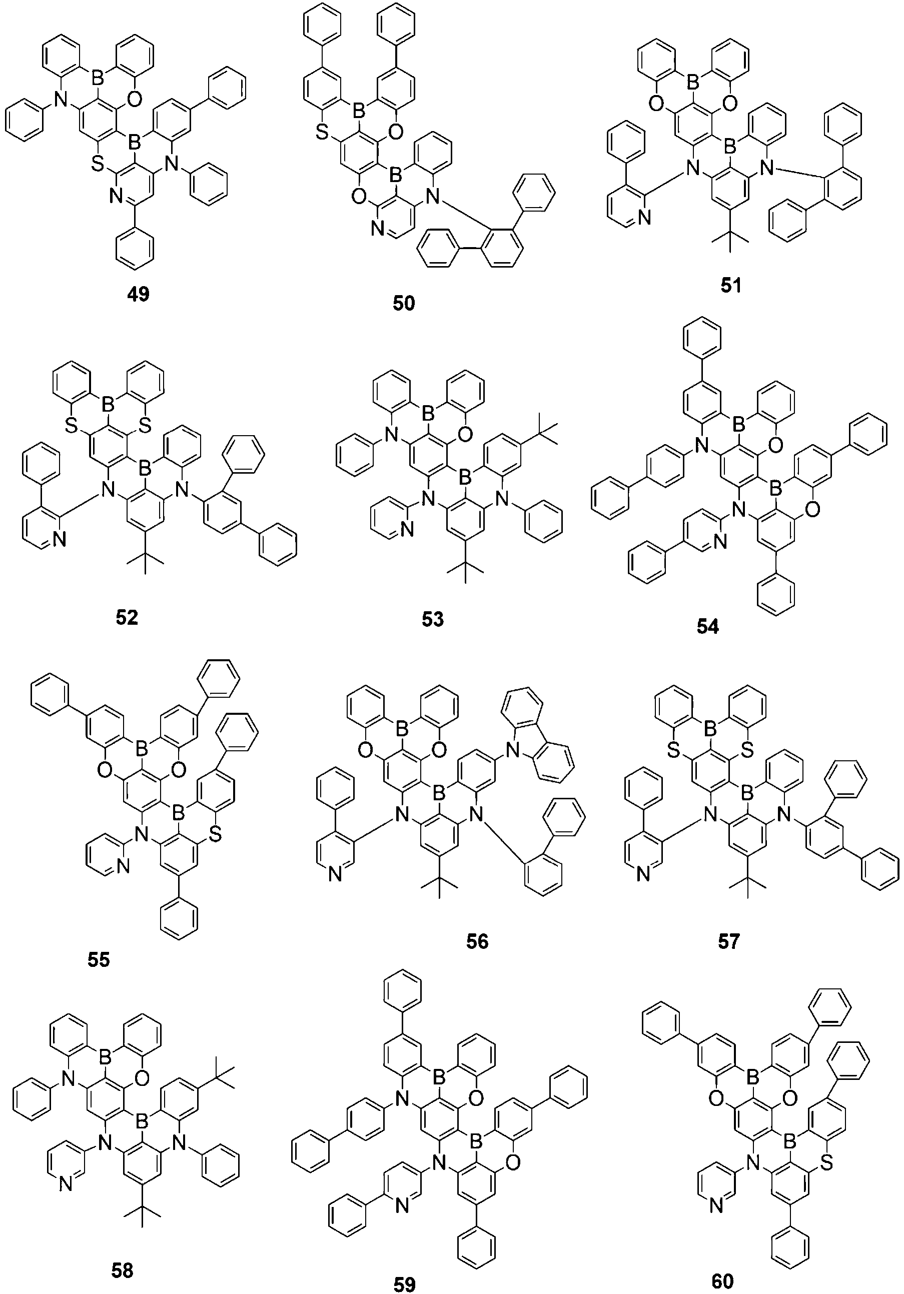 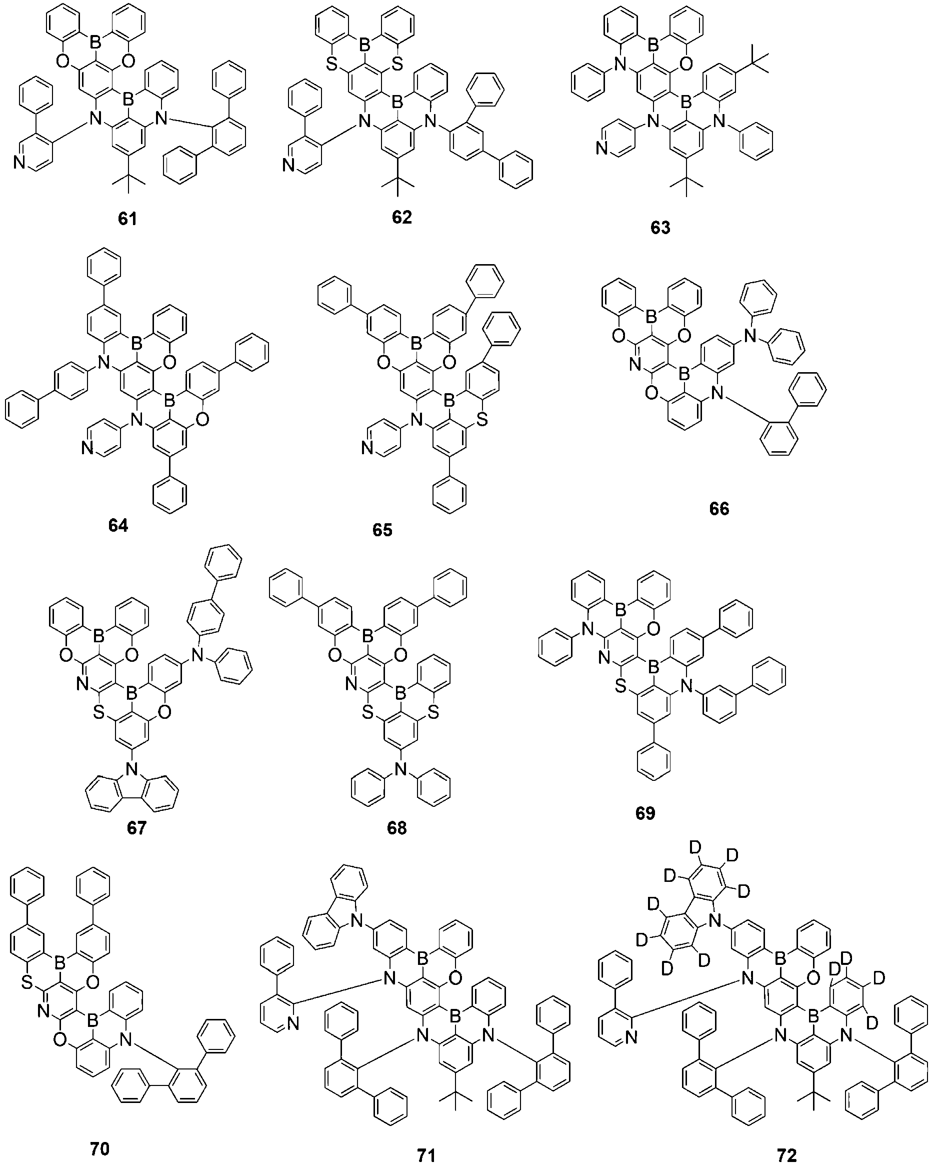 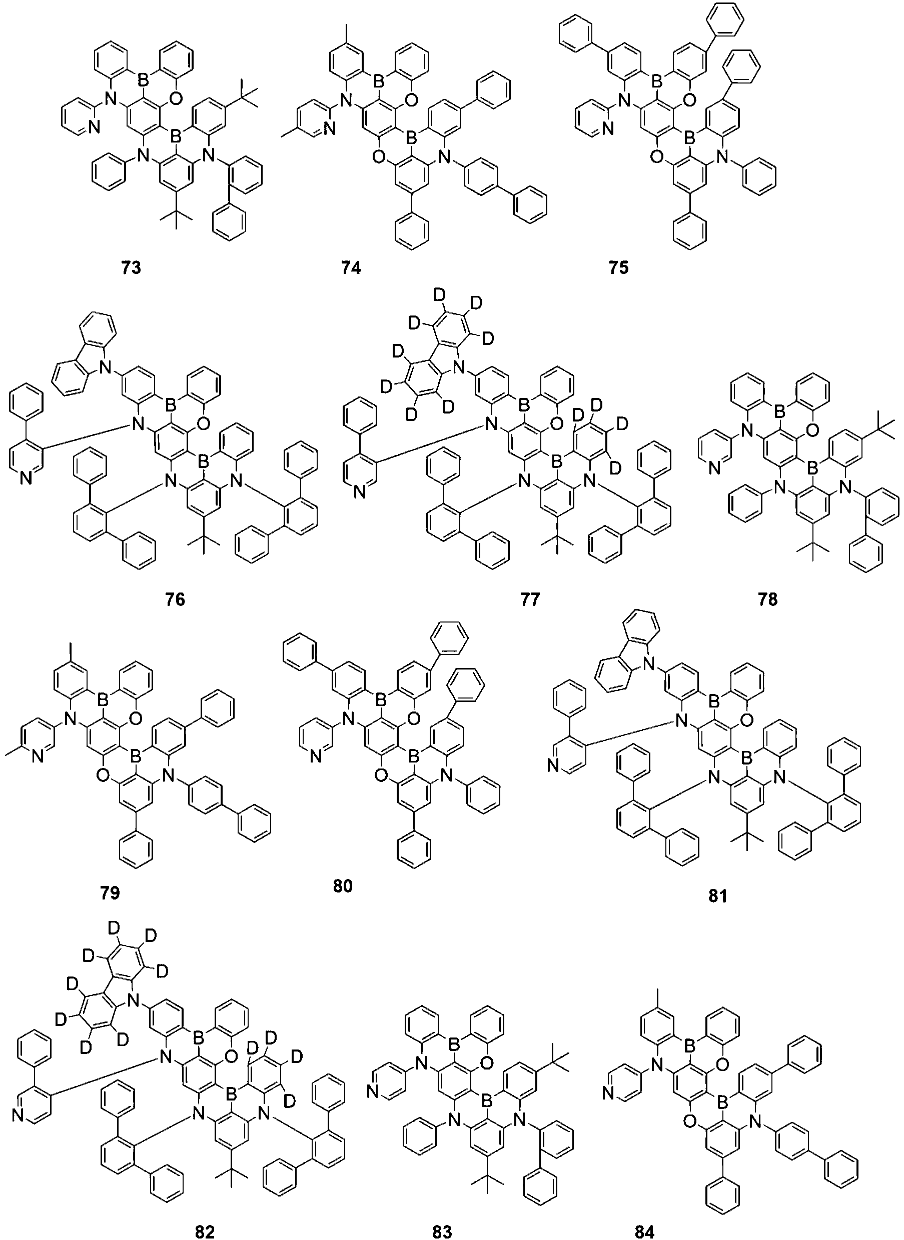 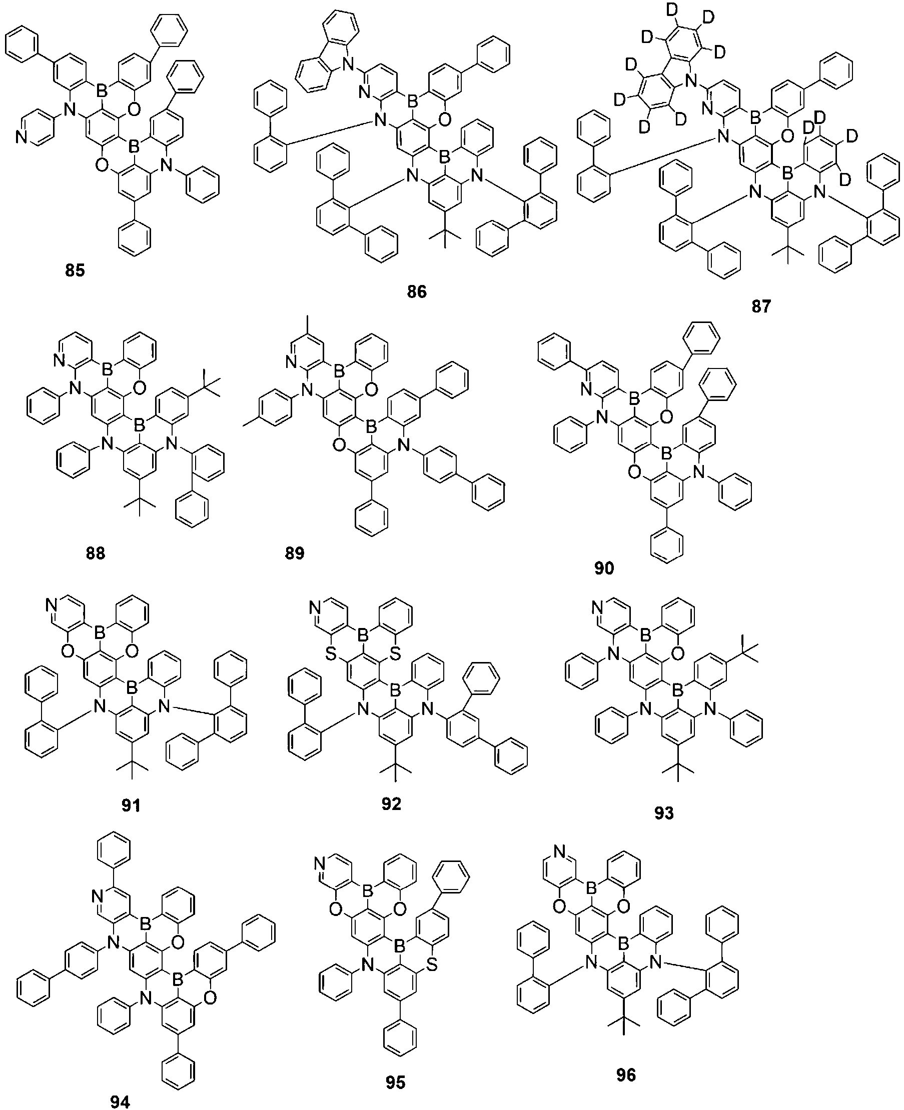 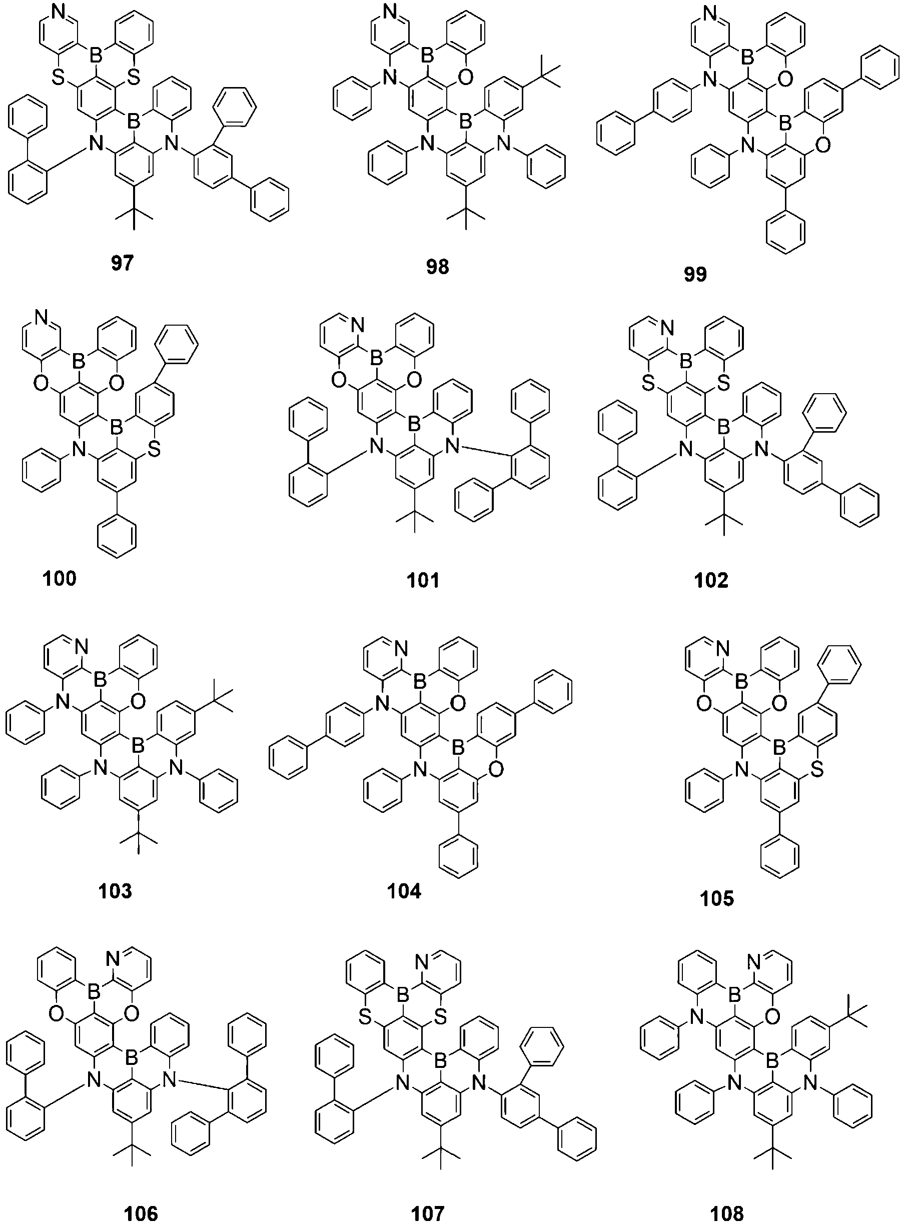 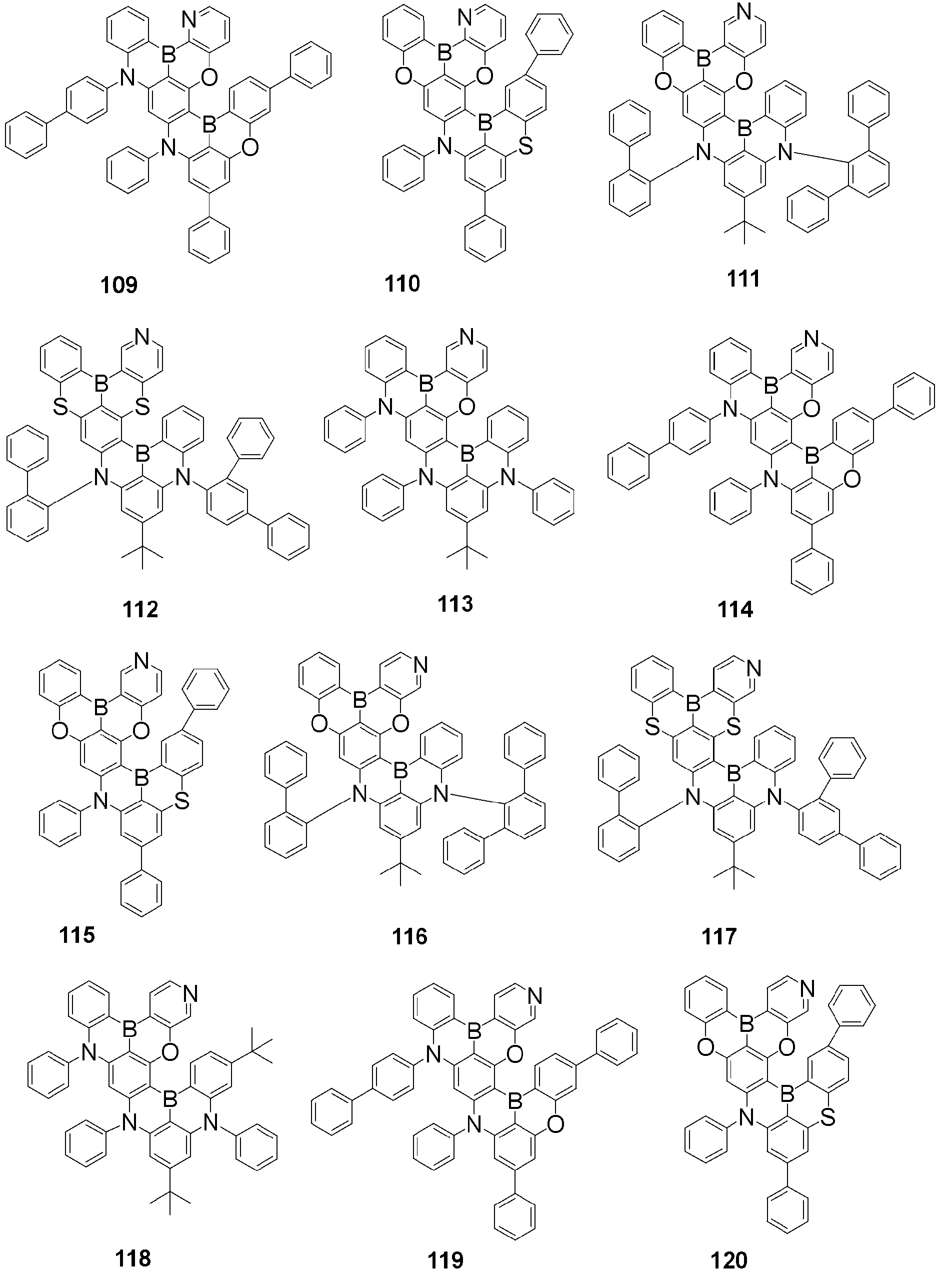 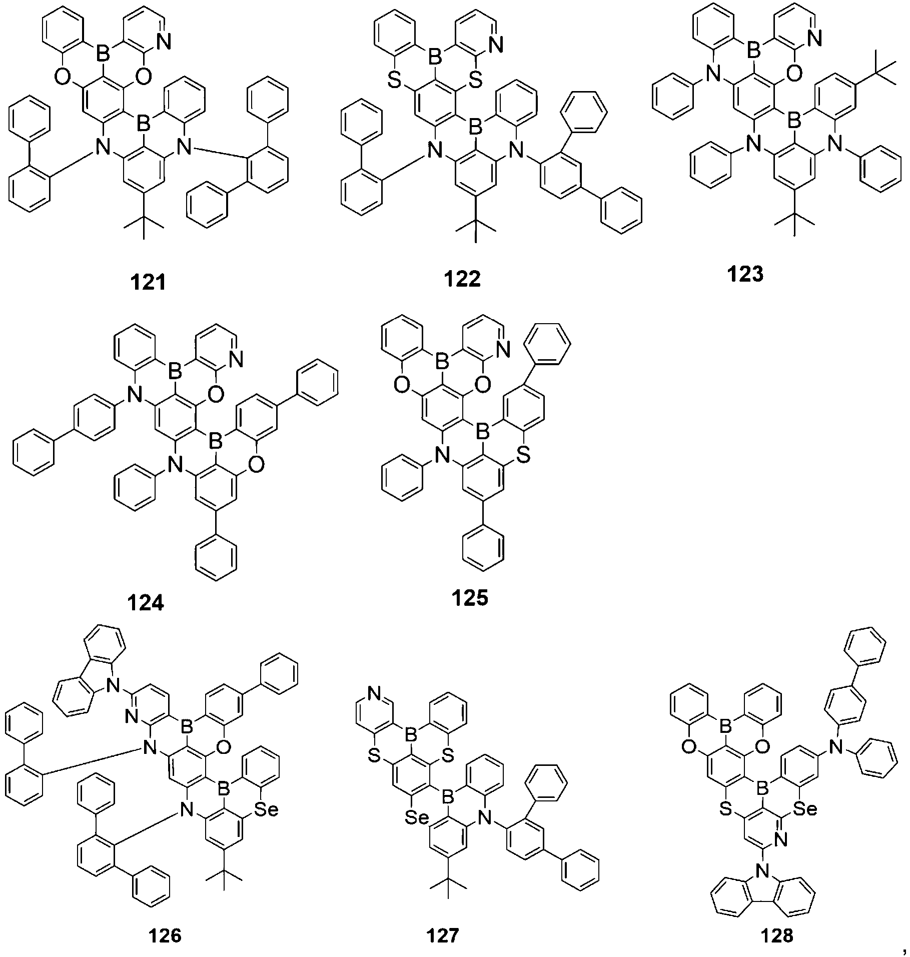 in Compound Group 1, D being deuterium.

15. An electronic device (EA) comprising a display module (DM) comprising a plurality of light emitting elements (ED-1, ED-2, ED-3), wherein
at least one selected from among the plurality of light emitting elements (ED-1, ED-2, ED-3) comprises a first electrode (EL1), a second electrode (EL2) on the first electrode (EL1), and a light emitting layer (EML-R, EML-G, EML-B) between the first electrode (EL1) and the second electrode (EL2) and comprising a polycyclic compound represented by Formula 1: 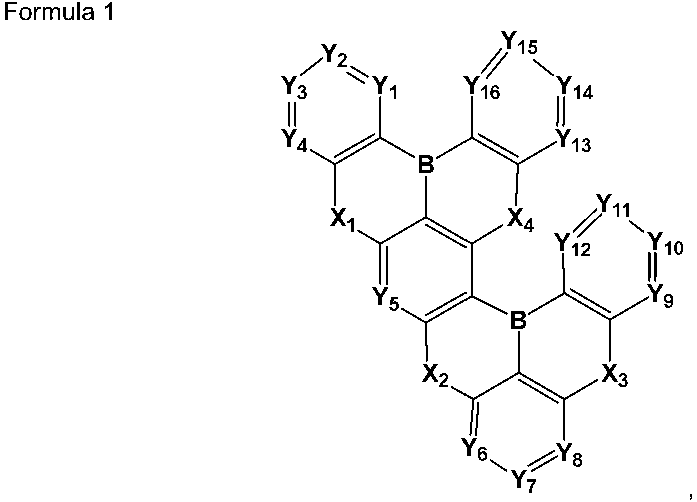
wherein, in Formula 1,
X₁ to X₄ are each independently O, S, or Se, or represented by Formula 2,
Y₁ to Y₁₆ are each independently CRₐ or N, and
Rₐ is hydrogen, deuterium, a cyano group, a substituted or unsubstituted amino group, a substituted or unsubstituted alkyl group of 1 to 10 carbon atoms, a substituted or unsubstituted aryl group of 6 to 30 ring-forming carbon atoms, or a substituted or unsubstituted heteroaryl group of 2 to 30 ring-forming carbon atoms: 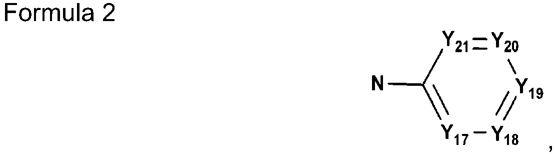 and
wherein, in Formula 2,
Y₁₇ to Y₂₁ are each independently CR_{b} or N, and
R_{b} is hydrogen, deuterium, a cyano group, a substituted or unsubstituted amino group, a substituted or unsubstituted alkyl group of 1 to 10 carbon atoms, a substituted or unsubstituted aryl group of 6 to 30 ring-forming carbon atoms, or a substituted or unsubstituted heteroaryl group of 2 to 30 ring-forming carbon atoms,
when none of X₁ to X₄ of Formula 1 is represented by Formula 2, then at least one selected from among Y₁ to Y₁₆ of Formula 1 is N, and
when at least one selected from among X₁ to X₄ of Formula 1 is represented by Formula 2, then at least one selected from among Y₁ to Y₁₆ of Formula 1 and Y₁₇ to Y₂₁ of Formula 2 is N, optionally further comprising at least one selected from among a processor (PR), a memory (MR), and a power module (PM).
